(19) Europäisches Patentamt / European Patent Office / Office européen des brevets

(11) **EP 2 978 820 B1**

(12) **EUROPEAN PATENT SPECIFICATION**

(45) Date of publication and mention of the grant of the patent:
**21.03.2018 Bulletin 2018/12**

(21) Application number: **14720867.2**

(22) Date of filing: **25.03.2014**

(51) Int Cl.:
***C09K 11/06*** *(2006.01)* ***A01G 9/14*** *(2006.01)*
***H01L 33/50*** *(2010.01)* ***H01L 31/055*** *(2014.01)*
***A01G 7/04*** *(2006.01)* ***C07D 401/00*** *(2006.01)*
***C07D 249/18*** *(2006.01)*

(86) International application number:
**PCT/US2014/031722**

(87) International publication number:
**WO 2014/160707 (02.10.2014 Gazette 2014/40)**

(54) **WAVELENGTH CONVERSION FILMS WITH MULTIPLE PHOTOSTABLE ORGANIC CHROMOPHORES**

WELLENLÄNGENUMWANDLUNGSFILME MIT MEHREREN LICHTSTABILEN ORGANISCHEN CHROMOPHOREN

FILMS À CONVERSION DE LONGUEUR D'ONDE COMPORTANT DE MULTIPLES CHROMOPHORES ORGANIQUES PHOTOSTABLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2013 US 201361805430 P**
**03.01.2014 US 201461923559 P**

(43) Date of publication of application:
**03.02.2016 Bulletin 2016/05**


(73) Proprietor: **Nitto Denko Corporation**
**Ibaraki**
**Osaka 567-8680 (JP)**

(72) Inventors:
- **GU, Tao**
  **Santa Clara, CA 95054 (US)**
- **ZHANG, Hongxi**
  **Temecula, CA 92592 (US)**
- **LIN, Weiping**
  **Carlsbad, CA 92009 (US)**
- **HSIEH, Wan-Yun**
  **San Diego, CA 92126 (US)**
- **YAMAMOTO, Michiharu**
  **Santa Clara**
  **CA 95054 (US)**

(74) Representative: **Grünecker Patent- und Rechtsanwälte**
**PartG mbB**
**Leopoldstraße 4**
**80802 München (DE)**



(56) References cited:

| | |
|---|---|
| **EP-A1- 2 557 606** | **WO-A1-2006/041221** |
| **WO-A1-2009/115574** | **WO-A1-2011/072876** |
| **WO-A2-2005/054212** | **WO-A2-2012/134992** |
| **CN-A- 102 464 794** | **DE-A1- 3 400 991** |
| **DE-A1-102005 062 687** | **JP-A- 2006 077 171** |
| **JP-A- 2011 151 094** | **US-A1- 2004 115 473** |
| **US-A1- 2007 003 783** | |

- **JIANGYI MAO ET AL: "Benzotriazole-Bridged Sensitizers Containing a Furan Moiety for Dye-Sensitized Solar Cells with High Open-Circuit Voltage Performance", CHEMISTRY - AN ASIAN JOURNAL, vol. 7, no. 5, 10 February 2012 (2012-02-10), pages 982-991, XP055049963, ISSN: 1861-4728, DOI: 10.1002/asia.201100967**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



EP 2 978 820 B1

## Description

BACKGROUND OF THE INVENTION

### Field of the Invention

The disclosure relates generally to the field of wavelength conversion films comprising organic photostable chromophores.

### Description of the Related Art

A deficiency of several solar energy harvesting devices (e.g. photovoltaic devices) is that they are unable to effectively utilize much of the light spectrum. In addition, the windows through which light is shined in these photovoltaic devices absorb certain wavelengths of light (typically the shorter UV wavelengths) instead of allowing the light to pass through to the photoconductive material layer where it can be converted into electricity. Thus, some radiative energy is lost to the device itself. Wavelength conversion films can be used to, among other things, improve the harvesting of solar energy by photovoltaics.

Attempts have been made to use inorganic wavelength down-shifting materials to improve the performance of photovoltaic devices. For example, silicon-based solar cells containing a wavelength down-shifting inorganic phosphor material have been made, solar cells with down-shifting wavelength conversion layers containing a quantum dot compounds have been made, and conversion films made with down-shifting inorganic fluorescent powders have been made. For example, WO 2012/134992 A2 discloses a photovoltaic cell comprising a wavelength conversion film comprising an optically transparent polymer matrix in combination with multiple chromophores.

There has been very little work reported on the use of photo-luminescent organic mediums for efficiency improvements in photovoltaic devices. The poor photostability of known organic luminescent dyes has inhibited their development. For example, an 11% efficiency enhancement of a CdS/CdTe cell by using Rhodamine 6G/Polyvinyl butyral film was reported by B.C. Hong and K. Kawano. However the photostability of this film was very poor under one sun (AM1.5G) irradiation, with greater than 50% degradation after only 24 hours. AM1.5G is a standard terrestrial solar spectral irradiance distribution as defined by the American Society for Testing and Materials (ASTM) standard 2006, see ASTM G-173-03. Furthermore, literature cautions against using photo-luminescent organic media as the stabilities of these materials are insufficient, for example see U.S. Patent Application Publication No. 2010/0012183. Most commercially available photo-luminescent media, including fluorescent dyes, exhibit photobleaching only days after solar illumination.

The use of luminescent dyes in greenhouse roofing materials to alter the incident solar spectrum plants are exposed to within a greenhouse has been attempted. However, the disclosed systems lack efficiency and stability. For instance, current systems lose a large amount of the emitted light to the polymeric or glass matrix which encapsulates the dyes. Also, the stability of the dyes is poor and the dyes often degrade quickly, especially when exposed to UV light.

Because of high cost and low efficiency/stability, there remains an unmet need for dyes that improve plant growth, are photostable, and can be used to improve solar energy harvesting simultaneously.

SUMMARY

Wavelength conversion layers comprising photostable multiple organic chromophore compounds are provided. Some embodiments provide a wavelength conversion film, comprising an optically transparent polymer matrix and a first organic photostable chromophore having an absorption maximum less than 400 nm and an emission maximum greater than 100 nm.

Any of the embodiments described above, or described elsewhere herein, can include one or more of the following features.

In some embodiments, the wavelength conversion film further comprises a second organic photostable chromophore.

In some embodiments of the wavelength conversion film, the absorption maximum of the second organic photostable chromophore is in the range from 480 nm to 620 nm and the emission maximum of the second organic photostable chromophore is in the range range from 550 nm to 800 nm.

The first organic photostable chromophore used in the wavelength conversion film of the present invention is represented by formula (I):

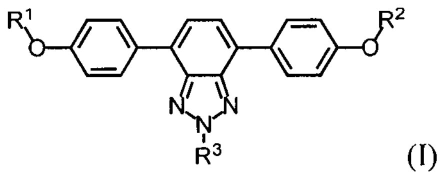

(I)

wherein each of $R^1$, $R^2$, and $R^3$ is independently selected from the group consisting of alkyl, a substituted alkyl, and aryl.

Alternatively, the first organic photostable chromophore is represented by formula (II-a) or (II-b):

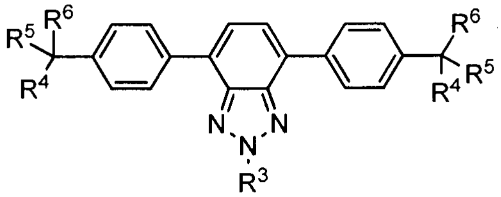

(II-a),

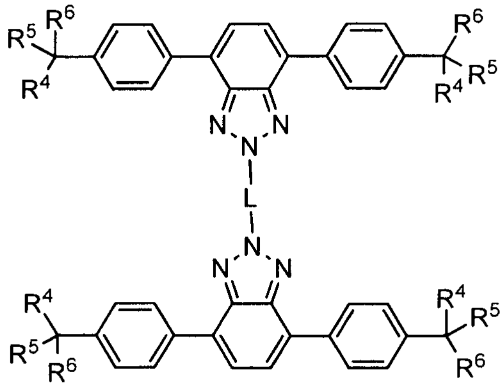

(II-b);

wherein:

$R^3$ is selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, optionally substituted carbonyl, optionally substituted ether, optionally substituted ketone, optionally substituted sulfone, and optionally substituted sulfonamide; or $R^3$ is an optionally substituted polycyclic ring system, wherein each ring is independently cycloalkyl, aryl, heterocycloalkyl, or heteroaryl;

$R^4$, $R^5$, and $R^6$ are independently selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted heteroarylalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, and optionally substituted carbonyl, optionally substituted ether, optionally substituted ketone, optionally substituted sulfone, and optionally substituted sulfonamide; or $R^4$ and $R^5$, $R^4$ and $R^6$, $R^5$ and $R^6$, or $R^4$ and $R^5$ and $R^6$, together form an optionally substituted ring or an optionally substituted polycyclic ring system, wherein each ring is independently cycloalkyl, aryl, heterocyclalkyl, or heteroaryl; and

L is selected from the group consisting of optionally substituted alkyl, optionally substituted heteroalkyl, optionally substituted alkylene, and optionally substituted heteroalkylene, optionally substituted alkynylene, optionally substituted arylene, optionally substituted heteroarylene.

Some embodiments provide a wavelength conversion film comprising at least one UV absorbing chromophore which exhibits an absorption peak at a wavelength less than 400 nm (e.g., in the UV radiation range), and at least one wavelength conversion chromophore which exhibits an absorption peak at a wavelength of equal to or greater than 400 nm. In some embodiments, the wavelength conversion film comprising at least one UV absorbing chromophore and at least one wavelength conversion chromophore absorbing photons of greater than or equal to wavelengths of 400 nm shows significantly improved photostability.

Some embodiments of the invention provide a wavelength conversion film comprising at least one UV absorbing

chromophore and at least one wavelength conversion chromophore in an optically transparent polymer matrix. In some embodiments the wavelength conversion film comprises additional UV absorbing chromophores. In some embodiments, the wavelength conversion film comprises additional wavelength conversion chromophores. In some embodiments, the film receives as input at least one photon having a first wavelength, and provides as output at least one photon having a second wavelength which is different than the first. By employing the film, a new type of optical light collection system, fluorescence-based solar collectors, fluorescence-activated displays, and single-molecule spectroscopy can be provided.

Some embodiments provide a photovoltaic module for the conversion of solar light energy into electricity. In some embodiments the photovoltaic module comprises at least one photovoltaic device or solar cell, and a wavelength conversion film as disclosed herein. In some embodiments, the wavelength conversion film is incorporated on top of, or encapsulated into, the photovoltaic device or solar cell. In some embodiments, incident light passes through the wavelength conversion film prior to reaching an area of the photovoltaic module where solar light energy is converted into electricity.

The photovoltaic module comprising at least one photovoltaic device or solar cell and the wavelength conversion film, as described herein, may include additional layers. For example, the photovoltaic module may comprise an adhesive layer in between the solar cell and wavelength conversion film. In some embodiments the photovoltaic module may also comprise glass or polymer layers, which encapsulate the device, or may be placed on top of the wavelength conversion film. The glass or polymer layers may be designed to protect and prevent oxygen and moisture penetration into the wavelength conversion film. In some embodiments, the glass or polymer layers may be used to internally refract or reflect photons that are emitted from the wavelength conversion film in a direction that is away from the photoelectric conversion layer of the solar cell. In some embodiments, the film may further comprise additional polymer layers, sensitizers, plasticizers, and/or other components which may improve efficiency or stability of the wavelength conversion film.

The wavelength conversion film may be applied to various photovoltaic devices. In some embodiments, the wavelength conversion film is applied to at least one solar cell or photovoltaic device selected from the group consisting of a silicon based device, a III-V or II-VI junction device, a Copper-Indium-Gallium-Selenium (CIGS) thin film device, an organic sensitizer device, an organic thin film device, or a Cadmium Sulfide/Cadmium Telluride (CdS/CdTe) thin film device.

The wavelength conversion film may be provided in various lengths and widths so as to accommodate different sizes and types of solar cells, or entire solar panels.

Other embodiments provide methods for improving the performance of a photovoltaic device or solar cell. In some embodiments, the method comprises applying a wavelength conversion film, as described herein, directly onto the light incident side of the photovoltaic device or solar cell. In some embodiments, the method comprises incorporating a wavelength conversion film, as described herein, directly into the photovoltaic device or solar cell during its fabrication, such that the wavelength conversion film is encapsulated between the photovoltaic device or solar cell and a cover substrate on the light incident side.

Some embodiments of the present invention describe a wavelength conversion film comprising a second organic photostable chromophore configured to absorb a second group of photons having a wavelength in the range of 480 to 620 nm and to re-emit the second group of photons at a wavelength in the range of about 550 to 800 nm. In some embodiments the wavelength conversion film is useful in luminescent panels.

Some embodiments of the present invention describe a wavelength conversion film comprising a second organic photostable chromophore configured to absorb a second group of photons having a wavelength in the range of 480 to 620 nm and to re-emit the second group of photons at a wavelength in the range of 550 to 800 nm. In some embodiments the wavelength conversion film is useful in luminescent panels.

Some embodiments of the present invention relate to luminescent panels comprising organic photostable chromophore compounds. The luminescent panel is useful as a greenhouse roof to provide improved wavelength profiles and plant growth compared to panels that do not incorporate organic photostable chromophore compounds. Some embodiments of the invention provide a luminescent panel comprising a light absorbing surface wherein the light absorbing surface is configured to absorb incident photons, and two or more chromophore compounds. In some embodiments, the two or more chromophore compounds may be located in one wavelength conversion film. In some embodiments, the two or more chromophore compounds are located in separate wavelength conversion films. In some embodiments, the at least one wavelength conversion film comprises a first organic photostable chromophore (A), which has an wavelength absorbance maximum in the UV wavelength range and re-emits in the blue wavelength range. In some embodiments, the at least one wavelength conversion film comprises a second organic photostable chromophore (B), which has an wavelength absorbance maximum in the green wavelength range and re-emits in the red wavelength range. In some embodiments, chromophore compounds (A) and (B) are used together. In some embodiments, the two chromophores may be mixed in a single wavelength conversion layer, or they may be provided in separate wavelength conversion layers. In some embodiments, the at least one wavelength conversion layer comprises a polymer matrix.

Some embodiments of the present invention provide highly efficient luminescent panels which utilize a mixture of two organic photostable chromophores designed to emit radiation in the wavelength regions which are optimal for

plant growth. In some embodiments, chromophore (A) absorbs light in the UV wavelength region and re-emits this light in the blue wavelength region. In some embodiments, chromophore (B) absorbs light in the green wavelength region and re-emits this light in the red wavelength region. As described herein, the light in the UV wavelength region is in the range of about 300 nm to about 400 nm. As described herein, the light in the blue wavelength region is in the range of about 400 nm to about 520 nm. As described herein, the light in the green wavelength region is in the range of about 480 nm to about 620 nm. As described herein, the light in the red wavelength region is in the range of about 570 nm to about 800 nm.

In some embodiments, a luminescent panel comprising at least one wavelength conversion film according to any of the above embodiments is provided.

In some embodiments of the luminescent panel, the emission spectrum of the first organic photostable chromophore and the absorption spectrum of the second photostable chromophore have minimal overlap.

In some embodiments, any of the the luminescent panels above can further comprise a transparent substrate layer. In some embodiments of the luminescent panel, the transparent substrate layer comprises glass or polymer.

In some embodiments, any of the the luminescent panels above can further comprise a stabilizer, antioxidant, UV absorber, or any combination thereof disposed within the luminescent panel.

In some embodiments, any of the the luminescent panels above can further comprise an additional layer wherein the additional layer further comprises a UV absorber, stabilizer, an antioxidant, or any combination thereof.

In some embodiments, any of the the luminescent panels above can further comprise at least one solar energy conversion device, wherein the at least one solar energy conversion device receives a portion of photons and converts those photons into electricity.

In some embodiments of the luminescent panel, the at least one solar energy conversion device is encapsulated within the luminescent panel.

In some embodiments of the luminescent panel, the at least one solar energy conversion device comprises a Silicon based device, a III-V or II- VI PN junction device, a Copper-Indium-Gallium-Selenium (CIGS) thin film device, an organic sensitizer device, an organic thin film device, or a Cadmium Sulfide/Cadmium Telluride (CdS/CdTe) thin film device

In some embodiments, any of the the luminescent panels above can further comprise a refractive index matching substance configured to attach the luminescent solar concentrator to the light incident surface of the at least one solar energy conversion device.

In some embodiments the organic photostable chromophore (A), and the organic photostable chromophore (B), are mixed within a single wavelength conversion layer which further comprises a polymer matrix. In some embodiments the organic photostable chromophore (A), and the organic photostable chromophore (B), are located in two separate wavelength conversion layers which independently further comprise a polymer matrix.

The luminescent panel comprising two organic photostable chromophore compounds, as described herein, may include additional layers. For example, the luminescent panel may comprise an adhesive layer disposed between the wavelength conversion layer or layers. In some embodiments, the luminescent panel may also comprise additional glass or polymer layers, which encapsulate the wavelength conversion layer(s), or may be placed on top of or underneath the wavelength conversion layers(s). The glass or polymer layers may be designed to protect and prevent oxygen and moisture penetration into the wavelength conversion film(s). In some embodiments, the luminescent panel may further comprise additional polymer layers, or additional components within the polymer layers or wavelength conversion layer(s) such as sensitizers, plasticizers, UV absorbers and/or other components which may improve efficiency or stability.

The luminescent panel may be provided in various lengths and widths so as to accommodate different sizes and types of greenhouse roofs.

One issue with incorporating luminescent materials into greenhouse roofing panels is that the incident photons, once absorbed and re-emitted by the luminescent material, often become trapped with the polymer matrix of the panel, and never reach the plant species inside the greenhouse. For greenhouse panels with luminescent materials which do not also comprise a solar cell or photovoltaic module, this trapped light is usually dissipated as heat. One advantage of incorporating solar energy conversion devices into the greenhouse roofing panels that have luminescent materials is that most of this trapped light will be absorbed by the solar energy conversion device, and converted into electricity, so that very little light is wasted.

Therefore, other embodiments of the present invention relates to a luminescent light and energy collection panel. The luminescent light and energy collection panel comprises the luminescent panel and at least one solar energy conversion device. The luminescent light and energy collection panel is useful as a greenhouse roof to simultaneously provide improved plant growth and an increase in solar harvesting efficiency compared to panels that do not incorporate two luminescent materials, and it is photostable for long periods of time. In some embodiments, the at least one solar energy conversion device is encapsulated within the luminescent panel such that the device is not exposed to the outside environment, and wherein the solar energy conversion device receives a portion of the solar energy and converts that energy into electricity. Consequently, the highly efficient luminescent light and energy collection panel utilizes a mixture

of two organic photostable chromophores designed to emit radiation in the wavelength regions which are optimal for plant growth, while simultaneously allowing trapped radiation to be converted into electricity. In some embodiments, chromophore (A) absorbs light in the UV wavelength region and re-emits this light in the blue wavelength region. In some embodiment, chromophore (B) absorbs light in the green wavelength region and re-emits this light in the red wavelength region.

Some embodiments provide a luminescent light and energy collection panel for the conversion of solar light energy into electricity. In some embodiments the luminescent light and energy collection panel comprises at least one photovoltaic device or solar cell. In some embodiments, the at least one solar cell or photovoltaic device is encapsulated within the luminescent light and energy collection panel such that the device is not exposed to the outside environment. In some embodiments the solar energy conversion device receives a portion of the direct incident solar energy and converts that energy into electricity. In some embodiments, incident light of a first wavelength is absorbed by the chromophore compounds in the wavelength conversion layer or layers, and is re-emitted at a second wavelength which is different than the first wavelength, and is then internally reflected and refracted within the luminescent light and energy collection panel until it reaches the at least one solar cell or photovoltaic device where it is converted into electricity. In some embodiments, the solar energy conversion device receives a portion of the solar energy re-emitted from the chromophore compounds within the wavelength conversion layer or layers.

The luminescent light and energy collection panel comprising two organic photostable chromophore compounds and at least one solar energy conversion device, as described herein, may include additional layers. For example, the luminescent light and energy collection panel may comprise an adhesive layer in between the solar cell and the wavelength conversion layer or layers. In some embodiments the luminescent light and energy collection panel may also comprise additional glass or polymer layers, which encapsulate the wavelength conversion layer(s), or may be placed on top of or underneath the wavelength conversion layers(s). The glass or polymer layers may be designed to protect and prevent oxygen and moisture penetration into the wavelength conversion film(s). In some embodiments, the glass or polymer layers may be used as part of the luminescent light and energy collection panel to internally refract and/or reflect photons that are emitted from the wavelength conversion layer(s) in a direction that is towards the at least one photovoltaic device or solar cell. In some embodiments, the luminescent light and energy collection panel may further comprise additional polymer layers, or additional components within the polymer layers or wavelength conversion layer(s) such as sensitizers, plasticizers, UV absorbers and/or other components which may improve efficiency or stability.

The luminescent light and energy collection panel may incorporate various types of photovoltaic devices (e.g. solar cells). In some embodiments, the luminescent light and energy collection panel comprises at least one solar cell or photovoltaic device selected from the group consisting of a silicon based device, a III-V or II- VI junction device, a Copper-Indium-Gallium-Selenium (CIGS) thin film device, an organic sensitizer device, an organic thin film device, or a Cadmium Sulfide/Cadmium Telluride (CdS/CdTe) thin film device. In some embodiments, the luminescent light and energy collection panel comprises multiple types of devices.

The luminescent light and energy collection panel may be provided in various lengths and widths so as to accommodate different sizes and types of solar cells, and/or to form different sizes and types of greenhouse roofs.

BRIEF DESCRIPTION OF THE DRAWINGS

Figure 1 is a side-view of an embodiment of a photovoltaic device comprising a wavelength conversion film.
Figure 2 is a side-view of another embodiment of a photovoltaic device comprising a wavelength conversion film.
Figure 3 is a side-view of an embodiment of a luminescent panel comprising a wavelength conversion film.
Figure 4 is a side-view of another embodiment of a luminescent panel comprising two wavelength conversion layers.
Figure 5 is a side-view of another embodiment of a luminescent panel comprising two wavelength conversion layers.
Figure 6 is a side-view of another embodiment of a luminescent panel comprising two wavelength conversion layers.
Figure 7 is a side-view of an embodiment of a luminescent light and energy collection panel comprising two wavelength conversion layers.
Figure 8 is a side-view of another embodiment of a luminescent light and energy collection panel comprising two wavelength conversion layers.
Figure 9 is a side-view of another embodiment of a luminescent light and energy collection panel comprising two wavelength conversion layers.
Figure 10 is a side-view of another embodiment of a luminescent light and energy collection panel comprising a wavelength conversion layers.
Figure 11 shows the absorption and emission spectrum for chromophore compound 3.
Figure 12 shows the absorption and emission spectrum for chromophore compound 4.
Figure 13 shows the absorption and emission spectrum for chromophore compound 5.

Figure 14 shows an example embodiment of a luminescent panel.

Figure 15 shows an example embodiment of a luminescent light and energy collection panel.

DETAILED DESCRIPTION

The embodiments will be explained with respect to example embodiments which are not intended to limit the present invention. In the present disclosure where conditions and/or structures are not specified, the skilled artisan in the art can readily provide such conditions and/or structures, in view of the present disclosure, as a matter of routine experimentation.

A chromophore compound, sometimes referred to as a luminescent dye or fluorescent dye, is a compound that absorbs photons of a particular wavelength or wavelength range, and re-emits the photon at a different wavelength or wavelength range. Chromophores used in film media can greatly enhance the performance of solar cells and photovoltaic devices. However, such devices are often exposed to extreme environmental conditions for long periods of time, e.g., 20 plus years. As such, maintaining the stability of the chromophore over a long period of time is important.

The use of an organic chromophore, as opposed to an inorganic chromophore, is attractive in that organic materials are typically cheaper and easier to use, making them a better economical choice. However, the poor photostability of organic luminescent dyes has inhibited their development. Furthermore, much of the literature cautions against using photo-luminescent organic media as the stabilities of these materials are insufficient, for example see U.S. Patent Application Publication No. 2010/0012183. Therefore, an unmet need exists for stable organic chromophores. Highly photo-stable wavelength conversion layers comprising multiple organic chromophore compounds are provided herein.

Some embodiments provide a wavelength conversion film, comprising a polymer matrix, a first organic chromophore configured to absorb photons having a first wavelength, and a second organic chromophore configured to absorb photons having a second wavelength. In some embodiments, the chromophores described herein have improved photostability. The wavelength conversion film comprising multiple chromophore compounds is useful in a variety of applications.

Chromophores can be up-converting or down-converting. In some embodiments, the wavelength conversion film comprises at least two chromophores that are down-shifting chromophores, meaning chromophores that convert photons of high energy (short wavelengths) into lower energy (long wavelengths). In some embodiments, the down-shifting chromophores may independently be a derivative of perylene, benzotriazole, benzothiadiazole, or combinations thereof, as are described in U.S. Patent Application Nos. 13/626,679 and 13/978,370, and U.S. Provisional Patent Application Nos. 61/430,053, 61/485,093, and 61/539,392. In some embodiments, the wavelength conversion film comprises at least one chromophore that is a benzo heterocyclic system, as described in U.S. Provisional Patent Application No. 61/749,225.

In some embodiments, the wavelength conversion chromophores represented by general formulae I, II-a, II-b, III-a, III-b, IV-a, IV-b, V-a, V-b, VI, VII-a, VII-b, VIII, IX-a, IX-b, X-a, and X-b are useful as fluorescent dyes in various applications, including in wavelength conversion films. As shown in the formulae, the dye comprises a benzo heterocyclic system in some embodiments. Additional detail and examples, without limiting the scope of the invention, on the types of compounds that can be used are described below.

As used herein, an "electron donor group" is defined as any group which increases the electron density of the 2*H*-benzo[*d*][1,2,3]triazole system.

An "electron donor linker" is defined as any group that can link two 2H-benzo[*d*][1,2,3]triazole systems providing conjugation of their $\pi$ orbitals, which can also increase or have neutral effect on the electron density of the 2*H*-benzo[*d*][1,2,3]triazole to which they are connected.

An "electron acceptor group" is defined as any group which decreases the electron density of the 2*H*benzo[*d*][1,2,3]triazole system. The placement of an electron acceptor group at the N-2 position of the 2*H*-benzo[*d*][1,2,3]triazole ring system.

The term "alkyl" refers to a branched or straight fully saturated acyclic aliphatic hydrocarbon group (i.e. composed of carbon and hydrogen containing no double or triple bonds). Alkyls include, but are not limited to, methyl, ethyl, propyl, isopropyl, butyl, isobutyl, tertiary butyl, pentyl, hexyl, and the like.

The term "heteroalkyl" used herein refers to an alkyl group comprising one or more heteroatoms. When two or more heteroatoms are present, they may be the same or different.

The term "cycloalkyl" used herein refers to saturated aliphatic ring system radical having three to twenty-five carbon atoms including, but not limited to, cyclopropyl, cyclopentyl, cyclohexyl, cycloheptyl, and the like.

The term "polycycloalkyl" used herein refers to saturated aliphatic ring system radical having multiple cylcoalkyl ring systems.

The term "alkenyl" used herein refers to a monovalent straight or branched chain radical of from two to twenty-five carbon atoms containing at least one carbon double bond including, but not limited to, 1-propenyl, 2-propenyl, 2-methyl-1-propenyl, 1-butenyl, 2-butenyl, and the like.

The term "alkynyl" used herein refers to a monovalent straight or branched chain radical of from two to twenty-five carbon atoms containing a carbon triple bond including, but not limited to, 1-propynyl, 1-butynyl, 2-butynyl, and the like.

The term "aryl" used herein refers to homocyclic aromatic radical whether one ring or multiple fused rings. Examples of aryl groups include, but are not limited to, phenyl, naphthyl, phenanthrenyl, naphthacenyl, fluorenyl, pyrenyl, and the like. Further examples include:

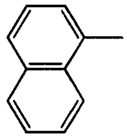
naphthalen-1-yl
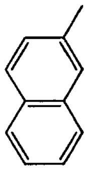
naphthalen-2-yl
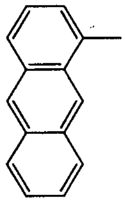
anthracen-1-yl
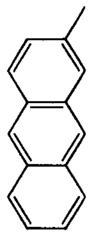
anthracen-2-yl
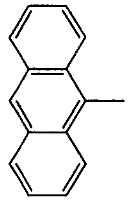
anthracen-9-yl

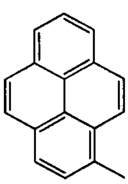
pyren-1-yl
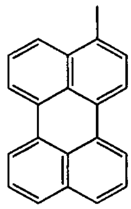
perylen-3-yl
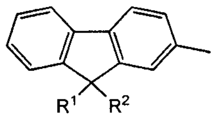
9*H*-fluoren-2-yl

The term "alkaryl" or "alkylaryl" used herein refers to an alkyl-substituted aryl radical. Examples of alkaryl include, but are not limited to, ethylphenyl, 9,9-dihexyl-9H-fluorene, and the like.

The term "aralkyl" or "arylalkyl" used herein refers to an aryl-substituted alkyl radical. Examples of aralkyl include, but are not limited to, phenylpropyl, phenylethyl, and the like.

The term "heteroaryl" used herein refers to an aromatic group comprising one or more heteroatoms, whether one ring or multiple fused rings. When two or more heteroatoms are present, they may be the same or different. In fused ring systems, the one or more heteroatoms may be present in only one of the rings. Examples of heteroaryl groups include, but are not limited to, benzothiazyl, benzoxazyl, quinazolinyl, quinolinyl, isoquinolinyl, quinoxalinyl, pyridinyl, pyrrolyl, oxazolyl, indolyl, thiazyl and the like. Further examples of substituted and unsubstituted heteroaryl rings include:

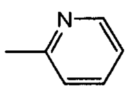
pyridin-2-yl
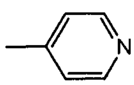
pyridin-4-yl
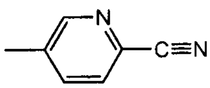
2-cyanopyridin-5-yl
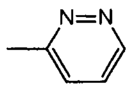
pyridazin-3-yl
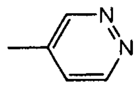
pyridazin-4-yl

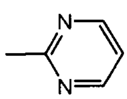
pyrimidin-2-yl
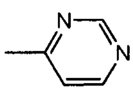
pyrimidin-4-yl
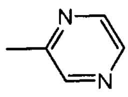
pyrazin-2-yl
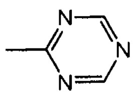
triazin-2-yl

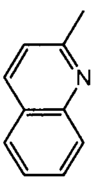
quinolin-2-yl
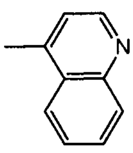
quinolin-4-yl
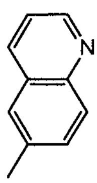
quinolin-6-yl
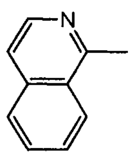
isoquinolin-1-yl
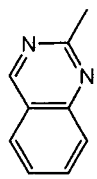
quinazolin-2-yl

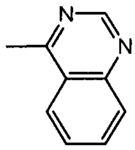
quinazolin-4-yl

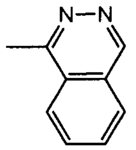
phthalazin-1-yl

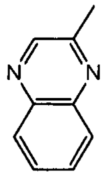
quinoxalin-2-yl

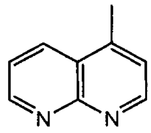
naphthyridin-4-yl

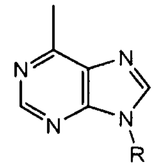
9*H*-purin-6-yl

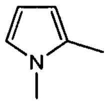
1*H*-pyrrol-2-yl

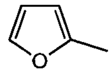
furan-2-yl

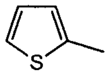
thiophen-2-yl

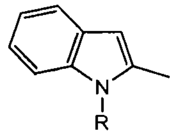
indol-2-yl

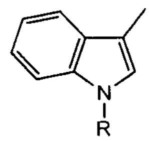
indol-3-yl

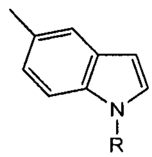
indol-3-yl

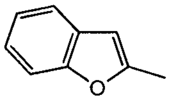
benzofuran-2-yl

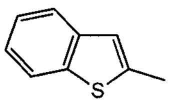
benzothiophen-2-yl

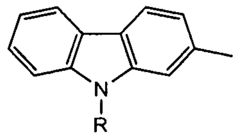
9*H*-carbazol-2yl

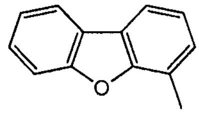
dibenzofuran-4-yl

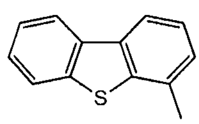
dibenzothiophen-4-yl

The term "alkoxy" used herein refers to straight or branched chain alkyl radical covalently bonded to the parent molecule through an --O-- linkage. Examples of alkoxy groups include, but are not limited to, methoxy, ethoxy, propoxy, isopropoxy, butoxy, n-butoxy, sec-butoxy, t-butoxy and the like.

The term "heteroatom" used herein refers to any atom that is not C (carbon) or H (hydrogen). Examples of heteroatoms include S (sulfur), N (nitrogen), and O (oxygen).

The term "cyclic amino" used herein refers to either secondary or tertiary amines in a cyclic moiety. Examples of cyclic amino groups include, but are not limited to, aziridinyl, piperidinyl, N-methylpiperidinyl, and the like.

The term "cyclic imido" used herein refers to an imide in the radical of which the two carbonyl carbons are connected by a carbon chain. Examples of cyclic imide groups include, but are not limited to, 1,8-naphthalimide, pyrrolidine-2,5-dione, 1H-pyrrole-2,5-dione, and the likes.

The term "alcohol" used herein refers to a radical -OH.

The term "acyl" used herein refers to a radical -C(=O)R.

The term "aryloxy" used herein refers to an aryl radical covalently bonded to the parent molecule through an --O-- linkage.

The term "acyloxy" used herein refers to a radical -O-C(=O)R.

The term "carbamoyl" used herein refers to a radical $-C(=O)NH_2$.

The term "carbonyl" used herein refers to a functional group C=O.

The term "carboxy" used herein refers to a radical -COOR.

The term "ester" used herein refers to a functional group RC(=O)OR'.

The term "amido" used herein refers to a radical -C(=O)NR'R".

The term "amino" used herein refers to a radical NR'R".

The term "heteroamino" used herein refers to a radical -NR'R" wherein R' and/or R" comprises a heteroatom.

The term "heterocyclic amino" used herein refers to either secondary or tertiary amines in a cyclic moiety wherein the group further comprises a heteroatom.

The term "cycloamido" used herein refers to an amido radical of-C(=O)NR'R" wherein R' and R" are connected by a carbon chain.

The term "sulfone" used herein refers to a sulfonyl radical of $-S(=O)_2R$.

The term "sulfonamide" used herein refers to a sulfonyl group connected to an amine group, the radical of which is $-S(=O)_2-NR'R"$.

As used herein, a substituted group is derived from the unsubstituted parent structure in which there has been an exchange of one or more hydrogen atoms for another atom or group. When substituted, the substituent group(s) is (are) one or more group(s) individually and independently selected from $C_1$-$C_{25}$ alkyl, $C_2$-$C_{25}$ alkenyl, $C_2$-$C_{25}$ alkynyl, $C_3$-$C_{25}$ cycloalkyl (optionally substituted with a moiety selected from the group consisting of halo, alkyl, alkoxy, alcohol, carboxyl, haloalkyl, CN, OH, $-SO_2$-alkyl, $-CF_3$, and $-OCF_3$), cycloalkyl geminally attached, $C_1$-$C_{25}$ heteroalkyl, $C_3$-$C_{25}$

heterocycloalkyl (e.g., tetrahydrofuryl) (optionally substituted with a moiety selected from the group consisting of halo, alkyl, alkoxy, alcohol, carboxyl, CN, $-SO_2$-alkyl, $-CF_3$, and $-OCF_3$), aryl (optionally substituted with a moiety selected from the group consisting of halo, alkyl, arylalkyl, alkoxy, alcohol, aryloxy, carboxyl, amino, imido, amido (carbamoyl), optionally substituted cyclic imido, cylic amido, CN, -NH-C(=O)-alkyl, $-CF_3$,$-OCF_3$, and aryl optionally substituted with $C_1$-$C_{25}$ alkyl), arylalkyl (optionally substituted with a moiety selected from the group consisting of halo, alkyl, alkoxy, alcohol, aryl, carboxyl, CN, $-SO_2$-alkyl, $-CF_3$, and $-OCF_3$), heteroaryl (optionally substituted with a moiety selected from the group consisting of halo, alkyl, alkoxy, alcohol, aryl, heteroaryl, aralkyl, carboxyl, CN, $-SO_2$-alkyl, $-CF_3$, and $-OCF_3$), halo (e.g., chloro, bromo, iodo and fluoro), cyano, hydroxy, optionally substituted cyclic imido, amino, imido, amido, $-CF_3$, $C_1$-$C_{25}$ alkoxy (optionally substituted with halo, alkyl, alkoxy, aryl, carboxyl, CN, OH, $-SO_2$-alkyl, $-CF_3$, and $-OCF_3$), aryloxy, acyloxy, sulfhydryl (mercapto), halo($C_1$-$C_6$)alkyl, $C_1$-$C_6$ alkylthio, arylthio, mono- and di-($C_1$-$C_6$)alkyl amino, quaternary ammonium salts, amino($C_1$-$C_6$)alkoxy, hydroxy($C_1$-$C_6$)alkylamino, amino($C_1$-$C_6$)alkylthio, cyanoamino, nitro, carbamoyl, keto (oxy), carbonyl, carboxy, acyl, glycolyl, glycyl, hydrazino, guanyl, sulfamyl, sulfonyl, sulfinyl, thiocarbonyl, thiocarboxy, sulfonamide, ester, C-amide, N-amide, N-carbamate, O-carbamate, urea and combinations thereof. Wherever a substituent is described as "optionally substituted" that substituent can be substituted with the above substituents.

In some embodiments, the first organic photostable chromophore is a dye represented by the following general formula (I):

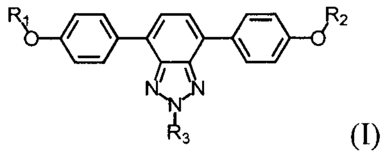

(I)

wherein $R_1$, $R_2$, and $R_3$ comprise and alkyl, a substituted alkyl, or an aryl. In some embodiments, $R_1$, $R_2$, and $R_3$ are $C_{1-10}$ alkyl, $C_{1-25}$ substituted alkyl, or $C_{1-25}$ aryl. Example compounds of general formula (I) include the following:

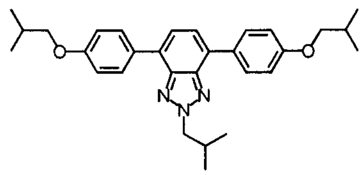
,
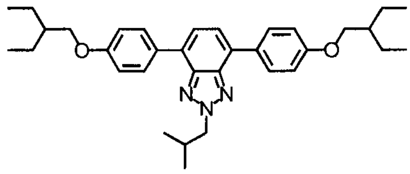
,
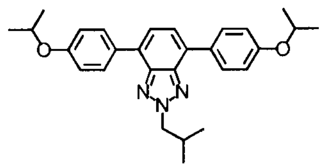
,

and

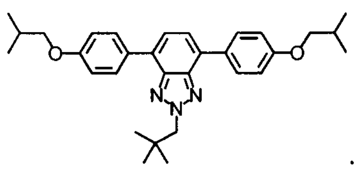
.

In some embodiments, the first organic photostable chromophore is represented by formula (II-a) or (II-b):

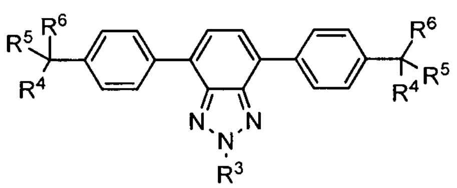
(II-a),
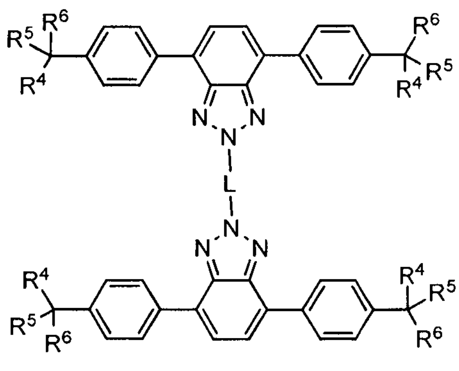
(II-b);

wherein $R^3$ is selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, optionally substituted carbonyl, optionally substituted ether, optionally substituted ketone, optionally substituted sulfone, and optionally substituted sulfonamide; or $R^3$ is an optionally substituted polycyclic ring system, wherein each ring is independently cycloalkyl, aryl, heterocycloalkyl, or heteroaryl; $R^4$, $R^5$, and $R^6$ are independently selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted heteroarylalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, and optionally substituted carbonyl, optionally substituted ether, optionally substituted ketone, optionally substituted sulfone, and optionally substituted sulfonamide; or $R^4$ and $R^5$, $R^4$ and $R^6$, $R^5$ and $R^6$, or $R^4$ and $R^5$ and $R^6$, together form an optionally substituted ring or an optionally substituted polycyclic ring system, wherein each ring is independently cycloalkyl, aryl, heterocyclalkyl, or heteroaryl; and L is selected from the group consisting of optionally substituted alkyl, optionally substituted heteroalkyl, optionally substituted alkylene, and optionally substituted heteroalkylene, optionally substituted alkynylene, optionally substituted arylene, optionally substituted heteroarylene.

In some embodiments, $R^3$ in formula II-a and formula II-b is selected from the group consisting of $C_{1-25}$ alkyl, $C_{1-25}$ heteroalkyl, $C_{2-25}$ alkenyl, $C_{3-25}$ cycloalkyl, polycycloalkyl, heterocycloalkyl, arylalkyl; and $R^3$ may be optionally substituted with one or more of any of the following substituents: $C_{1-25}$ alkyl, $C_{1-25}$ heteroalkyl, $C_{2-25}$ alkenyl, $C_{3-25}$ cycloalkyl, polycycloalkyl, heterocycloalkyl, aryl, heteroaryl, OH, $C_mH_{2m+1}O$ ether, $C_mH_{2m+1}CO$ ketone, $C_mH_{2m+1}CO_2$ carboxylic ester, $C_mH_{2m+1}OCO$ carboxylic ester, ArO aryloxy, ArCO aryl ketone, $ArCO_2$ ester of aryl-carboxylic acid, ArOCO carboxylic ester of phenol, $(C_mH_{2m+1})(C_pH_{2p+1})N$ amine, c-$(CH_2)_sN$ amine, $(C_mH_{2m+1})(C_pH_{2p+1})NCO$ amide, c-$(CH_2)_sNCO$ amide, $C_mH_{2m+1}CON(C_pH_{2p+1})$ amide, CN, $C_mH_{2m+1}SO_2$ sulfone, (CmH2m+i)(CpH2p+i)NS02 sulfonamide, $C_mH_{2m+1}SO_2N(C_pH_{2p+1})$ sulfonamide, or c-$(CH_2)_sNSO_2$ sulfonamide, wherein m is an integer in the range of 1 to 20, p is an integer in the range of 1 to 20, s is an integer in the range of 2 to 6, and Ar is any aromatic or heteroaromatic ring. $R^4$, $R^5$, and $R^6$ in formula II-a and formula II-b are independently selected from the group consisting of $C_{1-25}$ alkyl, $C_{1-25}$ heteroalkyl, $C_{2-25}$ alkenyl, $C_{3-25}$ cycloalkyl, polycycloalkyl, heterocycloalkyl, aryl, heteroaryl, arylalkyl, heteroarylalkyl, $CO_2C_mH_{2m+1}$ carboxylic ester, $(C_mH_{2m+1})(C_pH_{2p+1})NCO$ amide, c-$(CH_2)_sNCO$ amide, $COC_mH_{2m+1}$ ketone, COAr, $SO_2C_mH_{2m+1}$ sulfone, $SO_2Ar$ sulfone, $(C_mH_{2m+1})(C_pH_{2p+1})SO_2$ sulfonamide, c-$(CH_2)_sSO_2$ sulfonamide; and $R^4$, $R^5$, and $R^6$ are independently optionally substituted with one or more of any of the following substituents: $C_{1-25}$ alkyl, $C_{1-25}$ heteroalkyl, $C_{2-25}$ alkenyl, $C_{3-25}$ cycloalkyl, polycycloalkyl, heterocycloalkyl, aryl, heteroaryl, OH, $C_mH_{2m+1}O$ ether, $C_mH_{2m+1}CO$ ketone, $C_mH_{2m+1}CO_2$ carboxylic ester, $C_mH_{2m+1}OCO$ carboxylic ester, ArO aryloxy, ArCO aryl ketone, $ArCO_2$ ester of aryl carboxylic acid, ArOCO carboxylic ester of phenol, $(C_mH_{2m+1})(C_pH_{2p+1})N$ amine, c-$(CH_2)_sN$ amine, $(C_mH_{2m1})(C_pH_{2p+1})NCO$ amide, c-$(CH_2)_sNCO$ amide, $C_mH_{2m+1}CON(C_pH_{2p+1})$ amide, $C_mH_{2m+1}SO_2$ sulfone, $(C_mH_{2m+1})(C_pH_{2p+1})NSO_2$ sulfonamide, $C_mH_{2m+1}SO_2N(C_pH_{2p+1})$ sulfonamide, or c-$(CH_2)_sNSO_2$ sulfonamide, wherein m is an integer in the range of 1 to 20, p is an integer in the range of 1 to 20, s is an integer in the range of 2 to 6, and Ar is any aromatic or heteroaromatic ring. L in formula II-b is selected from the group consisting of $C_{1-25}$ alkyl, $C_{1-25}$ heteroalkyl, $C_{2-25}$ alkenyl; and L may be optionally substituted with one or more of any of the following substituents: $C_{1-25}$ alkyl, $C_{1-25}$ heteroalkyl, $C_{2-25}$ alkenyl, $C_{3-25}$ cycloalkyl, polycycloalkyl, heterocycloalkyl, aryl, heteroaryl, OH, $C_mH_{2m+1}O$ ether, $C_mH_{2m+1}CO$ ketone, $C_mH_{2m+1}CO_2$ carboxylic ester, $C_mH_{2m+1}OCO$ carboxylic ester, ArO aryloxy, ArCO aryl ketone, $ArCO_2$ ester of aryl-carboxylic acid, ArOCO carboxylic ester of phenol, $(C_mH_{2m+1})(C_pH_{2p+1})N$ amine, c-$(CH_2)_sN$ amine, $(C_mH_{2m+1})(C_pH_{2p+1})NCO$ amide, c-$(CH_2)_sNCO$ amide, $C_mH_{2m+1}CON(C_pH_{2p+1})$ amide, CN, $C_mH_{2m+1}SO_2$ sulfone, $(C_mH_{2m+1})(C_pH_{2p+1})NSO_2$ sulfonamide, $C_mH_{2m+1}SO_2N(C_pH_{2p+1})$ sulfonamide, or c-$(CH_2)_sNSO_2$ sulfonamide, wherein m is an integer in the range of 1 to 20, p is an integer in the range of 1 to 20, s is an integer in the range of 2 to 6, and Ar is any aromatic or heteroaromatic ring.

In some embodiments, $R^3$ in formula II-a and formula II-b is selected from the group consisting of $C_{1-25}$ alkyl, $C_{1-25}$ heteroalkyl, $C_{2-25}$ alkenyl, $C_{3-25}$ cycloalkyl, $C_{5-25}$ polycycloalkyl, $C_{1-25}$ heterocycloalkyl, $C_{1-25}$ arylalkyl; $R^4$, $R^5$, and $R^6$ are independently optionally substituted with one or more of any of the following substituents: $C_{1-25}$ alkyl, $C_{1-25}$ heteroalkyl, $C_{2-25}$ alkenyl, $C_{3-25}$ cycloalkyl, $C_{1-25}$ aryl, and $C_{1-25}$ heteroaryl.

In some embodiments, the first organic photostable chromophore or the second organic photostable chromophore is selected from the group consisting of:

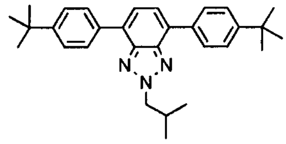,
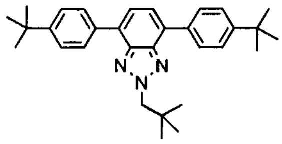,

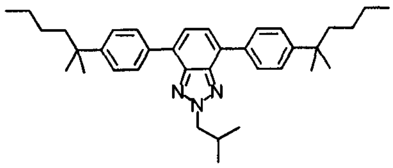,
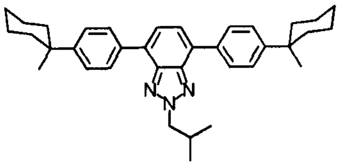,
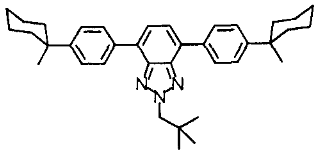,

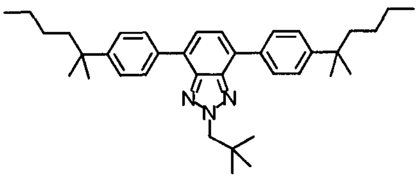,
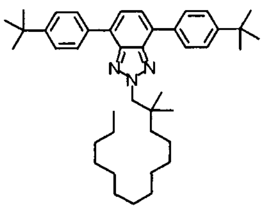,
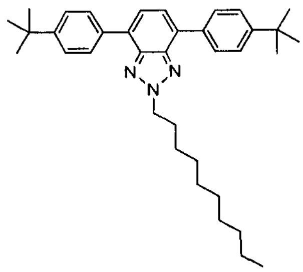,

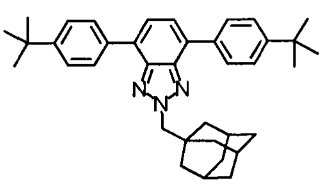,
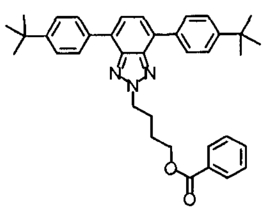,
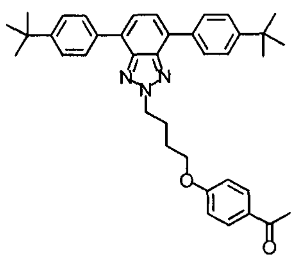,

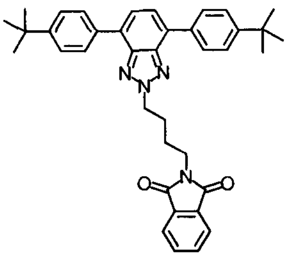,
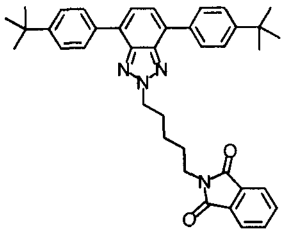,
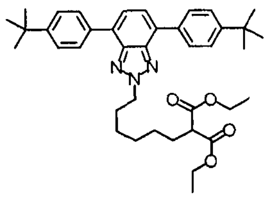,
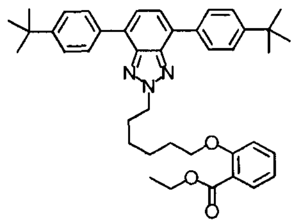,

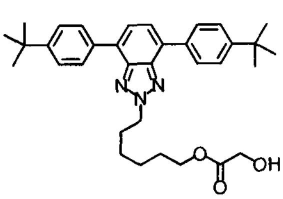,
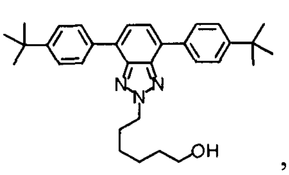,
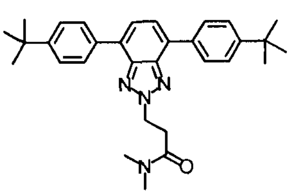,
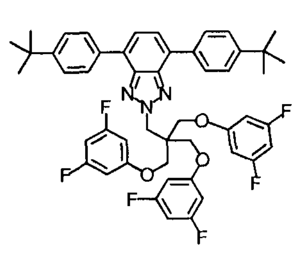,

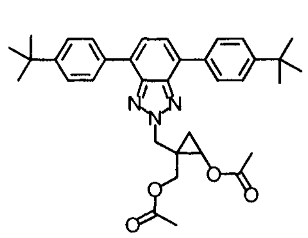
,
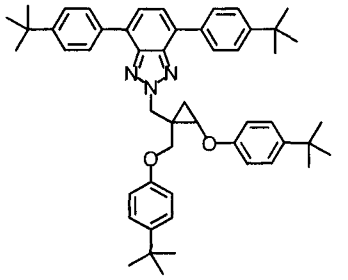
,
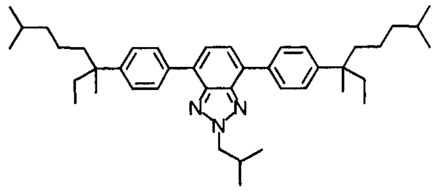
,
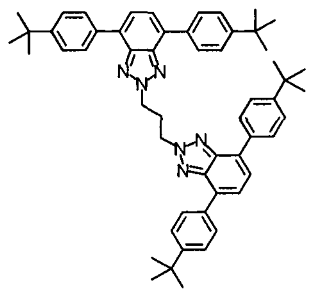
, or
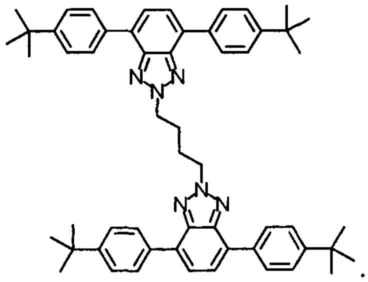
.

Formulae III-a and III-b

In some embodiments, the second organic photostable chromophore is represented by formula (III-a) or (III-b):

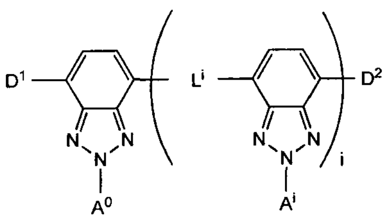
(III-a),
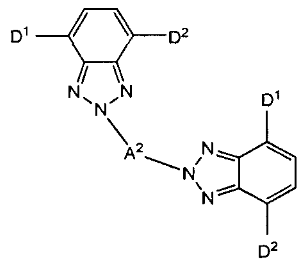
(III-b);

wherein $D^1$ and $D^2$ are electron donating groups, L' is an electron donor linker, and $A^0$ and $A^i$ are electron acceptor groups. In some embodiments, where more than one electron donor group is present, the other electron donor groups may be occupied by another electron donor, a hydrogen atom, or another neutral substituent. In some embodiments, at least one of the $D^1$, $D^2$, and L' is a group which increases the electron density of the 2*H*-benzo[*d*][1,2,3]triazole system to which it is attached.

In formulae III-a and III-b, i is an integer in the range of 0 to 100. In some embodiments, i is an integer in the range of 0 to 50, 0 to 30, 0 to 10, 0 to 5, or 0 to 3. In some embodiments, i is 0, 1, 2, 3, 4, 5, 6, 7, 8, 9, or 10.

In formulae III-a and III-b, $A^0$ and $A^i$ are each independently selected from the group consisting of optionally substituted alkyl, optionally substituted alkenyl, optionally substituted heteroalkyl, optionally substituted aryl, optionally substituted heteroaryl, optionally substituted amino, optionally substituted amido, optionally substituted cyclic amido, optionally substituted cyclic imido, optionally substituted alkoxy, and optionally substituted carboxy, and optionally substituted carbonyl.

In some embodiments, $A^0$ and $A^i$ are each independently selected from the group consisting of optionally substituted heteroaryl, optionally substituted aryl, optionally substituted cyclic imido, optionally substituted $C_{1-8}$ alkyl, and optionally substituted $C_{1-8}$ alkenyl; wherein the substituent for optionally substituted heteroaryl is selected from the group consisting of alkyl, aryl and halogen; the substitutent for optionally substituted aryl is - $NR^7$-C(=O)$R^8$ or optionally substituted cyclic imido, wherein wherein $R^7$ is selected from the group consisting of H, alkyl, alkenyl, aryl, heteroaryl, aralkyl, alkaryl; and $R^8$ is selected from the group consisting of optionally substituted alkylene, optionally substituted alkenylene, optionally substituted arylene, optionally substituted heteroarylene, ketone, and ester; or $R^7$ and $R^8$ may be connected together to form a ring.

In some embodiments, $A^0$ and $A^i$ are each independently phenyl substituted with a moiety selected from the group consisting of -$NR^7$-C(=O)$R^8$ and optionally substituted cyclic imido, wherein $R^7$ and $R^8$ are as described above.

In some embodiments, $A^0$ and $A^i$ are each optionally substituted heteroaryl or optionally substituted cyclic imido; wherein the substituent for optionally substituted heteroaryl and optionally substituted cyclic imido is selected from the group consisting of alkyl, aryl and halogen. In some embodiments, at least one of the $A^0$ and $A^i$ is selected from the group consisting of: optionally substituted pyridinyl, optionally substituted pyridazinyl, optionally substituted pyrimidinyl, optionally substituted pyrazinyl, optionally substituted triazinyl, optionally substituted quinolinyl, optionally substituted isoquinolinyl, optionally substituted quinazolinyl, optionally substituted phthalazinyl, optionally substituted quinoxalinyl, optionally substituted naphthyridinyl, and optionally substituted purinyl.

In other embodiments, $A^0$ and $A^i$ are each optionally substituted alkyl. In other embodiments, $A^0$ and $A^i$ are each optionally substituted alkenyl. In some embodiments, at least one of the $A^0$ and $A^i$ is selected from the group consisting of:

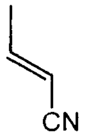, 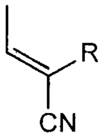, 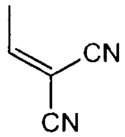, 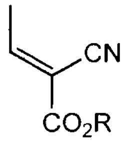, 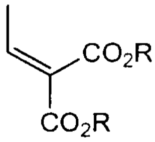, 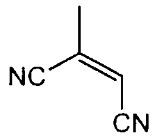, and 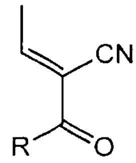 ;

wherein R is optionally substituted alkyl.

In formula III-a and III-b, $A^2$ is selected from the group consisting of optionally substituted alkylene, optionally substituted alkenylene, optionally substituted arylene, optionally substituted heteroarylene, ketone, ester, and

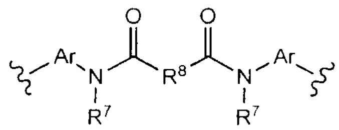 ;

wherein Ar is optionally substituted aryl or optionally substituted heteroaryl. $R^7$ is selected from the group consisting of H, alkyl, alkenyl, aryl, heteroaryl, aralkyl, alkaryl; and $R^8$ is selected from the group consisting of optionally substituted alkylene, optionally substituted alkenylene, optionally substituted arylene, optionally substituted heteroarylene, ketone, and ester; or $R^7$ and $R^8$ may be connected together to form a ring.

In some embodiments, $A^2$ is selected from the group consisting of optionally substituted arylene, optionally substituted heteroarylene, and

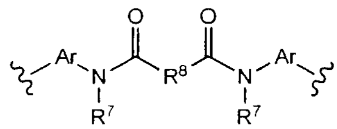 ,

wherein Ar, $R^7$ and $R^8$ are as described above.

In formulae III-a and III-b, $D^1$ and $D^2$ are each independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, provided that $D^1$ and $D^2$ are not both hydrogen.

In some embodiments, $D^1$ and $D^2$ are each independently selected from the group consisting of hydrogen, optionally substituted aryl, optionally substituted heteroaryl, and amino, provided that $D^1$ and $D^2$ are not both hydrogen. In some embodiments, $D^1$ and $D^2$ are each independently selected from the group consisting of hydrogen, optionally substituted aryl, optionally substituted heteroaryl, and diphenylamino, provided that $D^1$ and $D^2$ are not both hydrogen.

In some embodiments, $D^1$ and $D^2$ are each independently optionally substituted aryl. In some embodiments, $D^1$ and $D^2$ are each independently phenyl optionally substituted by alkoxy or amino. In other embodiments, $D^1$ and $D^2$ are each independently selected from hydrogen, optionally substituted benzofuranyl, optionally substituted thiophenyl, optionally substituted furanyl, dihydrothienodioxinyl, optionally substituted benzothiophenyl, and optionally substituted dibenzothiophenyl, provided that $D^1$ and $D^2$ are not both hydrogen.

In some embodiments, the substituent for optionally substituted aryl and soptionally substituted heteroaryl may be selected from the group consisting of alkoxy, aryloxy, aryl, heteroaryl, and amino.

In formulae III-a and III-B, L' is independently selected from the group consisting of optionally substituted

alkylene, optionally substituted alkenylene, optionally substituted alkynylene, optionally substituted arylene, optionally substituted heteroarylene. In some embodiments, L' is selected from the group consisting of optionally substituted heteroarylene and optionally substituted arylene.

In some embodiments, at least one of the L' is selected from the group consisting of: 1,2-ethylene, acetylene, 1,4-phenylene, 1,1'-biphenyl-4,4'-diyl, naphthalene-2,6-diyl, naphthalene-1,4-diyl, 9*H*-fluorene-2,7-diyl, perylene-3,9-diyl, perylene-3,10-diyl, or pyrene-1,6-diyl, 1*H*-pyrrole-2,5-diyl, furan-2,5-diyl, thiophen-2,5-diyl, thieno[3,2-*b*]thiophene-2,5-diyl, benzo[*c*]thiophene-1,3-diyl, dibenzo[*b,d*]thiophene-2,8-diyl, 9*H*-carbozole-3,6-diyl, 9*H*-carbozole-2,7-diyl, dibenzo[*b,d*]furan-2,8-diyl, 10*H*-phenothiazine-3,7-diyl, and 10*H*-phenothiazine-2,8-diyl; wherein each moiety is optionally substituted.

Formulae IV-a and IV-b

In some embodiments, the second organic photostable chromophore is represented by formula (IV-a) or (IV-b):

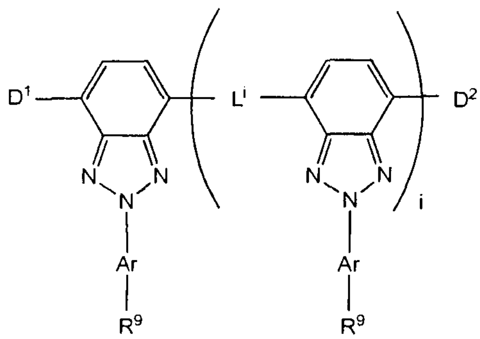
(IV-a),

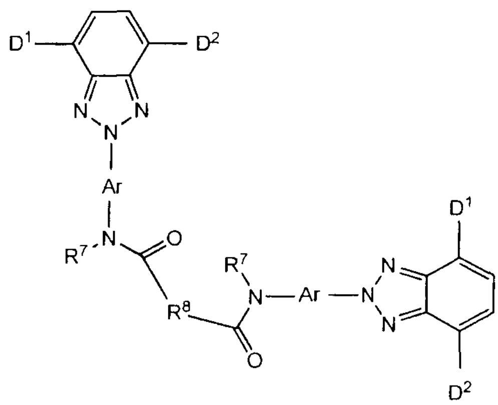
(IV-b);

wherein i is an integer in the range of 0 to 100. In some embodiments, i is an integer in the range of 0 to 50, 0 to 30, 0 to 10, 0 to 5, or 0 to 3. In some embodiments, i is 0, 1, 2, 3, 4, 5, 6, 7, 8, 9, or 10.

In formulae IV-a and IV-b, Ar is optionally substituted aryl or optionally substituted heteroaryl. In some embodiments, aryl substituted with an amido or a cyclic imido group at the N-2 position of the 2*H*-benzo[*d*][1,2,3]triazole ring system provides unexpected and improved benefits.

In formulae IV-a and IV-b, $R^9$ is

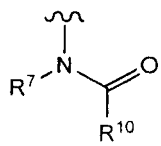

or optionally substituted cyclic imido; $R^7$ is each indepedently selected from the group consisting of H, alkyl, alkenyl, aryl, heteroaryl, aralkyl, alkaryl; $R^{10}$ is each independently selected from the group consisting of optionally substituted alkyl, optionally substituted alkenyl, optionally substituted aryl, optionally substituted heteroaryl; or $R^7$ and $R^{10}$ may be connected together to form a ring.

In some embodiments, $R^9$ is optionally substituted cyclic imido selected from the group consisting of:

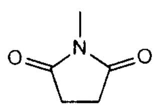 , 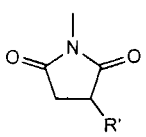 , 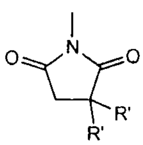 , 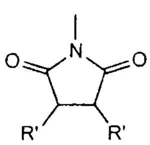 , 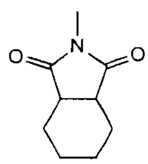 , 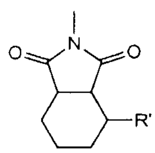 ,

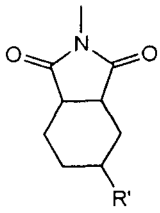, 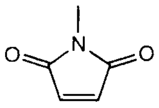, 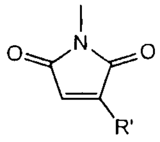, 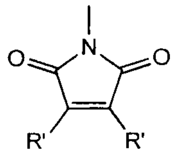, 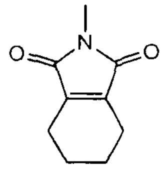, 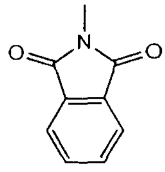,

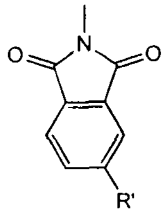, 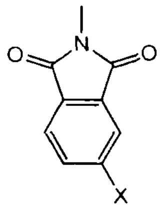, 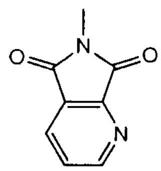, 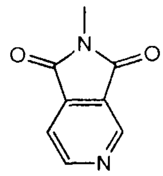, 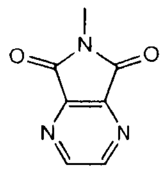, 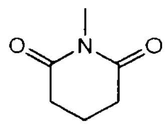,

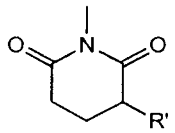, 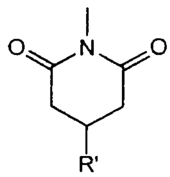, 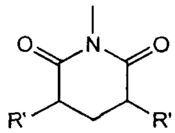, 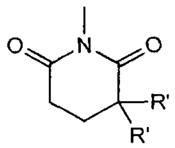, 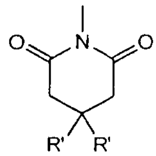, 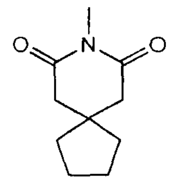,

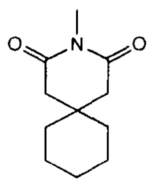, 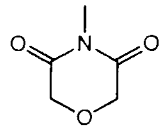, 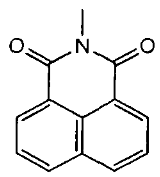, 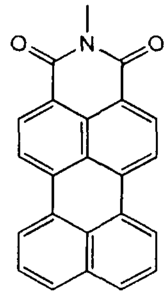, and 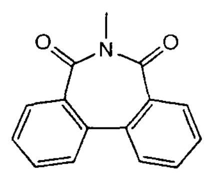;

and wherein R' is each optionally substituted alkyl or optionally substituted aryl; and X is optionally substituted heteroalkyl.

In formulae IV-a and IV-b, $R^8$ is selected from the group consisting of optionally substituted alkylene, optionally substituted alkenylene, optionally substituted arylene, optionally substituted heteroarylene.

In formulae IV-a and IV-b, $D^1$ and $D^2$ are each independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, provided that $D^1$ and $D^2$ are not both hydrogen.

In formulae IV-a and IV-b, $L^i$ is independently selected from the group consisting of optionally substituted alkylene, optionally substituted alkenylene, optionally substituted alkynylene, optionally substituted arylene, optionally substituted heteroarylene.

In some embodiments, at least one of the $L^i$ is selected from the group consisting of: 1,2-ethylene, acetylene, 1,4-phenylene, 1,1'-biphenyl-4,4'-diyl, naphthalene-2,6-diyl, naphthalene-1,4-diyl, *9H*-fluorene-2,7-diyl, perylene-3,9-diyl, perylene-3,10-diyl, or pyrene-1,6-diyl, 1*H*-pyrrole-2,5-diyl, furan-2,5-diyl, thiophen-2,5-diyl, thieno[3,2-*b*]thiophene-2,5-diyl, benzo[*c*]thiophene-1,3-diyl, dibenzo[*b,d*]thiophene-2,8-diyl, 9*H*-carbozole-3,6-diyl, 9*H*-carbozole-2,7-diyl, dibenzo[*b,d*]furan-2,8-diyl, 10*H*-phenothiazine-3,7-diyl, and 10*H*-phenothiazine-2,8-diyl; wherein each moiety is optionally substituted.

Formulae V-a and V-b

In some embodiments, the second organic photostable chromophore is represented by formula (V-a) or (V-b):

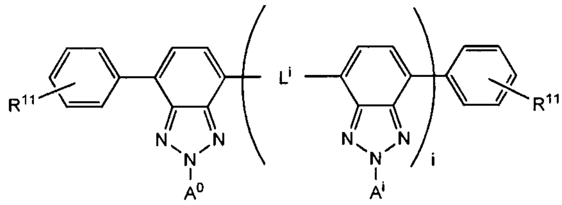

(V-a),

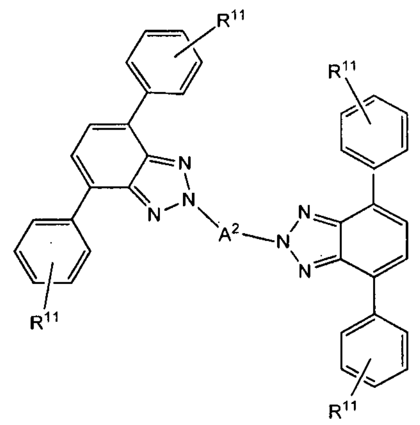

(V-b);

The placement of an alkyl group in formulae (V-a) and (V-b) at the N-2 position of the 2*H*-benzo[*d*][1,2,3]triazole ring system along with substituted phenyls at the C-4 and C-7 positions provides unexpected and improved benefits. In formula V-a and V-b, i is an integer in the range of 0 to 100. In some embodiments, i is an integer in the range of 0 to 50, 0 to 30, 0 to 10, 0 to 5, or 0 to 3. In some embodiments, i is 0, 1, 2, 3, 4, 5, 6, 7, 8, 9, or 10.

In formula V-a and V-b, $A^0$ and $A^i$ are each independently selected from the group consisting of optionally substituted alkyl, optionally substituted alkenyl, optionally substituted heteroalkyl, optionally substituted amido, optionally substituted alkoxy, optionally substituted cabonyl, and optionally substituted carboxy.

In some embodiments, $A^0$ and $A^i$ are each independently unsubstituted alkyl or alkyl substituted by a moiety selected from the group consisting of: -NRR", -OR, - COOR, -COR, -CONHR, -CONRR", halo and -CN; wherein R is $C_1$-$C_{20}$ alkyl, and R" is hydrogen or $C_1$-$C_{20}$ alkyl. In some embodiments, the optionally substituted alkyl may be optionally substituted $C_1$-$C_{40}$ alkyl. In some embodiments, $A^0$ and the $A^i$ are each independently $C_1$-$C_{40}$ alkyl or $C_1$-$C_{20}$ haloalkyl.

In some embodiments, $A^0$ and $A^i$ are each independently $C_1$-$C_{20}$ haloalkyl, $C_1$-$C_{40}$ arylalkyl, or $C_1$-$C_{20}$ alkenyl.

In formulae V-a and V-b, each $R^{11}$ is independently selected from the group consisting of optionally substituted alkoxy, optionally substituted aryloxy, optionally substituted acyloxy, and amino. In some embodiments, each $R^{11}$ is independently selected from the group consisting of optionally substituted $C_1$-$C_{20}$ alkoxy, optionally substituted $C_1$-$C_{20}$ aryloxy, optionally substituted $C_1$-$C_{20}$ acyloxy, and $C_1$-$C_{20}$ amino. In some embodiments, $R^{11}$ may attach to phenyl ring at ortho and/or para position. In some embodiments, $R^{11}$ may be alkoxy represented by the formula $OC_nH_{2n+1}$ where n = 1-40. In some embodiments, R" may be aryloxy represented by the following formulae: ArO or O-CR-OAr where R is alkyl, substituted alkyl, aryl, or heteroaryl, and Ar is any substituted or unsubstituted aryl, or substituted or unsubstituted heteroaryl. In some embodiments, $R^{11}$ may be acyloxy represented by the formula $OCOC_nH_{2n+1}$ where n = 1-40.

In formulae V-a and V-b, $A^2$ is selected from the group consisting of optionally substituted alkylene, optionally substituted alkenylene, optionally substituted arylene, optionally substituted heteroarylene, ketone, ester, and

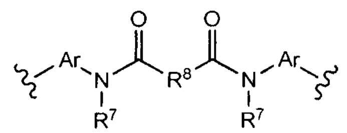

;

wherein Ar is optionally substituted aryl or optionally substituted heteroaryl, $R^7$ is selected from the group consisting of H, alkyl, alkenyl, aryl, heteroaryl, aralkyl, and alkaryl; and $R^8$ is selected from the group consisting of optionally substituted alkylene, optionally substituted alkenylene, optionally substituted arylene, optionally substituted heteroarylene, ketone, and ester; or $R^7$ and $R^8$ may be connected together to form a ring. In some embodiments, $R^7$ is selected from the group consisting of H, $C_1$-$C_{20}$ alkyl, $C_1$-$C_{20}$ alkenyl, $C_{1-}C_{20}$ aryl, $C_1$-$C_{20}$ heteroaryl, $C_1$-$C_{20}$ aralkyl, and $C_1$-$C_{20}$ alkaryl; and $R^8$ is selected from the group consisting of optionally substituted $C_1$-$C_{20}$ alkylene, optionally substituted $C_1$-$C_{20}$ alkenylene, optionally substituted $C_1$-$C_{20}$ arylene, optionally substituted $C_1$-$C_{20}$ heteroarylene, ketone, and ester

In formulae V-a and V-b, $L^i$ is independently selected from the group consisting of optionally substituted alkylene, optionally substituted alkenylene, optionally substituted alkynylene, optionally substituted arylene, optionally substituted heteroarylene.

In some embodiments, at least one of the $L^i$ is selected from the group consisting of: 1,2-ethylene, acetylene, 1,4-phenylene, 1,1'-biphenyl-4,4'-diyl, naphthalene-2,6-diyl, naphthalene-1,4-diyl, 9*H*-fluorene-2,7-diyl, perylene-3,9-diyl, perylene-3,10-diyl, or pyrene-1,6-diyl, 1*H*-pyrrole-2,5-diyl, furan-2,5-diyl, thiophen-2,5-diyl, thieno[3,2-*b*]thiophene-2,5-diyl, benzo[*c*]thiophene-1,3-diyl, dibenzo[*b,d*]thiophene-2,8-diyl, 9*H*-carbozole-3,6-diyl, 9*H*-carbozole-2,7-diyl,

dibenzo[*b,d*]furan-2,8-diyl, 10*H*-phenothiazine-3,7-diyl, and 10*H*-phenothiazine-2,8-diyl; wherein each moiety is optionally substituted.

Formula VI

In some embodiments, the second organic photostable chromophore is represented by formulae (VI):

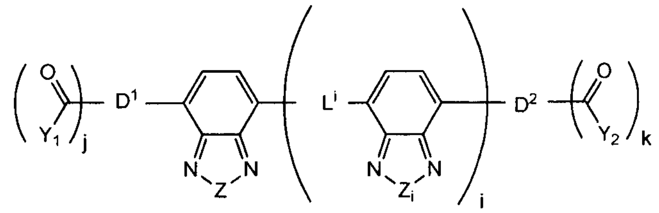

(VI);

wherein i is an integer in the range of 0 to 100. In some embodiments, i is an integer in the range of 0 to 50, 0 to 30, 0 to 10, 0 to 5, or 0 to 3. In some embodiments, i is 0, 1, 2, 3, 4, 5, 6, 7, 8, 9, or 10.

In formula VI, Z and $Z_i$ are each independently selected from the group consisting of -O-, -S-, -Se-, -Te-, $-NR^6-$, $-CR^6=CR^6-$, and $-CR^6=N-$, wherein $R^6$ is hydrogen, optionally substitute $C_1$-$C_6$ alkyl, or optionally substituted $C_1$-$C_{10}$ aryl; and

In formula VI, $D^1$ and $D^2$ are independently selected from the group consisting of optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido; j is 0, 1 or 2, and k is 0, 1, or 2. In some embodiments, the $-C(=O)Y_1$ and $-C(=O)Y_2$ groups may attach to the substituent(s) of the optionally substituted moiety for $D^1$ and $D^2$.

In formula VI, $Y_1$ and $Y_2$ are independently selected from the group consisting of optionally substituted aryl, optionally substituted alkyl, optionally substituted cycloalkyl, optionally substituted alkoxy, and optionally substituted amino; and

In formula VI, $L^i$ is independently selected from the group consisting of optionally substituted alkylene, optionally substituted alkenylene, optionally substituted alkynylene, optionally substituted arylene, optionally substituted heteroarylene.

In some embodiments, at least one of the $L^i$ is selected from the group consisting of: 1,2-ethylene, acetylene, 1,4-phenylene, 1,1'-biphenyl-4,4'-diyl, naphthalene-2,6-diyl, naphthalene-1,4-diyl, *9H*-fluorene-2,7-diyl, perylene-3,9-diyl, perylene-3,10-diyl, or pyrene-1,6-diyl, 1*H*-pyrrole-2,5-diyl, furan-2,5-diyl, thiophen-2,5-diyl, thieno[3,2-*b*]thiophene-2,5-diyl, benzo[*c*]thiophene-1,3-diyl, dibenzo[*b,d*]thiophene-2,8-diyl, 9*H*-carbozole-3,6-diyl, 9*H*-carbozole-2,7-diyl, dibenzo[*b,d*]furan-2,8-diyl, 10*H*-phenothiazine-3,7-diyl, and 10*H*-phenothiazine-2,8-diyl; wherein each moiety is optionally substituted.

With regard to $L^i$ in any of the formulae above, the electron linker represents a conjugated electron system, which may be neutral or serve as an electron donor itself. In some embodiments, some examples are provided below, which may or may not contain additional attached substituents.

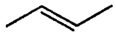 or 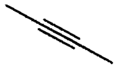 or 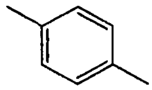 or 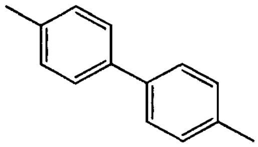

1,2-ethylene acetylene 1,4-phenylene 1,1'-biphenyl-4,4'-diyl

or 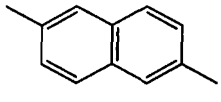 or 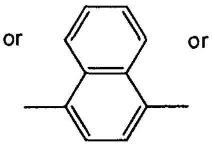 or 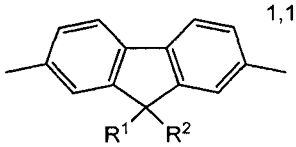

naphthalene-2,6-diyl naphthalene-1,4-diyl 9*H*-fluorene-2,7-diyl

or 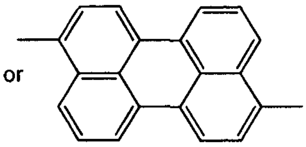 or 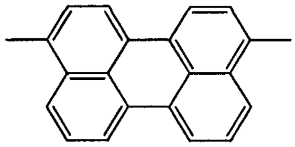 or 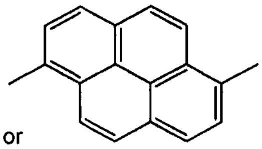

pyrene-1,6-diyl

perylene-3,9-diyl perylene-3,10-diyl etc.

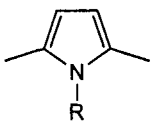 or 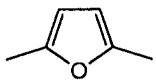 or 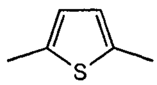 or

1*H*-pyrrole-2,5-diyl furan-2,5-diyl thiophen-2,5-diyl

or 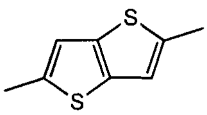 or 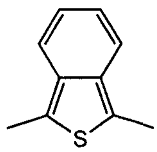 or 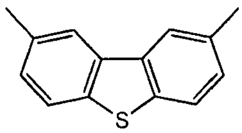

thieno[3,2-*b*]thiophene-2,5-diyl benzo[*c*]thiophene-1,3-diyl dibenzo[*b*,*d*]thiophene-2,8-diyl

or 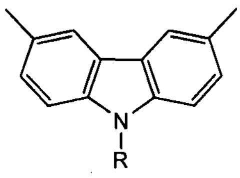 or 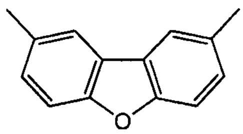 or 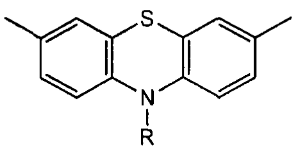

9*H*-carbazole-3,6-diyl dibenzo[*b*,*d*]furan-2,8-diyl 10*H*-phenothiazine-3,7-diyl

etc.

Formulae VII-a and VII-B

In some embodiments, the second organic photostable chromophore is represented by formula (VII-a) or (VII-b):

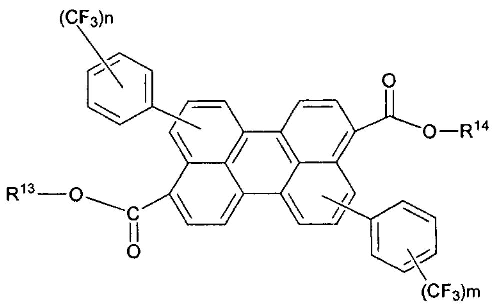 (VII-a) 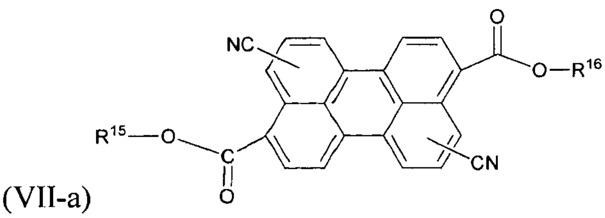 (VII-b);

wherein $R^{13}$ and $R^{14}$ in formula (VII-a) are each independently selected from the group consisting of hydrogen, $C_1$-$C_{10}$ alkyl, $C_3$-$C_{10}$ cycloalkyl, $C_1$-$C_{10}$ alkoxy, $C_6$-$C_{18}$ aryl, and $C_6$-$C_{20}$ aralkyl; m and n in formula (VII-a) are each independently in the range of from 1 to 5; and $R^{15}$ and $R^{16}$ in formula (VII-b) are each independently selected from the group consisting of a $C_6$-$C_{18}$ aryl and $C_6$-$C_{20}$ aralkyl. In some embodiments, if one of the cyano groups on formula (VII-b) is present on the 4-position of the perylene ring, then the other cyano group is not present on the 10-position of the perylene ring. In some embodiments, if one of the cyano groups on formula (VII-b) is present on the 10-position of the perylene ring, then the other cyano group is not present on the 4-position of the perylene ring.

In some embodiments, $R^{13}$ and $R^{14}$ are independently selected from the group consisting of hydrogen, $C_1$-$C_6$ alkyl, $C_2$-$C_6$ alkoxyalkyl, and $C_6$-$C_{18}$ aryl. In some embodiments, $R^{13}$ and $R^{14}$ are each independently selected from the group consisting of isopropyl, isobutyl, isohexyl, isooctyl, 2-ethyl-hexyl, diphenylmethyl, trityl, and diphenyl. In some embodiments, $R^{15}$ and $R^{16}$ are independently selected from the group consisting of diphenylmethyl, trityl, and diphenyl. In some embodiments, each m and n in formula (VII-a) is independently in the range of from 1 to 4.

The perylene diester derivative represented by the general formula (VII-a) or general formula (VII-b) can be made by known methods, such as those described in International Publication No. WO 2012/094409.

Formulae VIII

In some embodiments, the second organic photostable chromophore is represented by formula (VIII):

$$D_1-\mathrm{Het}-(L-\mathrm{Het})_i-D_2 \quad \text{(VIII)}$$

wherein Het is selected from the group consisting of:

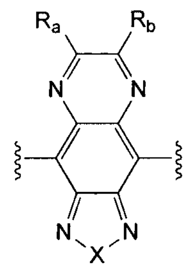 , 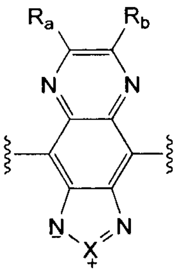 , 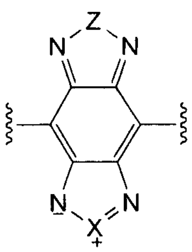 , 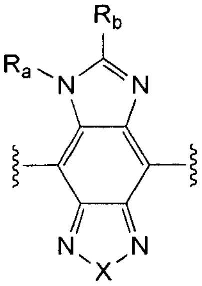 , 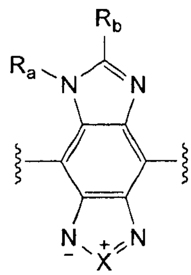 , 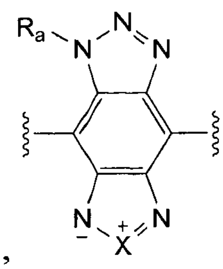 ,

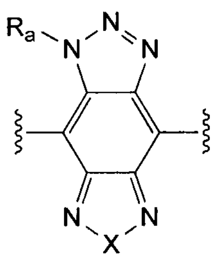 , 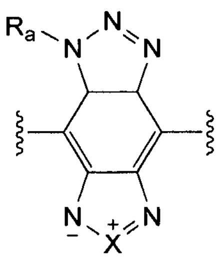 , 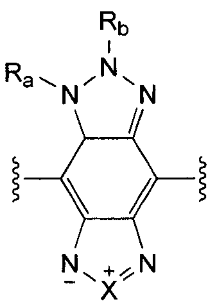 , 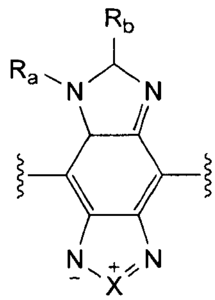 , and 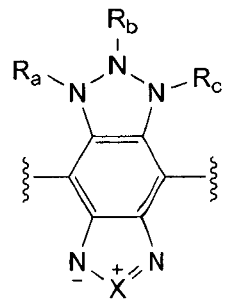 ,

and wherein i is 0 or an integer in the range of 1 to 100, X is selected from the group consisting of -N($A_0$)-, -O-, -S-, -Se-, and -Te-, and Z is selected from the group consisting of -N($R_a$)-, -O-, -S-, -Se-, and -Te-.

Each $A^0$ in formula VIII is selected from the group consisting of hydrogen, optionally substituted alkyl, optionally substituted alkenyl, optionally substituted heteroalkyl, optionally substituted aryl, optionally substituted heteroaryl, optionally substituted amino, optionally substituted amido, optionally substituted cyclic amido, optionally substituted cyclic imido, optionally substituted alkoxy, optionally substituted acyl, optionally substituted carboxy, and optionally substituted carbonyl.

Each $R_a$, $R_b$, and $R_c$, of formula VIII are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl,

optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl.

In some embodiments, each $R_a$, $R_b$, and $R_c$, of formula VIII are independently selected from the group consisting of hydrogen, optionally substituted $C_{1-8}$ alkyl, optionally substituted $C_{6-10}$ aryl, and optionally substituted $C_{6-10}$ heteroaryl. In some embodiments, each $R_a$, $R_b$, and $R_c$, of formula VIII are independently selected from the group consisting of hydrogen, $C_{1-8}$ alkyl, $C_{6-10}$ aryl, and $C_{6-10}$ heteroaryl, wherein $C_{1-8}$ alkyl, $C_{6-10}$ aryl, and $C_{6-10}$ heteroaryl may each be optionally substituted by optionally substituted $C_{3-10}$ cycloalkyl, optionally substituted $C_{1-8}$ alkoxy, halo, cyano, carboxyl, optionally substituted $C_{6-10}$ aryl, optionally substituted $C_{6-10}$ aryloxy,

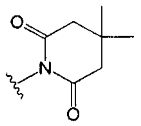 , or 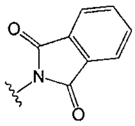 .

In some embodiments, $R_a$ and $R_b$, or $R_b$ and $R_c$, or $R_a$ and $R_c$, together form an optionally substituted ring system selected from the group consisting of:

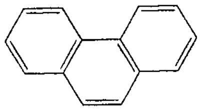 , 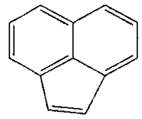 , 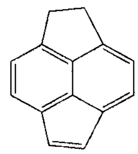 ,

and

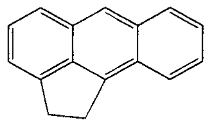 .

$D_1$ and $D_2$ are independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, -aryl-NR'R", -aryl-aryl-NR'R", and -heteroaryl-heteroaryl-R'; wherein R' and R" are independently selected from the group consisting of optionally substituted alkyl, optionally substituted alkenyl, optionally substituted aryl; provided that $D_1$ and $D_2$ are not both hydrogen, and $D_1$ and $D_2$ are not optionally substituted thiophene or optionally substituted furan.

In some embodiments, the chromophore is represented by formula VIII, wherein $D_1$ and $D_2$ are each independently selected from the group consisting of alkoxyaryl, - aryl-NR'R", and -aryl-aryl-NR'R"; wherein R' and R" are independently selected from the group consisting of alkyl and aryl optionally substituted by alkyl, alkoxy, or -C(=O)R; wherein R is optionally substituted aryl or optionally substituted alkyl; or one or both of R' and R" forms a fused heterocyclic ring with aryl to which the N is attached to.

In some embodiments, each $D_1$ and $D_2$ of formula VIII are independently $C_{6-10}$ aryl or optionally substituted $C_{6-10}$ aryl. The substituent(s) on the $C_{6-10}$ aryl may be selected from the group consisting of NR'R", -$C_{6-10}$ aryl-NR'R", $C_{1-8}$ alkyl and $C_{1-8}$ alkoxy; wherein R' and R" are independently selected from the group consisting of $C_{1-8}$ alkyl, $C_{1-8}$ alkoxy, $C_{6-10}$ aryl, $C_{6-10}$ aryl-$C_{1-8}$ alkyl, $C_{6-10}$ aryl-$C_{1-8}$ alkoxy, and $C_{6-10}$ aryl-C(=O)R, wherein R is optionally substituted $C_{1-8}$ alkyl, optionally substituted $C_{1-8}$ alkoxy or optionally substituted $C_{6-10}$ aryl; or one or both of R' and R" forms a fused heterocyclic ring with aryl to which the N is attached to.

L of formula VIII is independently selected from the group consisting of optionally substituted alkyl, optionally substituted aryl, optionally substituted heteroaryl, amino, amido, imido, optionally substituted alkoxy, acyl, carboxy, provided that L is not optionally substituted thiophene or optionally substituted furan.

In some embodiments, the chromophore is represented by formula VIII, wherein L is independently selected from the group consisting of haloalkyl, alkylaryl, alkyl substituted heteroaryl, arylalkyl, heteroamino, heterocyclic amino,

cycloamido, cycloimido, aryloxy, acyloxy, alkylacyl, arylacyl, alkylcarboxy, arylcarboxy, optionally substituted phenyl, and optionally substituted naphthyl.

In some embodiments, the chromophore is represented by formula VIII, provided that when Het is:

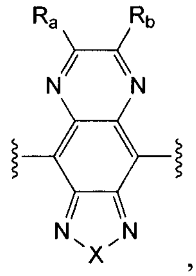

,

$R_a$ and $R_b$ are not both hydrogen, and $D_1$ and $D_2$ are independently selected from the group consisting of:

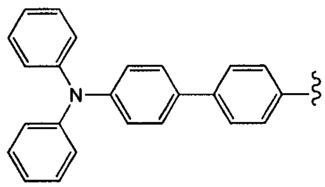

,

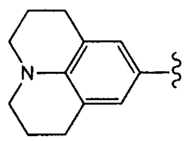

,

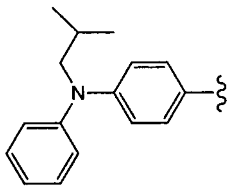

,

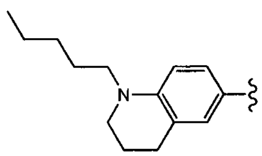

,

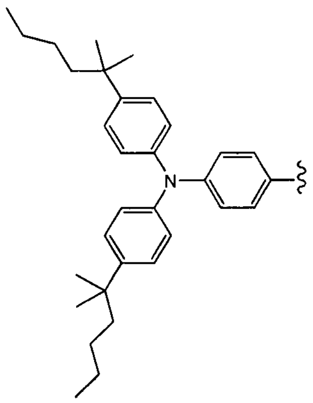

,

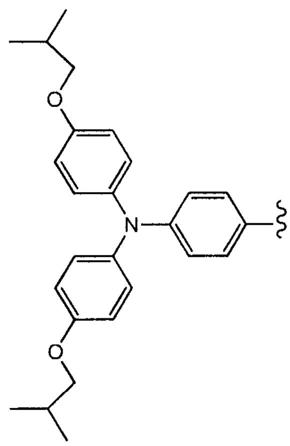

,

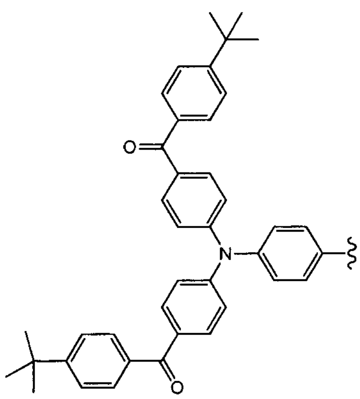

,

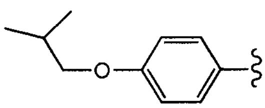

,

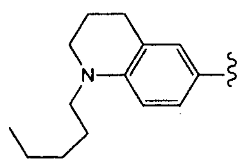

,

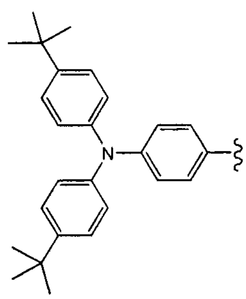

,

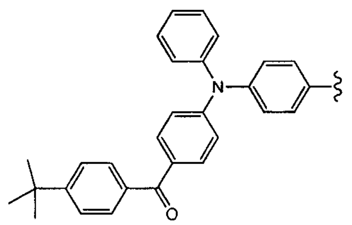, 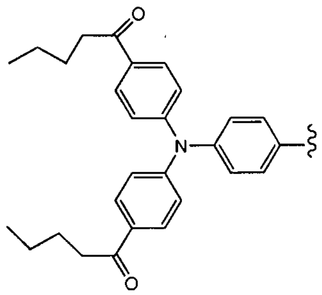, 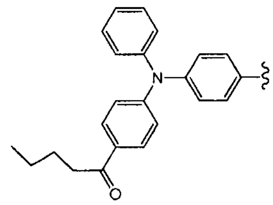,

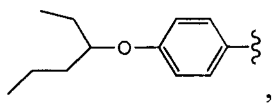, and 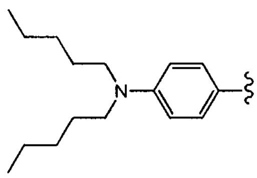.

In some embodiments, the chromophore is represented by formula VIII, provided that when Het is

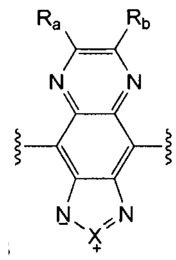,

$R_a$ and $R_b$ are not both hydrogen.

In some embodiments, the chromophore is represented by formula VIII, wherein Het is

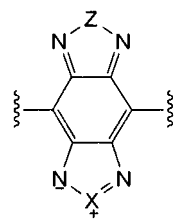,

X is selected from the group consisting of -N($A_0$)- and -Se-, Z is selected from the group consisting of -N(Ra)- and -S-, and $D_1$ and $D_2$ are independently selected from the group consisting of:

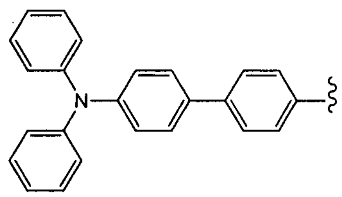, 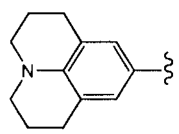,

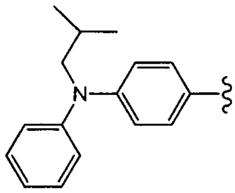 , 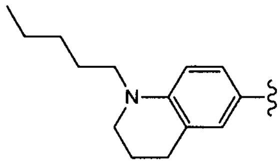 , 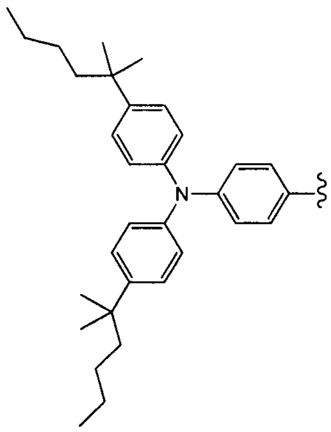 , 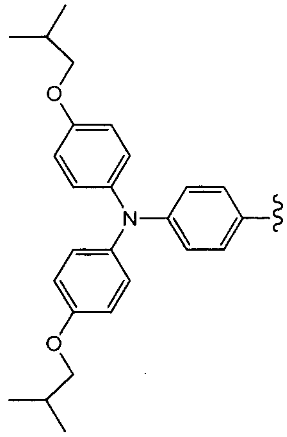 ,

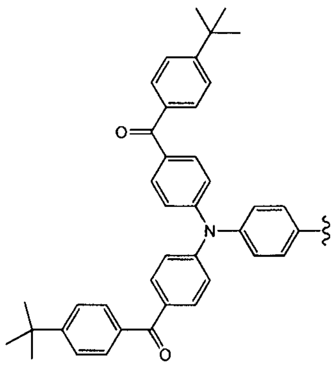 , 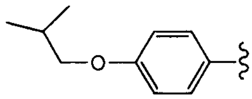 , 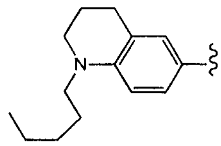 , 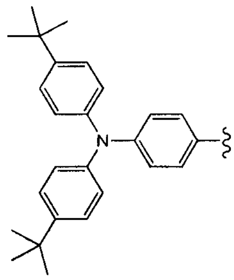 ,

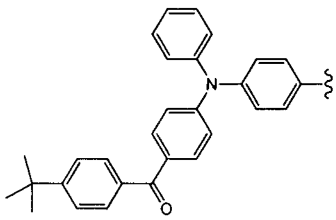 , 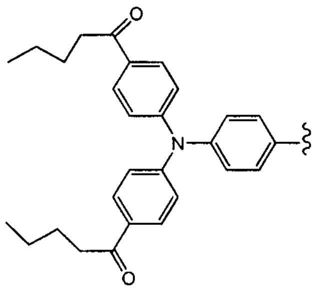 , 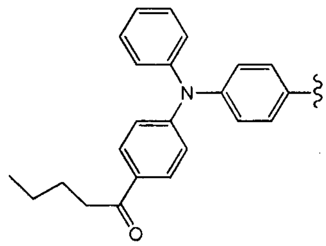 ,

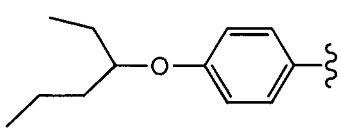 , and 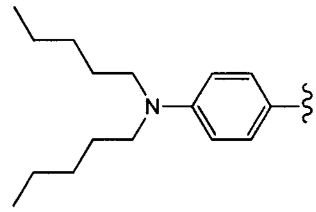 .

In some embodiments, the chromophore is represented by formula VIII, wherein Het is:

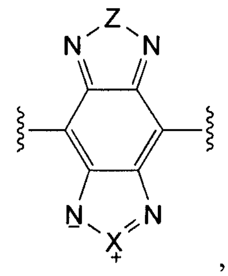

,

and X is selected from the group consisting of -S- and

–Se–, Z is –S-, and $D_1$ and $D_2$ are independently selected from the group consisting of:

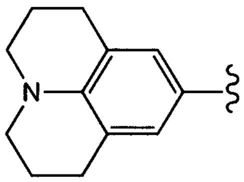

,

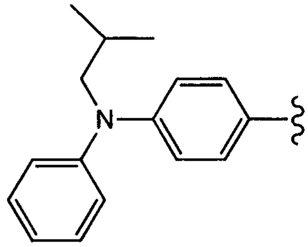

,

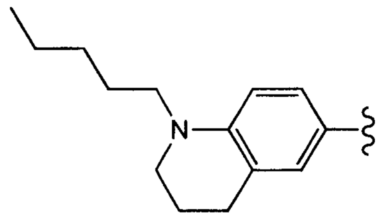

,

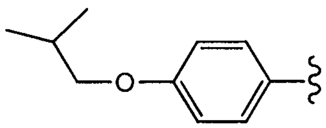

,

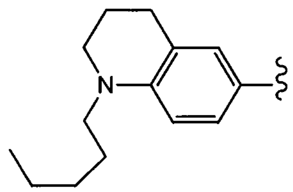

,

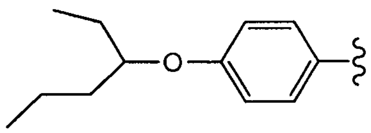

,

and

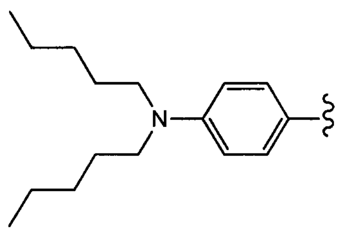

.

In some embodiments, the chromophore is represented by formula VIII, wherein Het is

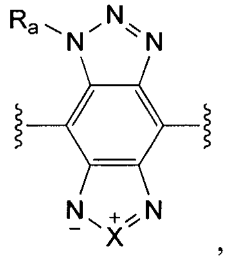

,

and wherein $D_1$ and $D_2$ are not hydroxy, or

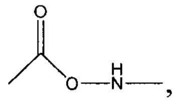

and $D_1$ and $D_2$ do not comprise bromine.

In formulae VIII, i is 0 or an integer in the range of 1 to 100. In some embodiments, i is 0 or an integer in the range of 1 to 50, 1 to 30, 1 to 10, 1 to 5, or 1 to 3. In some embodiments, i is 0, 1, 2, 3, 4, 5, 6, 7, 8, 9, or 10.

Formulae IX-a and IX-b

In some embodiments, the second organic photostable chromophore is represented by formula (IX-a) or (IX-b):

$Het_2$-$A_0$-$Het_2$ (IX-a),

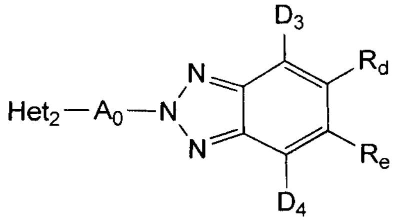

(IX-b)

wherein $Het_2$ is selected from the group consisting of:

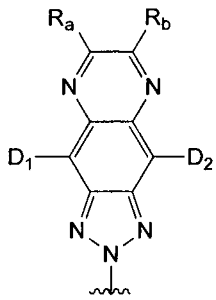 , 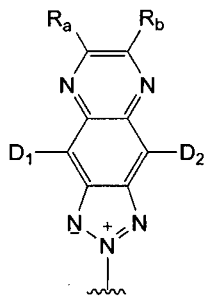 , 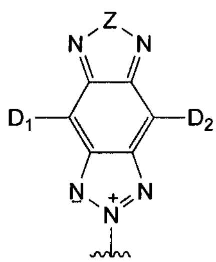 , 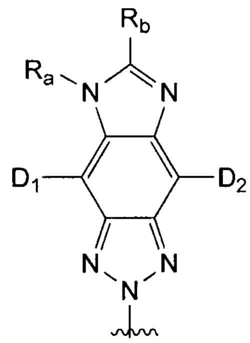 , 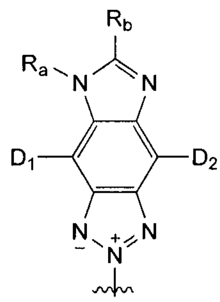 ,

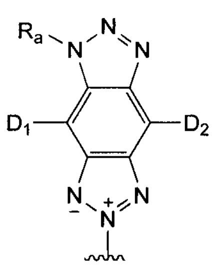 , 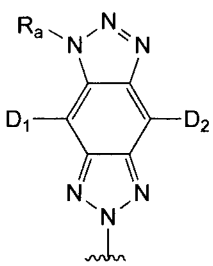 , 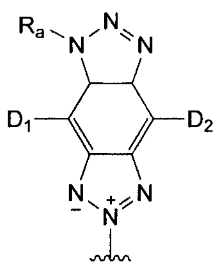 , 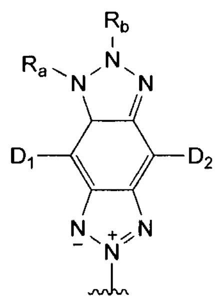 , 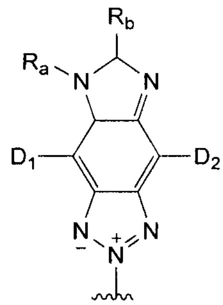 ,

and

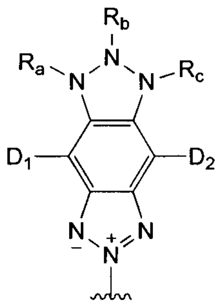
;

and wherein Z is selected from the group consisting of -N($R_a$)-, -O-, - S-, -Se-, and -Te-.

Each of the Ra, Rb, and Rc, in formula IX-a and formula IX-b is independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl.

In some embodiments, each $R_a$, $R_b$, and $R_c$ is independently selected from the group consisting of hydrogen, optionally substituted $C_{1-8}$ alkyl, optionally substituted $C_{6-10}$ aryl, and optionally substituted $C_{6-10}$ heteroaryl. In some embodiments, each $R_a$, $R_b$, and $R_c$, of formula (IX-a) and formula (IX-b) are independently selected from the group consisting of hydrogen, $C_{1-8}$ alkyl, $C_{6-10}$ aryl, and $C_{6-10}$ heteroaryl, wherein $C_{1-8}$ alkyl, $C_{6-10}$ aryl, and $C_{6-10}$ heteroaryl may each be optionally substituted by optionally substituted $C_{3-10}$ cycloalkyl, optionally substituted $C_{1-8}$ alkoxy, halo, cyano, carboxyl, optionally substituted $C_{6-10}$ aryl, optionally substituted $C_{6-10}$ aryloxy,

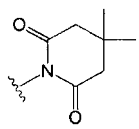
, or
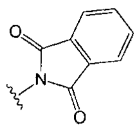
.

In some embodiments, $R_a$ and $R_b$, or $R_b$ and $R_c$, or $R_a$ and $R_c$, together form an optionally substituted ring system selected from the group consisting of:

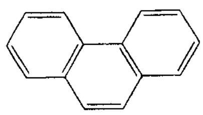
,
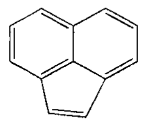
,
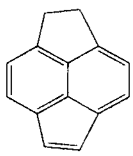
,

and

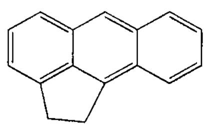
.

Each of the Rd and Re in formula IX-a and formula IX-b is independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally

substituted carboxy, and optionally substituted carbonyl; or Rd and Re together form an optionally substituted ring or an optionally substituted polycyclic ring system, wherein each ring is independently cycloalkyl, aryl, heterocyclyl, or heteroaryl.

Each of $D_1$, $D_2$, $D_3$, and $D_4$ in formula IX-a and formula IX-b are each independently $C_{6-10}$ aryl or optionally substituted $C_{6-10}$ aryl. The substituent(s) on the $C_{6-10}$ aryl may be selected from the group consisting of NR'R", -$C_{6-10}$ aryl-NR'R", $C_{1-8}$ alkyl and $C_{1-8}$ alkoxy, wherein R' and R" are independently selected from the group consisting of $C_{1-8}$ alkyl, $C_{1-8}$ alkoxy, $C_{6-10}$ aryl, $C_{6-10}$ aryl-$C_{1-8}$ alkyl, $C_{6-10}$ aryl-$C_{1-8}$ alkoxy, and $C_{6-10}$ aryl-C(=O)R, wherein R is optionally substituted $C_{1-8}$ alkyl, optionally substituted $C_{1-8}$ alkoxy or optionally substituted $C_{6-10}$ aryl; or one or both of R' and R" forms a fused heterocyclic ring with aryl to which the N is attached to.

In some embodiments, the chromophore is represented by formula IX-a or IX-b, wherein $D_1$ and $D_2$ are each independently selected from the group consisting of alkoxyaryl, -aryl-NR'R", and -aryl-aryl-NR'R"; wherein R' and R" are independently selected from the group consisting of alkyl and aryl optionally substituted by alkyl, alkoxy, or -C(=O)R; wherein R is optionally substituted aryl or optionally substituted alkyl; or one or both of R' and R" forms a fused heterocyclic ring with aryl to which the N is attached to.

In some embodiments, each of $D_1$, $D_2$, $D_3$, and $D_4$ in formula IX-a and formula IX-b are each independently $C_{6-10}$ aryl or optionally substituted $C_{6-10}$ aryl. The substituent(s) on the $C_{6-10}$ aryl may be selected from the group consisting of -NR'R", -$C_{6-10}$ aryl-NR'R", $C_{1-8}$ alkyl and $C_{1-8}$ alkoxy, wherein R' and R" are independently selected from the group consisting of $C_{1-8}$ alkyl, $C_{1-8}$ alkoxy, $C_{6-10}$ aryl, $C_{6-10}$ aryl-$C_{1-8}$ alkyl, $C_{6-10}$ aryl-$C_{1-8}$ alkoxy, and $C_{6-10}$ aryl-C(=O)R, R is optionally substituted $C_{1-8}$ alkyl, optionally substituted $C_{1-8}$ alkoxy or optionally substituted $C_{6-10}$ aryl; or one or both of R' and R" forms a fused heterocyclic ring with aryl to which the N is attached to.

In some embodiments, the chromophore is represented by formula IX-a or formula IX-b, wherein $Het_2$ is

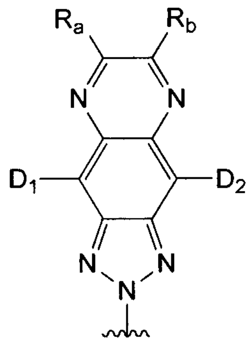

,

provided that $R_a$ and $R_b$ are not both hydrogen, and $D_1$ and $D_2$ are independently selected from the group consisting of:

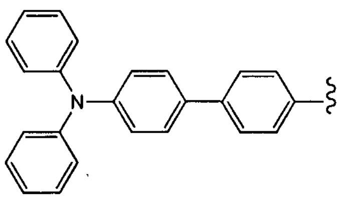

,

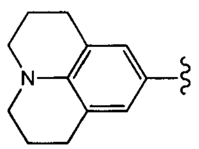

,

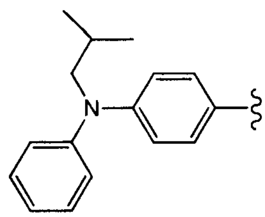

,

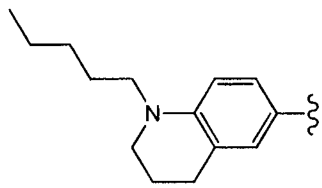

,

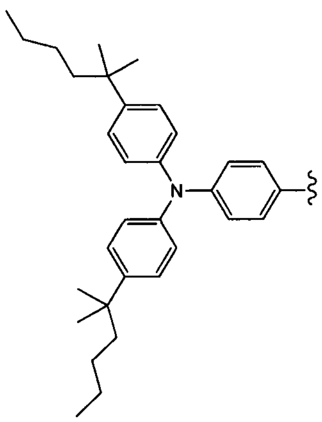, 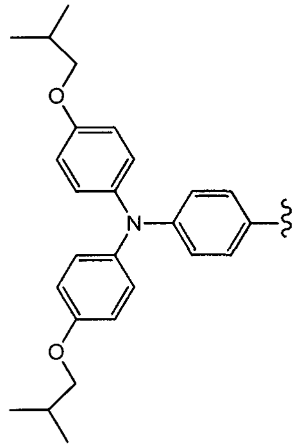, 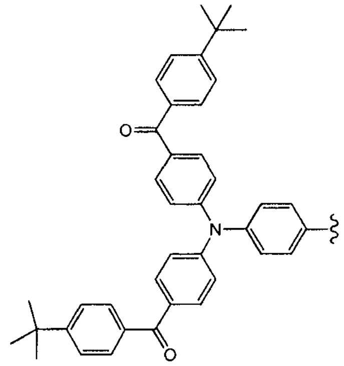,

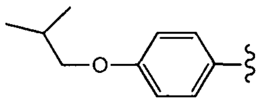, 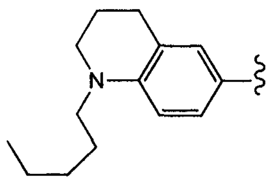, 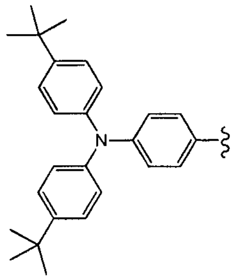, 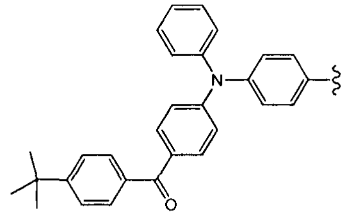,

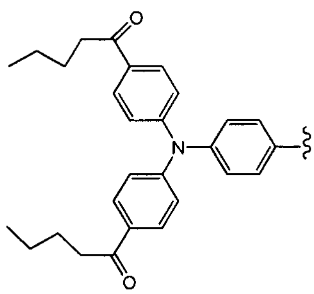, 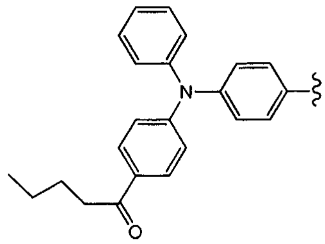, 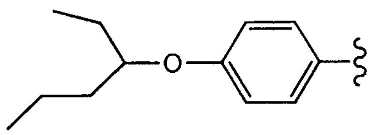,

and

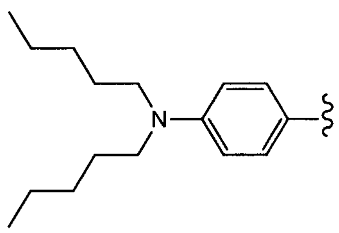.

In some embodiments, the chromophore is represented by formula IX-a or formula IX-b, wherein $Het_2$ is

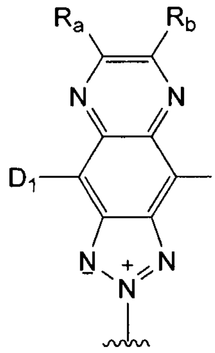

,

provided that $R_a$ and $R_b$ are not both hydrogen.

In some embodiments, the chromophore is represented by formula IX-a or formula IX-b, wherein $Het_2$ is

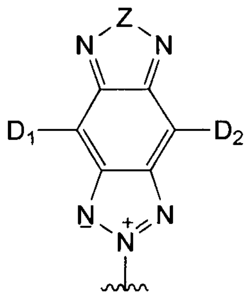

,

and provided that $D_1$ and $D_2$ are independently selected from the group consisting of:

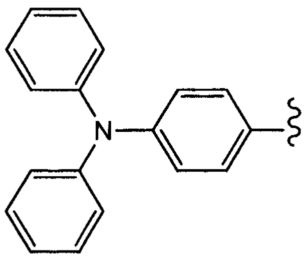

,

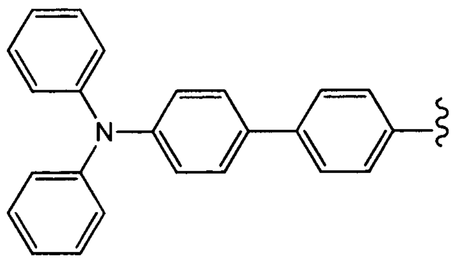

,

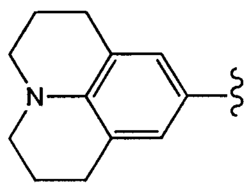

,

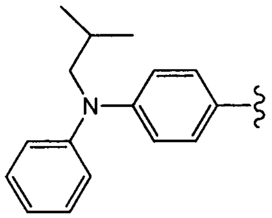 , 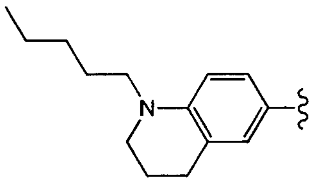 , 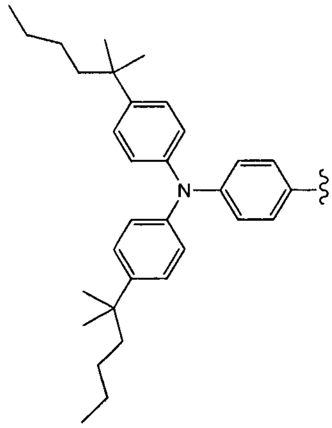 ,

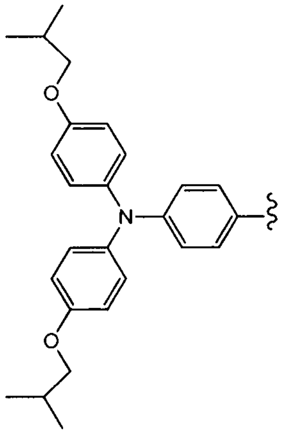 , 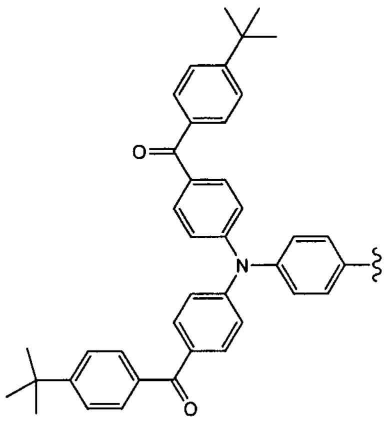 , 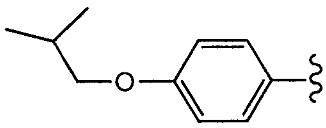 ,

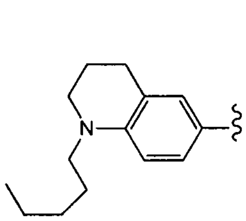 , 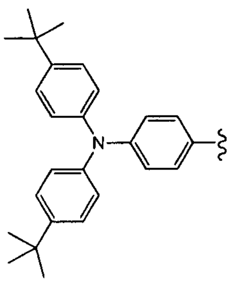 , 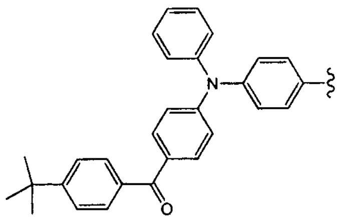 , 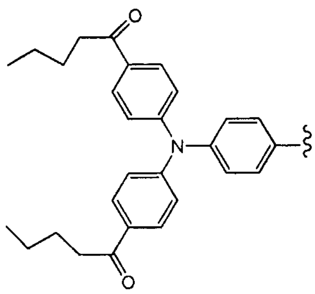

, 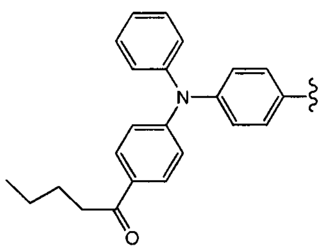 , 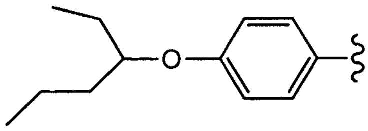 , and 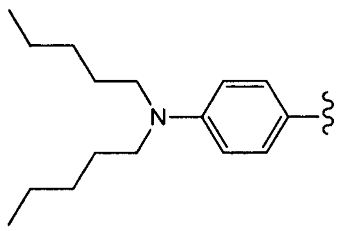 .

In some embodiments, the chromophore is represented by formula IX-a or IX-b, wherein $Het_2$ is

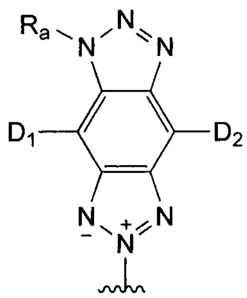

,

provided that $D_1$ and $D_2$ are not hydroxy, or

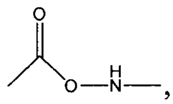

and $D_1$ and $D_2$ do not comprise bromine.

Formulae X-a and X-b

In some embodiments, the second organic photostable chromophore is represented by formula (X-a) or (X-b):

$Het_3$-$R_a$-$Het_3$ (X-a),

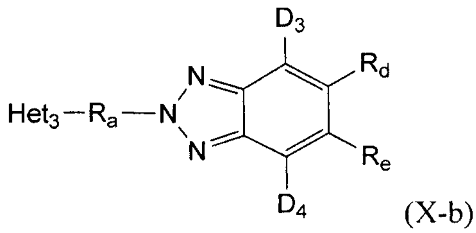

(X-b)

wherein $Het_3$ is selected from the group consisting of:

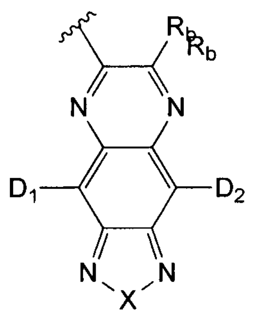

,

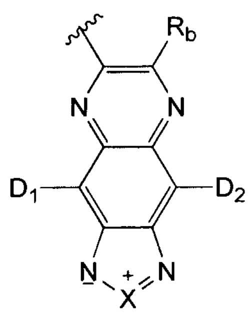

,

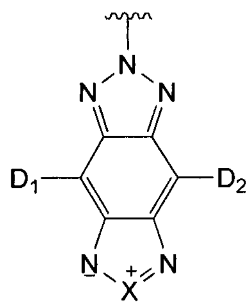

,

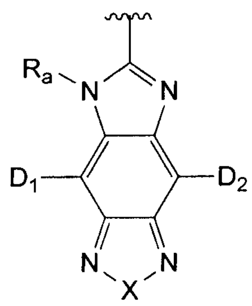

,

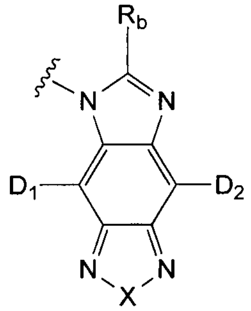,
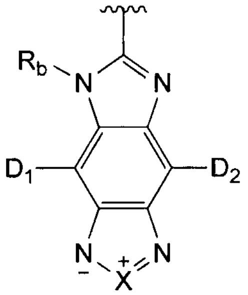,
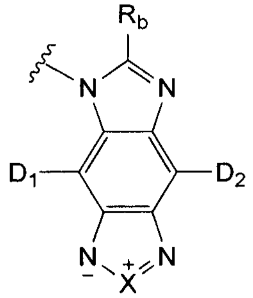,
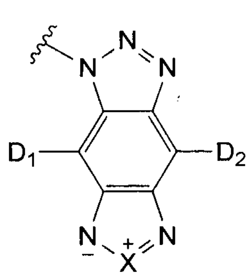,
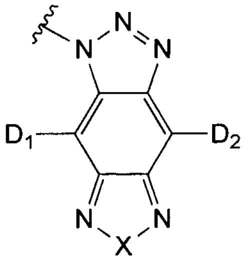,
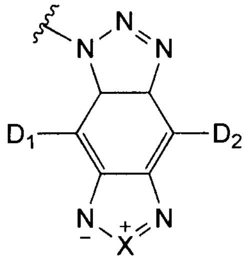,
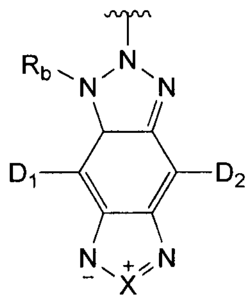,
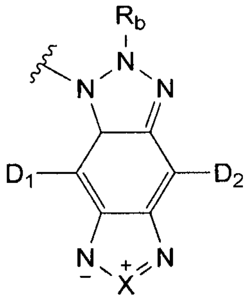,
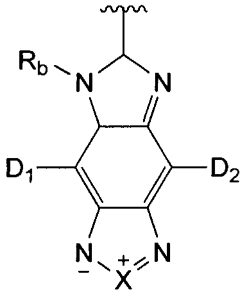,
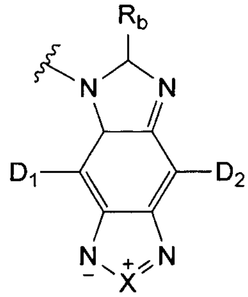,
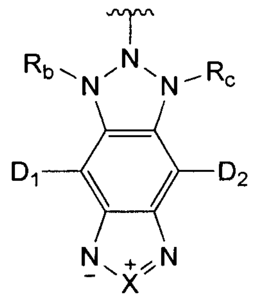, and
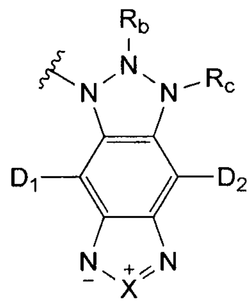,

and wherein X is selected from the group consisting of -N($A_0$)-, -O-, -S-, -Se-, and -Te-.

Each $A_0$ of formula X-a and formula X-b is selected from the group consisting of hydrogen, optionally substituted alkyl, optionally substituted alkenyl, optionally substituted heteroalkyl, optionally substituted aryl, optionally substituted heteroaryl, optionally substituted amino, optionally substituted amido, optionally substituted cyclic amido, optionally substituted cyclic imido, optionally substituted alkoxy, optionally substituted acyl, optionally substituted carboxy, and optionally substituted carbonyl. In some embodiments, $A_0$ is $C_{1-8}$ alkyl.

Each $R_a$, $R_b$, and $R_c$, of formula X-a and formula X-b is independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl.

In some embodiments, each $R_a$, $R_b$, and $R_c$ is independently selected from the group consisting of hydrogen, optionally substituted $C_{1-8}$ alkyl, optionally substituted $C_{6-10}$ aryl, and optionally substituted $C_{6-10}$ heteroaryl. In some embodiments, each $R_a$, $R_b$, and $R_c$, of formula X-a and formula X-b are independently selected from the group consisting of hydrogen, $C_{1-8}$ alkyl, $C_{6-10}$ aryl, and $C_{6-10}$ heteroaryl, wherein $C_{1-8}$ alkyl, $C_{6-10}$ aryl, and $C_{6-10}$ heteroaryl may each be optionally substituted by optionally substituted $C_{3-10}$ cycloalkyl, optionally substituted $C_{1-8}$ alkoxy, halo, cyano, carboxyl, optionally substituted $C_{6-10}$ aryl, optionally substituted $C_{6-10}$ aryloxy,

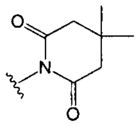 , or 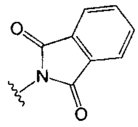 .

In some embodiments, $R_a$ and $R_b$, or $R_b$ and $R_c$, or $R_a$ and $R_c$, together form an optionally substituted ring system selected from the group consisting of:

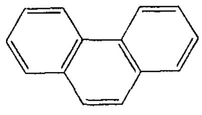 , 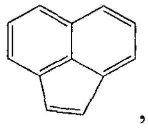 , 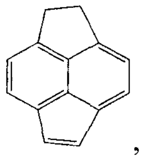 , and 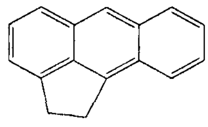 .

Each $R_d$ and $R_e$ of formula X-a and formula X-b is independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_d$ and $R_e$ together form an optionally substituted ring or an optionally substituted polycyclic ring system, wherein each ring is independently cycloalkyl, aryl, heterocyclyl, or heteroaryl.

Each $D_1$, $D_2$, $D_3$, and $D_4$ of formula X-a and formula X-b is independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, -aryl-NR'R", -ary-aryl-NR'R", and -heteroaryl-heteroaryl-R'; wherein R' and R" are independently selected from the group consisting of optionally substituted alkyl, optionally substituted alkenyl, and optionally substituted aryl; or one or both of R' and R" forms a fused heterocyclic ring with aryl to which the N is attached to; provided that $D_1$ and $D_2$ are not both hydrogen, and $D_1$ and $D_2$ are not optionally substituted thiophene or optionally substituted furan.

In some embodiments, the chromophore is represented by formula X-a or formula X-b, wherein $D_1$ and $D_2$ are each independently selected from the group consisting of alkoxyaryl, -aryl-NR'R", and -aryl-aryl-NR'R"; wherein R' and R" are independently selected from the group consisting of alkyl and aryl optionally substituted by alkyl, alkoxy, or -C(=O)R; wherein R is optionally substituted aryl or optionally substituted alkyl; or one or both of R' and R" forms a fused heterocyclic ring with aryl to which the N is attached to.

In some embodiments, each of $D_1$, $D_2$, $D_3$, and $D_4$ in formula X-a and formula X-b are each independently $C_{6-10}$ aryl or optionally substituted $C_{6-10}$ aryl. The substituent(s) on the $C_{6-10}$ aryl may be selected from the group consisting of -NR'R", -$C_{6-10}$ aryl-NR'R", $C_{1-8}$ alkyl and $C_{1-8}$ alkoxy, wherein R' and R" are independently selected from the group consisting of $C_{1-8}$ alkyl, $C_{1-8}$ alkoxy, $C_{6-10}$ aryl, $C_{6-10}$ aryl-$C_{1-8}$ alkyl, $C_{6-10}$ aryl-$C_{1-8}$ alkoxy, and $C_{6-10}$ aryl-C(=O)R, wherein R is optionally substituted $C_{1-8}$ alkyl, optionally substituted $C_{1-8}$ alkoxy or optionally substituted $C_{6-10}$ aryl; or one or both of R' and R" forms a fused heterocyclic ring with aryl to which the N is attached to.

In some embodiments, the chromophore is represented by formula X-a or formula X-b, wherein $Het_3$ is

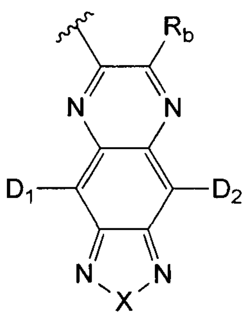 ,

provided that $D_1$ and $D_2$ are independently selected from the group consisting of:

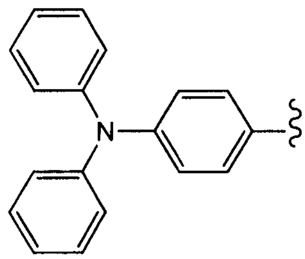

,

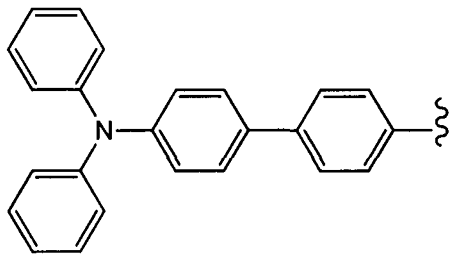

,

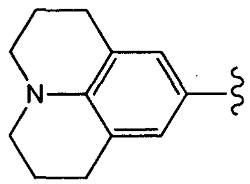

,

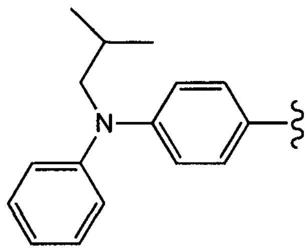

,

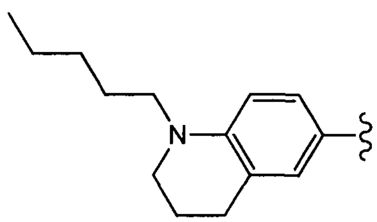

,

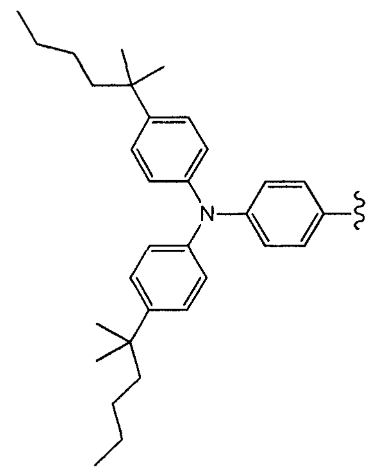

,

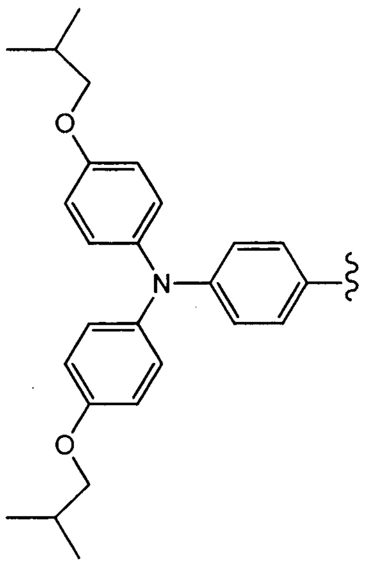

,

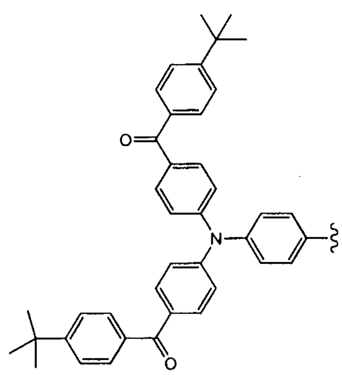

,

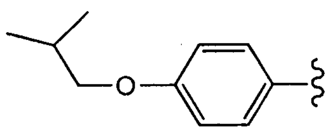

,

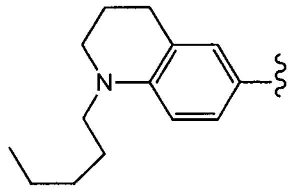 , 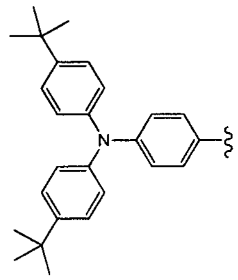 , 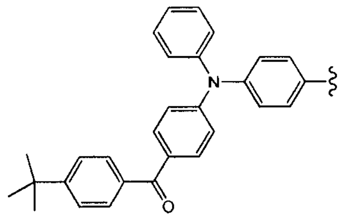 ,

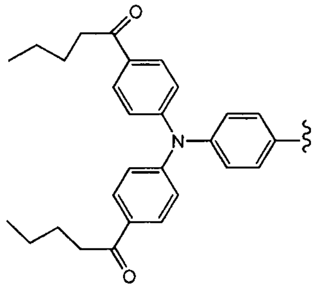 , 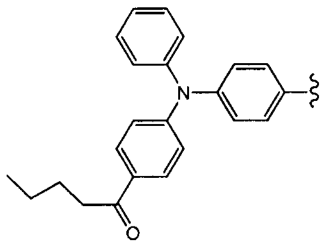 , 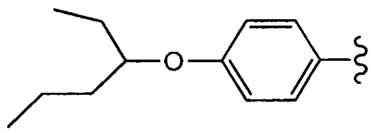 ,

and

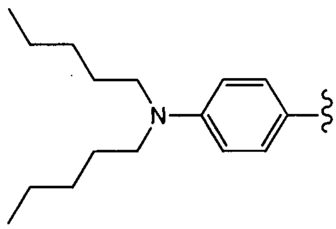 .

In some embodiments, the chromophore is represented by formula X-a or formula X-b, wherein $Het_3$ is

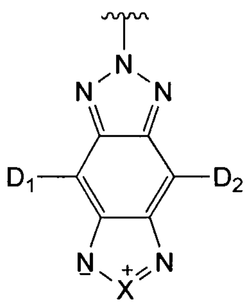 ,

provided that $D_1$ and $D_2$ are independently selected from the group consisting of:

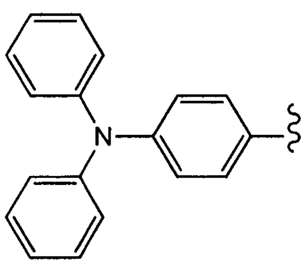 ,

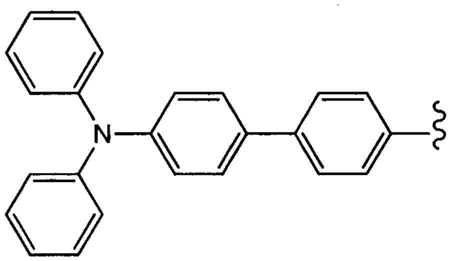
,
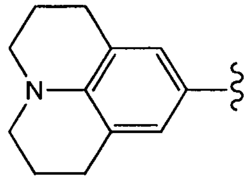
,

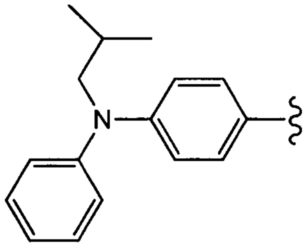
,
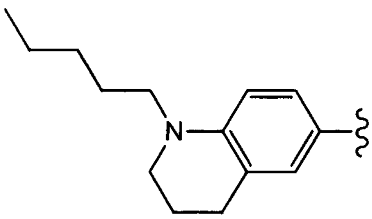
,
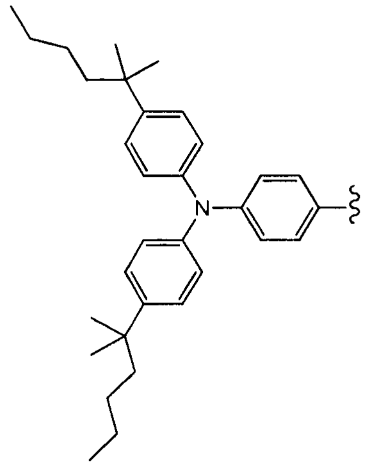
,

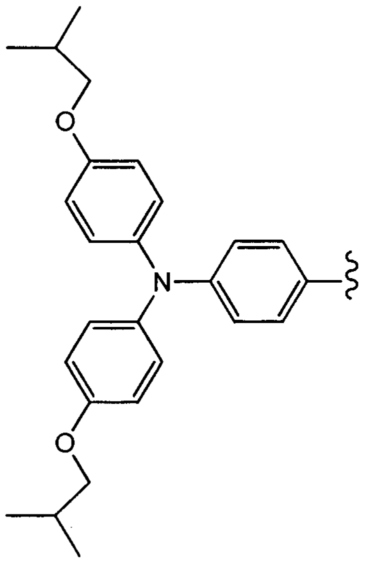
,
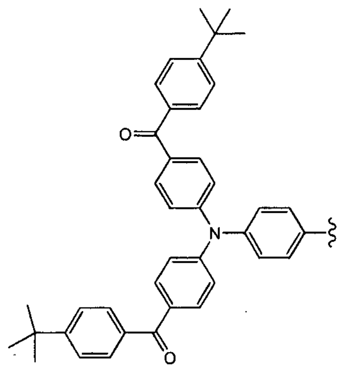
,
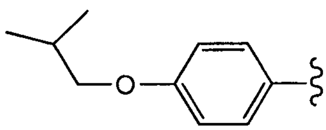
,

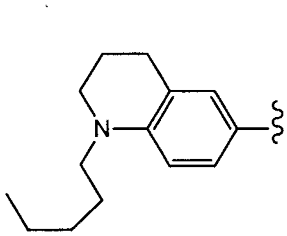
,
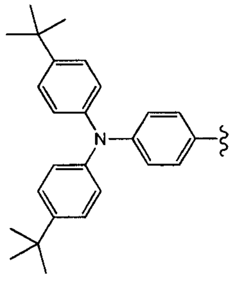
,
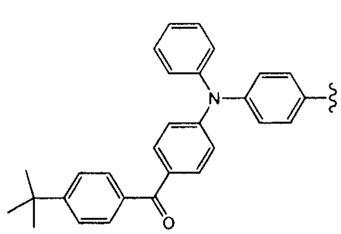
,

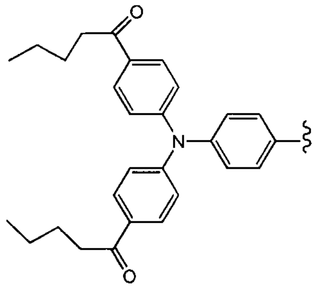,
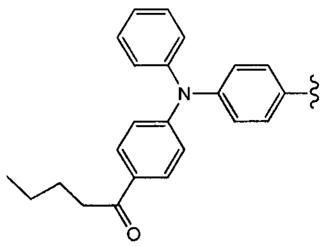,
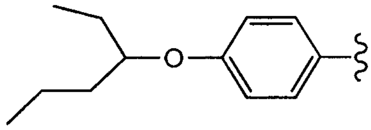,

and

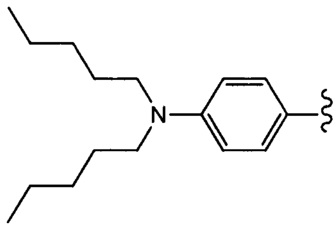.

In some embodiments, the chromophore is represented by formual X-a or formula X-b, wherein $Het_3$ is

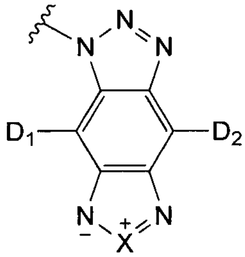,

provided that $D_1$ and $D_2$ are not hydroxy or

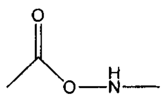,

and $D_1$ and $D_2$ do not comprise bromine.

In some embodiments, X in formula VIII, formula X-a, and formula X-b, is selected from the group consisting of $-N(A_0)-$, -S-, and -Se-.

In some embodiments, Z in formula VIII, formula IX-a, and formula IX-b, is selected from the group consisting of $-N(R_a)-$, -S-, and -Se-.

In some embodiments, $A_0$ in formula VIII, formula IX-a, formula IX-b, formula X-a, and formula X-b, is selected from the group consisting of hydrogen, optionally substituted $C_{1-10}$ alkyl, optionally substituted aryl, optionally substituted heteroaryl, and optionally substituted alkoxyalkyl. In some embodiments, $A_0$ is selected from the group consisting of: hydrogen, methyl, ethyl, propyl, isopropyl, butyl, isobutyl, tert-butyl, pentyl, hexyl,

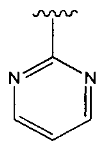, 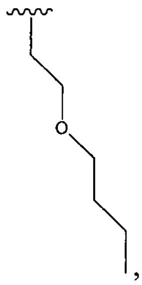, 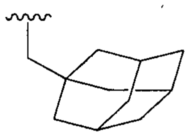, and 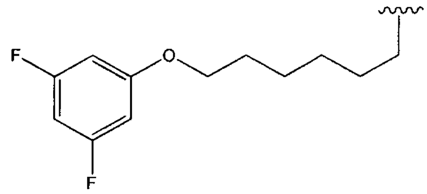.

In some embodiments, $A_0$ is hydrogen or $C_{1-8}$ alkyl . In some embodiments $A_0$ is isobutyl. In some embodiments $A_0$ is tert-butyl. In some embodiments, $A_0$ is

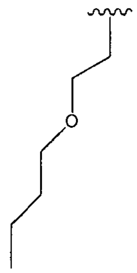.

In some embodiments, $A_0$ is

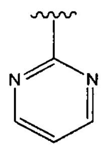.

In some embodiments, $R_a$, $R_b$, or $R_c$, in formula VIII, formula IX-a, formula IX-b, formula X-a, and formula X-b, are independently selected from the group consisting of hydrogen, optionally substituted $C_{1-10}$ alkyl, optionally substituted aryl, optionally substituted heteroaryl, and optionally substituted alkoxyalkyl. In some embodiments $R_a$ and $R_b$, or $R_b$ and $R_c$, or $R_a$ and $R_c$, together form an optionally substituted polycyclic ring system.

In some embodiments, $R_a$, $R_b$, or $R_c$, in formula VIII, formula IX-a, formula IX-b, formula X-a, and formula X-b, are independently selected from the group consisting of hydrogen, methyl, ethyl, propyl, isopropyl, butyl, isobutyl, tert-butyl, pentyl, hexyl,

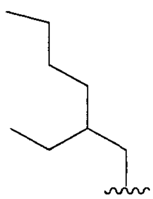, 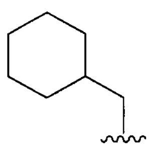, 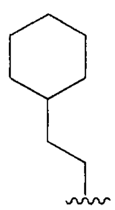, 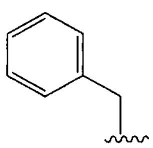, 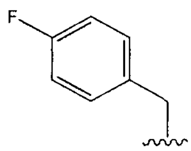, 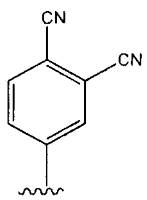, 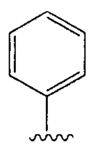,

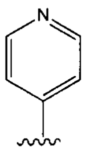, 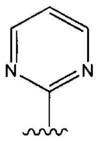, 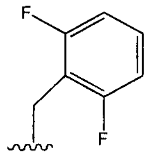. 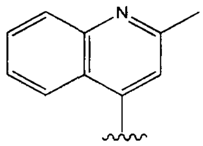, 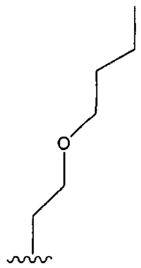, 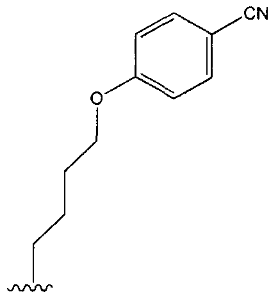, 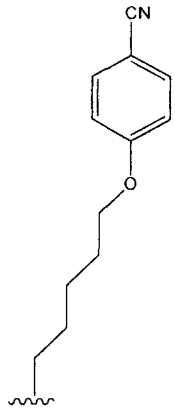,

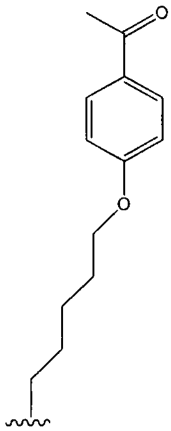, 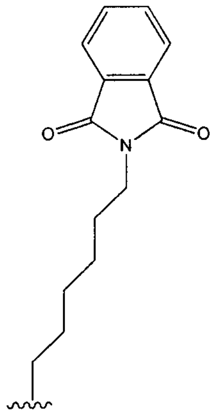, 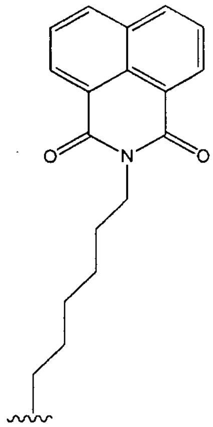, 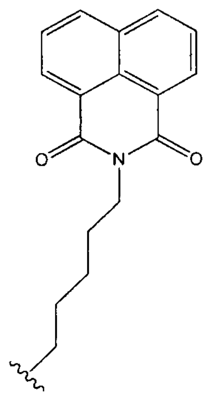,

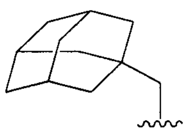 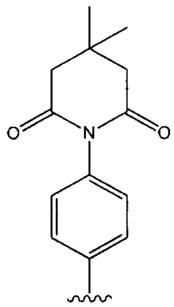, 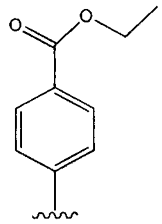, 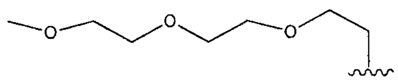,

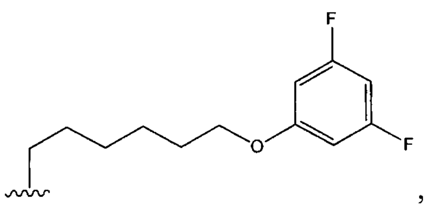, 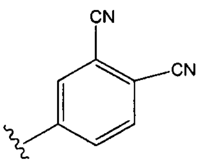 and 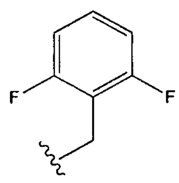.

In some embodiments, $R_a$ and $R_b$, or $R_b$ and $R_c$, together form one of the following ring structures

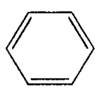, 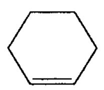, 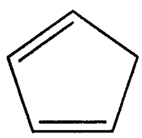, 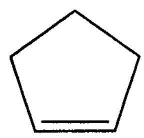, 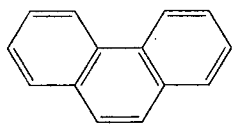,

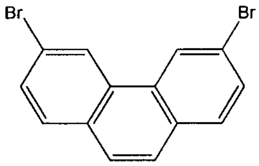,

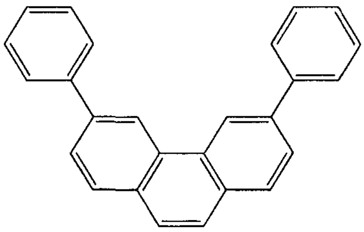, 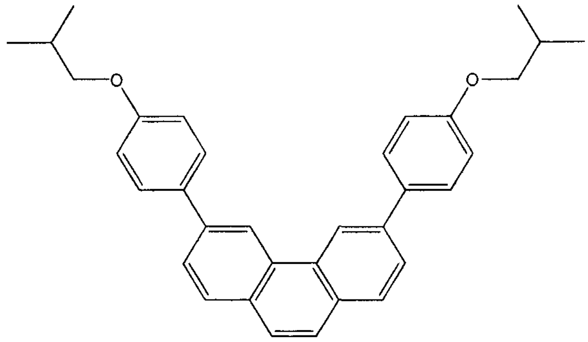,

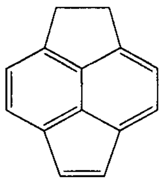, 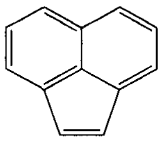, 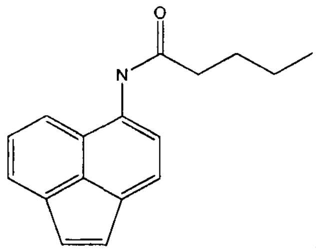, and 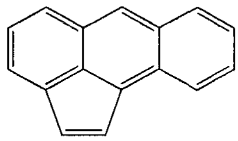.

In some embodiments, $D_1$ and $D_2$ are each independently selected from the group consisting of the following structures:

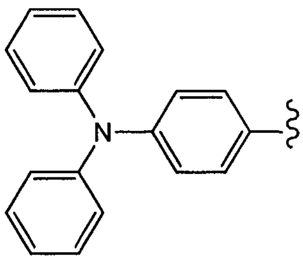,

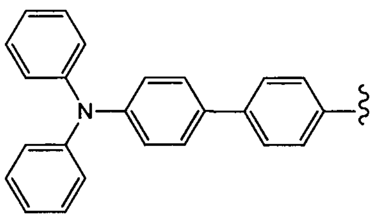, 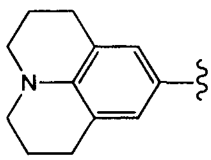, 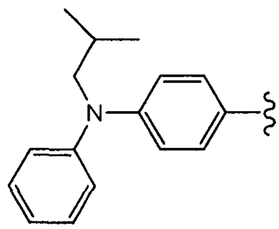,

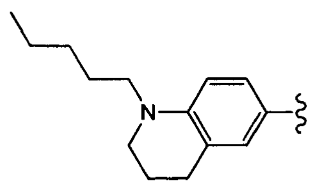, 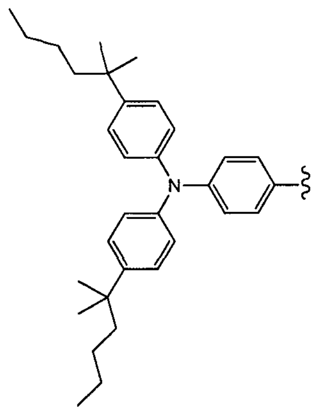, 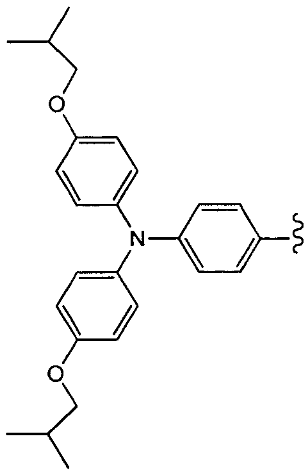,

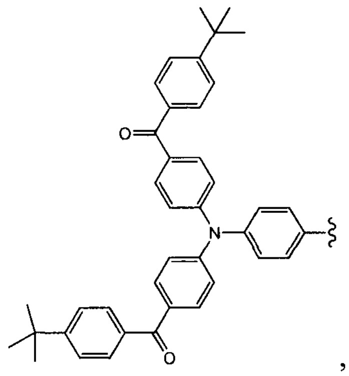, 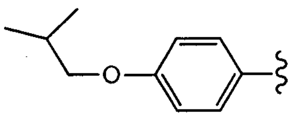, 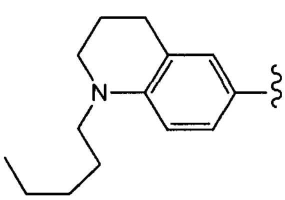, 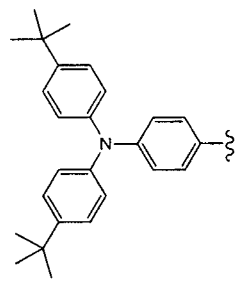

, 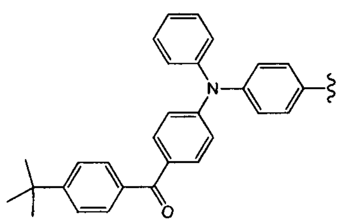, 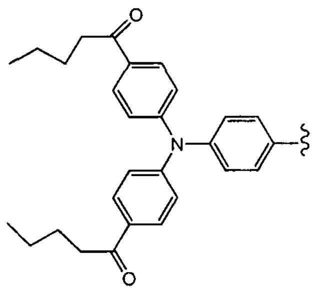, 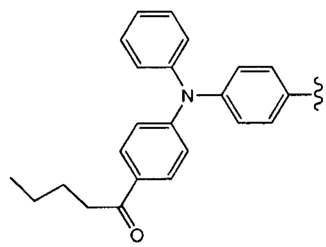,

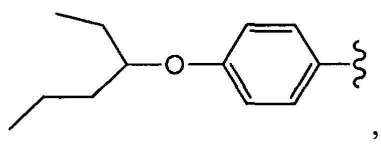, and 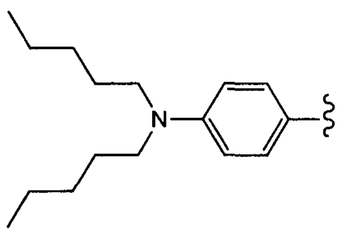.

In some embodiments, at least one of the L in formula VIII is selected from the group consisting of: 1,2-ethylene, acetylene, 1,4-phenylene, 1,1'-biphenyl-4,4'-diyl, naphthalene-2,6-diyl, naphthalene-1,4-diyl, 9*H*- fluorene-2,7-diyl, perylene-3,9-diyl, perylene-3,10-diyl, or pyrene-1,6-diyl, 1*H*-pyrrole-2,5-diyl, furan-2,5-diyl, thiophen-2,5-diyl, thieno[3,2-*b*]thiophene-2,5-diyl, benzo[*c*]thiophene-1,3-diyl, dibenzo[*b*,*d*]thiophene-2,8-diyl, 9*H*-carbozole-3,6-diyl, 9*H*-carbozole-2,7-diyl, dibenzo[*b*,*d*]furan-2,8-diyl, 10*H*-phenothiazine-3,7-diyl, and 10*H*-phenothiazine-2,8-diyl; wherein each moiety is optionally substituted.

With regard to L in any of the formulae above, the electron linker represents a conjugated electron system, which may be neutral or serve as an electron donor itself. In some embodiments, some examples are provided below,

which may or may not contain additional attached substituents.

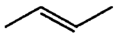 or 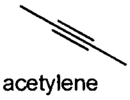 or 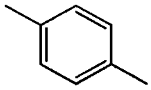 or 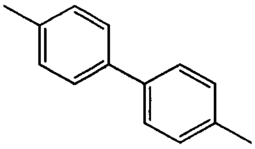

1,2-ethylene acetylene 1,4-phenylene 1,1'-biphenyl-4,4'-diyl

or 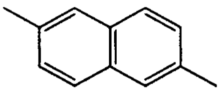 or 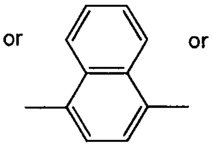 or 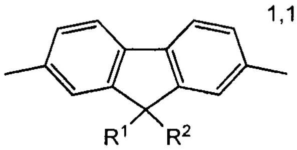

naphthalene-2,6-diyl naphthalene-1,4-diyl 9*H*-fluorene-2,7-diyl

or 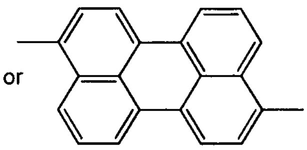 or 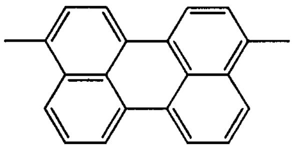 or 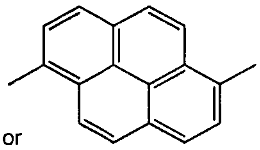

perylene-3,9-diyl perylene-3,10-diyl pyrene-1,6-diyl

etc.

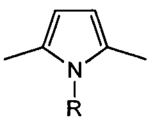 or 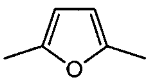 or 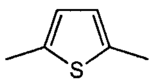 or

1*H*-pyrrole-2,5-diyl furan-2,5-diyl thiophen-2,5-diyl

or 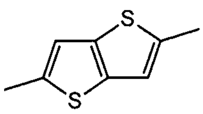 or 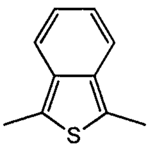 or 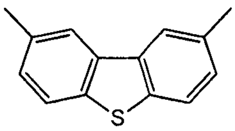

thieno[3,2-*b*]thiophene-2,5-diyl benzo[*c*]thiophene-1,3-diyl dibenzo[*b*,*d*]thiophene-2,8-diyl

or 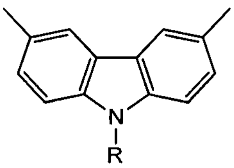 or 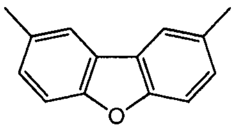 or 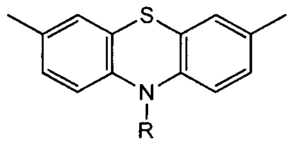

9*H*-carbazole-3,6-diyl dibenzo[*b*,*d*]furan-2,8-diyl 10*H*-phenothiazine-3,7-diyl

etc.

The above mentioned combination of chromophores is especially suitable for use in the solar cells and agriculture applications because they are surprisingly more stable in harsh environmental conditions than currently available wavelength converting chromophores. This stability makes these chromophores advantageous in their use as wavelength conversion materials for solar cells and agriculture applications. Without such photostability, these chromophores would degrade and lose efficiency.

In some embodiments the photostability of chromophores can be measured by fabricating a wavelength conversion film containing the chromophore compound and then measuring the absorption peak prior to exposure and after exposure to continuous one sun (AM1.5G) irradiation at ambient temperature. The preparation of such a wavelength conversion film is described in the EXAMPLES section below. The amount of remaining chromophore after irradiation can be measured using the maximum absorption of the chromophore before and after irradiation using the following equation:

$$\frac{\text{Absorption Peak Intensity After Irradiation}}{\text{Absorption Peak Intensity Before Irradiation}} \times 100\% = \%\ \text{Chromophore Remaining}$$

The % degradation can be measured using the following equation:

$$\frac{(\text{Absorption Peak Intensity Before Irradiation - Absorption Peak Intensity After Irradiation})}{\text{Absorption Peak Intensity Before Irradiation}} \times 100\% = \%\ \text{Chromophore Degraded}$$

Easily degraded chromophores typically show a substantial decay of the absorption peak within a few hours of one sun irradiation. Films with excellent photostability will maintain the peak absorption over a long time period of exposure to one sun irradiation. In some embodiments, a photostable chromophore shows less than about 30%, 20%, 15%, 10%, 5%, 2.5%, 1.0%, or 0.5% degradation in maximum absorption peak intensity after 24 hours of continuous one sun (AM1.5G) irradiation at ambient temperature. In some embodiments, a photostable chromophore has greater than about 70%, 80%, 85%, 90%, 95%, 97.5%, 99.0%, or 99.5% of the chromophore remaning (as measured by maximum absorption peak intensity) after 24 hours of continuous one sun (AM1.5G) irradiation at ambient temperature..

Advantageously, some embodiments of the disclosed polymer matrices of the wavelength conversion film are optically transparent. Optical transparency improves the transmittance of light through the wavelength conversion film allowing more energy to be captured from the light. Additionally, when used as, for example, a window, the additional light that travels through the wavelength conversion film results enhanced brightness through the window. In some embodiments, an optically transparent material (e.g. polymer layer, wavelength conversion layer, polymer matrix, glass layer, etc.) allows transmission of greater than about 80%, 90%, 95%, 97.5%, 99.0%, 99.5%, or 99.9% of the intensity visible light spectrum.

In some embodiments, the first organic photostable chromophore and the second organic photostable chromophore are independently present in the polymer matrix of the wavelength conversion layer in an amount in the range of about 0.01 wt% to about 10.0 wt%, by weight of the polymer matrix. In some embodiments, the first organic photostable chromophore and the second organic photostable chromophore are independently present in the polymer matrix of the wavelength conversion layer in an amount in the range of about 0.01 wt% to about 3.0 wt%, by weight of the polymer matrix. In some embodiments, the first organic photostable chromophore and the second organic photostable chromophore are independently present in the polymer matrix of the wavelength conversion layer in an amount in the range of about 0.05 wt% to about 2.0 wt%, by weight of the polymer matrix. In some embodiments, the first organic photostable chromophore and the second organic photostable chromophore are independently present in the polymer matrix of the wavelength conversion layer in an amount in the range of about 0.1 wt% to about 1.0 wt%, by weight of the polymer matrix.

The overall thickness of the wavelength conversion film may also vary over a wide range. In some embodiments, the wavelength conversion film thickness is in the range of about 0.1 μm to about 1 mm. In some embodiments, the wavelength conversion film thickness is in the range of about 0.5 μm to about 0.5 mm.

In some embodiments, of the wavelength conversion film, the polymer matrix may be made of one host polymer, a host polymer and a co-polymer, or multiple polymers.

In some embodiments, the polymer matrix material used in the wavelength conversion film has a refractive index in the range of about 1.4 to about 1.7. In some embodiments, the refractive index of the polymer matrix material used in the wavelength conversion layer is in the range of about 1.45 to about 1.55.

## Photovoltaic Application

The present disclosure relates to a wavelength conversion film, and a photovoltaic module which utilizes the same, to enhance the photoelectric conversion efficiency of a photovoltaic device. The use of a down-shifting medium in these photovoltaic and solar cell devices, when applied to the light incident side of the device, causes the shorter wavelength light to become excited and re-emitted from the medium at a longer (higher) more favorable wavelength, which can then be utilized by the photovoltaic device or solar cell. However, the use of organic chromophores as the down-shifting medium in these wavelength conversion films has been very challenging due to their poor photostability, especially when exposed to harmful UV radiation.

Some embodiments provide a wavelength conversion film comprising at least one photostable organic chromophore which exhibits an absorption peak maximum at a wavelength less than 400 nm (e.g., in the UV radiation range), and at least one photostable organic chromophore which exhibits an absorption peak maximum at a wavelength of greater than 400 nm. In some embodiments, the wavelength conversion film comprising at least one photostable organic chromophore which exhibits an absorption peak maximum at a wavelength less than about 400 nm, and at least one

photostable organic chromophore which exhibits an absorption peak maximum at a wavelength of equal to or greater than about 400 nm, shows significantly improved photostability. In some embodiments, the wavelength conversion film can be applied to at least one solar cell or photovoltaic device. The use of the wavelength conversion film as described herein, significantly enhances the solar harvesting efficiency of solar cells, solar panels, and photovoltaic devices.

In some embodiments of the wavelength conversion film, at least one chromophore is designed to absorb harmful UV radiation and convert it to lower energy photons (e.g., the UV absorbing chromophore), while the other chromophore is also designed to absorb high energy photons, typically in the visible light spectrum, and convert these photons to the lower energy wavelengths that are most efficiently converted into electricity by the solar cell. For example, the second chromophore may have an absorption peak maximum in the range of about 425 nm to about 475 nm and an emission peak maximum in the range of about 500 nm to about 550 nm, wherein the photostability of the film is improved due to the first chromophore reducing the UV radiation exposure of the second chromophore, while also maintaining equivalent or better solar harvesting efficiency of the solar cell.

It has now been discovered that by using two or more chromophores in the wavelength conversion film, wherein at least one photostable organic chromophore which exhibits an absorption peak maximum at a wavelength less than about 400 nm (e.g., in the UV radiation range), and at least one photostable organic chromophore which exhibits an absorption peak maximum at a wavelength of equal to or greater than 400 nm, the photostability of the film is significantly improved as the UV absorbing chromophore reduces the exposure of the second chromophore to UV radiation. Therefore, a wavelength conversion film comprising an optically transparent polymer matrix at least one photostable organic chromophore which exhibits an absorption peak maximum at a wavelength less than about 400 nm, and at least one photostable organic chromophore which exhibits an absorption peak maximum at a wavelength of equal to or greater than about 400 nm, shows an increase in photostability compared to a similar wavelength conversion film comprising only a single wavelength conversion chromophore. In some embodiments the wavelength conversion film comprises additional UV absorbing chromophores. In some embodiments, the wavelength conversion film comprises additional wavelength conversion chromophores.

In addition, both the at least one photostable organic chromophore which exhibits an absorption peak maximum at a wavelength less than about 400 nm, and the at least one photostable organic chromophore which exhibits an absorption peak maximum at a wavelength of equal to or greater than 400 nm, in the wavelength conversion film as described herein, can be selected such that they convert high energy photons into lower energy photons which are more effectively converted into electricity by the photovoltaic device. This further increases the efficiency of the photovoltaic device. In some embodiments, the chromophore which exhibits an absorption peak maximum at a wavelength of equal to or greater than 400 nm, converts higher energy photons into lower energy photons which are more effectively converted into electricity by the photovoltaic device. The wavelength conversion film is useful in various applications, such as optical light collection systems, fluorescence-based solar collectors, fluorescence-activated displays, and single-molecule spectroscopy, to name a few.

In some embodiments, the wavelength conversion film comprises an optically transparent polymer matrix and at least one photostable organic chromophore which exhibits an absorption peak maximum at a wavelength less than about 400 nm, and at least one photostable organic chromophore which exhibits an absorption peak maximum at a wavelength of equal to or greater than about 400 nm. In some embodiments, the wavelength conversion film receives as input at least one photon having a first wavelength, and provides as output at least one photon having a second wavelength which is different than the first. In some embodiments, the photostability is increased compared to a wavelength conversion film comprising only one wavelength conversion chromophore. In some embodiments, the wavelength conversion film comprises a first chromophore which exhibits an absorption peak at wavelength 1, and a second chromophore which exhibits an absorption peak at wavelength 2, wherein wavelength 2 is longer than wavelength 1.

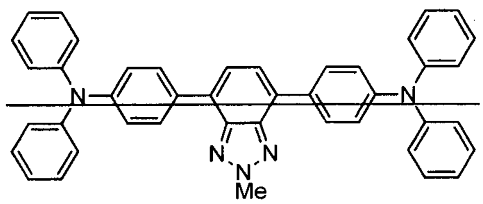

In some embodiments, the wavelength conversion film comprises at least three different chromophores. It may be desirable to have multiple chromophores in the wavelength conversion film, depending on the solar module that is to be used in the structure. For example, in a solar module system having an optimum photoelectric conversion at about 500 nm wavelength, the efficiency of such a system can be improved by converting photons of other wavelengths into 500 nm wavelengths, while the stability can also be improved by using a chromophore which absorbs the harmful UV photons and reduces the exposure of the other chromophores to the UV radiation. In such instance, a first chromophore

may act to convert photons having peak maximum absorption wavelengths less than about 400 nm into photons of a peak maximum emission wavelengths of about 430 nm, while a second chromophore may act to convert photons having peak maximum absorption wavelengths in the range of about 420 nm to about 450 nm into photons having a peak maximum emission wavelength of about 470 nm, and a third chromophore may act to convert photons having peak maximum absorption wavelengths in the range of about 450 nm to about 480 nm into photons having peak maximum emission wavelengths of about 500 nm or more. Particular wavelength control may be selected based upon the chromophore(s) utilized.

In some embodiments, the wavelength conversion film further comprises one or multiple sensitizers. In some embodiments the sensitizer comprises nanoparticles, nanometals, nanowires, or carbon nanotubes. In some embodiments the sensitizer comprises a fullerene. In some embodiments the fullerene is selected from the group consisting of optionally substituted $C_{60}$, optionally substituted $C_{70}$, optionally substituted $C_{84}$, optionally substituted single-wall carbon nanotube, and optionally substituted multi-wall carbon nanotube. In some embodiments the fullerene is selected from the group consisting of [6,6]-phenyl-$C_{61}$-butyricacid-methylester, [6,6]-phenyl-$C_{71}$-butyricacid-methylester, and [6,6] -phenyl-$C_{85}$-butyricacid-methylester. In some embodiments the sensitizer is selected from the group consisting of optionally substituted phthalocyanine, optionally substituted perylene, optionally substituted porphyrin, and optionally substituted terrylene. In some embodiments the wavelength conversion layer of the structure further comprises a combination of sensitizers, wherein the combination of sensitizers is selected from the group consisting of optionally substituted fullerenes, optionally substituted phthalocyanines, optionally substituted perylenes, optionally substituted porphyrins, and optionally substituted terrylenes.

In some embodiments the wavelength conversion film comprises the sensitizer in an amount in the range of about 0.01% to about 5%, by weight based on the total weight of the composition.

In some embodiments the wavelength conversion film further comprises one or multiple plasticizers. In some embodiments, the plasticizer is selected from N-alkyl carbazole derivatives and triphenylamine derivatives.

An aspect of the invention provides a photovoltaic module for the conversion of solar light energy into electricity comprising at least one photovoltaic device or solar cell, and a wavelength conversion film described herein. The wavelength conversion film is incorporated on top of, or encapsulated into, a photovoltaic device or solar cell, such that the incident light passes through the wavelength conversion film prior to reaching the area of the module where the solar light energy is converted into electricity.

In some embodiments, additional materials may be used in the photovoltaic module, such as glass plates or polymer layers. The materials may be used to encapsulate the wavelength conversion film, or they may be used to protect or encapsulate both the solar cell and wavelength conversion film. In some embodiments, glass plates selected from low iron glass, borosilicate glass, or soda-lime glass, may be used in the module. In some embodiments of the module, the composition of the glass plate or polymer layers may also further comprise a strong UV absorber to block harmful high energy radiation into the solar cell.

In some embodiments, additional chromophores may be located in separate layers or sublayers within the photovoltaic module. For example, the wavelength conversion film comprises at least one UV absorbing chromophore and the at least one wavelength conversion chromophore, and an additional polymer sublayer in between the solar cell and the wavelength conversion film comprises an additional UV absorbing chromophore and/or an additional wavelength conversion chromophore.

Another aspect of the invention is a method for improving the performance of a photovoltaic device or solar cell comprising applying a wavelength conversion film directly onto the light incident side of the solar cell or photovoltaic device, as illustrated, for example, in Figure 1. In some embodiments, the wavelength conversion film is configured to encapsulate the at least one photovoltaic device such that incident light passes through the wavelength conversion film prior to reaching the at least one photovoltaic device. Another aspect of the invention, is a method for improving the performance of a photovoltaic device or solar cell, comprising incorporating a wavelength conversion film directly into the photovoltaic device or solar cell during fabrication, so that the wavelength conversion film is encapsulated between the photovoltaic device or solar cell and its cover substrate on the light incident side, as illustrated, for example, in Figure 2. In some embodiments, the method involves applying the wavelength conversion film directly to the at least one photovoltaic device, wherein the wavelength conversion film is configured to encapsulate the at least one photovoltaic device such that incident light passes through the wavelength conversion film prior to reaching the photovoltaic device.

In some embodiments the cover substrate is a glass plate. In some embodiments the cover substrate comprises a polymer material selected from the group consisting of polyethylene terephthalate, polymethyl methacrylate, polyvinyl butyral, ethylene vinyl acetate, ethylene tetrafluoroethylene, polyimide, polycarbonate, polystyrene, siloxane sol-gel, polyurethane, polyacrylate, and combinations thereof.

In some embodiments, the method involves using additional materials or layers such as glass sheets, edge sealing tape, frame materials, polymer materials, or adhesive layers to adhere additional layers to the system.

The wavelength conversion film can be constructed to be compatible with all different types and sizes of solar cells and solar panels, including Silicon based devices, III-V and II-VI PN junction devices, CIGS thin film devices, organic

sensitizer devices, organic thin film devices, CdS/CdTe thin film devices, dye sensitized devices, etc. Devices, such as an amorphous Silicon solar cell, a microcrystalline Silicon solar cell, and a crystalline Silicon solar cell, can also be improved.

In some embodiments of the module, additional materials or layers may be used such as edge sealing tape, frame materials, polymer materials, or adhesive layers to adhere additional layers to the system. In some embodiments, the module further comprises an additional polymer layer containing a UV absorber.

In some embodiments of the module, the composition of the wavelength conversion film further comprises an antioxidant which may act to prevent additional degradation of the chromophore compounds. In some embodiments, the thickness of the wavelength conversion film is between about 10 μm and about 2 mm.

In some embodiments, the module further comprises an adhesive layer. In some embodiments, an adhesive layer adheres the wavelength conversion film to the light incident surface of the solar cell. Various types of adhesives may be used. In some embodiments, the adhesive layer comprises a substance selected from the group consisting of rubber, acrylic, silicone, vinyl alkyl ether, polyester, polyamide, urethane, fluorine, epoxy, ethylene vinyl acetate, and combinations thereof. The adhesive can be permanent or non-permanent. In some embodiments, the thickness of the adhesive layer is between about 1 μm and 100 μm. In some embodiments, the refractive index of the adhesive layer is in the range of about 1.4 to about 1.7.

Other layers may also be included to further enhance the photoelectric conversion efficiency of solar modules. For example, the module may additionally have a microstructured layer, which is designed to further enhance the solar harvesting efficiency of solar modules by decreasing the loss of photons to the environment which are often re-emitted from the chromophore after absorption and wavelength conversion in a direction that is away from the photoelectric conversion layer of the solar module device (see U.S. Provisional Patent Application No. 61/555,799). A layer with various microstructures on the surface (i.e. pyramids or cones) may increase internal reflection and refraction of the photons into the photoelectric conversion layer of the device, further enhancing the solar harvesting efficiency of the device.

In some embodiments the wavelength conversion film of the module comprising a wavelength conversion film, and at least one solar cell or photovoltaic device, wherein the wavelength conversion film comprises at least one UV absorbing chromophore, at least one wavelength conversion chromophore, and an optically transparent polymer matrix, is formed by first synthesizing a UV absorbing chromophore/wavelength conversion chromophore/polymer solution in the form of a liquid or gel, applying the UV absorbing chromophore/wavelength conversion/polymer solution to a glass plate using standard methods of application, such as spin coating or drop casting, then curing the chromophore/polymer solution to a solid form (i.e. heat treating, UV exposure, etc.) as is determined by the formulation design. Once dry, the film can then be adhered to the light incident surface of a solar cell.

In some embodiments, the wavelength conversion film of the module comprising a wavelength conversion film, and at least one solar cell or photovoltaic device, is formed by first synthesizing a UV absorbing chromophore/wavelength conversion/polymer thin film, and then adhering the UV absorbing chromophore/wavelength conversion/polymer thin film to the light incident surface of a solar cell using an optically transparent and photostable adhesive and/or laminator.

In some embodiments, the wavelength conversion film 100 is directly attached onto the light incident surface 102 of a solar cell 103, as shown in Figure 1.

In some embodiments, the module further comprises a refractive index matching substance. In some embodiments, the refractive index matching substance comprises a liquid or optical adhesive. In some embodiments, the index matching substance 101 is applied between the wavelength conversion film and the front substrate of the solar cell to ensure better light out-coupling efficiency. In some embodiments the refractive index matching liquid used is a Series A mineral oil comprising aliphatic and alicyclic hydrocarbons, and hydrogenated terphenyl from Cargille-Sacher Labratories, Inc.

In some embodiments, the wavelength conversion film 100 is directly applied as the encapsulation layer during solar cell fabrication, as shown in Figure 2. This configuration is possible due to the excellent photostability of the wavelength conversion film disclosed herein. The wavelength conversion film 100 is encapsulated between the solar cell module 103 and its front cover substrate 102.

The module comprising a wavelength conversion film, and at least one solar cell or photovoltaic device, as disclosed herein, is applicable for all different types of solar cell devices. Devices, such as a Silicon based device, a III-V or II-VI PN junction device, a Copper-Indium-Gallium-Selenium (CIGS) thin film device, an organic sensitizer device, an organic thin film device, or a Cadmium Sulfide/Cadmium Telluride (CdS/CdTe) thin film device, can be improved. In some embodiments, the module comprises at least one photovoltaic device or solar cell comprising a Cadmium Sulfide/Cadmium Telluride solar cell. In some embodiments, the photovoltaic device or solar cell comprises a Copper Indium Gallium Diselenide solar cell. In some embodiments, the photovoltaic or solar cell comprises a III-V or II-VI PN junction device. In some embodiments, the photovoltaic or solar cell comprises an organic sensitizer device. In some embodiments, the photovoltaic or solar cell comprises an organic thin film device. In some embodiments, the photovoltaic device or solar cell comprises an amorphous Silicon (a-Si) solar cell. In some embodiments, the photovoltaic device or

solar cell comprises a microcrystalline Silicon (μc-Si) solar cell. In some embodiments, the photovoltaic device or solar cell comprises a crystalline Silicon (c-Si) solar cell.

In some embodiments, the solar cell efficiency enhancement is measured first with no wavelength conversion film and then with a wavelength conversion film under one sun irradiation (AM1.5G) by using a Newport solar simulator system. The efficiency enhancement of the CdS/CdTe solar cell is determined by the equation below:

$$\text{Efficiency Enhancement}=(\eta_{cell+film}-\eta_{cell})/\eta_{cell}*100\%$$

In some embodiments, a CdS/CdTe solar cell is modified with a wavelength conversion film according to the method disclosed herein, and the efficiency enhancement is determined to be greater than 5%. In some embodiments, a CdS/CdTe solar cell is modified with a wavelength conversion film and the efficiency enhancement is determined to be greater than 10%. In some embodiments, a CdS/CdTe solar cell is modified with a wavelength conversion film and the efficiency enhancement is determined to be greater than 13%. In some embodiments, a CdS/CdTe solar cell is modified with a wavelength conversion film and the efficiency enhancement is determined to be greater than 14%. In some embodiments, a CdS/CdTe solar cell is modified with a wavelength conversion film and the efficiency enhancement is determined to be greater than 15%.

In some embodiments, a wavelength conversion film comprises an optically transparent polymer matrix and two or more chromophores. In some embodiments, the film can be fabricated by (i) preparing a polymer solution with dissolved polymer powder in a solvent, such as cyclopentanone, dioxane, tetrachloroethylene (TCE), etc., at a predetermined ratio; (ii) preparing a chromophore containing a polymer mixture by mixing the polymer solution with the two or more chromophores at a predetermined weight ratio to obtain a chromophore-containing polymer solution, (iii) forming the chromophore/polymer thin film by directly casting the chromophore-containing polymer solution onto a glass substrate, then heat treating the substrate from room temperature up to 100°C in 2 hours, completely removing the remaining solvent by further vacuum heating at 130°C overnight, and (iv) peeling off the chromophore/polymer thin film under the water and then drying out the free-standing polymer film before use; (v) the film thickness can be controlled from 0.1μm~1mm by varying the chromophore/polymer solution concentration and evaporation speed.

Greenhouse Applications

Additional uses for wavelength conversion films include greenhouse roofing materials. Plants use the energy in sunlight to convert carbon dioxide from the atmosphere and water into simple sugars. Plants then use these sugars as structural building blocks. Sugars form the main structural component of the plant. It is understood that plants react differently to the intensity and wavelengths of the light during their development. As described in U.S Patent Application No. 2011/0016779, improved plant growth is achieved using light in the violet-blue region and in the orange-red region. Light in the green region is usually not used by the plant (and is often reflected by the leaves).

In some instances, photovoltaic devices (e.g. solar cells) have been incorporated into greenhouse roofing materials to convert incident solar radiation to electricity. This electricity is then used for other applications within the greenhouse system. While the utilization of solar energy offers a promising alternative energy source, the use of photovoltaic modules lowers the amount of available light for the plant species.

A significant amount of development effort is ongoing to find greenhouse roofing materials with photovoltaic devices which provide sufficient electrical generation efficiency and the desired plant growth for an acceptable cost. For instance, as disclosed in U.S. Patent 6135665, a polymer sheeting comprising an inorganic luminescent material, yttrium-europium, is described for use in greenhouses. However, the cost to synthesize these inorganic luminescent compounds is considerably higher than the cost to synthesize organic luminescent compounds, and therefore may not be feasible. As described in U.S. Patent Application No 2011/0016779, the use of greenhouse roofing materials which incorporate organic luminescent dyes has not been possible due to the poor photostability of these dyes, with the known commercially available dyes exhibiting photobleaching typically within days of exposure to solar radiation.

The use of a luminescent dye in greenhouse roofing materials, has typically comprised down-shifting dyes, which causes the shorter wavelength light to become excited and re-emitted within the luminescent panel at a longer (higher) more favorable wavelength. It is well established that plant species growth occurs with the exposure of the plant to blue light and red light. Typically, plants do not use green light, and either absorb this light as heat, or reflect it away. Additionally, the UV portion of the spectrum is not only not used by most plant species, but is usually quite harmful to the plant. Elimination of the UV portion of light is often done by incorporating a UV absorber into the roofing material to absorb all of the UV radiation, effectively removing it from the spectrum that reaches the plant inside the greenhouse. Because UV is so harmful to plant species, blocking the UV portion of light may enhance plant growth. However, this solar energy is then lost to the environment as heat. Previous attempts to further enhance plant growth have incorporated a luminescent dye into greenhouse roofing panels which converts green light into red light, basically increasing the

usuable solar energy that is directed to the plant. The conversion and use of the UV wavelengths of light for greenhouses has not been reported.

In some embodiments of the present invention, organic photostable chromophores that can convert UV energy into blue light have been found to further enhance plant growth by further increasing the amount of usuable light available to the plant.

Some embodiments of the present invention relate to luminescent panels comprising organic photostable chromophore compounds. The luminescent panel is useful as a greenhouse roof to provide improved wavelength profiles and plant growth compared to panels that do not incorporate organic photostable chromophore compounds. The chromophore compounds comprise a first organic photostable chromophore (A), which has an wavelength absorbance maximum in the UV wavelength range and has an wavelength emission maximum in the blue wavelength range, and a second organic photostable chromophore (B), which has an wavelength absorbance maximum in the green wavelength range and has an wavelength emission maximum in the red wavelength range. The two chromophores may be mixed in the same wavelength conversion layer, or they may be in separate layers. In some embodiments, a luminescent solar collection panel may be formed by incorporating at least one solar energy conversion device into the luminescent panel. The present disclosure relates to luminescent panels for greenhouse roof material. In some embodiments, the luminescent panel comprises at least one organic photostable chromophore compound. In some embodiments, the luminescent panel comprises a mixture of at least two organic photostable chromophore compounds. In some embodiments, the luminescent panel is useful as a greenhouse roof to provide improved plant growth compared to panels that do not incorporate luminescent chromophores that are photostable for long periods of time. In some embodiments, in embodiments with at least two chromophore compounds, the chromophore compounds comprise a first organic photostable chromophore (A), which has an wavelength absorbance maximum in the UV wavelength range and has an wavelength emission maximum in the blue wavelength range, and a second organic photostable chromophore (B), which has an wavelength absorbance maximum in the green wavelength range and has an wavelength emission maximum in the red wavelength range. In some embodiments, the two chromophores may be mixed in the same wavelength conversion layer. In some embodiments, when more than one wavelength conversion layer is present, the two chromophores may be in different wavelength conversion layers. In some embodiments, the at least one wavelength conversion layer further comprises a polymer matrix.

In some embodiments, it may be desirable to use chromophores in which the absorption and emission spectrums do not overlap. This helps to minimize re-absorption of photons, and improves efficiency. For instance, in some embodiments, the emission spectrum of (A) and the absorption spectrum of (B) have minimal overlap. In some embodiments, minimal overlap is an overlap ranging from about 0% to about 3%, from about 3% to about 5%, from about 5% to about 10%, from about 10% to about 15%, from about 15% to about 25%, or from about 25% to about 35%, where the percent overlap is a measure of the area under the portion of overlapping spectra divided by the area under either the emission or absorption curve. In some embodiments, minimal overlap is less than about 35%, 30%, 25%, 20%, 15%, 10%, 5%, 3%, 2%, or 1%.

There is no limit to the number of chromophores that can be used in the luminescent panel. In some embodiments, the two chromophores (A) and (B) are mixed into one wavelength conversion layer. In some embodiments, the two chromophores (A) and (B) are located in separate wavelength conversion layer(s). In some embodiments, additional chromophores may be incorporated into the luminescent panel to provide the desired properties. In some embodiments, the chromophores utilized in the luminescent panel may be tailored to provide specific emission spectrums which are optimal to the specific plant species that is to be grown within the greenhouse. In some embodiments, the wavelength conversion layer(s) comprises three or more chromophores. In some embodiments, the wavelength conversion layer(s) comprises four or more chromophores. In some embodiments, the wavelength conversion layer(s) comprises five or more chromophores.

There is also no requirement on the location in which the chromophores may be placed in the luminescent panel with respect to the incident solar light. In some embodiments, chromophore (A) may be in a wavelength conversion layer that receives the incident solar energy before the wavelength conversion layer comprising chromophore (B). In some embodiments, chromophore (B) may be in a wavelength conversion layer that receives the incident solar energy before the wavelength conversion layer comprising chromophore (A). In some embodiments, it may be desirable to have the wavelength conversion layer comprising chromophore (A) receive the solar energy first. In some embodiments, chromophore (A) acts to convert UV wavelengths to blue wavelengths. Chromophore compounds often degrade much faster when exposed to UV wavelengths. Therefore, by having the wavelength conversion layer comprising chromophore (A) exposed to the incident solar radiation first, much of the UV light can be converted to blue light, and the underlying layers will not be exposed to the UV light. This conversion of UV light effectively increases the stability of the wavelength conversion layer comprising chromophore (B) by reducing the exposure of this layer to UV radiation. Therefore, in some embodiments, the wavelength conversion layers are placed in ascending order of their wavelength absorption properties.

In some embodiments, the luminescent panel may further comprise glass or polymer layers. The glass or polymer layers may act to protect the wavelength conversion layer or layers. The glass or polymer layers may also act

as a substrate with which to adhere the wavelength conversion layer or layers onto.

In some embodiments of the luminescent panel, the wavelength conversion layer or layers may be sandwiched in between glass or polymer plates, wherein the glass or polymer plates may act to protect the wavelength conversion layer or layers from moisture or oxygen penetration.

In some embodiments of the luminescent panel, the polymer matrix of the wavelength conversion layer or layers is independently formed from a substance selected from the group consisting of polyethylene terephthalate, polymethyl methacrylate, polyvinyl butyral, ethylene vinyl acetate, ethylene tetrafluoroethylene, polyimide, amorphous polycarbonate, polystyrene, siloxane sol-gel, polyurethane, polyacrylate, and combinations thereof.

In some embodiments of the luminescent panel, the polymer matrix of the wavelength conversion layer or layers may be made of one host polymer, a host polymer and a co-polymer, or multiple polymers.

In some embodiments, the polymer matrix material used in the wavelength conversion layer or layers has a refractive index in the range of about 1.40 to about 1.70. In some embodiments, the refractive index of the polymer matrix material used in the wavelength conversion layer is in the range of about 1.45 to about 1.55. In some embodiments, the refractive index of the polymer matrix material used in the wavelength conversion layer or layers is in the range of about 1.45 to about 1.55, from about 1.40 to about 1.50, from about 1.50 to about 1.60, or from about 1.60 to about 1.70.

In some embodiments, the wavelength conversion layer comprises an optically transparent polymer matrix and at least one of chromophore (A) or chromophore (B). In some embodiments, a wavelength conversion layer can be fabricated by (i) preparing a polymer solution with dissolved polymer powder in a solvent, such as cyclopentanone, dioxane, tetrachloroethylene (TCE), etc., at a predetermined ratio; (ii) preparing a chromophore containing a polymer mixture by mixing the polymer solution with the one or more chromophores at a predetermined weight ratio to obtain a chromophore-containing polymer solution, (iii) forming the chromophore/polymer thin film by directly casting the chromophore-containing polymer solution onto a glass substrate, then heat treating the substrate from room temperature up to 100°C in 2 hours, completely removing the remaining solvent by further vacuum heating at 130°C overnight, and (iv) peeling off the chromophore/polymer thin film under the water and then drying out the free-standing polymer film before use; (v) the film thickness can be controlled from 0.1μm~1mm by varying the chromophore/polymer solution concentration and evaporation speed.

In some embodiments, the composition of the at least one wavelength conversion layer further comprises an antioxidant which may act to prevent additional degradation of the chromophore compounds.

In some embodiments, additional materials may be used in the luminescent panel, such as glass plates, polymer layers, or reflective mirror layers. The materials may be used to encapsulate the wavelength conversion layer or layers, or they may be used to protect or encapsulate the wavelength conversion layer(s). In some embodiments, glass plates selected from low iron glass, borosilicate glass, or soda-lime glass, may be used in the luminescent panel. In some embodiments, the composition of the glass plate or polymer layers may also further comprise a strong UV absorber to block harmful high energy radiation into the panel. The UV absorber in the glass plates or polymer layers may also block harmful high energy radiation from the wavelength conversion layer, thus improving the lifetime of the wavelength conversion layer(s).

A chromophore with improved lifetime is one for which the length of time it takes for 50% of the original chromophore to degrade has been increased by greater than about 50%, 100%, 200%, or 300%. For instance, if a chromophore typically degraded such that 50% of the chromophore remained after 10 days, a 100% increase in the lifetime of the chromophore would mean that the chromophore took 20 days to degrade to 50%. That degradation rate slowing would constitute an improved lifetime.

In another embodiment, the luminescent solar collection panel comprises the luminescent panel, as disclosed herein, and at least one solar energy conversion device. The luminescent solar collection panel is useful as a greenhouse roof to simultaneously provide improved plant growth and an increase in solar harvesting efficiency compared to panels that do not incorporate two luminescent materials, and it is photostable for long periods of time. In some embodiments, the at least one solar energy conversion device is encapsulated within the luminescent panel such that the device is not exposed to the outside environment, and wherein the solar energy conversion device receives a portion of the solar energy and converts that energy into electricity.

In some embodiments of the luminescent panel, additional materials or layers may be used such as edge sealing tape, frame materials, polymer materials, or adhesive layers to adhere additional layers to the system. In some embodiments, the luminescent panel further comprises an additional polymer layer containing a UV absorber. In some embodiments, the UV absorber may be selected to absorb UV wavelengths that are not absorbed by the chromophore (A). By doing this, the UV wavelengths which can be converted to useable blue light by the chromophore (A) will be converted, while the UV wavelengths that cannot be converted by chromophore (A) will be absorbed by the UV absorber, so that these harmful wavelengths do not reach the plants inside the greenhouse.

Figure 3 illustrates an embodiment of a luminescent panel 104 comprising a first organic photostable chromophore (A) 105, and a second organic photostable chromophore (B) 106, wherein (A) 105 and (B) 106 are mixed within a wavelength conversion layer 100, and wherein said wavelength conversion layer 100 comprises a polymer matrix. In

some embodiments, (A) 105 has an absorption peak maximum in the UV region of the electromagnetic spectrum 107 and has an emission peak maximum in the blue region of the electromagnetic spectrum 108. As used herein, a colored region of the electromagnetic spectrum refers to the visible light region of the electromagnetic spectrum. In some embodiments, (B) 106 has an absorption peak maximum in the green region of the electromagnetic spectrum 109 and has a emission peak maximum in the red region of the electromagnetic spectrum 110.

In some embodiments, the luminescent light and energy collection panel comprises at least one solar energy conversion device. The luminescent light and energy collection panel is useful as a greenhouse roof to simultaneously provide improved plant growth and to allow solar energy harvesting. In some embodiments, the at least one solar energy conversion device is encapsulated within the luminescent panel such that the device is not exposed to the outside environment, and wherein the solar energy conversion device receives a portion of the solar energy and converts that energy into electricity.

One issue with incorporating luminescent materials into greenhouse roofing panels is that the incident photons, once absorbed and re-emitted by the luminescent material, often become trapped within the polymer matrix of the panel, and never reach the plant species inside the greenhouse. For greenhouse panels with luminescent materials which do not also comprise a solar cell or photovoltaic module, this trapped light is usually dissipated as heat. One advantage of incorporating solar energy conversion devices into the greenhouse roofing panels that have luminescent materials is that most of this trapped light will be absorbed by the solar energy conversion device, and converted into electricity, so that very little light is wasted.

Simultaneously, the incorporation of solar energy conversion devices into the panel provides sufficient electricity generation by converting a portion of the solar energy into electricity. Various designs can be used to incorporate solar cells into the luminescent panel to form a luminescent light and energy collection panel, depending on the electricity generation that is desired and the amount of photons that are needed to reach the plant species. When solar energy conversion devices are incorporated into greenhouse roofing panels, the solar energy conversion device competes with the plants for the incident solar radiation. The solar energy conversion device is opaque, and will block the incident solar radiation. So if too much of the greenhouse roofing panel has solar energy conversion devices incorporated, the solar energy reaching the plants inside the greenhouse may be too low. In some embodiments, the amount of solar energy conversion devices incorporated into the luminescent light and energy collection panel may be tailored to meet the solar radiation requirements of the plants within the greenhouse. In some embodiments, different portions of the greenhouse may comprise different densities of solar energy conversion devices within the luminescent light and energy collection panels. For instance, the north side of a greenhouse roof may incorporate more solar energy conversion devices in the luminescent light and energy collection panels compared to the south side of the greenhouse. Adjustments may be made based on the location of the greenhouse.

There is no restriction on the placement of the solar energy conversion device within the luminescent panel. In some embodiments, the solar energy conversion device may be incorporated into one of the wavelength conversion layers of the luminescent panel. In some embodiments, the solar energy conversion device may be incorporated in between the wavelength conversion layer or layers and another polymer or glass layer of the luminescent panel. In some embodiments, the placement of the solar energy conversion device in the luminescent panel may be designated based on the type of solar energy conversion device. For instance, in some embodiments, the solar energy conversion devices which degrade quickly with exposure to UV radiation may be placed in the luminescent panel such that the wavelength conversion layer comprising chromophore (A) has an absorption peak maximum in the UV region of the electromagnetic spectrum and has an emission peak maximum in the blue region of the electromagnetic spectrum, so that these harmful UV photons are converted to longer wavelength photons before they reach the solar energy conversion device, effectively protecting the solar energy conversion device from receiving UV radiation.

Different types of solar cells often utilize different wavelengths of photons differently. For example, some Silicon based devices are more efficient at converting higher wavelength photons into electricity, while CdTe based solar cells may be more efficient at converting photons in the orange and red spectrum into electricity. Therefore, the solar energy conversion device may also be placed within a wavelength conversion layer that re-emits radiation at the optimal wavelength for the solar energy conversion device to convert photons into electricity. For instance, silicon based solar cells which exhibit their maximum electrical conversion rates with blue photons, would be placed in the luminescent panel at a position that would allow the silicon solar cell to capture mostly blue photons. The optimal electrical conversion rates vary with different types of solar cells. Therefore, in some embodiments, the solar energy conversion device may be placed within the luminescent panel at a position that maximizes the capture of the optimal wavelength photons for that particular solar energy conversion device.

The luminescent light and energy collection panel is compatible with all different types of solar energy conversion devices. Therefore, in some embodiments, the luminescent light and energy collection panel can be constructed to be compatible with all different types and sizes of solar cells and solar panels, including Silicon based devices, III-V and II-VI PN junction devices, CIGS thin film devices, organic sensitizer devices, organic thin film devices, CdS/CdTe thin film devices, dye sensitized devices, etc. Devices, such as an amorphous Silicon solar cell, a microcrystalline Silicon solar

cell, and a crystalline Silicon solar cell, can also be utilized. In some embodiments, the solar energy conversion device comprises at least one photovoltaic device or solar cell comprising a Cadmium Sulfide/Cadmium Telluride solar cell. In some embodiments, the solar energy conversion device comprises a Copper Indium Gallium Diselenide solar cell. In some embodiments, the solar energy conversion device comprises a III-V or II-VI PN junction device. In some embodiments, the solar energy conversion device comprises an organic sensitizer device. In some embodiments, the solar energy conversion device comprises an organic thin film device. In some embodiments, the solar energy conversion device comprises an amorphous Silicon (a-Si) solar cell. In some embodiments, the solar energy conversion device comprises a microcrystalline Silicon (μc-Si) solar cell. In some embodiments, the solar energy conversion device comprises a crystalline Silicon (c-Si) solar cell.

In some embodiments of the luminescent light and energy collection panel, multiple types of photovoltaic devices may be used within the panel and may be independently selected and incorporated into the luminescent panel according to the emission wavelength of the wavelength conversion layer, to provide the highest possible photoelectric conversion efficiency. Additionally, a mixture of chromophores in the wavelength conversion layer may be selected such that the emission spectrum of the wavelength conversion layer is optimized for a particular photovoltaic or solar cell device, provided that the light reaching the plants inside the greenhouse comprises blue and red wavelengths.

In some embodiments, the luminescent light and energy collection panel further comprises a refractive index matching liquid that is used to attach the layers within the luminescent panel to the light incident surface of the photovoltaic device or solar cell. In some embodiments the refractive index matching liquid used is a Series A mineral oil comprising aliphatic and alicyclic hydrocarbons, and hydrogenated terphenyl from Cargille-Sacher Labratories, Inc.

In some embodiments, as shown in Figure 3, the re-emitted photons may become trapped by internal reflection 111 within the luminescent panel. This internally reflected portion of the spectrum can be harvested in a photovoltaic device to produce useable electricity.

Figure 4 illustrates an embodiment of a luminescent panel 104 comprising a first organic photostable chromophore (A) 105, and a second organic photostable chromophore (B) 106, wherein (A) 105 is located in a first wavelength conversion layer 100' and (B) 106 is located in a second wavelength conversion layer 100". In some embodiments, not pictured, (B) 106 is located in the first wavelength conversion layer 100' and (A) 105 is located in the second wavelength conversion layer 100". In some embodiments, each wavelength conversion layer independently comprises a polymer matrix. In some embodiments, (A) 105 has an absorption peak maximum in the UV region of the electromagnetic spectrum 107 and has an emission peak maximum in the blue region of the electromagnetic spectrum 108 and (B) 106 has an absorption peak maximum in the green region of the electromagnetic spectrum 109 and has an emission peak maximum in the red region of the electromagnetic spectrum 110. In some embodiments, the re-emitted photons may become trapped by internal reflection 111 and are transported to a solar cell.

In some embodiments, the luminescent light and energy collection panel 104 further comprises one or more adhesive layers. In some embodiments, the one or more adhesive layers adhere the wavelength conversion layer or layers together. In some embodiments, the adhesive film may adhere the solar energy conversion device to any of the various layers within the luminescent panel. Various types of adhesives may be used. In some embodiments, the adhesive layer or layers independently comprises a substance selected from the group consisting of rubber, acrylic, silicone, vinyl alkyl ether, polyester, polyamide, urethane, fluorine, epoxy, ethylene vinyl acetate, and combinations thereof. The adhesive can be permanent or non-permanent. In some embodiments, the thickness of the adhesive layer is between about 1 μm and 100 μm. In some embodiments, the refractive index of the adhesive layer is in the range of about 1.40 to about 1.70.

Figure 5 illustrates an embodiment of a luminescent panel 104 comprising a first organic photostable chromophore (A) 105 is located in a first wavelength conversion layer 100' and (B) 106 is located in a second wavelength conversion layer 100" and further comprising a glass or polymer plate 112. As discussed above, these layers 100', 100", 112 may be adhered to one another using adhesive layers. Also, as above, each of said wavelength conversion layers 100', 100" may independently comprise a polymer matrix wherein (A) 105 has an absorption peak maximum in the UV region of the electromagnetic spectrum 107 and has an emission peak maximum in the blue region of the electromagnetic spectrum 108, and wherein (B) 106 has an absorption peak maximum in the green region of the electromagnetic spectrum 109 and has an emission peak maximum in the red region of the electromagnetic spectrum 110. In some embodiments, the re-emitted photons may become trapped by internal reflection 111 within the luminescent panel. This internally reflected portion of the spectrum can be harvested in a photovoltaic device to produce useable electricity. The glass or polymer plate 112 can be used to increase the efficiency of reflection and refraction within the luminescent panel 104 to increase the amount of light harvested by the photovoltaic.

Other layers may also be included to further enhance the photoelectric conversion efficiency of luminescent solar collection panel. For example, the luminescent solar collection panel may additionally have at least one microstructured layer, which is designed to further enhance the solar harvesting efficiency of solar modules by decreasing the loss of photons to the environment (see U.S. Provisional Patent Application No. 61/555,799). A layer with various microstructures on the surface (i.e. pyramids or cones) may increase internal reflection and refraction of the photons

into the photoelectric conversion layer of the solar cell, further enhancing the solar harvesting efficiency of the device. As above, these layers may be adhered to each other using an adhesive layer.

In some embodiments, the wavelength conversion layer of the luminescent light and energy collection panel comprising at least one wavelength conversion layer, and at least two organic photostable chromophores, and wherein the wavelength conversion layer or layers further comprises optically transparent polymer matrix, is formed by first synthesizing the chromophore/polymer solution in the form of a liquid or gel, applying the chromophore/polymer solution to a glass or polymer plate using standard methods of application, such as spin coating or drop casting, then curing the chromophore/polymer solution to a solid form (i.e. heat treating, UV exposure, etc.) as is determined by the formulation design. Once dry, the film can then be used in the luminescent light and energy collection panel in a variety of structures.

Figure 7 illustrates an embodiment of a luminescent light and energy collection panel comprising a luminescent panel 104 and at least one solar energy conversion device 103. The luminescent panel comprises a first organic photostable chromophore (A) 105 is located in a first wavelength conversion layer 100’ and (B) 106 is located in a second wavelength conversion layer 100". In some embodiments, each of the wavelength conversion layers 100’, 100" independently further comprises a polymer matrix, and wherein (A) 105 has an absorption peak maximum in the UV region of the electromagnetic spectrum 107 and has an emission peak maximum in the blue region of the electromagnetic spectrum 108, and wherein (B) 106 has an absorption peak maximum in the green region of the electromagnetic spectrum 109 and has an emission peak maximum in the red region of the electromagnetic spectrum 110. In some embodiments, the re-emitted photons may become trapped by internal reflection 111 within the luminescent panel, wherein these trapped photons may be absorbed by the solar energy conversion device 103. In some embodiments, the luminescent panel further comprises glass or polymer plates 112.

Solar energy conversion devices utilizing different types of light incident surfaces may be used. For instance, some solar energy conversion devices are dual sided, and may receive radiation from two sides. Some solar energy conversion devices may only receive radiation on one side. In some embodiments of the luminescent light and energy collection panel, a dual sided solar energy conversion device is used such that it may receive direct incident solar radiation on one of its sides, and it may also receive indirect radiation from internal reflection within the luminescent panel on two of its sides. In some embodiments of the luminescent light and energy collection panel, a single sided solar energy conversion device is used and is positioned within the luminescent light and energy collection panel such that it receives direct incident solar radiation on its one side, and may also receive indirect radiation from internal reflection within the luminescent panel on its one side. It may be desirable to position the solar energy conversion device upside down, such that the light incident side of the solar energy conversion device is facing away from the sun. When the solar energy conversion device is upside down, it cannot receive direct solar radiation, which limits the radiation that will be converted into energy to that of the photons which become trapped within the luminescent panel and are internally reflected and refracted until they reach the solar energy conversion device. This helps to alleviate the competition between the plants and the solar cells. It also protects the solar cells from direct sunlight, which may increase their lifetime by decreasing the amount of UV radiation exposure. Therefore, in some embodiments of the luminescent light and energy collection panel, a single sided solar energy conversion device is used and is positioned within the luminescent light and energy collection panel such that it cannot receive direct incident solar radiation on its one side, and may only receive indirect radiation from internal reflection within the luminescent panel on its one side.

In some embodiments, as shown in Figure 7, the solar energy conversion device 103 may be dual sided or single sided, and may be positioned to receive both direct and indirect photons, or it may be positioned to receive only indirect photons.

Figure 8 illustrates an embodiment of a luminescent light and energy collection panel comprising a luminescent panel 104 and at least one solar energy conversion device 103. The luminescent panel comprises a first organic photostable chromophore (A) 105 is located in a first wavelength conversion layer 100’ and (B) 106 is located in a second wavelength conversion layer 100". In some embodiments, each of the wavelength conversion layers 100’, 100" independently further comprises a polymer matrix, and wherein (A) 105 has an absorption peak maximum in the UV region of the electromagnetic spectrum 107 and has an emission peak maximum in the blue region of the electromagnetic spectrum 108, and wherein (B) 106 has an absorption peak maximum in the green region of the electromagnetic spectrum 109 and has an emission peak maximum in the blue region of the electromagnetic spectrum 110. In some embodiments, the re-emitted photons may become trapped by internal reflection 111 within the luminescent panel, wherein these trapped photons may be absorbed by the solar energy conversion device 103. In some embodiments, the solar energy conversion device 103 may be dual sided or single sided, and may be positioned to receive both direct and indirect photons, or it may be positioned to receive only indirect photons. In some embodiments, the luminescent panel further comprises a glass or polymer plate 112.

Figure 9 illustrates an embodiment of a luminescent light and energy collection panel comprising a luminescent panel 104 and at least one solar energy conversion device 103. The luminescent panel 104 comprises a first organic photostable chromophore (A) 105 is located in a first wavelength conversion layer 100’ and (B) 106 is located in a second wavelength conversion layer 100". In some embodiments, each of the wavelength conversion layers 100’, 100" independently further comprises a polymer matrix. In some embodiments, (A) 105 has an absorption peak maximum in the UV region of the electromagnetic spectrum 107 and has an emission peak maximum in the blue region of the electromagnetic spectrum 108. In some embodiments, (B) 106 has an absorption peak maximum in the green region of the electromagnetic spectrum 109 and has an emission peak maximum in the red region of the electromagnetic spectrum 110. In some embodiments, the re-emitted photons 108, 110 may become trapped by internal reflection 111 within the luminescent panel, wherein these trapped photons may be absorbed by the solar energy conversion device 103. In some embodiments, the solar energy conversion device 103 may be dual sided or single sided, and may be positioned to receive both direct and indirect photons, or it may be positioned to receive only indirect photons. In some embodiments, the luminescent panel further comprises a glass or polymer plate 112.

Figure 10 illustrates an embodiment of a luminescent light and energy collection panel comprising a luminescent panel 104 and at least one solar energy conversion device 103. The luminescent panel comprises a first organic photostable chromophore (A) 105, and a second organic photostable chromophore (B) 106, wherein (A) 105 and (B) 106 are mixed within the same wavelength conversion layer 100. In some embodiments, the wavelength conversion layer comprises a polymer matrix and (A) 105 has an absorption peak maximum in the UV region of the electromagnetic spectrum 107 and has an emission peak maximum in the blue region of the electromagnetic spectrum 108. In some embodiments, (B) 106 has an absorption peak maximum in the green region of the electromagnetic spectrum 109 and has an emission peak maximum in the red region of the electromagnetic spectrum 110. In some embodiments, the re-emitted photons may become trapped by internal reflection 111 within the luminescent panel 104 and these trapped photons may be absorbed by the solar energy conversion device 103. In some embodiments, the solar energy conversion device 103 may be dual sided or single sided, and may be positioned to receive both direct and indirect photons, or it may be positioned to receive only indirect photons. In some embodiments, the luminescent panel further comprises a glass or polymer plate 112.

In some embodiments, a method for increasing the growth rate of plants is provided. In some embodiments, wherein the growth rate of a plant that is exposed to light that has been filtered using the luminescent panels described above, is increased by about 0 to about 5%, about 5% to about 10%, about 10% to about 20%, about 20% to about 30% about 30% to about 40%, about 40% to about 50%, about 50% to about 60%, about 60% to about 70%, about 70% to about 100%, or over about 100%, values in between or otherwise, relative to a plant not exposed to light that has been filtered.

Some embodiments pertain to a method for increasing the growth rate of a plant comprising exposing a plant to light that has been filtered through the luminescent panel as described above or below.

Some embodiments pertain to method for increasing the growth rate of a plant comprising exposing a plant to light that has been filtered through the luminescent panel as described above or below, wherein the luminescent panel further comprises a photovoltaic.

In some embodiments, the growth rate using the luminescent panels described herein is increased in the range from about 1% to about 40%, about 5% to about 30%, about 10% to about 25%, or about 15% to about 20% relative to a plant receiving light filtered through a conventional greenhouse panel. In some embodiments, the plant growth rate is increased by more than about 40%, 30%, 25%, 20%, 15%, 10%, 5%, or about 1% relative to a plant receiving light filtered through a conventional greenhouse panel..

Some embodiments pertain to a method for increasing the fruit yield of a plant comprising exposing a plant to light that has been filtered through the luminescent panel and/or energy collection panel as described above or below. In some embodiments, the fruit yield is increased by an amount in the range from about 1% to about 40%, about 5% to about 30%, about 10% to about 25%, or about 15% to about 20% relative to a plant receiving light filtered through a conventional greenhouse panel. In some embodiments, the plant fruit yield is increased by more than about 40%, 30%, 25%, 20%, 15%, 10%, 5%, or about 1% relative to a plant receiving light filtered through a conventional greenhouse panel.

Some embodiments pertain to a greenhouse panel comprising at least one wavelength conversion layer comprising, a light absorbing surface wherein the light absorbing surface is configured to absorb incident photons, a second organic photostable chromophore having an absorption maximum in the range from about 480 nm to about 620 nm and an emission maximum in the range range from about 550 nm to about 800 nm.

For purposes of summarizing aspects of the invention and the advantages achieved over the related art, certain objects and advantages of the invention are described in this disclosure. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein. Further aspects, features and advantages of this invention will become apparent from the examples which follow.

EXAMPLES

PHOTOVOLTAIC APPLICATION

Synthesis of Chromophore Compounds

Compound 1A

Synthesis of Compound 1A was performed according to the following scheme:

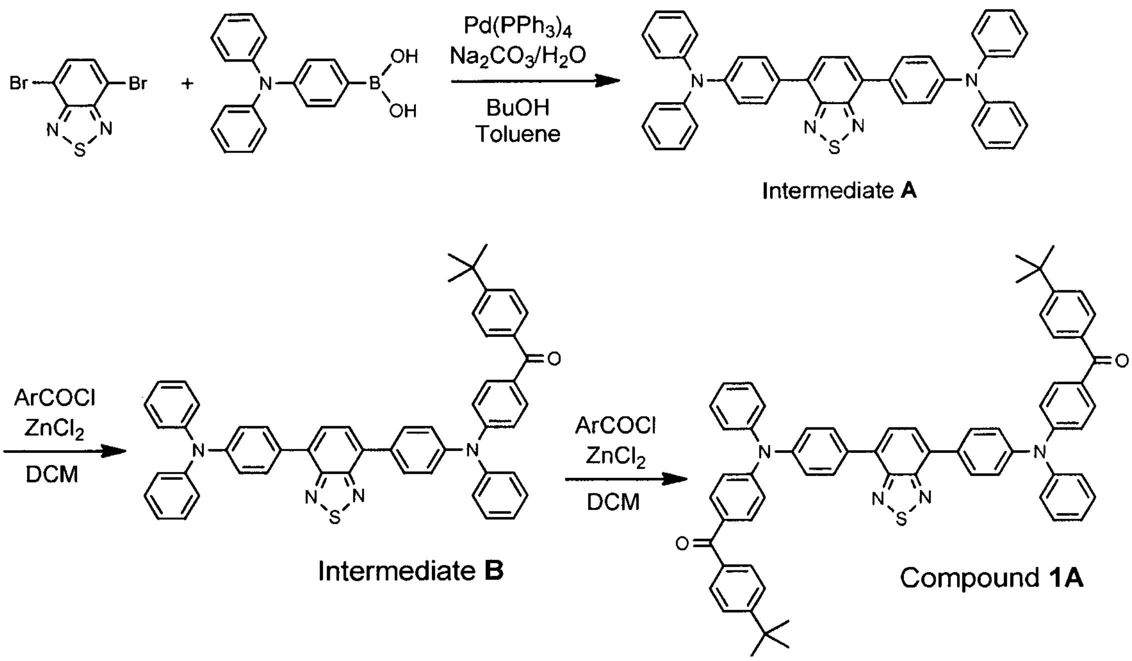


A mixture of 4,7-dibromobenzo[2,1,3]thiadiazole (13.2 g, 45 mmol), 4-(*N,N*-diphenylamino)phenylboronic acid (30.0 g, 104 mmol), a solution of sodium carbonate (21.2 g, 200 mmol) in water (80 mL), tetrakis(triphenylphosphine)palladium(0) (5.0 g, 4.3 mmol), *n*-butanol (800 mL), and toluene (400 mL) was stirred under argon and heated at 100°C for 20 hours. After cooling to room temperature, the mixture was diluted with water (600 mL) and stirred for 2 hours. Finally, the reaction mixture was extracted with toluene (2 L), and the volatiles were removed under reduced pressure. The residue was chromatographed using silica gel and hexane/dichloromethane (1:1) as an eluent to give 26.96 g (43.3 mmol, 96%) of 4,7-bis[(*N,N*-diphenylamino)phenyl)]benzo[2,1,3]thiadiazole (Intermediate **A**).

To a solution of Intermediate **A** (22.0 g, 35.3 mmol) in dichloromethane (800 mL) stirred under argon and cooled in an ice/water bath were added in small portions 4-*t*-butylbenzoyl chloride (97.4 mL, 500 mmol) and 1M solution of zinc chloride in ethyl ether (700 mL, 700 mmol). The obtained mixture was stirred and heated at 44°C for 68 hours. The reaction mixture was poured onto crushed ice (2 kg), stirred, treated with saturated sodium carbonate to pH 8, diluted with dichloromethane (2 L) and filtered through a frit-glass funnel under atmospheric pressure. The dichloromethane layer was separated, dried over magnesium sulfate, and the solvent was evaporated. Column chromatography of the residue (silica gel, hexane/dichloromethane/ethyl acetate, 48:50:2) followed by recrystallization from ethanol gave pure luminescent dye Intermediate **B** as the first fraction, 7.72 g (28%). $^1H$ NMR (400 MHz, $CDCl_3$): δ 7.94 (d, 2H, J = 7.3 Hz), 7.87 (d, 2H, J = 7.7 Hz), 7.74 (m, 6H), 7.47 (d, 2H, J = 7.3 Hz), 7.36 (t, 2H, J = 7.3 Hz), 7.31 (d, 2H, J = 7.3 Hz), 7.27 (m, 6H), 7.19 (m, 7H), 7.13 (d, 2H, J = 7.7 Hz), 7.06 (t, 2H, J = 7.3 Hz), 1.35 (s, 9H). UV-vis spectrum: $\lambda_{max}$ = 448 nm (dichloromethane), 456 nm (PVB film). Fluorimetry: $\lambda_{max}$ = 618 nm (dichloromethane), 562 nm (PVB film).

The second fraction gave luminescent dye Compound **1A**, 12.35 g (37% yield). $^1H$ NMR (400 MHz, $CDCl_3$): δ 7.95 (d, 4H, J = 8.4 Hz), 7.79-7.73 (m, 10H), 7.48 (d, 4H, J = 7.7 Hz), 7.36 (t, 4H, J = 7.7 Hz), 7.31 (d, 4H, J = 8.4 Hz), 7.25 (d, 4H, J = 7.7 Hz), 7.18 (t, J = 7.3, 2H, Ph), 7.14 (d, 4H, J = 8.8 Hz),1.35 (s, 18H). UV-vis spectrum: $\lambda_{max}$ = 437 nm (dichloromethane), 455 nm (PVB film). Fluorimetry: $\lambda_{max}$ = 607 nm (dichloromethane), 547 nm (PVB film).

Compound 1B

Synthesis of Compound **1B** was performed according to the following scheme:

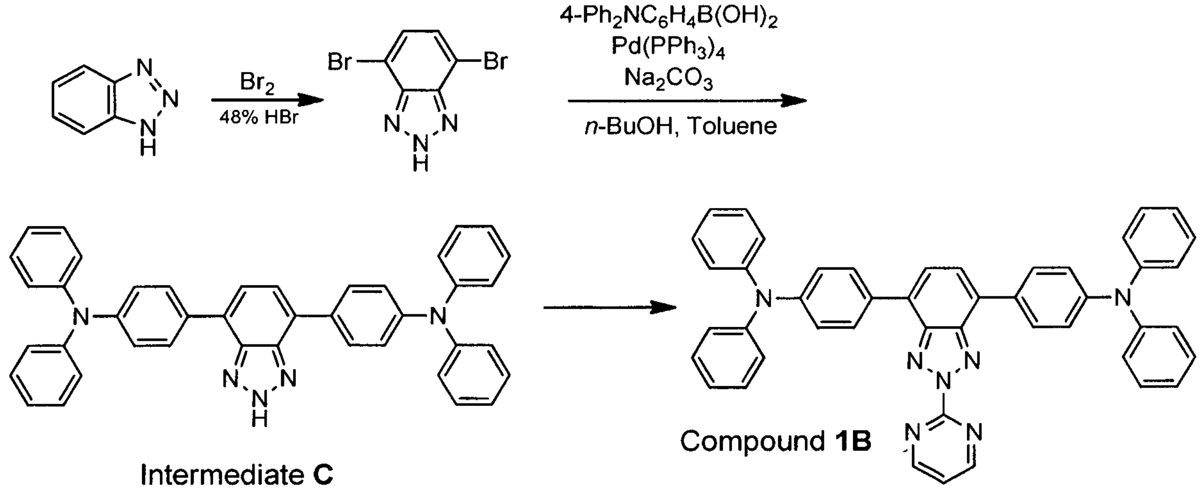


Intermediate **C**

Compound **1B**

A mixture of benzotriazole (5.96 g, 50 mmol), bromine (7.7 mL, 150 mmol) and 48% HBr (30 mL) was heated at 120°C for 24 hours. The reaction mixture was poured into ice/water (200 mL), neutralized with 5N NaOH, and the excess of bromine was removed by addition of 1M sodium thiosulfate (test with KI/starch paper). After stirring for 30 minutes, the solid was filtered off, washed with water and dried in a vacuum oven. The crude product was purified by column chromatography (silica gel, dichloromethane/ethyl acetate 75:25) and washing with ethyl acetate (50 mL) to 4,7-dibromo-2*H*-benzo[*d*][1,2,3]triazole 2.65 g (19%).

A mixture of 4,7-dibromo-2H-benzo[*d*][1,2,3]triazole (1.37 g, 5.5 mmol), 4-(diphenylamino)phenylboronic acid (3.47 g, 12 mmol), sodium carbonate (5,30 g, 50 mmol) in water (10 mL), tetrakis(triphenylphosphine)palladium (0) (1.15 g, 1.0 mmol), *n*-butanol (80 mL), and toluene (10 mL) was stirred and heated under argon at 120°C for 4 days. The reaction mixture was poured into water (300 mL), stirred for 15 minutes, and extracted with dichloromethane (2 x 300 mL). The solution was dried over anhydrous sodium sulfate, the solvent was removed under reduced pressure, and the residue was chromatographed (silica gel, dichloromethane/ethyl acetate 95:5) to give 4,7-bis(4-(N,N-diphenylamino)phenyl)-2*H*-benzo[*d*][1,2,3]triazole (Intermediate **C**), 1.85 g (56%). $^1H$ NMR (400 MHz, $CDCl_3$): δ 7.58 (s, 2H, benzotriazole), 7.16-7.23 (m, 16H, *p*-phenylene and Ph), 7.07 (t, J = 7.3, 4H, Ph), 7.02 (bs, 1H, N-H).

A mixture of Intermediate **C** (500 mg, 0.82 mmol), 2-chloropyrimidine (343 mg, 3.0 mmol), 60% NaH (60 mg, 1.5 mmol), and dimethlyformamide (10 mL) was stirred under argon and heated at 120°C for 20 hours. The reaction mixture was poured into water (100 mL) and extracted with dichloromethane (4 x 100 mL). The extract was dried over anhydrous sodium sulfate, the volatiles were removed under reduced pressure, and the residue was chromatographed using silica gel and dichloromethane/ethyl acetate (95:5) as an eluent. The obtained product was recrystallized from ethanol to give 4,7-bis(4-(*N,N*-diphenylamino)phenyl)-2-(pyrimidin-2-yl)-2*H*benzo[*d*][1,2,3]triazole (Compound **1B**), orange crystals, 340 mg (61%). $^1H$ NMR (400 MHz, $CDCl_3$): δ 8.99 (d, J = 5.1 Hz, 2H, pyrimidine), 8.02 (d, J = 8.8 Hz, 4 H, *p*-phenylene), 7.66 (s, 2H, benzotriazole), 7.47 (t, J = 4.8 Hz, 1H, pyrimidine), 7.28 (m, 8H, Ph), 7.21 (d, J = 8.4 Hz, 4H, *p*-phenylene), 7.18 (m, 8H, Ph), 7.05 (tt, J = 7.3 and 1.1 Hz, 4H, Ph). UV-vis spectrum (dichloromethane): $\lambda_{max}$ = 451 nm. Fluorimetry (dichloromethane): $\lambda_{max}$ = 600 nm. UV-vis spectrum (PVB): $\lambda_{max}$ = 450 nm. Fluorimetry (PVB): $\lambda_{max}$ = 563 nm.

Compound 2 (A UV Absorbing Chromophore)

Synthesis of Compound **2** was performed according to the following scheme:

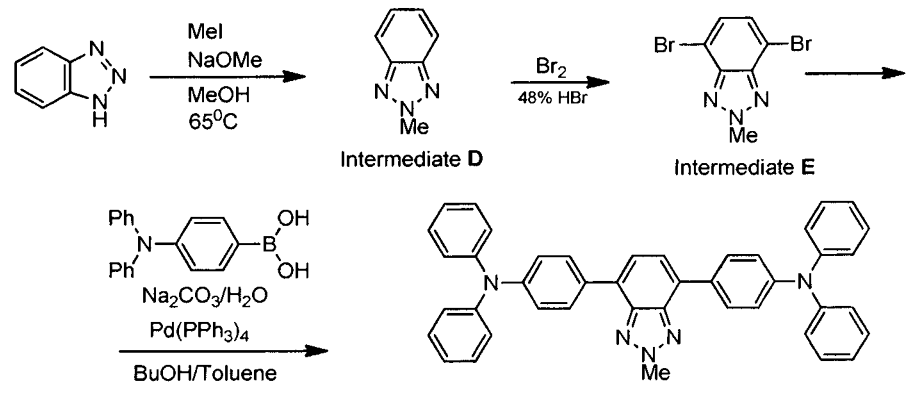


Intermediate **D**

Intermediate **E**

Compound **2**

A solution of benzotriazole (23.82 g, 200 mmol), sodium methoxide (13.56 g, 250 mmol) and iodomethane (15.60 mL, 250 mmol) in methanol (100 mL) was heated at reflux for 24 hours. The reaction mixture was poured into water (200 mL) and extracted with dichloromethane (2 x 100 mL). The extract was dried over sodium carbonate and chromatographed using silica gel and dichloromethane/ethyl acetate (gradient method of 98:2 → 90:10) as an eluent to give 2-methylbenzotriazole (Intermediate **D**) (3.50 g, 10.5%) as the first fraction.

A solution of Intermediate **D** (3.00 g, 22.5 mmol) in 48% hydrobromic acid (25 mL) was treated with bromine (4.5 mL, 86.8 mmol) and heated at 120°C for 18 hours. The reaction mixture was poured into ice/water (100 mL), treated with 2N sodium hydroxide to pH 10, and extracted with dichloromethane (2 x 100 mL). The extract was dried over magnesium sulfate and filtered through a layer of silica gel to give 4,7-dibromo-2-methylbenzotriazole (Intermediate **E**) (4.35 g, 67%).

A mixture of Intermediate **E** (2.90 g, 10.0 mmol), 4-(diphenylamino)phenylboronic acid (7.50 g, 26 mmol), tetrakis(triphenylphosphine)palladium(0) (1.16 g, 1.0 mmol), sodium carbonate (5.30 g, 50 mmol) in water (25 mL), and 1,2-dimethoxyethane (80 mL) was stirred under argon and heated at 110°C for 40 hours. The reaction mixture was poured into water (100 mL), stirred for 2 hours, and extracted with dichloromethane (2 x 100 mL). The extract was dried over sodium sulfate, the solvent was removed under reduced pressure, and the residue was chromatographed using hexane/dichloromethane (gradient method of 9:1 → 2:8) as an eluent. The fractions containing the desired product were combined and concentrated to give chromophore Compound **2** (4.06 g, 64%) as a yellow crystalline material. $^1$H NMR ($CDCl_3$) δ 7.95 (d, J = 8.8 Hz, 4 H), 7.59 (s, 2 H), 7.27 (m, 8 H), 7.18 (m, 12 H), 7.04 (tt, J = 7.3 and 1.1 Hz, 2 H), 4.57 (s, 3 H). UV-vis spectrum (dichloromethane): $\lambda_{max}$ = 402 nm. Fluorimetry (dichloromethane): $\lambda_{max}$ = 492 nm. UV-vis spectrum (PVB): $\lambda_{max}$ = 407 nm. Fluorimetry (PVB): $\lambda_{max}$ = 470 nm.

Intermediate F

Common Intermediate **F** was synthesized according to the following scheme.

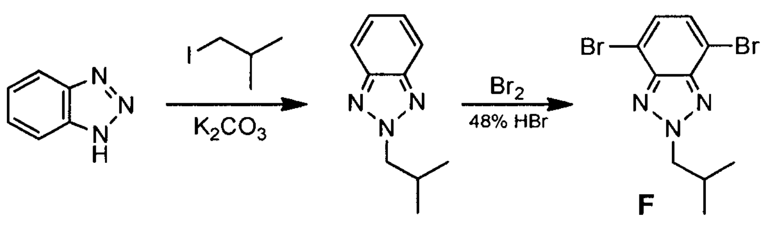


**F**

Step 1: 2-Isobutyl-2*H*-benzo[*d*][1,2,3]triazole.

A mixture of benzotriazole (11.91 g, 100 mmol), 1-iodo-2-methylpropane (13.8 mL, 120 mmol), potassium carbonate (41.46 g, 300 mmol), and dimethylformamide (200 mL) was stirred and heated under argon at 40°C for 2 days. The reaction mixture was poured into ice/water (1 L) and extracted with toluene/hexanes (2:1, 2 x 500 mL). The extract was washed with 1 N HCl (2 x 200 mL) followed by brine (100 mL), dried over anhydrous magnesium sulfate, and the solvent was removed under reduced pressure. The residue was triturated with hexane (200 mL) and set aside at room temperature for 2 hours. The precipitate was separated and discarded, and the solution was filtered through a

layer of silica gel (200 g). The silica gel was washed with hexane/dichloromethane/ethyl acetate (37:50:3, 2 L). The filtrate and washings were combined, and the solvent was removed under reduced pressure to give 2-isobutyl-2*H*-benzo[*d*][1,2,3]triazole (8.81 g, 50% yield) as an oily product. $^1$H NMR (400 MHz, $CDCl_3$): δ 7.86 (m, 2H, benzotriazole), 7.37 (m, 2H, benzotriazole), 4.53 (d, J = 7.3 Hz, 2H, *i*-Bu), 2.52 (m, 1H, *i*-Bu), 0.97 (d, J = 7.0 Hz, 6H, *i*-Bu).

Step 2: 4,7-Dibromo-2-isobutyl-2*H*-benzo[*d*][1,2,3]triazole Intermediate **F**).

A mixture of 2-isobutyl-2*H*-benzo[*d*][1,2,3]triazole (8.80 g, 50 mmol), bromine (7.7 mL, 150 mmol) and 48% HBr (50 mL) was heated at 130°C for 24 hours under a reflux condenser connected with an HBr trap. The reaction mixture was poured into ice/water (200 mL), treated with 5 N NaOH (100 mL) and extracted with dichloromethane (2 x 200 mL). The extract was dried over anhydrous magnesium sulfate, and the solvent was removed under reduced pressure. A solution of the residue in hexane/dichloromethane (1:1, 200 mL) was filtered through a layer of silica gel and concentrated to give 4,7-dibromo-2-isobutyl-2*H*-benzo[*d*][1,2,3]triazole, Intermediate **F** (11.14 g, 63% yield) as an oil that slowly solidified upon storage at room temperature. $^1$H NMR (400 MHz, $CDCl_3$): δ 7.44 (s, 2H, benzotriazole), 4.58 (d, J = 7.3 Hz, 2H, *i*-Bu), 2.58 (m, 1H, *i*-Bu), 0.98 (d, J = 6.6 Hz, 6H, *i*-Bu).

Compound 3

Example Chromophore Compound 3 was synthesized according to the following reaction scheme.

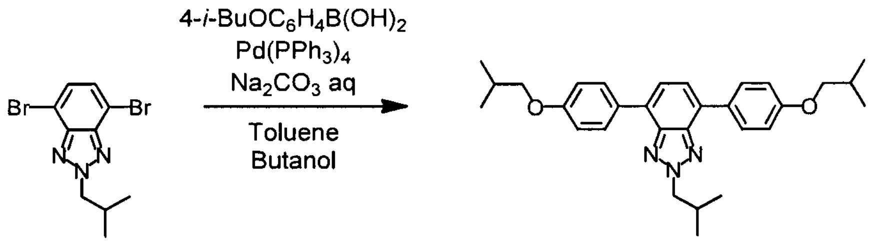


**F** **3**

A mixture of Intermediate **F** (1.32 g, 4.0 mmol), 4-isobutoxyphenylboronic acid (1.94 g, 10.0 mmol), tetrakis(triphenylphosphine)palladium(0) (1.00 g, 0.86 mmol), solution of sodium carbonate (2.12 g, 20 mmol) in water (15 mL), butanol (50 mL), and toluene (30 mL) was vigorously stirred and heated under argon at 100°C for 16 hours. The reaction mixture was poured into water (300 mL), stirred for 30 minutes and extracted with toluene/ethyl acetate/hexane (5:3:2, 500 mL). The volatiles were removed under reduced pressure, and the residue was chromatographed (silica gel, hexane/dichloromethane, 1:1). The separated product was recrystallized from ethanol to give pure 4,7-bis(4-isobutoxyphenyl)-2-isobutyl-2*H*-benzo[*d*][1,2,3]triazole, Compound **3** (1.57 g, 83% yield). $^1$H NMR (400 MHz, $CDCl_3$): δ 7.99 (d, J = 8.7 Hz, 4H, 4-*i*-BuOC$_6$H$_4$), 7.55 (s, 2H, benzotriazole), 7.04 (d, J = 8.8 Hz, 4H, 4-*i*-BuOC$_6$H$_4$), 4.58 (d, J = 7.3 Hz, 2H, *i*-Bu), 3.79 (d, J = 6.6 Hz, 4H, 4-*i*-BuOC$_6$H$_4$), 2.59 (m, 1H, *i*-Bu), 2.13 (m, 2H, 4-*i*-BuOC$_6$H$_4$), 1.04 (d, J = 6.6 Hz, 12H, 4-*i*-BuOC$_6$H$_4$), 1.00 (d, J = 6.6 Hz, 6H, *i*-Bu). UV-vis spectrum (PVB): $\lambda_{max}$ = 359 nm. Fluorimetry (PVB): $\lambda_{max}$ = 434 nm. Figure 11 shows the absorption and emission spectrum for Compound 3.

General Procedure for Preparation of Tosylates

Equimolar amounts of p-toluenesulfonic chloride, corresponding alcohols and 1.2 equivalents of triethylamine were stirred in dichloromethane overnight at room temperature. Work-up with water, drying with anhydrous $MgSO_4$, and concentration provided 95-98% pure tosylated alcohols which were used without purification in the synthesis of the compounds described below.

Intermediate G

Intermediate G is synthesized according to the following reaction scheme:

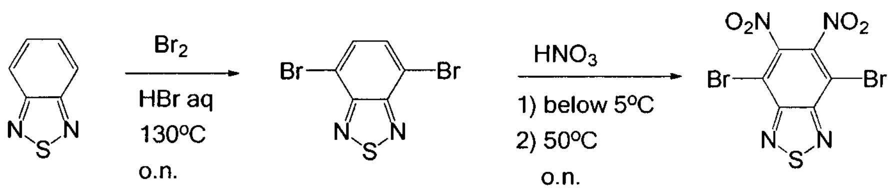


Intermediate G

Benzothiadiazole (25g, 184 mmol) was reacted overnight with 20.8mL bromine (2.2eq) in 400mL of 48% HBr (in water) at 125-130°C. After cooling the reaction mixture (heavy suspension of redish-brown solid) was poured into 1 liter of crushed ice and left to stir for 30 minutes. Filtration, washing with water, followed by washing with sodium sulfite solution and water gave 4,7-dibromobenzothiadiazole as brick color needles, (50.1g, 92%, after drying in vacuum oven). This material was used for nitration with fuming nitric acid in trifluoromethanesulfonic acid (TFMSA) as follows: nitric acid (10.0mL) was added dropwise to TFMSA (150g) which was cooled below 5°C with intensive stirring (white solid formed). 4,7-Dibromobenzothiadiazole (as solid) was added portionwise to the above reaction mixture and, after it became homogenous, the flask was placed in an oil bath and left to stir at 50°C for 16-24 hours. The reaction was monitored by $^{13}C$ NMR (110.4, 145.0, and 151.4ppm). Pouring the solution into 500mL of ice/water afforded Intermediate G (4,7-dibromo-5,6-dinitrobenzothiadiazole) as a yellowish solid which was thoroughly washed with water and dried in vacuum oven (30.6g, 94%).

Intermediate H

Intermediate H is synthesized according to the following reaction scheme:

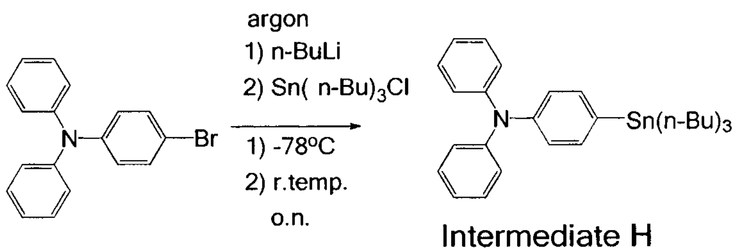


Intermediate H

4-Bromotriphenylamine (65.0g, 200 mmol) was placed in a 500 ml dry three necked RB flask equipped with a magnetic stirring bar, low temperature thermometer and argon inlet. Tetrahydrofurane was transferred to the reaction flask using a cannula (200ml) and cooled in a dry-ice acetone bath to -78°C and n-BuLi 91.6M in hexane (130mL) was added dropwise over a period of 30 minutes. The reaction mixture was left to stir at the same temperature for 30 minutes at which time tributyltin chloride (65.0mL) was added dropwise over 30 minutes. The reaction was left to stir overnight, after which the reaction was allowed to warm to room temperature. The solution was poured into ice-cold water (approximately 500mL) and extracted using diethyl ether (2 x 250mL). The organic layer was dried with $MgSO_4$ and the solvent was removed by evaporation to give 106.5g of Intermediate **H** as yellowish oil, by $^1H$ NMR approximately 95% pure.

Intermediate I

Intermediate I is synthesized according to the following reaction scheme:

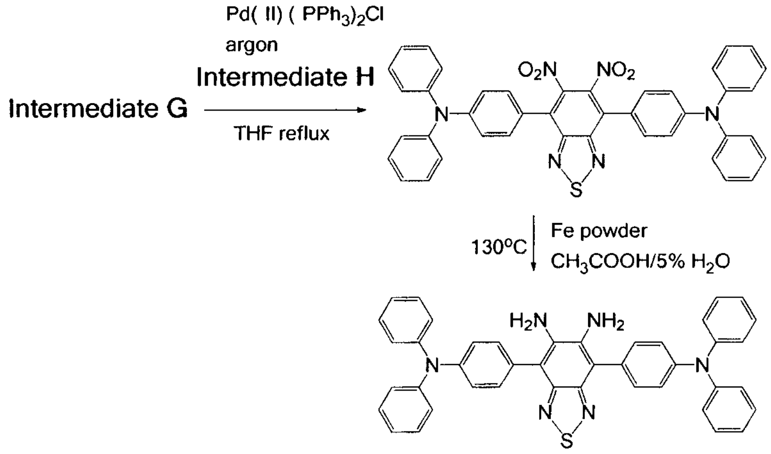


Intermediate I

Step 1: A mixture of Intermediate **G** (3.84g, 10 mmol), Intermediate **H** (10.7g, 20 mmol), and Bis(triphenylphosphine)palladium(II) chloride (1.40g, 2.0mmol) in tetrahydrofurane was stirred and heated under argon at 70°C for 5 hours. The solvent was removed and MeOH was added (100mL) to the residue. The purple solid was separated by filtration, washed with MeOH, and dried to give 4,4'-(5,6-dinitrobenzo[c][1,2,5]thiadiazole-4,7-diyl)bis(N,N-diphenylaniline) (7.0g) as purple solid.

Step 2: A mixture of the above crude 4,4'-(5,6-dinitrobenzo[c][1,2,5]thiadiazole-4,7-diyl)bis(N,N-diphenylaniline) (calculated for 10 mmol) with iron dust (5.6g, 100mmol) was heated in glacial acetic acid (100mL) with 5% of water (to prevent formation of side product, imidazole) at 110°C for 2 hours. The solution was poured into ice-water (200mL) and the resulting solid was separated by filtration, washed with water and dried. After filtering through 2 layers of silica gel (to remove particles of iron) using ethyl DCM/hexane (3:2) and concentration, Intermediate **I** (4,7-bis(4-(diphenylamino)phenyl)benzo[c][1,2,5]thiadiazole-5,6-diamine) was collected as a light brown solid (4.50 g, 68%, after 2 steps). $^1H$ NMR (400MHz, $CDCl_3$): δ 7.44 (d, J= 8.6 Hz, 4H), 7.16-7.30 (m, 20H), 7.44 (t, J=6.3 Hz, 4H).

Intermediate J

Intermediate J is synthesized according to the following reaction scheme:

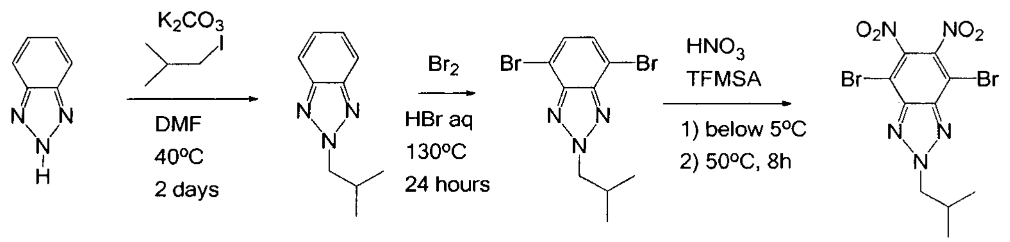


Intermediate J

Step 1: A mixture of benzotriazole (11.91 g, 100 mmol), 1-iodo-2-methylpropane (13.8 mL, 120 mmol), potassium carbonate (41.46 g, 300 mmol), and dimethylformamide (200 mL) was stirred and heated under argon at 40°C for 2 days. The reaction mixture was poured into ice/water (1 L) and extracted with toluene/hexanes (2:1, 2 x 500 mL). The extract was washed with 1 N HCl (2 x 200 mL) followed by brine (100 mL). The extract was then dried over anhydrous $MgSO_4$, and the solvent was removed under reduced pressure. The residue was triturated with hexane (200 mL) and set aside at room temperature for 2 hours. The precipitate was separated and discarded, and the solution was filtered through a layer of silica gel (200 g). The silica gel was washed with hexane/dichloromethane/ethyl acetate (37:50:3, 2 L). The filtrate and washings were combined, and the solvent was removed under reduced pressure to give 2-isobutyl-2*H*-benzo[*d*][1,2,3]triazole (8.81 g, 50% yield) as an oily product. $^1H$ NMR (400 MHz, $CDCl_3$): δ 7.86 (m, 2H, benzotriazole), 7.37 (m, 2H, benzotriazole), 4.53 (d, J = 7.3 Hz, 2H, *i*-Bu), 2.52 (m, 1H, *i*-Bu), 0.97 (d, J = 7.0 Hz, 6H, *i*-Bu).

Step 2: A mixture of 2-isobutyl-2*H*-benzo[*d*][1,2,3]triazole (8.80 g, 50 mmol), bromine (7.7 mL, 150 mmol) and 48% HBr (50 mL) was heated at 130°C for 24 hours under a reflux condenser connected with an HBr trap. The reaction mixture was poured into ice/water (200 mL), treated with 5 N NaOH (100 mL) and extracted with dichloromethane (2 x

200 mL). The extract was dried over anhydrous magnesium sulfate, and the solvent was removed under reduced pressure. A solution of the residue in hexane/dichloromethane (1:1, 200 mL) was filtered through a layer of silica gel and concentrated to yield 4,7-dibromo-2-isobutyl-2*H*-benzo[*d*][1,2,3]triazole, (11.14 g, 63% yield) as an oil that slowly solidified upon storage at room temperature. $^1$H NMR (400 MHz, $CDCl_3$): δ 7.44 (s, 2H, benzotriazole), 4.58 (d, J = 7.3 Hz, 2H, *i*-Bu), 2.58 (m, 1H, *i*-Bu), 0.98 (d, J = 6.6 Hz, 6H, *i*-Bu).

Step 3: 4,7-dibromo-2-isobutyl-2*H*-benzo[*d*][1,2,3]triazole (17.8g, 53 mmol) was added at 0-5°C to a premixed fuming $HNO_3$ (7.0mL) and TFMSA (110g) portionwise and after approximately 10 minutes the reaction mixture was placed in an oil bath and heated at 55°C for 8 hours. The solution was then cooled by pouring into 500mL of ice/water. The solid obtained was thoroughly washed with water, followed by MeOH and dried in a vacuum oven to yield Intermediate **J** (4,7-dibromo-2-isobutyl-5,6-dinitro-2H-benzo[d][1,2,3]triazole) as yellowish solid (20.4g, 91%). $^1$H NMR (400MHz, $CDCl_3$): δ 4.66 (δ, J= 7.2 Hz, 2H, i-Bu), 2.60 (m, 1H, i-Bu), 1.01 (d, J=7.0 Hz, 6H, i-Bu).

Intermediate K

Intermediate K is synthesized according to the following reaction scheme:

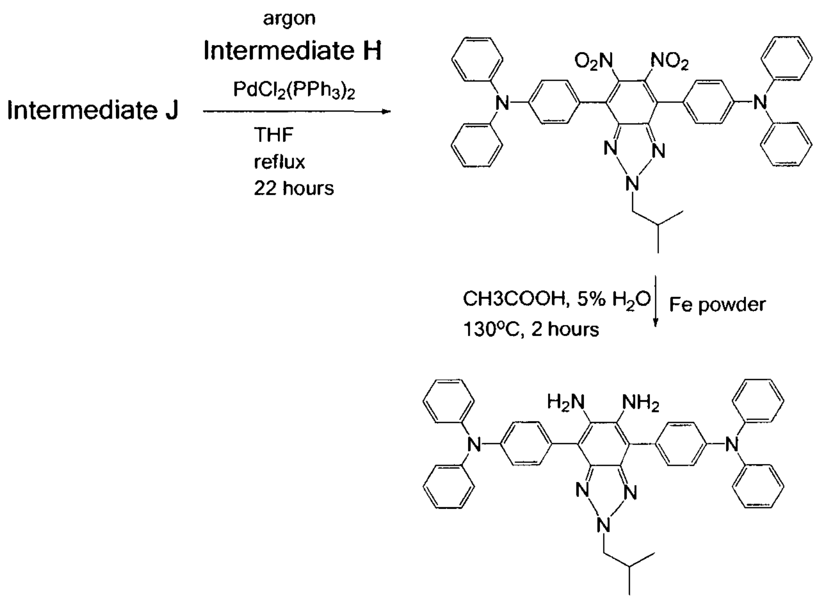


Intermediate K

Step 1: In a three necked reaction flask equipped with argon inlet and magnetic stirring bar, was placed THF (100mL), Intermediate H (31.1g, 30 mmol), and argon was bubbled through for approximately 10 minutes before bis(triphenylphosphine)palladium(II) chloride (10% molar per Intermediate C, 1.80 g, 2.5 mmol) was added. The reaction was stirred under argon for 10 minutes before Intermediate J (10.6 g, 25 mmol) was added in one portion. The reaction mixture was refluxed for 22 hours. The reaction was monitored by LCMS and TLC. The reaction was cooled and MeOH (200 mL) was added while stirring. A dark orange color solid was formed which was separated by filtration, washed with MeOH, and dried to give 4,4'-(2-isobutyl-5,6-dinitro-2H-benzo[d][1,2,3]triazole-4,7-diyl)bis(N,N-diphenylaniline) (11.5 g, 62%, purity by LCMS 86%).

Step 2: A mixture of 4,4'-(2-isobutyl-5,6-dinitro-2H-benzo[d][1,2,3]triazole-4,7-diyl)bis(N,N-diphenylaniline) (6.0 g, 8.0mmol) and iron powder (4.5 g, 80 mmol) was heated and stirred in glacial acetic acid (100 mL) at 130°C for 2 hours. The reaction was monitored by LCMS and TLC. The reaction was cooled and poured into water to yield yellow solid which was separated by filtration, washed with water and dried to give Intermediate **K** (4,7-bis(4-(diphenylamino)phenyl)-2-isobutyl-2H-benzo[d][1,2,3]triazole-5,6-diamine) (4.6g, 66%, purity by LCMS 82%).

Compound 4

Synthesis of Compound **4** was performed according to the following scheme:

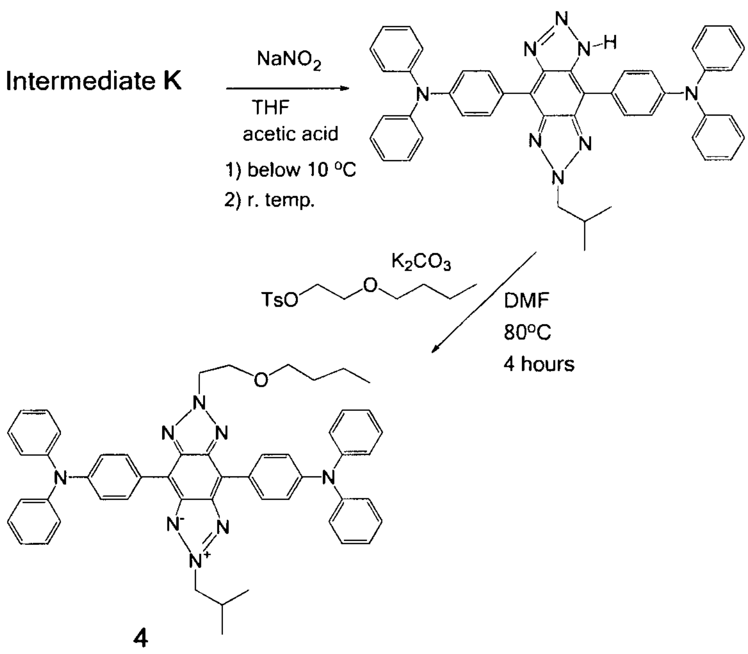


4

Step 1: Intermediate **K** (5.54g, 8 mmol) was dissolved in 50 mL of THF (for solubility) and 50 mL of acetic acid was added. The mixture was cooled in an ice/water bath before 12 mL of 1M solution of $NaNO_2$ in water was added. After 10 minutes the reaction was complete. Diluting with 400 mL of water afforded an orange color solid which was separated by filtration, washed and dried to give 4,4'-(6-isobutyl-1,6-dihydrobenzo[1,2-d:4,5-d']bis([1,2,3]triazole)-4,8-diyl)bis(N,N-diphenylaniline) as an orange solid (2.72g, 48%). $^1H$ NMR (400MHz, $CDCl_3$): $\delta$ 8.5 (bs, 1H), 7.9 (bs, 1H), 7.2-7.3 (m, 24H), 7.08 (t, J= 7.3 Hz, 4H), 4.65 (d, □J= 7.4 Hz, 2H), 2.64 (m, 1H), 1.01 (d, J=6.5 Hz, 6H).

Step 2: Then, 1.70 g of 4,4'-(6-isobutyl-1,6-dihydrobenzo[1,2-d:4,5-d']bis([1,2,3]triazole)-4,8-diyl)bis(N,N-diphenylaniline, calculated for 2.5 mmol was dissolved in DMF (30 mL). Potassium carbonate (2.80 g, 20 mmol) was added, followed by 2-butoxyethyl 4-methylbenzenesulfonate (1.36 g, 5 mmol) and the reaction mixture was heated at 125°C for 50 minutes. The solution was rotavaped and the residue was triturated with MeOH. The redish-brown solid was separated, washed with MeOH and dried. Column chromatography (silica gel, DCM/Hex-3:2) provided Compound **4** (4,4'-(2-(2-butoxyethyl)-6-isobutyl-1,2,3,6-tetrahydrobenzo[1,2-d:4,5-d']bis([1,2,3]triazole)-4,8-diyl)bis(N,N-diphenylaniline)) as a red solid (1.62g, 80%). $^1H$ NMR (400MHz, $CDCl_3$): $\delta$ 8.60 (d, J=8.7 Hz, 4H), 7.20-732 (m, 20H), 7.06 (t, J=7.3 Hz, 4H), 5.02 (t, J=5.8Hz, 2H), 4.66 (d, J=7.4 Hz, 2H), 4.20 (t, J=6.0 Hz, 2H), 3.48 (t, J=6.6 Hz, 2H), 2.66 (d, J= 6.9 Hz, 2H), 1.50 (m, 2H), 1.23 (m, 2H), 1.00 (m, 2H), 1.03 (d, J=6.6 Hz, 6H), 0.78 (t, J=7.7 Hz). UV-vis spectrum: $\lambda_{max}$ = 517 nm (dichloromethane), 512 nm (PMMA film). Fluorimetry: $\lambda_{max}$ = 615 nm (dichloromethane), 606 nm (PMMA film). Figure 12 shows the absorption and emission spectrum for Compound 4.

Compound 5

Synthesis of Compound **5** was performed according to the following scheme:

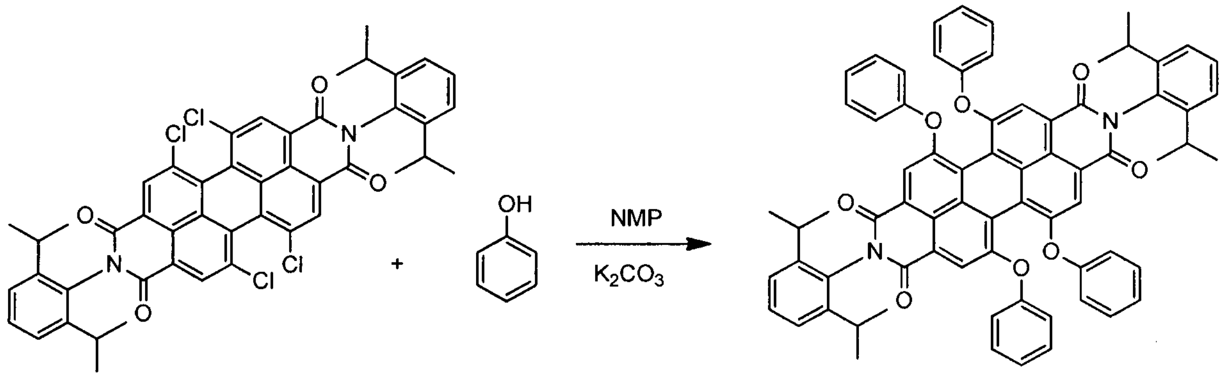


**Intermediate L**

**5**

A mixture of 1.89 g of Intermediate **L**, 1.05 g of phenol, 40 ml of N-methylpyrrolidone (NMP), and 1.23 g of $K_2CO_3$ were added together under an Argon atmosphere and heated to 132 °C overnight. Then, the reaction mixture was poured into 1 N hydrochloric acid solution, which caused precipitation of the products. The precipitates were filtered out, washed with water, and dried in oven. The crude product was purified by column chromatography on silica gel with dichloromethane/hexane (v/v, 3:2) as eluent to give Compound **5** as a red solid (0.82 g, 34%). UV-vis spectrum (PVB): $\lambda_{max}$ = 574 nm. Fluorimetry (PVB): $\lambda_{max}$ = 603 nm. Figure 13 shows the absorption and emission spectrum for Compound 5.

Commercial Compound Y083

Commercial compound Y083 was purchased from BASF and used as received. The compound has the following structure:

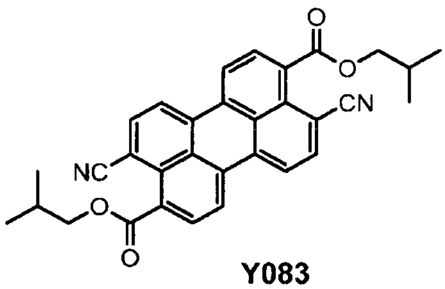

**Y083**

Photostability of Novel Chromophores Compared to Commercial Chromophore

A wavelength conversion film, comprising one chromophore, and an optically transparent polymer matrix, is fabricated by (i) preparing a 20 wt% Polyvinyl butyral (PVB) (from Aldrich and used as received) polymer solution with dissolved polymer powder in cyclopentanone; (ii) preparing a chromophore containing an PVB matrix by mixing the PVB polymer solution with the synthesized Chromophore Compound at a concentration of $10^{-5}$mol/g ($10^{-5}$mol of Chromophore Compound per gram of PVB), to obtain a chromophore-containing polymer solution; (iii) stirring the solution for approximately 30 minutes; (iv) then forming the chromophore/polymer film by directly drop casting the dye-containing polymer solution onto a glass substrate, then allowing the film to dry at room temperature over night followed by heat treating the film at 60°C under vacuum for 10 minutes, to completely remove the remaining solvent, and (v) hot pressing the dry composition under vacuum to form a bubble free film with film thickness of approximately 20μm.

Measurement of the Photostability of the Novel Chromophores

The wavelength conversion film, was exposed to continuous one sun (AM1.5G) irradiation at ambient temperature. The absorption peak of the wavelength conversion film was measured using a UV-Vis spectrometer prior to exposure, and thereafter at 24 hours total exposure. The initial UV-Vis absorption data was normalized to its absorption peak maximum so that at 0 hours the peak intensity is 100%. The UV-Vis measurements after exposure to one sun are

then normalized to the initial 0 hour data, and the absorption peak intensity is reported as the photostability. Easily degraded films typically show a drastic decay of the absorption peak within a few hours of one sun irradiation. Films with excellent photostability will maintain the peak absorption over a long time period of exposure to one sun irradiation. The Table below shows the photostability of the novel chromophores compared to a commercially available organic chromophore.

| Chromophore | Photostability after 24 hours Exposure |
|---|---|
| Compound 1A | 90% |
| Compound 1B | 97% |
| Compound 2 | 88% |
| Compound 3 | 84% |
| Compound 5 | 95% |
| Y083 (purchased from BASF and used as received) | 41% |

Reference Example 1

A wavelength conversion film **101**, which comprises two or more chromophores, and an optically transparent polymer matrix, is fabricated by (i) preparing a 15 wt% Ethyl Vinyl Acetate (EVA) (from Aldrich and used as received) polymer solution with dissolved polymer powder in cyclopentanone; (ii) preparing a chromophore containing an EVA matrix by mixing the EVA polymer solution with the synthesized Compound **1A** at a weight ratio (Compound **1A**/EVA) of 0.3 wt%, and Compound **2** at a weight ratio (Compound **2**/EVA) of 0.3 wt%, to obtain a chromophore-containing polymer solution; (iii) stirring the solution for approximately 30 minutes; (iv) then forming the chromophore/polymer film by directly drop casting the dye-containing polymer solution onto a substrate, then allowing the film to dry at room temperature over night followed by heat treating the film at 60°C under vacuum for 10 minutes, to completely remove the remaining solvent, and (v) hot pressing the dry composition under vacuum to form a bubble free film with film thickness of approximately 200μm.

Measurement of the Efficiency Enhancement

The Solar cell photoelectric conversion efficiency was measured by a Newport 300W full spectrum solar simulator system. The light intensity was adjusted to one sun (AM1.5G) by a 2x2cm calibrated reference monocrystalline silicon solar cell. Then the I-V characterization of the CdS/CdTe solar cell was performed under the same irradiation and its efficiency is calculated by the Newport software program which is installed in the simulator. The CdS/CdTe solar cell used in this study has an efficiency $\eta_{cell}$ of 11.3%, which is similar to the efficiency level achieved in most commercially available CdS/CdTe cells. After determining the stand alone efficiency of the cell, the Reference Example 1 wavelength conversion film, which was cut to the same shape and size of the light incident active window of the CdS/CdTe cell, was attached to the light incident front glass substrate of the CdS/CdTe cell as illustrated in FIG. **1**, using a refractive index matching liquid (n = 1.500) fill in between the luminescent film and the light incident glass surface of the CdS/CdTe solar cell. The solar cell efficiency with the wavelength conversion film $\eta_{cell+luminescent}$ film was measured again under same one sun exposure. The efficiency enhancement of the CdS/CdTe solar cell due to the attached wavelength conversion film was determined using the following equation:

$$\text{Efficiency Enhancement}=(\eta_{cell+luminescent\ film}-\eta_{cell})/\eta_{cell}*100\%$$

Table 1 shows the efficiency enhancement for each of the wavelength conversion films fabricated. Measurement error for this test is on the order of +/-1%.

Measurement of the Photostability

The Reference Example 1 wavelength conversion film, was exposed to continuous one sun (AM1.5G) irradiation at ambient temperature. The absorption peak of the wavelength conversion film was measured using a UV-Vis spectrometer prior to exposure, and thereafter at 3 hours total exposure, 20 hours total exposure, 46 hours total exposure, and 70 hours total exposure. The initial UV-Vis absorption data was normalized to its absorption peak maximum so that

at 0 hours the peak intensity is 100%. The UV-Vis measurements after exposure to one sun are then normalized to the initial 0 hour data, and the absorption peak intensity is reported as the photostability. Easily degraded films typically show a drastic decay of the absorption peak within a few hours of one sun irradiation. Films with excellent photostability will maintain the peak absorption over a long time period of exposure to one sun irradiation. Table 2 shows the photostability of the wavelength conversion films that were fabricated.

Comparative Example 2

Comparative Example 2 is synthesized using the same method as given in Reference Example 1, except that Compound **2** is not used. Table 1 shows the efficiency enhancement of this film and Table 2 shows the photostability.

Reference Example 3

Reference Example 3 is synthesized using the same method as given in Reference Example 1, except that Compound **1B** is used instead of Compound **1A**. Table 1 shows the efficiency enhancement of this film and Table 2 shows the photostability.

Comparative Example 4

Comparative Example 4 is synthesized using the same method as given in Reference Example 3, except that Compound 2 is not used. Table 1 shows the efficiency enhancement of this film and Table 2 shows the photostability.

Reference Example 5

Example 5 is synthesized using the same method as given in Reference Example 1, except that the polymer matrix used is Elvax (Elvax 1300 from Dupont and used as received). Table 1 shows the efficiency enhancement of this film and Table 2 shows the photostability.

Comparative Example 6

Comparative Example 6 is synthesized using the same method as given in Reference Example 5, except that Compound **2** is not used. Table 1 shows the efficiency enhancement of this film and Table 2 shows the photostability.

Reference Example 7

Reference Example 7 is synthesized using the same method as given in Reference Example 5, except that Compound **1B** is used instead of Compound **1A**. Table 1 shows the efficiency enhancement of this film and Table 2 shows the photostability.

Comparative Example 8

Comparative Example 8 is synthesized using the same method as given in Reference Example 7, except that Compound **2** is not used. Table 1 shows the efficiency enhancement of this film and Table 2 shows the photostability.

Reference Example 9

Reference Example 9 is synthesized using the same method as given in Example 1, except that the polymer matrix used is Poly vinyl butyral (Mowital B60T from Kuraray and used as received). Table 1 shows the efficiency enhancement of this film and

Table 2 shows the photostability.

Comparative Example 10

Comparative Example 10 is synthesized using the same method as given in Reference Example 9, except that Compound **2** is not used. Table 1 shows the efficiency enhancement of this film and Table 2 shows the photostability.

Reference Example 11

Reference Example 11 is synthesized using the same method as given in Reference Example 9, except that Compound **1B** is used instead of Compound **1A.** Table 1 shows the efficiency enhancement of this film and Table 2 shows the photostability.

Comparative Example 12

Comparative Example 12 is synthesized using the same method as given in Reference Example 11, except that Compound 2 is not used. Table 1 shows the efficiency enhancement of this film and Table 2 shows the photostability.

Reference Example 13

Reference Example 13 is synthesized using the same method as given in Reference Example 1, except that the polymer matrix used is Poly vinyl butyral (PVB from Sigma Aldrich and used as received). Table 1 shows the efficiency enhancement of this film and Table 2 shows the photostability.

Comparative Example 14

Comparative Example 14 is synthesized using the same method as given in Reference Example 13, except that Compound **2** is not used. Table 1 shows the efficiency enhancement of this film and Table 2 shows the photostability.

Reference Example 15

Reference Example 15 is synthesized using the same method as given in Reference Example 13, except that Compound **1B** is used instead of Compound **1A**. Table 1 shows the efficiency enhancement of this film and Table 2 shows the photostability.

Comparative Example 16

Comparative Example 16 is synthesized using the same method as given in Reference Example 15, except that Compound **2** is not used. Table 1 shows the efficiency enhancement of this film and Table 2 shows the photostability.

**Table 1 Efficiency Enhancement Measurements of the Wavelength Conversion Film**

| Example | Chromophore Compounds | Polymer Matrix | Efficiency Enhancement |
|---|---|---|---|
| Ref. Ex. 1 | 1A + 2 | EVA | 16.83% |
| Comp. Ex. 2 | 1A | EVA | 15.83% |
| Ref. Ex. 3 | 1B + 2 | EVA | 16.55% |
| Comp. Ex. 4 | 1B | EVA | 16.63% |
| Ref. Ex. 5 | 1A + 2 | Elvax | 15.65% |
| Comp. Ex. 6 | 1A | Elvax | 14.90% |
| Ref. Ex. 7 | 1B + 2 | Elvax | 15.11% |
| Comp. Ex. 8 | 1B | Elvax | 15.28% |
| Ref. Ex. 9 | 1A + 2 | PVB60T | 16.18% |
| Comp. Ex. 10 | 1A | PVB60T | 15.66% |
| Ref. Ex. 11 | 1B + 2 | PVB60T | 13.78% |
| Comp. Ex. 12 | 1B | PVB60T | 13.52% |
| Ref. Ex. 13 | 1A + 2 | PVB | 16.77% |
| Comp. Ex. 14 | 1A | PVB | 15.51% |
| Ref. Ex. 15 | 1B + 2 | PVB | 14.00% |

(continued)

| Example | Chromophore Compounds | Polymer Matrix | Efficiency Enhancement |
|---|---|---|---|
| Comp. Ex. 16 | 1B | PVB | 14.41% |

Table 1 shows that the wavelength conversion films with a mixture of both Compound **1A** and Compound **2** showed better efficiency than the films that only contained Compound **1A,** for all four different kinds of polymer matrix. The wavelength conversion films with a mixture of both Compound **1B** and Compound **2** showed similar efficiency as the films that only contained Compound **1B**. The measurement error for the efficiency test is on the order of ~+/-1%. Therefore, the addition of Compound **2**, which is a UV absorbing chromophore, to the wavelength conversion film had either no effect on the

CdS/CdTe solar cell efficiency or showed an improvement in the CdS/CdTe solar cell efficiency.

**Table 2 Photostability Measurements of the Wavelength Conversion Film**

| Example | Chromophore Compounds | Polymer Matrix | 0 hrs | 3 hrs | 20 hrs | 46 hrs | 70 hrs |
|---|---|---|---|---|---|---|---|
| Ref. Ex. 1 | 1A + 2 | EVA | 100% | 100% | 92% | 87% | 84% |
| Comp. Ex. 2 | 1A | EVA | 100% | 100% | 87% | 67% | 52% |
| Ref. Ex. 3 | 1B + 2 | EVA | 100% | 96% | 91% | 88% | 85% |
| Comp. Ex. 4 | 1B | EVA | 100% | 98% | 91% | 82% | 75% |
| Ref. Ex. 5 | 1A + 2 | Elvax | 100% | 100% | 95% | 86% | 78% |
| Comp. Ex. 6 | 1A | Elvax | 100% | 99% | 83% | 47% | 17% |
| Ref. Ex. 7 | 1B + 2 | Elvax | 100% | 98% | 95% | 85% | 68% |
| Comp. Ex. 8 | 1B | Elvax | 100% | 98% | 94% | 77% | 51% |
| Ref. Ex. 9 | 1A + 2 | PVB60T | 100% | 99% | 95% | 87% | 78% |
| Comp. Ex. 10 | 1A | PVB60T | 100% | 99% | 94% | 79% | 63% |
| Ref. Ex. 11 | 1B + 2 | PVB60T | 100% | 99% | 98% | 96% | 95% |
| Comp. Ex. 12 | 1B | PVB60T | 100% | 99% | 97% | 94% | 90% |
| Ref. Ex. 13 | 1A + 2 | PVB | 100% | 99% | 96% | 87% | 77% |
| Comp. Ex. 14 | 1A | PVB | 100% | 100% | 94% | 80% | 60% |
| Ref. Ex. 15 | 1B + 2 | PVB | 100% | 99% | 99% | 94% | 90% |
| Comp. Ex. 16 | 1B | PVB | 100% | 100% | 98% | 92% | 87% |

Table 2 shows that the photostability of the wavelength conversion film containing a mixture of both Compound **1A** and Compound **2** is significantly improved compared to the wavelength conversion films containing only Compound **1A** for all four different kinds of polymer matrix. The largest improvement in photostability due to the addition of a second chromphore was obtained after 70 hrs of one sun exposure of the wavelength conversion film comprising Elvax polymer matrix, which showed only 17% photostability with only Compound **1A**, and was improved to 78% photostability when both Compound **1A** and Compound **2** were contained in the film. Similarly, the wavelength conversion films comprising a mixture of both Compound **1B** and Compound **2** also showed significant improvement in photostability compared to films comprised of only Compound **1B**.

The object of this current invention is to provide a wavelength conversion film comprising at least two chromophores which is suitable for encapsulating solar cells, photovoltaic devices, solar modules, and solar panels. As illustrated by the above examples, the use of this material improves the solar cell light conversion efficiency and has better photostability than the wavelength conversion films that only contain a single chromophore compound.

GREENHOUSE APPLICATION

Synthesis of Wavelength Conversion Film

In an embodiment, a wavelength conversion film was fabricated as follows: (i) preparing a 20 wt% Ethylene vinyl Acetate (EVA purchased from Aldrich and used as received) polymer solution with dissolved polymer powder in cyclopentanone; (ii) preparing the chromophore containing a EVA matrix by mixing the EVA polymer solution with the synthesized Chromophore Compound (Compound 3, 4 or 5) at a weight ratio of Chromophore/EVA of 0.3 wt%, to obtain a chromophore-containing polymer solution; (iii) stirring the solution for approximately 30 minutes; (iv) then forming the chromophore/polymer film by directly drop casting the dye-containing polymer solution onto a substrate, then allowing the film to dry at room temperature over night followed by heat treating the film at 60°C under vacuum for 10 minutes, to completely remove the remaining solvent, and (v) hot pressing the dry composition under vacuum to form a bubble free film with film thickness of approximately 0.3 mm.

Example 17

An Example 17 luminescent panel **104** was constructed comprising two wavelength conversion layers **100** and a glass plate **112**, similar to the structure shown in Figure 14, where the layers were placed on top of each other and adhered together due to the natural stickiness of the wavelength conversion film. The panel had major planar surface area dimensions of approximately 1 inch by 2 inches. The solar radiation **113** was incident on the glass plate, with the wavelength conversion layer comprising chromophore (A) **105** (Compound 3) in the second layer, and the wavelength conversion layer comprising chromophore (B) **106** (Compound 5) in the third layer.

Comparative Example 18

A Comparative Example 18 device was constructed similar to Example 17, except that the wavelength conversion layer comprising chromophore (A) **105**, was replaced with only an EVA layer (no chromophore with UV-blue conversion).

Measurement of Device Transmission

The transmission spectrum with exposure to standard one sun (AM1.5G) radiation of the Example 17 and Comparative Example 18 devices were measured using a UV-Vis-NIR Spectrophotometer model UltraScan® PRO from HunterLab, and it was found that the Example 17 device had 9% more blue light transmitted from the luminescent panel compared to the Comparative Example 18 device.

Example 19

An Example 19 luminescent panel **104** was constructed similar to Example 17, except that the wavelength conversion layer comprising chromophore (B) **106** used Compound 4 instead of Compound 5.

Comparative Example 20

A Comparative Example 20 device was constructed similar to Example 19, except that the wavelength conversion layer comprising chromophore (A) **105**, was replaced with only an EVA layer (no chromophore with UV-blue conversion).

Measurement of Device Transmission

The transmission spectrum with exposure to standard one sun (AM1.5G) radiation of the Example 19 and Comparative Example 20 devices were measured using a UV-Vis-NIR Spectrophotometer model UltraScan® PRO from HunterLab, and it was found that the Example 19 device had 7% more blue light transmitted from the luminescent panel compared to the Comparative Example 20 device.

Example 21

An Example 21 luminescent light and energy collection panel was constructed comprising two wavelength conversion layers **100** and a glass plate **112**, and a solar energy conversion device **103** similar to the structure shown

in Figure 15, where the layers were placed on top of each other and adhered together due to the natural stickiness of the wavelength conversion film. The panel had major planar surface area dimensions of approximately 6 inches by 6 inches. The solar radiation **113** was incident on the glass plate, with the wavelength conversion layer comprising chromophore (A) **105** (Compound 3) in the second layer, and the wavelength conversion layer comprising chromophore (B) **106** (Compound 5) in the third layer. A crystalline silicon solar cell (c-Si) device (from IXYS Corporation), with dimensions 6 inches x 1.0 cm and conversion efficiency of 15%, was positioned inside of the wavelength conversion layer comprising chromophore (A) **105**, with the light incident surface of the solar cell facing the glass plate.

Comparative Example 22

A Comparative Example 22 device was constructed similar to Example 21, except that the wavelength conversion layer comprising chromophore (A) **105**, was replaced with only an EVA layer (no chromophore with UV-blue conversion).

Measurement of the Efficiency

The Solar cell photoelectric conversion efficiency was measured by a Newport 300W full spectrum solar simulator system. The light intensity was adjusted to one sun (AM1.5G) by a 6in x 1cm calibrated reference monocrystalline silicon solar cell. The solar cell efficiency within the Example 21 and Comparative Example 22 devices was measured and compared. A 3% increase in efficiency was observed for the Example 21 device compared to the Comparative Example 22 device.

Example 23

For Example 23 the same luminescent light and energy collection panel was used that was constructed in Example 21, except that it was turned upside down, so that the sun light was incident on the wavelength conversion layer comprising chromophore (B) 106. In this Example 23, the light incident surface of the solar cell is not facing the sun light, and therefore only indirect guided luminescent light may reach the solar cell.

Comparative Example 24

Similarly, for Comparative Example 24, the same device constructed for Comparative Example 22 was used, except it was turned upside down for exposure to the solar radiation. In this Comparative Example 24, the light incident surface of the solar cell is not facing the sun light, and therefore only indirect guided luminescent light may reach the solar cell.

Measurement of the Efficiency

The Solar cell photoelectric conversion efficiency was measured by a Newport 300W full spectrum solar simulator system. The light intensity was adjusted to one sun (AM1.5G) by a 6in x 1cm calibrated reference monocrystalline silicon solar cell. The solar cell efficiency within the Example 23 and Comparative Example 24 devices was measured and compared. A 13% increase in efficiency was observed for the Example 23 device compared to the Comparative Example 24 device.

The Example 17-20 devices show that the use of a luminescent panel with a first organic photostable chromophore (A), and a second organic photostable chromophore (B), wherein (A) and (B) are located in two separate wavelength conversion layers, wherein said wavelength conversion layer(s) further comprise(s) a polymer matrix, and wherein (A) acts to absorb photons in the range of 300 to 450 nm and re-emit these photons in the range of 400 to 520 nm, and wherein (B) acts to absorb photons in the range of 480 to 620 nm and re-emit these photons in the range of 550 to 800 nm, showed increased transmission of blue light. The increased transmission of blue light through the luminescent panel is useful for enhancing plant growth within a greenhouse.

Further, the Example 21-24 devices show that the solar cell conversion efficiency is also enhanced in luminescent light and energy collection panels comprising a first organic photostable chromophore (A), and a second organic photostable chromophore (B), wherein (A) and (B) are located in two separate wavelength conversion layers, wherein said wavelength conversion layer(s) further comprise(s) a polymer matrix, and wherein (A) acts to absorb photons in the range of 300 to 450 nm and re-emit these photons in the range of 400 to 520 nm, and wherein (B) acts to absorb photons in the range of 480 to 620 nm and re-emit these photons in the range of 550 to 800 nm, compared to devices which only have one photostable chromophore.

An object of this current invention is to provide a luminescent panel that enhances plant growth and also to

provide a luminescent light and energy collection panel that simultaneously enhances plant growth and solar electricity generation when installed as a roof for a greenhouse, compared to panels that do not incorporate two organic photostable chromophores. As illustrated by the above examples, the use of the luminescent panel and the luminescent light and energy collection panel provides improved blue light transmission and increased solar cell efficiency compared to devices with only one chromophore.

The following prophetic examples demonstrate potential results using the panels described herein.

Example 25

Two greenhouses are fabricated. The first green house is fabricated using conventional greenhouse windows and the second is fabricated using the luminescent panels from Example 17. Tomato plant saplings of approximately the same size and age are grown either the first greenhouse or the second green house. After 6 weeks, the tomato plants produce fruit. The tomato plants from the second greenhouse produce 20% more fruit than the tomato plants from the first greenhouse. The tomatoes from the second greenhouse are 10% larger on average than the tomatos from the first greenhouse.

Example 26

Two greenhouses are fabricated. The first green house is fabricated using greenhouse windows containing an embedded commercially available UV absorber and chromophore. The second is fabricated using the luminescent panels from Example 18. Pumpkin seeds are planted and grown in either the first greenhouse or the second green house. After 8 weeks, pumpkins are ready to harvest. The pumpkin plants from the second greenhouse produce 15% more pumpkins on average than the pumpkin plants from the first greenhouse. The pumpkins from the second greenhouse are 18% larger on average than the pumpkins from the first greenhouse.

## Claims

**1.** A wavelength conversion film, comprising:

an optically transparent polymer matrix;
a first organic photostable chromophore having an absorption maximum less than 400 nm and an emission maximum greater than 400 nm,

wherein the first organic photostable chromophore is represented by formula (I):

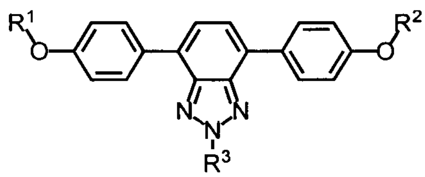

(I)

wherein each of $R^1$, $R^2$, and $R^3$ is independently selected from the group consisting of alkyl, a substituted alkyl, and aryl.

**2.** A wavelength conversion film, comprising:

an optically transparent polymer matrix;

a first organic photostable chromophore having an absorption maximum less than 400 nm and an emission maximum greater than 400 nm,
wherein the first organic photostable chromophore is represented by formula (II-a) or (II-b):

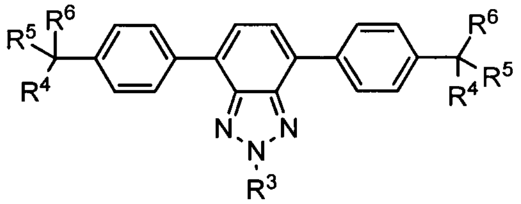
(II-a),
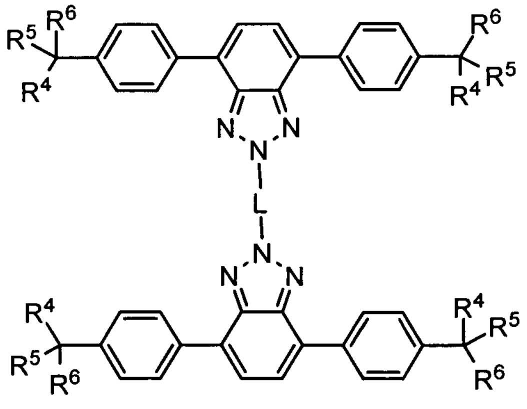
(II-b);

wherein:

$R^3$ is selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, optionally substituted carbonyl, optionally substituted ether, optionally substituted ketone, optionally substituted sulfone, and optionally substituted sulfonamide; or $R^3$ is an optionally substituted polycyclic ring system, wherein each ring is independently cycloalkyl, aryl, heterocycloalkyl, or heteroaryl;

$R^4$, $R^5$, and $R^6$ are independently selected from the group consisting of optionally substituted alkyl, optionally substituted alkenyl, optionally substituted cycloalkyl, optionally substituted heteroalkyl, optionally substituted aryl, optionally substituted heteroaryl, optionally substituted alkoxyalkyl, optionally substituted heteroalkenyl, optionally substituted arylalkyl, optionally substituted heteroaryl, optionally substituted heteroarylalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, and optionally substituted carboxy, and optionally substituted carbonyl, optionally substituted ether, optionally substituted ketone, optionally substituted sulfone, and optionally substituted sulfonamide; or $R^4$ and $R^5$, $R^4$ and $R^6$, $R^5$ and $R^6$, or $R^4$ and $R^5$ and $R^6$, together form an optionally substituted ring or an optionally substituted polycyclic ring system, wherein each ring is independently cycloalkyl, aryl, heterocyclalkyl, or heteroaryl; and

L is selected from the group consisting of optionally substituted alkyl, optionally substituted heteroalkyl, optionally substituted alkylene, and optionally substituted heteroalkylene, optionally substituted alkynylene, optionally substituted arylene, optionally substituted heteroarylene.

**3.** The wavelength conversion film of any one of Claims 1 or 2, further comprising a second organic photostable chromophore, wherein the second organic photostable chromophore is represented by formula (III-a) or (III-b):

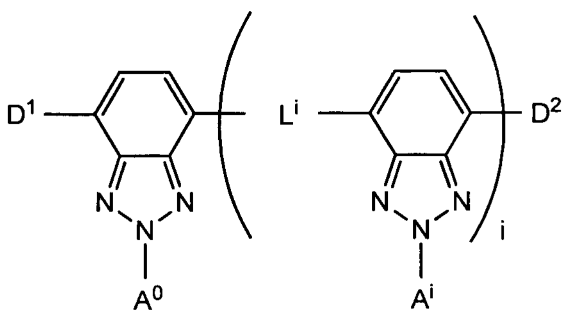
(III-a)
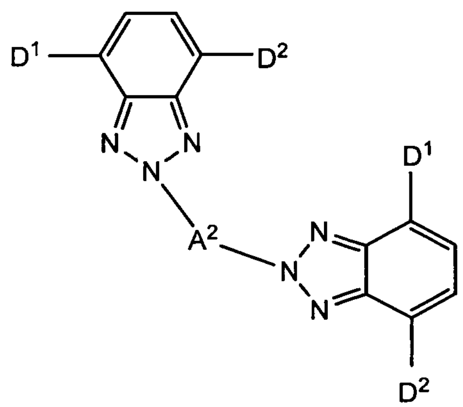
(III-b)

wherein:

i is an integer in the range of 0 to 100;

$A^0$ and $A^i$ are each independently selected from the group consisting of optionally substituted alkyl, optionally substituted alkyenyl, optionally substituted heteroalkyl, optionally substituted aryl, optionally substituted heteroaryl, optionally substituted amino, optionally substituted amido, optionally substituted cyclo amido, optionally substituted cyclo imido, optionally substituted alkoxy, and optionally substituted carboxy, and optionally substituted carbonyl;

$A^2$ is selected from the group consisting of optionally substituted alkylene, optionally substituted alkenylene, optionally substituted arylene, optionally substituted heteroarylene, ketone, ester, and

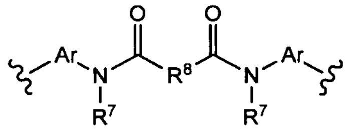

;

wherein Ar is optionally substituted aryl or optionally substituted heteroaryl; $R^7$ is selected from the group consisting of H, alkyl, alkenyl, aryl, heteroaryl, aralkyl, alkaryl; and $R^8$ is selected from the group consisting of optionally substituted alkylene, optionally substituted alkenylene, optionally substituted arylene, optionally substituted heteroarylene, ketone, and ester; or $R^7$ and $R^8$ may be connected together to form a ring.

$D^1$ and $D^2$ are independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclo amido, and cyclo imido, provided that $D^1$ and $D^2$ are not both hydrogen; and

$L^i$ is independently selected from the group consisting of optionally substituted alkylene, optionally substituted alkenylene, optionally substituted alkynylene, optionally substituted arylene, and optionally substituted heteroarylene.

**4.** The wavelength conversion film of any one of Claims 1 or 2, further comprising a second organic photostable chromophore, wherein the second organic photostable chromophore is represented by formula (IV-a) or (IV-b):

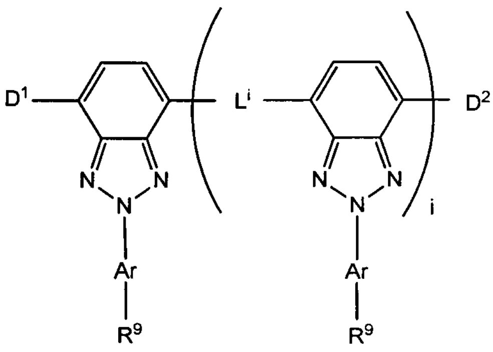

(IV-a),

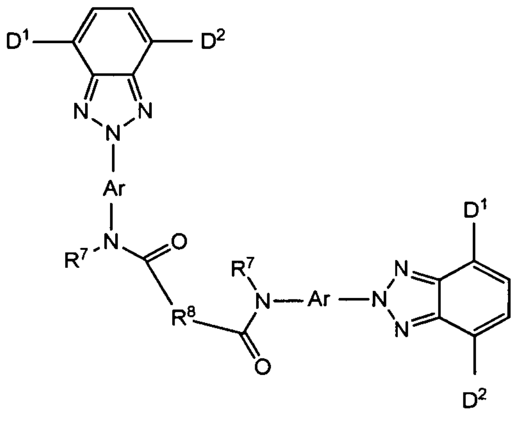

(IV-b);

wherein:

i is an integer in the range of 0 to 100;

Ar is optionally substituted aryl or optionally substituted heteroaryl;

$R^9$ is

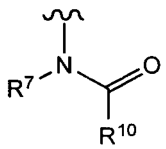

or optionally substituted cyclic imido;

$R^7$ is each independently selected from the group consisting of H, alkyl, alkenyl, aryl, heteroaryl, aralkyl, and alkaryl;

$R^{10}$ is each independently selected from the group consisting of optionally substituted alkyl, optionally substituted alkenyl, optionally substituted aryl, and optionally substituted heteroaryl; or $R^7$ and $R^{10}$ may be connected together to form a ring;

$R^8$ is selected from the group consisting of optionally substituted alkylene, optionally substituted alkenylene, optionally substituted arylene, optionally substituted heteroarylene;

$D^1$ and $D^2$ are each independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, provided that $D^1$ and $D^2$ are not both hydrogen; and

$L^i$ is independently selected from the group consisting of optionally substituted alkylene, optionally substituted alkenylene, optionally substituted alkynylene, optionally substituted arylene, optionally substituted heteroarylene.

**5.** The wavelength conversion film of any one of Claims 1 or 2, further comprising a second organic photostable chromophore, wherein the second organic photostable chromophore is represented by formula (V-a) or (V-b):

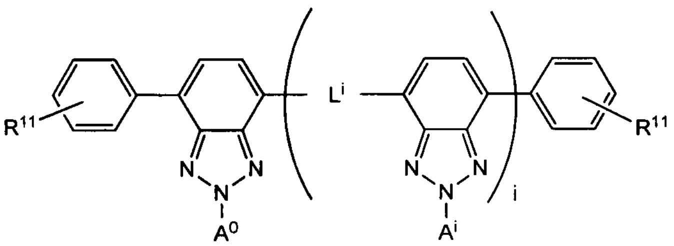

,

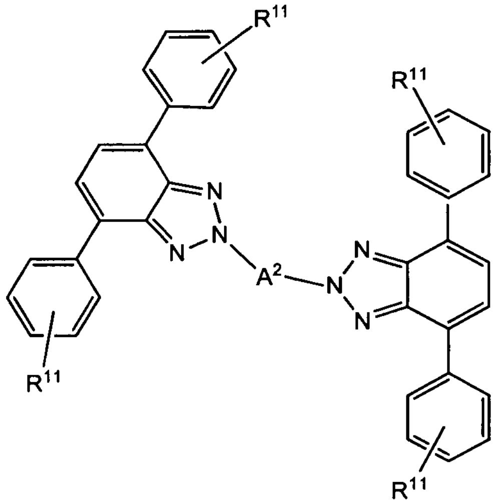

(V-a) (V-b);

wherein:

i is an integer in the range of 0 to 100.

$A^0$ and $A^i$ are each independently selected from the group consisting of optionally substituted alkyl, optionally substituted alkenyl, optionally substituted heteroalkyl, optionally substituted amido, optionally substituted alkoxy, optionally substituted cabonyl, and optionally substituted carboxy;

each $R^{11}$ is independently selected from the group consisting of optionally substituted alkoxy, optionally substituted aryloxy, optionally substituted acyloxy, and amino;

$A^2$ is selected from the group consisting of optionally substituted alkylene, optionally substituted alkenylene, optionally substituted arylene, optionally substituted heteroarylene, ketone, ester, and

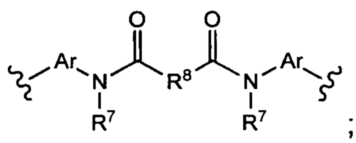

;

wherein Ar is optionally substituted aryl or optionally substituted heteroaryl; $R^7$ is selected from the group consisting of H, alkyl, alkenyl, aryl, heteroaryl, aralkyl, alkaryl; and $R^8$ is selected from the group consisting of optionally substituted alkylene, optionally substituted alkenylene, optionally substituted arylene, optionally substituted heteroarylene, ketone, and ester; or $R^7$ and $R^8$ may be connected together to form a ring; and

$L^i$ is independently selected from the group consisting of optionally substituted alkylene, optionally substituted alkenylene, optionally substituted alkynylene, optionally substituted arylene, optionally substituted heteroarylene.

6. The wavelength conversion film of any one of Claims 1 or 2, further comprising a second organic photostable chromophore, wherein the second organic photostable chromophore is represented by formula (VI):

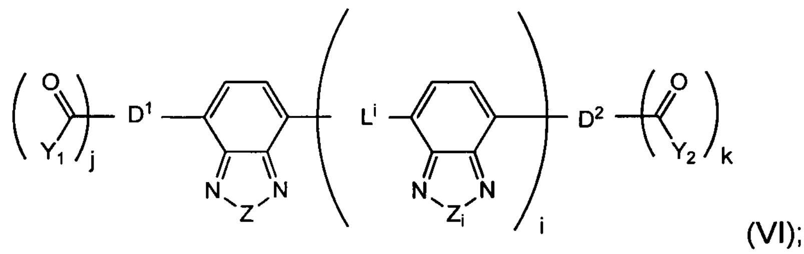

(VI);

wherein,

i is an integer in the range of 0 to 100;

Z and $Z_i$ are each independently selected from the group consisting of -O-,-S-, -Se-, -Te-, $-NR^{12}-$, $-CR^{12}=CR^{12}-$, and $-CR^{12}=N-$, wherein $R^{12}$ is hydrogen, optionally substituted $C_1$-$C_6$ alkyl, or optionally substituted $C_1$-$C_{10}$ aryl; and

$D^1$ and $D^2$ are independently selected from the group consisting of optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido;

j is 0, 1 or 2, and k is 0, 1, or 2;

$Y_1$ and $Y_2$ are independently selected from the group consisting of optionally substituted aryl, optionally substituted alkyl, optionally substituted cycloalkyl, optionally substituted alkoxy, and optionally substituted amino; and

$L^i$ is independently selected from the group consisting of optionally substituted alkylene, optionally substituted alkenylene, optionally substituted alkynylene, optionally substituted arylene, optionally substituted heteroarylene.

7. The wavelength conversion film of any one of Claims 1 or 2, further comprising a second organic photostable chromophore, wherein the second organic photostable chromophore is represented by formula (VII-a) or formula (VII-b):

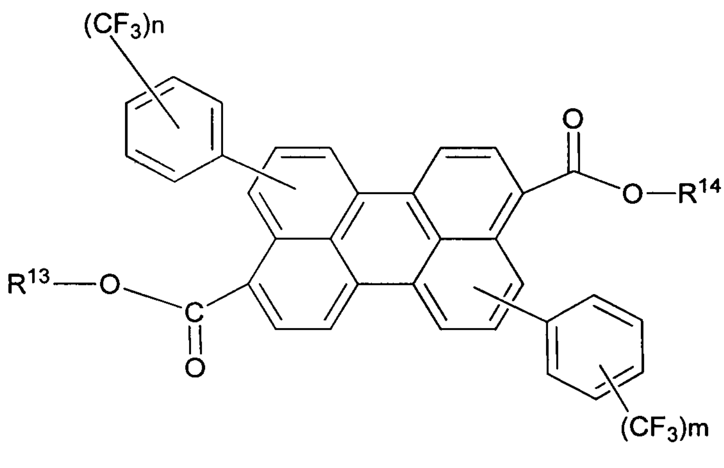

(VII-a)

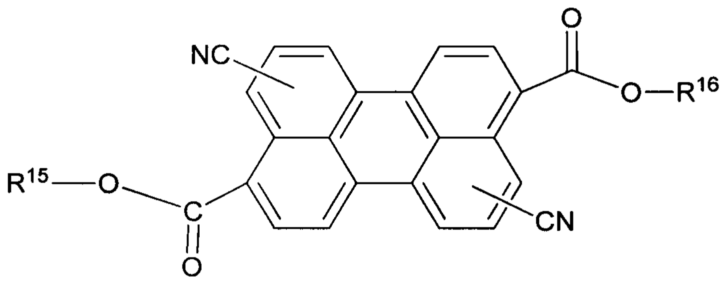

(VII-b);

wherein $R^{13}$ and $R^{14}$ in formula (VII-a) are each independently selected from the group consisting of hydrogen, $C_1$-$C_{10}$ alkyl, $C_3$-$C_{10}$ cycloalkyl, $C_1$-$C_{10}$ alkoxy, $C_6$-$C_{18}$ aryl, and $C_6$-$C_{20}$ aralkyl; m and n in formula (VII-a) are each independently in the range of from 1 to 5; and $R^{15}$ and $R^{16}$ in formula (VII-b) are each independently selected from the group consisting of a $C_6$-$C_{18}$ aryl and $C_6$-$C_{20}$ aralkyl.

**8.** The wavelength conversion film of any one of Claims 1 or 2, further comprising a second organic photostable chromophore, wherein the second organic photostable chromophore is represented by formula (VIII):

$$D_1{-}\mathrm{Het}\left(-L-\mathrm{Het}\right)_i D_2 \quad \text{(VIII)}$$

wherein Het is selected from the group consisting of:

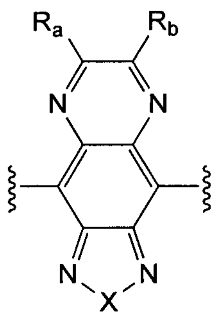
,
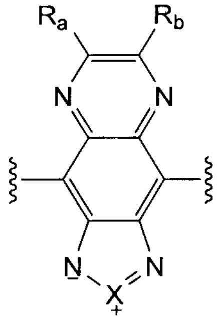
,
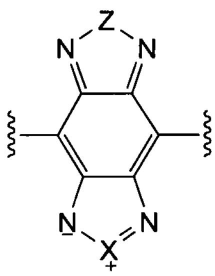
,
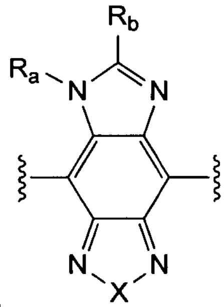
,

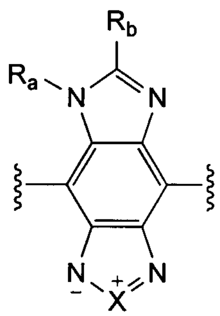
,
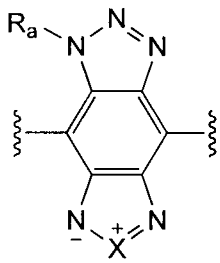
,
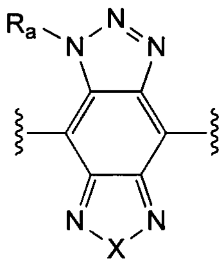
,
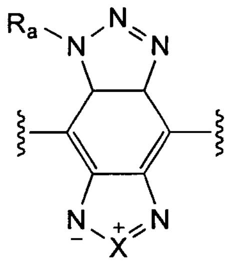
,

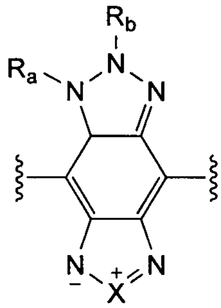, 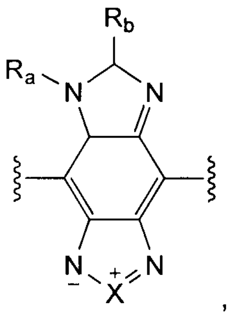, and 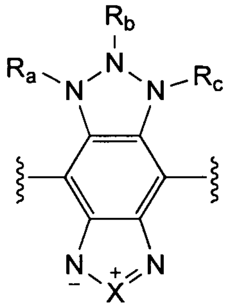;

wherein:

i is 0 or an integer in the range of 1 to 100;

X is selected from the group consisting of -N($A_0$)-, -O-, -S-, -Se-, and -Te-;

Z is selected from the group consisting of -N($R_a$)-, -O-, -S-, -Se-, and -Te-;

$A_0$ is selected from the group consisting of hydrogen, optionally substituted alkyl, optionally substituted alkenyl, optionally substituted heteroalkyl, optionally substituted aryl, optionally substituted heteroaryl, optionally substituted amino, optionally substituted amido, optionally substituted cyclic amido, optionally substituted cyclic imido, optionally substituted alkoxy, optionally substituted acyl, optionally substituted carboxy, and optionally substituted carbonyl;

$R_a$, $R_b$, and $R_c$, are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl;

$D_1$ and $D_2$ are independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, -aryl-NR'R", -aryl-aryl-NR'R", and -heteroaryl-heteroaryl-R'; wherein R' and R" are independently selected from the group consisting of optionally substituted alkyl, optionally substituted alkenyl, optionally substituted aryl; provided that $D_1$ and $D_2$ are not both hydrogen, and $D_1$ and $D_2$ are not optionally substituted thiophene or optionally substituted furan; and,

L is independently selected from the group consisting of optionally substituted alkyl, optionally substituted aryl, optionally substituted heteroaryl, amino, amido, imido, optionally substituted alkoxy, acyl, carboxy, provided that L is not optionally substituted thiophen or optionally substituted furan.

**9.** The wavelength conversion film of any one of Claims 1 or 2, wherein the second organic photostable chromophore is represented by formula (IX-a) or formula (IX-b):

$Het_2$-$A_0$-$Het_2$ (IX-a),

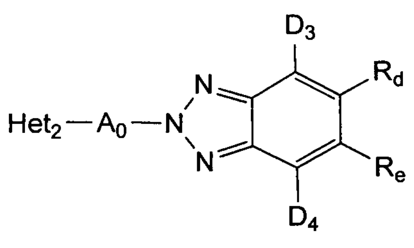

**(IX-b)**

wherein $Het_2$ is selected from the group consisting of:

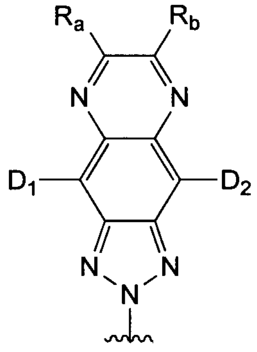 , 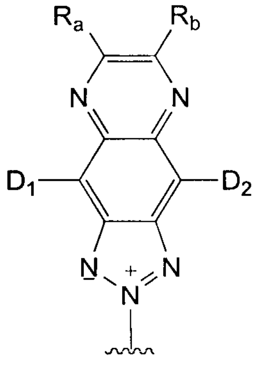 , 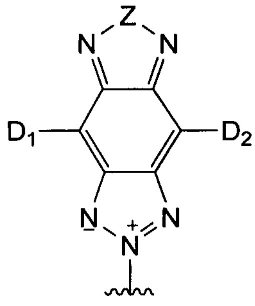 , 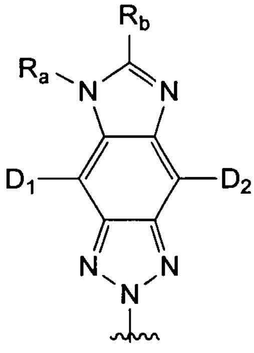 ,

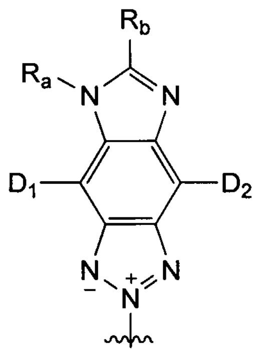 , 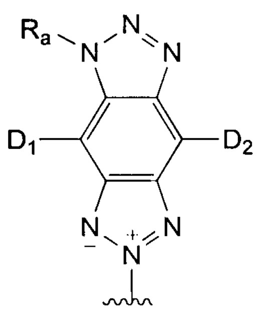 , 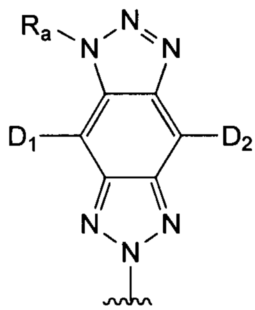 , 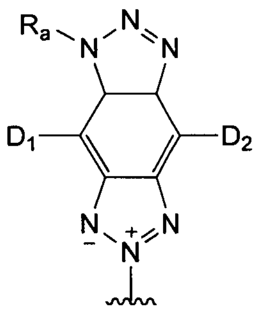 ,

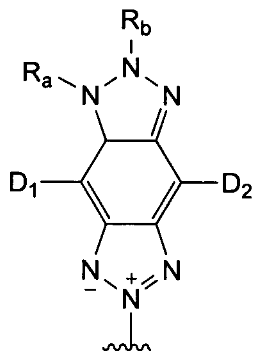 , 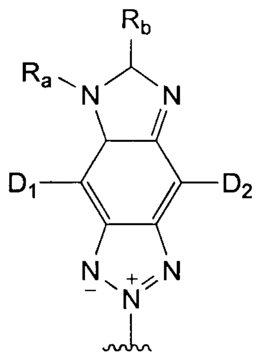 , and 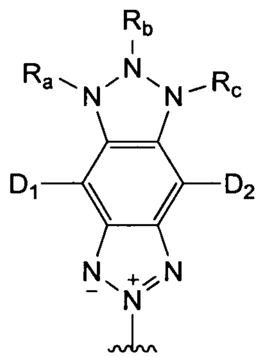 ;

wherein:

Z is selected from the group consisting of $-N(R_a)-$, -O-, -S-, -Se-, and -Te-;

$R_a$, $R_b$, and $R_c$, are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl;

$R_d$ and $R_e$ are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_d$ and $R_e$ together form an optionally substituted

ring or an optionally substituted polycyclic ring system, wherein each ring is independently cycloalkyl, aryl, heterocyclyl, or heteroaryl;

$D_1$, $D_2$, $D_3$, and $D_4$ are independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, -aryl-NR'R", -aryl-aryl-NR'R", and -heteroaryl-heteroaryl-R'; wherein R' and R" are independently selected from the group consisting of optionally substituted alkyl, optionally substituted alkenyl, optionally substituted aryl; provided that $D_1$ and $D_2$ are not both hydrogen, and $D_1$ and $D_2$ are not optionally substituted thiophen or optionally substituted furan.

**10.** The wavelength conversion film of any one of Claims 1 or 2, wherein the second organic photostable chromophore is represented by formula (X-a) or (X-b):

$$Het_3\text{-}R_a\text{-}Het_3 \qquad (X\text{-}a),$$

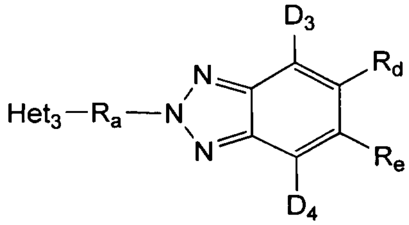

(X-b)

wherein $Het_3$ is selected from the group consisting of:

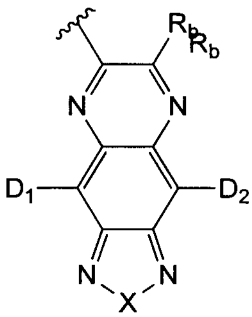
,
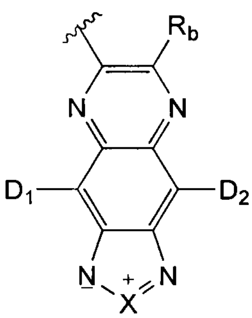
,
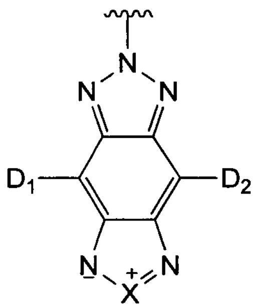
,
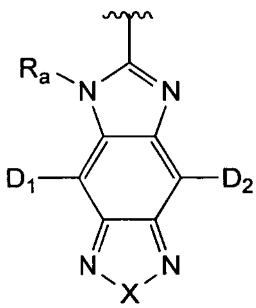
,
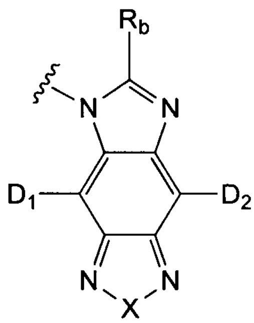
,
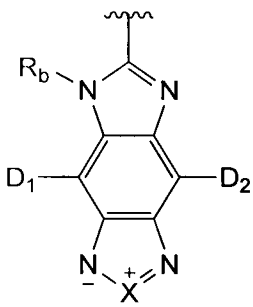
,
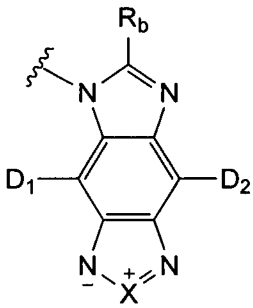
,
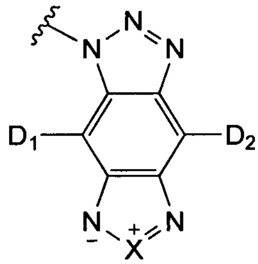
,

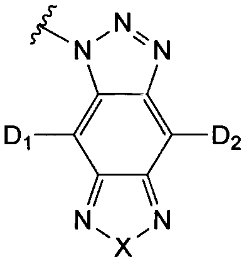 , 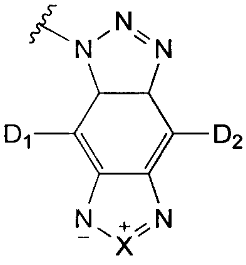 , 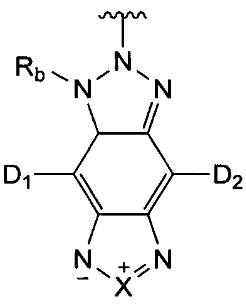 , 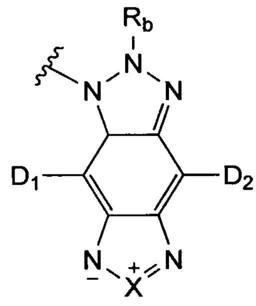 ,

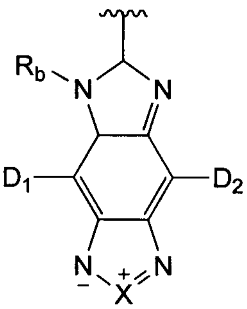 , 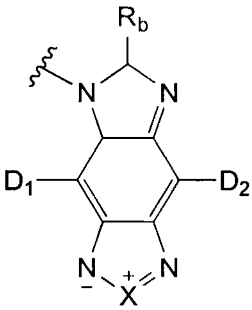 , 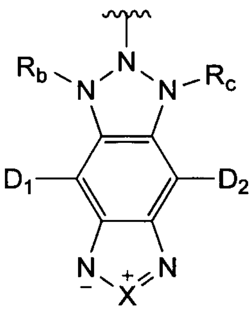 , and 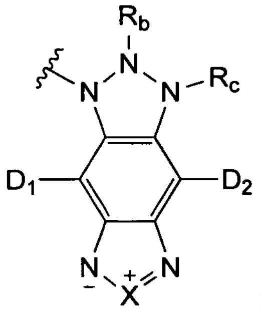 ;

wherein:

X is selected from the group consisting of -N($A_0$)-, -O-, -S-, -Se-, and -Te-;

$A_0$ is selected from the group consisting of hydrogen, optionally substituted alkyl, optionally substituted alkenyl, optionally substituted heteroalkyl, optionally substituted aryl, optionally substituted heteroaryl, optionally substituted amino, optionally substituted amido, optionally substituted cyclic amido, optionally substituted cyclic imido, optionally substituted alkoxy, optionally substituted acyl, optionally substituted carboxy, and optionally substituted carbonyl;

$R_a$, $R_b$, and $R_c$, are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_a$ and $R_b$, or $R_b$ and $R_c$, or $R_a$ and $R_c$, together form an optionally substituted ring or an optionally substituted polycyclic ring system, wherein each ring is independently cycloalkyl, aryl, heterocyclyl, or heteroaryl; $R_d$ and $R_e$ are independently selected from the group consisting of hydrogen, optionally substituted alkyl, optionally substituted alkoxyalkyl, optionally substituted alkenyl, optionally substituted heteroalkyl, optionally substituted heteroalkenyl, optionally substituted aryl, optionally substituted arylalkyl, optionally substituted heteroaryl, optionally substituted cylcoalkyl, optionally substituted cycloalkenyl, optionally substituted cycloheteroalkyl, optionally substituted cycloheteroalkenyl, optionally substituted amino, optionally substituted amido, optionally substituted cyclic amido, optionally substituted cyclic imido, optionally substituted alkoxy, optionally substituted carboxy, and optionally substituted carbonyl; or $R_d$ and $R_e$ together form an optionally substituted ring or an optionally substituted polycyclic ring system, wherein each ring is independently cycloalkyl, aryl, heterocyclyl, or heteroaryl;

$D_1$, $D_2$, $D_3$, and $D_4$ are independently selected from the group consisting of hydrogen, optionally substituted alkoxy, optionally substituted aryloxy, optionally substituted acyloxy, optionally substituted alkyl, optionally substituted aryl, optionally substituted heteroaryl, optionally substituted amino, amido, cyclic amido, and cyclic imido, -aryl-NR'R", -aryl-aryl-NR'R", and -heteroaryl-heteroaryl-R'; wherein R' and R" are independently selected from the group consisting of optionally substituted alkyl, optionally substituted alkenyl, and optionally substituted aryl; provided that $D_1$ and $D_2$ are not both hydrogen, and $D_1$ and $D_2$ are not optionally substituted thiophen or optionally substituted furan.

**11.** The wavelength conversion film of any one of Claims 2 to 10, wherein the absorption maximum of the first chromophore is less than 400 nm and the absorption maximum of the second chromophore is greater than 400 nm.

**12.** A photovoltaic module comprising:

at least one photovoltaic device; and
the wavelength conversion film according to any of Claims 1 to 11, wherein the wavelength conversion film is configured to encapsulate the at least one photovoltaic device such that incident light passes through the wavelength conversion film prior to reaching the at least one photovoltaic device.

**13.** The photovoltaic module of Claim 12, wherein the photovoltaic device comprises at least one device selected from the group consisting of a Silicon based device, a III-V or II-VI PN junction device, a Copper-Indium-Gallium-Selenium (CIGS) thin film device, an organic sensitizer device, an organic thin film device, and a Cadmium Sulfide/Cadmium Telluride (CdS/CdTe) thin film device.

**14.** A luminescent panel comprising at least one wavelength conversion film according to any one of Claims 1 to 11.

**Patentansprüche**

**1.** Wellenlängenumwandlungsfilm, umfassend:

eine optisch transparente Polymermatrix;
einen ersten organischen photostabilen Chromophor mit einem Absorptionsmaximum kleiner als 400 mm und einem Emissionsmaximum größer als 400 nm,
wobei der erste organische photostabile Chromophor durch Formel (I) wiedergegeben ist:

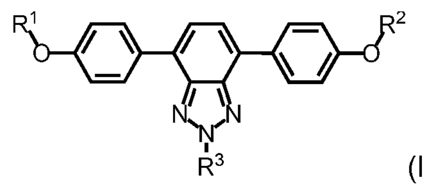
(I)

wobei jedes von $R^1$, $R^2$ und $R^3$ unabhängig ausgewählt ist aus der Gruppe bestehend aus Alkyl, einem substituierten Alkyl und Aryl.

**2.** Wellenlängenumwandlungsfilm, umfassend:

eine optisch transparente Polymermatrix;
einen ersten organischen photostabilen Chromophor mit einem Absorptionsmaximum kleiner als 400 nm und einem Emissionsmaximum größer als 400 nm,
wobei der erste organische photostabile Chromophor durch Formel (II-a) oder (II-b) wiedergegeben ist:

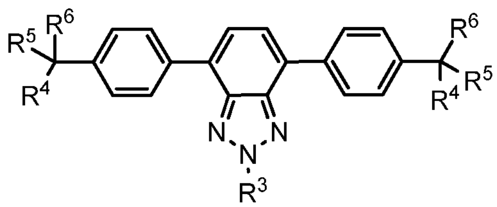
(II-a),
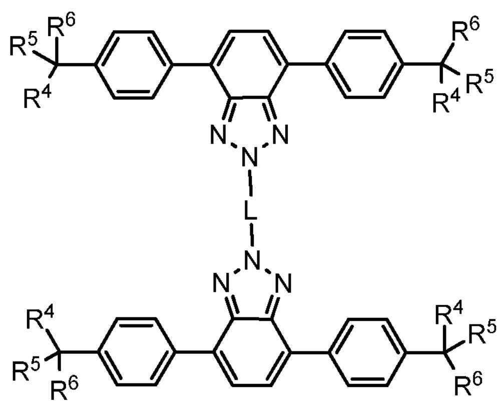
(II-b);

wobei:

$R^3$ ausgewählt ist aus der Gruppe bestehend aus gegebenenfalls substituiertem Alkyl, gegebenenfalls substituiertem Alkenyl, gegebenenfalls substituiertem Cycloalkyl, gegebenenfalls substituiertem Heteroalkyl, gegebenenfalls substituiertem Aryl, gegebenenfalls substituiertem Heteroaryl, gegebenenfalls substituiertem Alkoxyalkyl, gegebenenfalls substituiertem Heteroalkenyl, gegebenenfalls substituiertem Arylalkyl, gegebenenfalls substituiertem Heteroaryl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy und gegebenenfalls substituiertem Carboxy, gegebenenfalls substituiertem Carbonyl, gegebenenfalls substituiertem Ether, gegebenenfalls substituiertem Keton, gegebenenfalls substituiertem Sulfon und gegebenenfalls substituiertem Sulfonamid; oder $R^3$ ein gegebenenfalls substituiertes polycyclisches Ringsystem ist, wobei jeder Ring unabhängig Cycloalkyl, Aryl, Heterocycloalkyl oder Heteroaryl ist;

$R^4$, $R^5$ und $R^6$ unabhängig ausgewählt sind aus der Gruppe bestehend aus gegebenenfalls substituiertem Alkyl, gegebenenfalls substituiertem Alkenyl, gegebenenfalls substituiertem Cycloalkyl, gegebenenfalls substituiertem Heteroalkyl, gegebenenfalls substituiertem Aryl, gegebenenfalls substituiertem Heteroaryl, gegebenenfalls substituiertem Alkoxyalkyl, gegebenenfalls substituiertem Heteroalkenyl, gegebenenfalls substituiertem Arylalkyl, gegebenenfalls substituiertem Heteroaryl, gegebenenfalls substituiertem Heteroarylalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, und gegebenenfalls substituiertem Carboxy und gegebenenfalls substituiertem Carbonyl, gegebenenfalls substituiertem Ether, gegebenenfalls substituiertem Keton, gegebenenfalls substituiertem Sulfon und gegebenenfalls substituiertem Sulfonamid; oder $R^4$ und $R^5$, $R^4$ und $R^6$, $R^5$ und $R^6$, oder $R^4$ und $R^5$ und $R^6$ zusammen einen gegebenenfalls substituierten Ring oder ein gegebenenfalls substituiertes polycyclisches Ringsystem bilden, wobei jeder Ring unabhängig Cycloalkyl, Aryl, Heterocycloalkyl, oder Heteroaryl ist; und

L ausgewählt ist aus der Gruppe bestehend aus gegebenenfalls substituiertem Alkyl, gegebenenfalls substituiertem Heteroalkyl, gegebenenfalls substituiertem Alkylen, und gegebenenfalls substituiertem Heteroalkylen, gegebenenfalls substituiertem Alkinylen, gegebenenfalls substituiertem Arylen, gegebenenfalls substituiertem Heteroarylen.

**3.** Wellenlängenumwandlungsfilm nach einem der Ansprüche 1 oder 2, außerdem umfassend einen zweiten organischen photostabilen Chromophor, wobei der zweite organische photostabile Chromophor durch Formel (III-a) oder (III-b) wiedergegeben ist:

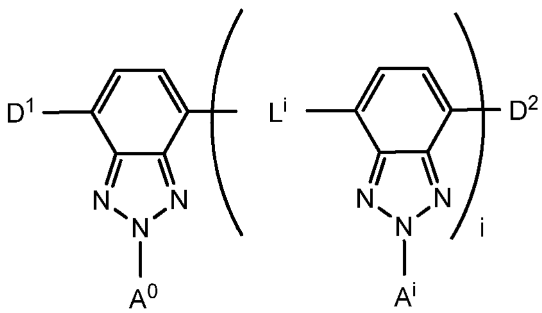
(III-a)

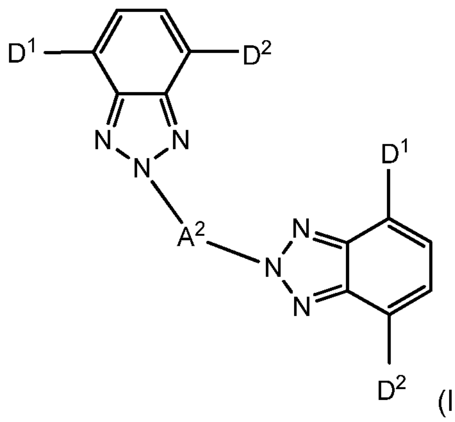
(III-b)

wobei:

i eine ganze Zahl im Bereich von 0 bis 100 ist;

$A^0$ und $A^i$ jeweils unabhängig ausgewählt sind aus der Gruppe bestehend aus gegebenenfalls substituiertem Alkyl, gegebenenfalls substituiertem Alkenyl, gegebenenfalls substituiertem Heteroalkyl, gegebenenfalls substituiertem Aryl, gegebenenfalls substituiertem Heteroaryl, gegebenenfalls substituiertem Amino, gegebenenfalls substituiertem Amido, gegebenenfalls substituiertem Cycloamido, gegebenenfalls substituiertem Cycloimido, gegebenenfalls substituiertem Alkoxy, und gegebenenfalls substituiertem Carboxy und gegebenenfalls substituiertem Carbonyl;

$A^2$ ausgewählt ist aus der Gruppe bestehend aus gegebenenfalls substituiertem Alkylen, gegebenenfalls substituiertem Alkenylen, gegebenenfalls substituiertem Arylen, gegebenenfalls substituiertem Heteroarylen, Keton, Ester und

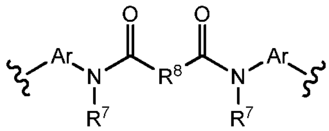

;

wobei Ar gegebenenfalls substituiertes Aryl oder gegebenenfalls substituiertes Heteroaryl ist; $R^7$ ausgewählt ist aus der Gruppe bestehend aus H, Alkyl, Alkenyl, Aryl, Heteroaryl, Aralkyl, Alkaryl; und $R^8$ ausgewählt ist aus der Gruppe bestehend aus gegebenenfalls substituiertem Alkylen, gegebenenfalls substituiertem Alkenylen, gegebenenfalls substituiertem Arylen, gegebenenfalls substituiertem Heteroarylen, Keton und Ester; oder $R^7$ und $R^8$ miteinander verbunden sein können unter Bildung eines Rings,

$D^1$ und $D^2$ unabhängig ausgewählt sind aus der Gruppe bestehend aus Wasserstoff, gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, Cycloamido und Cycloimido, vorausgesetzt, dass $D^1$ und $D^2$ nicht beide Wasserstoff sind; und

$L^i$ unabhängig ausgewählt ist aus der Gruppe bestehend aus gegebenenfalls substituiertem Alkylen, gegebenenfalls substituiertem Alkenylen, gegebenenfalls substituiertem Alkinylen, gegebenenfalls substituiertem Arylen und gegebenenfalls substituiertem Heteroarylen.

**4.** Wellenlängenumwandlungsfilm nach einem der Ansprüche 1 oder 2, außerdem umfassend einen zweiten organischen photostabilen Chromophor, wobei der zweite organische photostabile Chromophor durch Formel (IV-a) oder (IV-b) wiedergegeben ist:

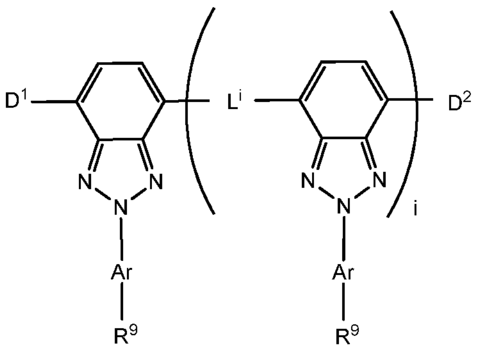

(IV-a),

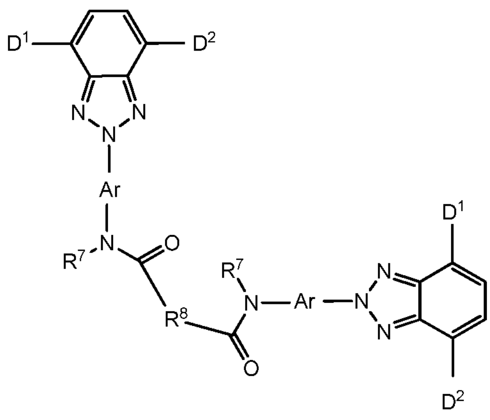

(IV-b);

wobei:

i eine ganze Zahl im Bereich von 0 bis 100 ist;

Ar gegebenenfalls substituiertes Aryl oder gegebenenfalls substituiertes Heteroaryl ist;

$R^9$

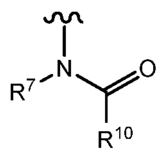

oder gegebenenfalls substituiertes cyclisches Imido ist;

$R^7$ jeweils unabhängig ausgewählt ist aus der Gruppe bestehend aus H, Alkyl, Alkenyl, Aryl, Heteroaryl, Aralkyl und Alkaryl;
$R^{10}$ jeweils unabhängig ausgewählt ist aus der Gruppe bestehend aus gegebenenfalls substituiertem Alkyl, gegebenenfalls substituiertem Alkenyl, gegebenenfalls substituiertem Aryl und gegebenenfalls substituiertem Heteroaryl; oder $R^7$ und $R^{10}$ miteinander verbunden sein können unter Bildung eines Rings;
$R^8$ ausgewählt ist aus der Gruppe bestehend aus gegebenenfalls substituiertem Alkylen, gegebenenfalls substituiertem Alkenylen, gegebenenfalls substituiertem Arylen, gegebenenfalls substituiertem Heteroarylen;
$D^1$ und $D^2$ jeweils unabhängig ausgewählt sind aus der Gruppe bestehend aus Wasserstoff, gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, cyclischem Amido und cyclischem Imido, vorausgesetzt, dass $D^1$ und $D^2$ nicht beide Wasserstoff sind; und
$L^i$ unabhängig ausgewählt ist aus der Gruppe bestehend aus gegebenenfalls substituiertem Alkylen, gegebenenfalls substituiertem Alkenylen, gegebenenfalls substituiertem Alkinylen, gegebenenfalls substituiertem Arylen, gegebenenfalls substituiertem Heteroarylen.

**5.** Wellenlängenumwandlungsfilm nach einem der Ansprüche 1 oder 2, außerdem umfassend einen zweiten organischen photostabilen Chromophor, wobei der zweite organische photostabile Chromophor durch Formel (V-a) oder (V-b) wiedergegeben ist:

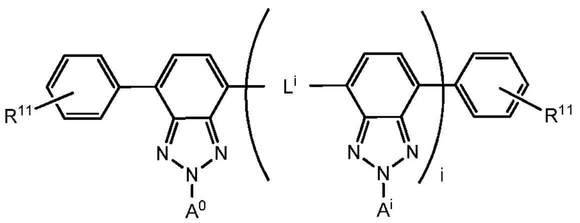

(V-a)

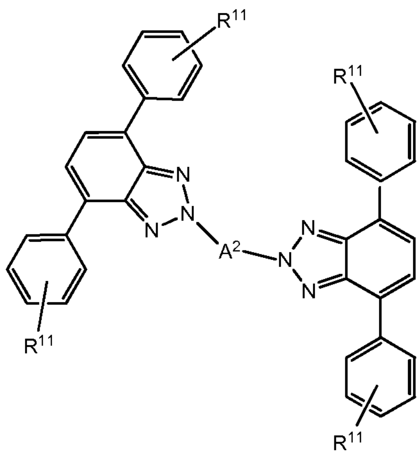

(V-b);

wobei:

i eine ganze Zahl im Bereich von 0 bis 100 ist,
$A^0$ und $A^i$ jeweils unabhängig ausgewählt sind aus der Gruppe bestehend aus gegebenenfalls substituiertem Alkyl, gegebenenfalls substituiertem Alkenyl, gegebenenfalls substituiertem Heteroalkyl, gegebenenfalls substituiertem Amido, gegebenenfalls substituiertem Alkoxy, gegebenenfalls substituiertem Carbonyl, und gegebenenfalls substituiertem Carboxy;
jedes $R^{11}$ unabhängig ausgewählt ist aus der Gruppe bestehend aus gegebenenfalls substituiertem Alkoxy, gegebenenfalls substituiertem Aryloxy, gegebenenfalls substituiertem Acyloxy und Amino;
$A^2$ ausgewählt ist aus der Gruppe bestehend aus gegebenenfalls substituiertem Alkylen, gegebenenfalls substituiertem Alkenylen, gegebenenfalls substituiertem Arylen, gegebenenfalls substituiertem Heteroarylen, Keton, Ester und

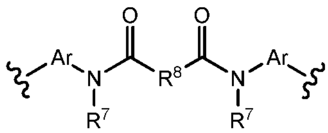
;

wobei Ar gegebenenfalls substituiertes Aryl oder gegebenenfalls substituiertes Heteroaryl ist; $R^7$ ausgewählt ist aus der Gruppe bestehend aus H, Alkyl, Alkenyl, Aryl, Heteroaryl, Aralkyl, Alkaryl; und $R^8$ ausgewählt ist aus der Gruppe bestehend aus gegebenenfalls substituiertem Alkylen, gegebenenfalls substituiertem Alkenylen, gegebenenfalls substituiertem Arylen, gegebenenfalls substituiertem Heteroarylen, Keton und Ester; oder $R^7$ und $R^8$ miteinander verbunden sein können unter Bildung eines Rings; und

$L^i$ unabhängig ausgewählt ist aus der Gruppe bestehend aus gegebenenfalls substituiertem Alkylen, gegebenenfalls substituiertem Alkenylen, gegebenenfalls substituiertem Alkinylen, gegebenenfalls substituiertem Arylen, gegebenenfalls substituiertem Heteroarylen.

**6.** Wellenlängenumwandlungsfilm nach einem der Ansprüche 1 oder 2, außerdem umfassend einen zweiten organischen photostabilen Chromophor, wobei der zweite organische photostabile Chromophor durch Formel (VI) wiedergegeben ist:

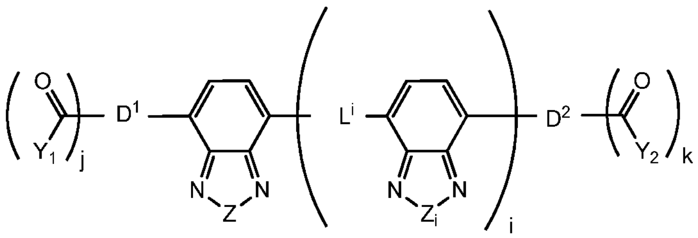
(VI);

wobei,

i eine ganze Zahl im Bereich von 0 bis 100 ist;

Z und $Z_i$ jeweils unabhängig ausgewählt sind aus der Gruppe bestehend aus -O-, -S-, -Se-, -Te-, $-NR^{12}-$, $-CR^{12}=CR^{12}-$, und $-CR^{12}=N-$, wobei $R^{12}$ Wasserstoff, gegebenenfalls substituiertes $C_1$-$C_6$-Alkyl, oder gegebenenfalls substituiertes $C_1$-$C_{10}$-Aryl ist; und

$D^1$ und $D^2$ unabhängig ausgewählt sind aus der Gruppe bestehend aus gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, cyclischem Amido und cyclischem Imido;

j 0, 1 oder 2 ist und k 0, 1 oder 2 ist;

$Y_1$ und $Y_2$ unabhängig ausgewählt sind aus der Gruppe bestehend aus gegebenenfalls substituiertem Aryl, gegebenenfalls substituiertem Alkyl, gegebenenfalls substituiertem Cycloalkyl, gegebenenfalls substituiertem Alkoxy und gegebenenfalls substituiertem Amino; und

$L^1$ unabhängig ausgewählt ist aus der Gruppe bestehend aus gegebenenfalls substituiertem Alkylen, gegebenenfalls substituiertem Alkenylen, gegebenenfalls substituiertem Alkinylen, gegebenenfalls substituiertem Arylen, gegebenenfalls substituiertem Heteroarylen.

**7.** Wellenlängenumwandlungsfilm nach einem der Ansprüche 1 oder 2, außerdem umfassend einen zweiten organischen photostabilen Chromophor, wobei der zweite organische photostabile Chromophor durch Formel (VII-a) oder Formel (VII-b) wiedergegeben ist:

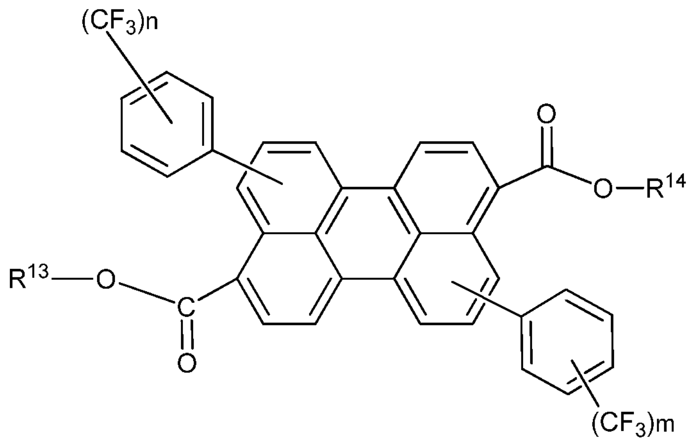

(VII-a)

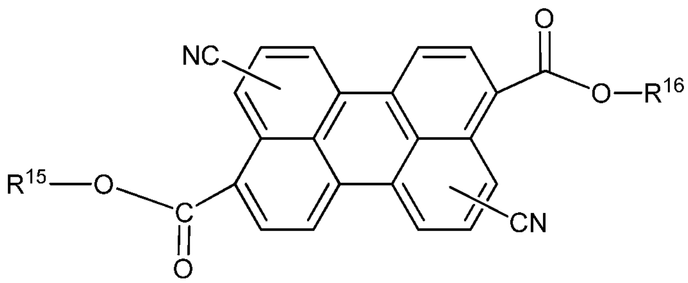

(VII-b);

wobei $R^{13}$ und $R^{14}$ in Formel (VII-a) jeweils unabhängig ausgewählt sind aus der Gruppe bestehend aus Wasserstoff, $C_1$-$C_{10}$-Alkyl, $C_3$-$C_{10}$-Cycloalkyl, $C_1$-$C_{10}$-Alkoxy, $C_6$-$C_{18}$-Aryl und $C_6$-$C_{20}$-Aralkyl; m und n in Formel (VII-a) jeweils unabhängig im Bereich von 1 bis 5 liegen; und $R^{15}$ und $R^{16}$ in Formel (VII-b) jeweils unabhängig ausgewählt sind aus der Gruppe bestehend aus einem $C_6$-$C_{18}$-Aryl und $C_6$-$C_{20}$-Aralkyl.

**8.** Wellenlängenumwandlungsfilm nach einem der Ansprüche 1 oder 2, außerdem umfassend einen zweiten organischen photostabilen Chromophor, wobei der zweite organische photostabile Chromophor durch Formel (VIII) wiedergegeben ist:

$$D_1-\mathrm{Het}\left(-L-\mathrm{Het}\right)_i-D_2 \quad \text{(VIII)}$$

wobei Het ausgewählt ist aus der Gruppe bestehend aus:

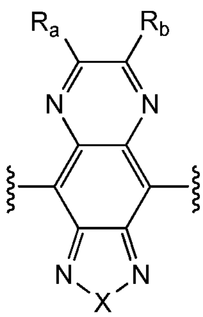

,

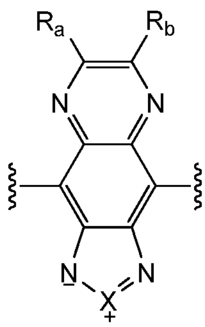

,

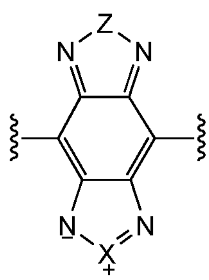

,

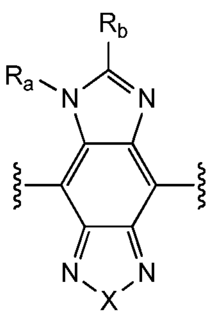

,

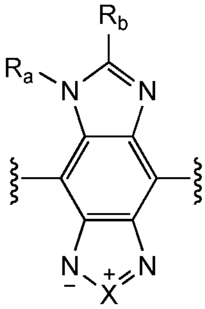,
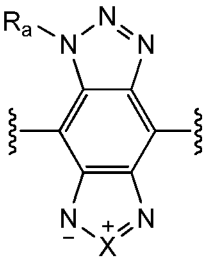,
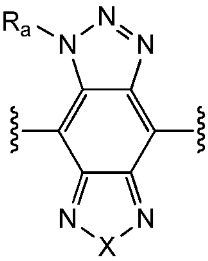,
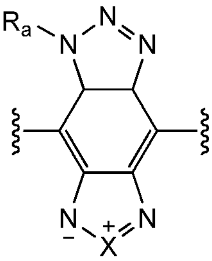,

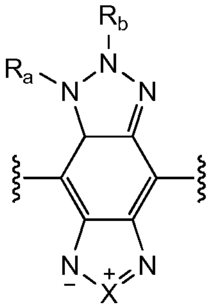,
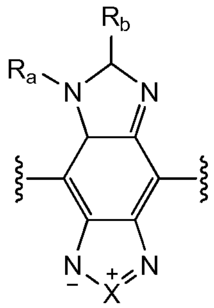, und
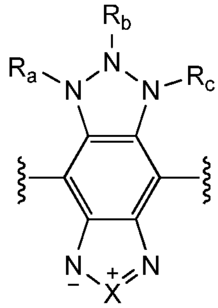;

wobei:

i 0 oder eine ganze Zahl im Bereich von 1 bis 100 ist;

X ausgewählt ist aus der Gruppe bestehend aus -N($A_0$)-, -O-, -S-, -Se-, und -Te-;

Z ausgewählt ist aus der Gruppe bestehend aus -N($R_a$)-, -O-, -S-, -Se-, und -Te-;

$A_0$ ausgewählt ist aus der Gruppe bestehend aus Wasserstoff, gegebenenfalls substituiertem Alkyl, gegebenenfalls substituiertem Alkenyl, gegebenenfalls substituiertem Heteroalkyl, gegebenenfalls substituiertem Aryl, gegebenenfalls substituiertem Heteroaryl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Acyl, gegebenenfalls substituiertem Carboxy und gegebenenfalls substituiertem Carbonyl;

$R_a$, $R_b$, und $R_c$ unabhängig ausgewählt sind aus der Gruppe bestehend aus Wasserstoff, gegebenenfalls substituiertem Alkyl, gegebenenfalls substituiertem Alkoxyalkyl, gegebenenfalls substituiertem Alkenyl, gegebenenfalls substituiertem Heteroalkyl, gegebenenfalls substituiertem Heteroalkenyl, gegebenenfalls substituiertem Aryl, gegebenenfalls substituiertem Arylalkyl, gegebenenfalls substituiertem Heteroaryl, gegebenenfalls substituiertem Cycloalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Carboxy und gegebenenfalls substituiertem Carbonyl; oder $R_a$ und $R_b$, oder $R_b$ und $R_c$, oder $R_a$ und $R_c$ zusammen einen gegebenenfalls substituierten Ring oder ein gegebenenfalls substituiertes polycyclisches Ringsystem bilden, wobei jeder Ring unabhängig Cycloalkyl, Aryl, Heterocyclyl oder Heteroaryl ist;

$D_1$ und $D_2$ unabhängig ausgewählt sind aus der Gruppe bestehend aus Wasserstoff, gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, cyclischem Amido und cyclischem Imido, -Aryl-NR'R", -Aryl-Aryl-NR'R", und -Heteroaryl-Heteroaryl-R', wobei R' und R" unabhängig ausgewählt sind aus der Gruppe bestehend aus gegebenenfalls substituiertem Alkyl, gegebenenfalls substituiertem Alkenyl, gegebenenfalls substituiertem Aryl; vorausgesetzt, dass $D_1$ und $D_2$ nicht beide Wasserstoff sind, und $D_1$ und $D_2$ nicht gegebenenfalls substituiertes Thiophen oder gegebenenfalls substituiertes Furan sind; und

L unabhängig ausgewählt ist aus der Gruppe bestehend aus gegebenenfalls substituiertem Alkyl, gegebenenfalls substituiertem Aryl, gegebenenfalls substituiertem Heteroaryl, Amino, Amido, Imido, gegebenenfalls substituiertem Alkoxy, Acyl, Carboxy, vorausgesetzt, dass L nicht gegebenenfalls substituiertes Thiophen oder gegebenenfalls substituiertes Furan ist.

**9.** Wellenlängenumwandlungsfilm nach einem der Ansprüche 1 oder 2, wobei der zweite organische photostabile Chromophor durch Formel (IX-a) oder Formel (IX-b) wiedergegeben ist:

$$Het_2\text{-}A_0\text{-}Het_2 \qquad (IX\text{-}a),$$

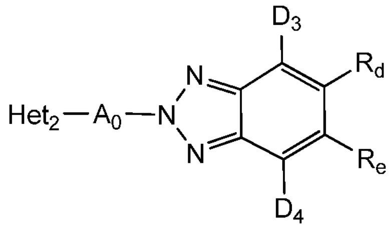

(IX-b)

wobei $Het_2$ ausgewählt ist aus der Gruppe bestehend aus:

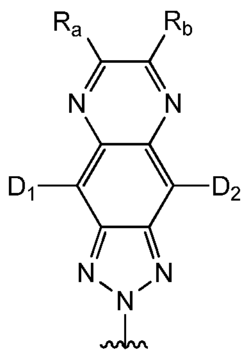
,
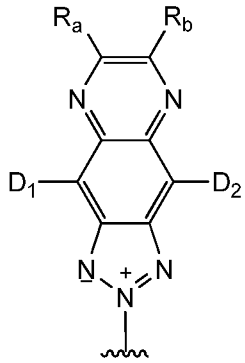
,
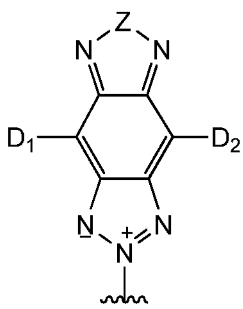
,
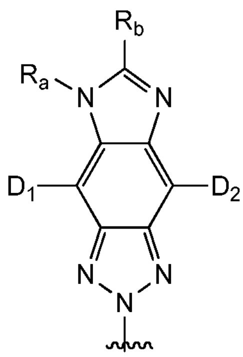
,
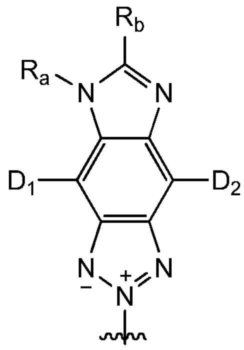
,
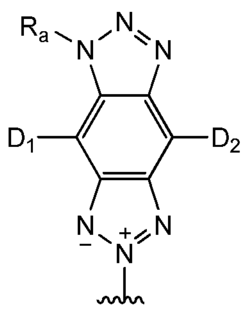
,
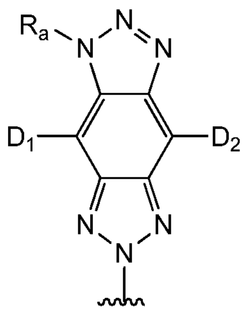
,
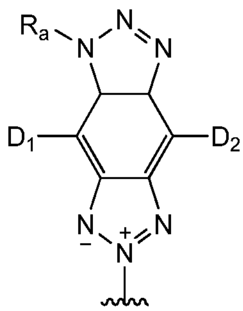
,
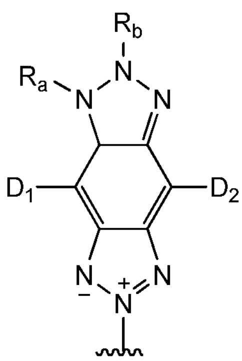
,
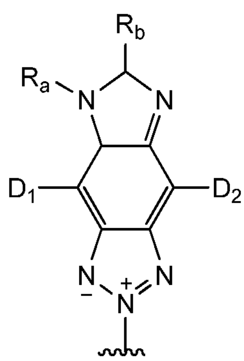
, und
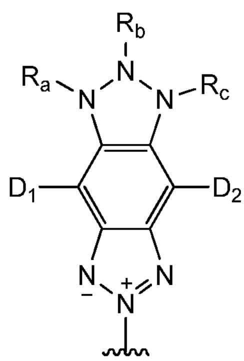
;

wobei:

Z ausgewählt ist aus der Gruppe bestehend aus $-N(R_a)-$, -O-, -S-, -Se-, und -Te-;

$R_a$, $R_b$ und $R_c$ unabhängig ausgewählt sind aus der Gruppe bestehend aus Wasserstoff, gegebenenfalls substituiertem Alkyl, gegebenenfalls substituiertem Alkoxyalkyl, gegebenenfalls substituiertem Alkenyl, gegebenenfalls substituiertem Heteroalkyl, gegebenenfalls substituiertem Heteroalkenyl, gegebenenfalls substituiertem Aryl, gegebenenfalls substituiertem Arylalkyl, gegebenenfalls substituiertem Heteroaryl, gegebenenfalls substituiertem Cycloalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Carboxy und gegebenenfalls substituiertem Carbonyl; oder $R_a$ und $R_b$, oder $R_b$ und $R_c$, oder $R_a$ und $R_c$ zusammen einen gegebenenfalls substituierten Ring oder ein gegebenenfalls substituiertes polycyclisches Ringsystem bilden, wobei jeder Ring unabhängig Cycloalkyl, Aryl, Heterocyclyl oder Heteroaryl ist;
$R_d$ und $R_e$ unabhängig ausgewählt sind aus der Gruppe bestehend aus Wasserstoff, gegebenenfalls substituiertem Alkyl, gegebenenfalls substituiertem Alkoxyalkyl, gegebenenfalls substituiertem Alkenyl, gegebenenfalls substituiertem Heteroalkyl, gegebenenfalls substituiertem Heteroalkenyl, gegebenenfalls substituiertem Aryl, gegebenenfalls substituiertem Arylalkyl, gegebenenfalls substituiertem Heteroaryl, gegebenenfalls substituiertem Cycloalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Carboxy und gegebenenfalls substituiertem Carbonyl; oder $R_d$ und $R_e$ zusammen einen gegebenenfalls substituierten Ring oder ein gegebenenfalls substituiertes polycyclisches Ringsystem bilden, wobei jeder Ring unabhängig Cycloalkyl, Aryl, Heterocyclyl oder Heteroaryl ist;
$D_1$, $D_2$, $D_3$ und $D_4$ unabhängig ausgewählt sind aus der Gruppe bestehend aus Wasserstoff, gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, cyclischem Amido und cyclischem Imido, -Aryl-NR'R", -Aryl-Aryl-NR'R", und -Heteroaryl-Heteroaryl-R'; wobei R' und R" unabhängig ausgewählt sind aus der Gruppe bestehend aus gegebenenfalls substituiertem Alkyl, gegebenenfalls substituiertem Alkenyl, gegebenenfalls substituiertem Aryl; vorausgesetzt, dass $D_1$ und $D_2$ nicht beide Wasserstoff sind, und $D_1$ und $D_2$ nicht gegebenenfalls substituiertes Thiophen oder gegebenenfalls substituiertes Furan sind.

**10.** Wellenlängenumwandlungsfilm nach einem der Ansprüche 1 oder 2, wobei der zweite organische photostabile Chromophor durch Formel (X-a) oder (X-b) wiedergegeben ist:

$$Het_3\text{-}R_a\text{-}Het_3 \qquad (X\text{-}a),$$

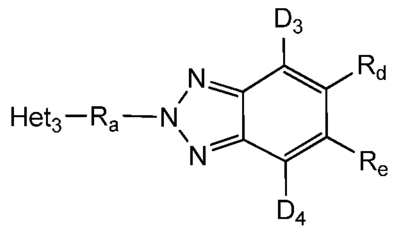

(X-b)

wobei $Het_3$ ausgewählt ist aus der Gruppe bestehend aus:

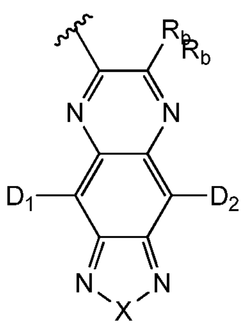
,
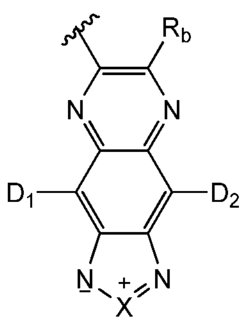
,
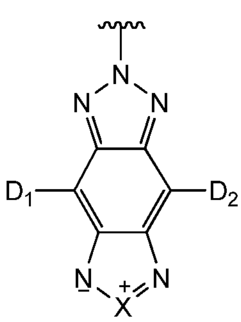
,
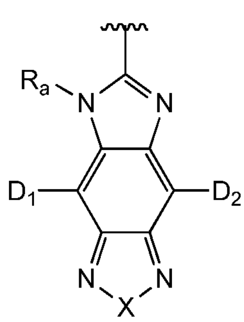
,

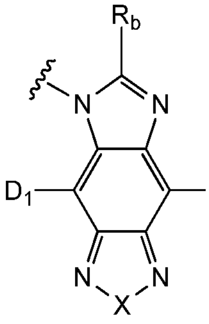 , 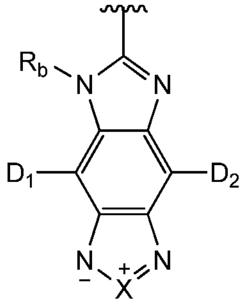 , 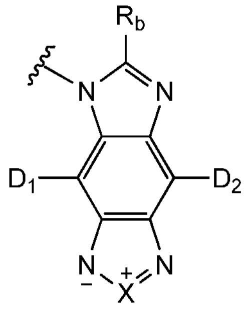 , 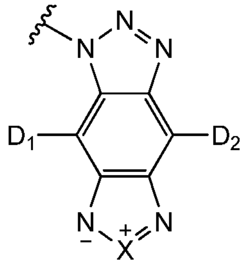 ,

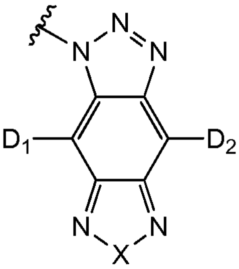 , 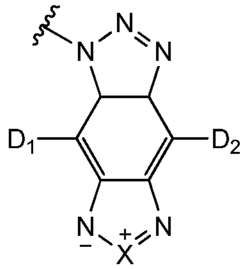 , 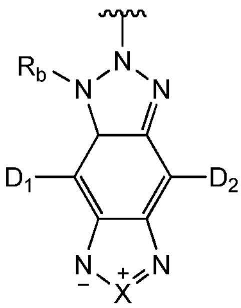 , 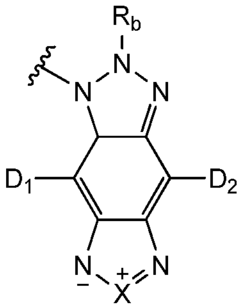 ,

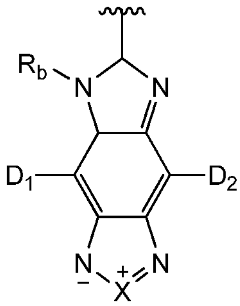 , 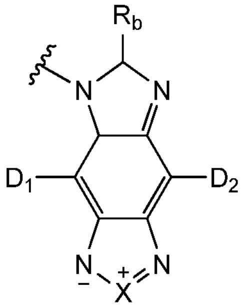 , 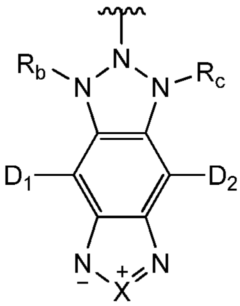 , und 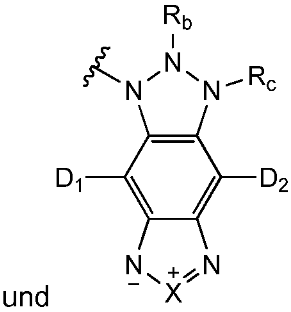 ;

wobei:

X ausgewählt ist aus der Gruppe bestehend aus $-N(A_0)-$, -O-, -S-, -Se-, und -Te-;

$A_0$ ausgewählt ist aus der Gruppe bestehend aus Wasserstoff, gegebenenfalls substituiertem Alkyl, gegebenenfalls substituiertem Alkenyl, gegebenenfalls substituiertem Heteroalkyl, gegebenenfalls substituiertem Aryl, gegebenenfalls substituiertem Heteroaryl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Acyl, gegebenenfalls substituiertem Carboxy, und gegebenenfalls substituiertem Carbonyl;

$R_a$, $R_b$ und $R_c$ unabhängig ausgewählt sind aus der Gruppe bestehend aus Wasserstoff, gegebenenfalls substituiertem Alkyl, gegebenenfalls substituiertem Alkoxyalkyl, gegebenenfalls substituiertem Alkenyl, gegebenenfalls substituiertem Heteroalkyl, gegebenenfalls substituiertem Heteroalkenyl, gegebenenfalls substituiertem Aryl, gegebenenfalls substituiertem Arylalkyl, gegebenenfalls substituiertem Heteroaryl, gegebenenfalls substituiertem Cycloalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Carboxy und gegebenenfalls substituiertem Carbonyl; oder $R_a$ und $R_b$, oder $R_b$ und $R_c$, oder $R_a$ und $R_c$ zusammen einen gegebenenfalls substituierten Ring oder ein gegebenenfalls substituiertes polycyclisches Ringsystem bilden, wobei jeder Ring unabhängig Cycloalkyl, Aryl, Heterocyclyl oder Heteroaryl ist; $R_d$ und $R_e$ unabhängig ausgewählt sind aus der Gruppe bestehend aus Wasserstoff, gegebenenfalls substituiertem Alkyl, gegebenenfalls substituiertem Alkoxyalkyl, gegebenenfalls substituiertem Alkenyl, gegebenenfalls substituiertem Heteroalkyl, gegebenenfalls substituiertem Heteroalkenyl, gegebenenfalls substituiertem Aryl, gegebenenfalls substituiertem Arylalkyl, gegebenenfalls substituiertem Heteroaryl, gegebenenfalls substituiertem Cycloalkyl, gegebenenfalls substituiertem Cycloalkenyl, gegebenenfalls substituiertem Cycloheteroalkyl, gegebenenfalls substituiertem Cycloheteroalkenyl, gegebenenfalls substituiertem Amino, gegebenenfalls substituiertem Amido, gegebenenfalls substituiertem cyclischen Amido, gegebenenfalls substituiertem cyclischen Imido, gegebenenfalls substituiertem Alkoxy, gegebenenfalls substituiertem Carboxy und gegebenenfalls substituiertem Carbonyl; oder $R_d$ und $R_e$ zusammen einen gegebenenfalls substituierten Ring oder ein gegebenenfalls substituiertes polycyclisches Ringsystem bilden, wobei jeder Ring unabhängig Cycloalkyl, Aryl, Heterocyclyl oder Heteroaryl ist;
$D_1$, $D_2$, $D_3$ und $D_4$ unabhängig ausgewählt sind aus der Gruppe bestehend aus Wasserstoff, gegebenenfalls substituiertem Alkoxy, gegebenenfalls substituiertem Aryloxy, gegebenenfalls substituiertem Acyloxy, gegebenenfalls substituiertem Alkyl, gegebenenfalls substituiertem Aryl, gegebenenfalls substituiertem Heteroaryl, gegebenenfalls substituiertem Amino, Amido, cyclischem Amido und cyclischem Imido, -Aryl-NR'R", -Aryl-Aryl-NR'R" und -Heteroaryl-Heteroaryl-R'; wobei R' und R" unabhängig ausgewählt sind aus der Gruppe bestehend aus gegebenenfalls substituiertem Alkyl, gegebenenfalls substituiertem Alkenyl und gegebenenfalls substituiertem Aryl; vorausgesetzt, dass $D_1$ und $D_2$ nicht beide Wasserstoff sind, und $D_1$ und $D_2$ nicht gegebenenfalls substituiertes Thiophen oder gegebenenfalls substituiertes Furan sind.

**11.** Wellenlängenumwandlungsfilm nach einem der Ansprüche 2 bis 10, wobei das Absorptionsmaximum des ersten Chromophors kleiner als 400 nm ist und das Absorptionsmaximum des zweiten Chromophors größer als 400 nm ist.

**12.** Photovoltaisches Modul umfassend:

wenigstens eine photovoltaische Vorrichtung; und
den Wellenlängenumwandlungsfilm gemäß einem der Ansprüche 1 bis 11, wobei der Wellenlängenumwandlungsfilm so konfiguriert ist, dass er die wenigstens eine photovoltaische Vorrichtung einkapselt, so dass einfallendes Licht durch den Wellenlängenumwandlungsfilm hindurchgeht, bevor es die wenigstens eine photovoltaische Vorrichtung erreicht.

**13.** Photovoltaisches Modul nach Anspruch 12, wobei die photovoltaische Vorrichtung wenigstens eine Vorrichtung, ausgewählt aus der Gruppe, bestehend aus einer Vorrichtung auf Siliciumbasis, einer III-V oder II-VI PN-Übergangs-Vorrichtung, einer Kupfer-Indium-Gallium-Selen (CIGS)-Dünnschichtvorrichtung, einer organischen Sensibilisatorvorrichtung, einer organischen Dünnschichtvorrichtung und einer Cadmiumsulfid/Cadmiumtellurid (CdS/CdTe)-Dünnschichtvorrichtung, umfasst.

**14.** Leuchtschirm bzw. -tafel umfassend wenigstens einen Wellenlängenumwandlungsfilm gemäß einem der Ansprüche 1 bis 11.

## Revendications

**1.** Film de conversion de longueur d'onde, comprenant :

une matrice polymère optiquement transparente ;
un premier chromophore organique photostable ayant un maximum d'absorption inférieur à 400 nm et un maximum d'émission supérieur à 400 nm, le premier chromophore organique photostable étant représenté par la formule (I) :

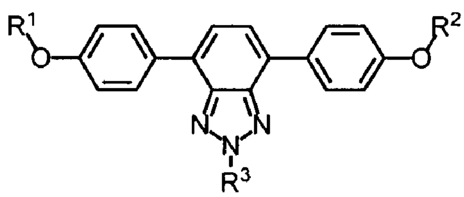

(I)

dans laquelle chacun de $R^1$, $R^2$ et $R^3$ est choisi indépendamment dans le groupe constitué d'alkyle, d'un alkyle substitué et d'aryle.

**2.** Film de conversion de longueur d'onde, comprenant :

une matrice polymère optiquement transparente ;
un premier chromophore organique photostable ayant un maximum d'absorption inférieur à 400 nm et un maximum d'émission supérieur à 400 nm, le premier chromophore organique photostable étant représenté par la formule (II-a) ou (II-b) :

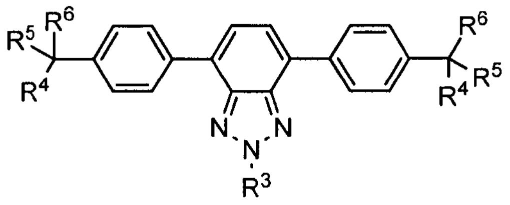
(II-a),
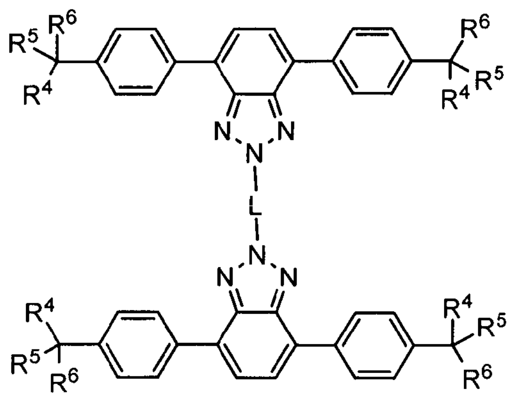
(II-b)

dans lesquelles :

$R^3$ est choisi dans le groupe constitué d'alkyle éventuellement substitué, alcényle éventuellement substitué, cycloalkyle éventuellement substitué, hétéroalkyle éventuellement substitué, aryle éventuellement substitué, hétéroaryle éventuellement substitué, alkoxyalkyle éventuellement substitué, hétéroalcényle éventuellement substitué, arylalkyle éventuellement substitué, hétéroaryle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué et carboxy éventuellement substitué, carbonyle éventuellement substitué, éther éventuellement substitué, cétone éventuellement substituée, sulfone éventuellement substituée et sulfonamide éventuellement substitué ; ou $R^3$ est un système de cycles polycyclique éventuellement substitué, dans lequel chaque cycle est indépendamment un cycloalkyle, un aryle, un hétérocycloalkyle ou un hétéroaryle ;
$R^4$, $R^5$ et $R^6$ sont choisis indépendamment dans le groupe constitué d'alkyle éventuellement substitué, alcényle éventuellement substitué, cycloalkyle éventuellement substitué, hétéroalkyle éventuellement substitué, aryle éventuellement substitué, hétéroaryle éventuellement substitué, alkoxyalkyle éventuellement substitué, hétéroalcényle éventuellement substitué, arylalkyle éventuellement substitué, hétéroaryle éventuellement substitué, hétéroarylalkyle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué et carboxy éventuellement substitué, carbonyle éventuellement substitué, éther éventuellement substitué, cétone éventuellement substituée, sulfone éventuellement substituée et sulfonamide éventuellement substitué ; ou $R^4$ et $R^5$, $R^4$ et $R^6$, $R^5$ et $R^6$ ou $R^5$ et $R^6$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ; et
L est choisi dans le groupe constitué d'alkyle éventuellement substitué, hétéroalkyle éventuellement substitué, alkylène éventuellement substitué et hétéroalkylène éventuellement substitué, alcynylène éventuellement substitué, arylène éventuellement substitué, hétéroarylène éventuellement substitué.

**3.** Film de conversion de longueur d'onde selon l'une quelconque des revendications 1 ou 2, comprenant en outre un second chromophore organique photostable, le second chromophore organique photostable étant représenté par la formule (III-a) ou (III-b) :

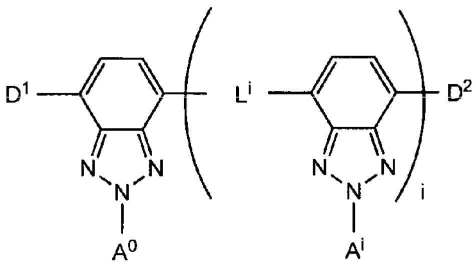
(III-a)

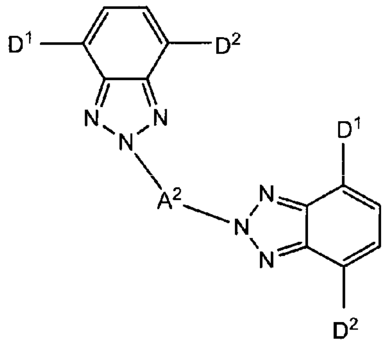
(III-b)

dans lesquelles :

i est un entier dans la plage de 0 à 100 ;

$A^0$ et $A^i$ sont choisis chacun indépendamment dans le groupe constitué d'alkyle éventuellement substitué, alcényle éventuellement substitué, hétéroalkyle éventuellement substitué, aryle éventuellement substitué, hétéroaryle éventuellement substitué, amino éventuellement substitué, amido éventuellement substitué, amido cyclique éventuellement substitué, imido cyclique éventuellement substitué, alkoxy éventuellement substitué et carboxy éventuellement substitué et carbonyle éventuellement substitué ;

$A^2$ est choisi dans le groupe constitué d'alkylène éventuellement substitué, alcénylène éventuellement substitué, arylène éventuellement substitué, hétéroarylène éventuellement substitué, cétone, ester et

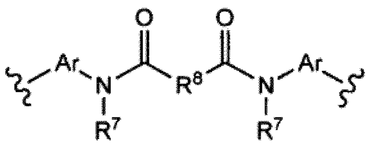
;

où Ar est un aryle éventuellement substitué ou un hétéroaryle éventuellement substitué ; $R^7$ est choisi dans le groupe constitué de H, alkyle, alcényle, aryle, hétéroaryle, aralkyle, alkaryle ; et $R^8$ est choisi dans le groupe constitué d'alkylène éventuellement substitué, alcénylène éventuellement substitué, arylène éventuellement substitué, hétéroarylène éventuellement substitué, cétone et ester ; ou $R^7$ et $R^8$ peuvent être reliés ensemble pour former un cycle.

$D^1$ et $D^2$ sont choisis indépendamment dans le groupe constitué d'hydrogène, alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique, à condition que $D^1$ et $D^2$ ne soient pas tous deux un hydrogène ; et

$L^i$ est choisi indépendamment dans le groupe constitué d'alkylène éventuellement substitué, alcénylène éventuellement substitué, alcynylène éventuellement substitué, arylène éventuellement substitué et hétéroarylène éventuellement substitué.

**4.** Film de conversion de longueur d'onde selon l'une quelconque des revendications 1 ou 2, comprenant en outre un second chromophore organique photostable, le second chromophore organique photostable étant représenté par la formule (IV-a) ou (IV-b) :

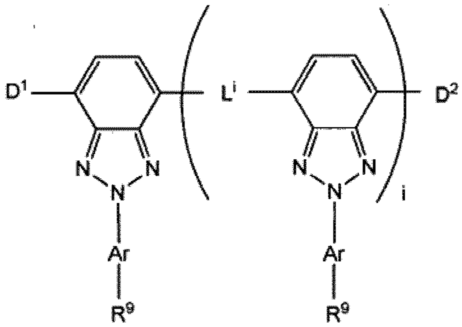

(IV-a),

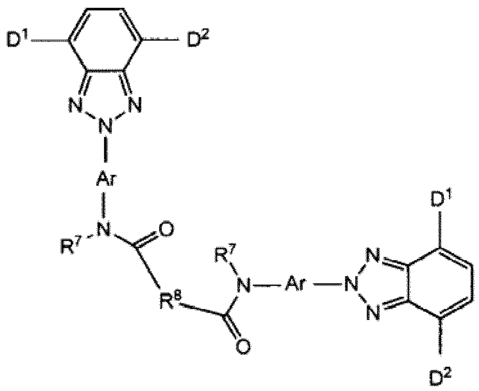

(IV-b) ;

dans lesquelles :

i est un entier dans la plage de 0 à 100 ;
Ar est un aryle éventuellement substitué ou un hétéroaryle éventuellement substitué ;
$R^9$ est

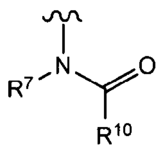

ou un amido cyclique éventuellement substitué ;
$R^7$ est choisi chacun indépendamment dans le groupe constitué de H, alkyle, alcényle, aryle, hétéroaryle, aralkyle et alkaryle ;
$R^{10}$ est choisi chacun indépendamment dans le groupe constitué d'alkyle éventuellement substitué, alcényle éventuellement substitué, aryle éventuellement substitué et hétéroaryle éventuellement substitué ; ou $R^7$ et $R^{10}$ peuvent être reliés ensemble pour former un cycle ;
$R^8$ est choisi dans le groupe constitué d'alkylène éventuellement substitué, alcénylène éventuellement substitué, arylène éventuellement substitué, hétéroarylène éventuellement substitué ;
$D^1$ et $D^2$ sont choisis chacun indépendamment dans le groupe constitué d'hydrogène, alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique, à condition que $D^1$ et $D^2$ ne soient pas tous deux un hydrogène ; et
$L^i$ est choisi indépendamment dans le groupe constitué d'alkylène éventuellement substitué, alcénylène éventuellement substitué, alcynylène éventuellement substitué, arylène éventuellement substitué, hétéroarylène éventuellement substitué.

**5.** Film de conversion de longueur d'onde selon l'une quelconque des revendications 1 ou 2, comprenant en outre un second chromophore organique photostable, le second chromophore organique photostable étant représenté par la formule (V-a) ou (V-b) :

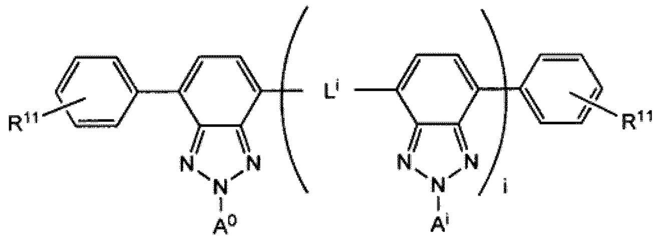

(V-a)

,

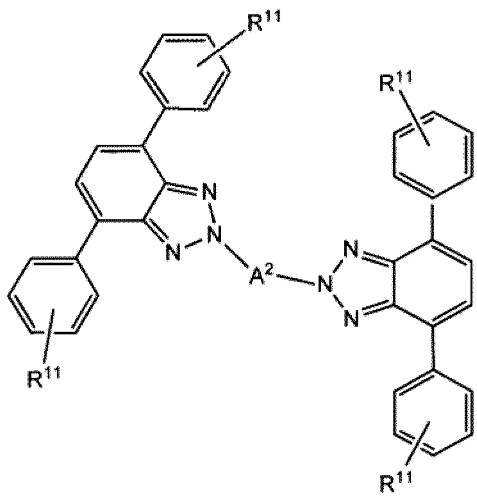

(V-b);

dans lesquelles :

i est un entier dans la plage de 0 à 100 ;

$A^0$ et $A^i$ sont choisis chacun indépendamment dans le groupe constitué d'alkyle éventuellement substitué, alcényle éventuellement substitué, hétéroalkyle éventuellement substitué, amido éventuellement substitué, alkoxy éventuellement substitué, carbonyle éventuellement substitué et carboxy éventuellement substitué ;

chaque $R^{11}$ est choisi indépendamment dans le groupe constitué d'alcoxy éventuellement substitué, aryloxy éventuellement substitué, acyloxy éventuellement substitué et amino ;

$A^2$ est choisi dans le groupe constitué d'alkylène éventuellement substitué, alcénylène éventuellement substitué, arylène éventuellement substitué, hétéroarylène éventuellement substitué, cétone, ester et

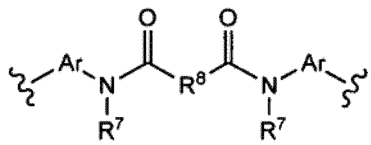

;

où Ar est un aryle éventuellement substitué ou un hétéroaryle éventuellement substitué ; $R^7$ est choisi dans le groupe constitué de H, alkyle, alcényle, aryle, hétéroaryle, aralkyle, alkaryle ; et $R^8$ est choisi dans le groupe constitué d'alkylène éventuellement substitué, alcénylène éventuellement substitué, arylène éventuellement substitué, hétéroarylène éventuellement substitué, cétone et ester ; ou $R^7$ et $R^8$ peuvent être reliés ensemble pour former un cycle ; et

$L^i$ est choisi indépendamment dans le groupe constitué d'alkylène éventuellement substitué, alcénylène éventuellement substitué, alcynylène éventuellement substitué, arylène éventuellement substitué, hétéroarylène éventuellement substitué.

**6.** Film de conversion de longueur d'onde selon l'une quelconque des revendications 1 ou 2, comprenant en outre un second chromophore organique photostable, le second chromophore organique photostable étant représenté par la formule (VI) :

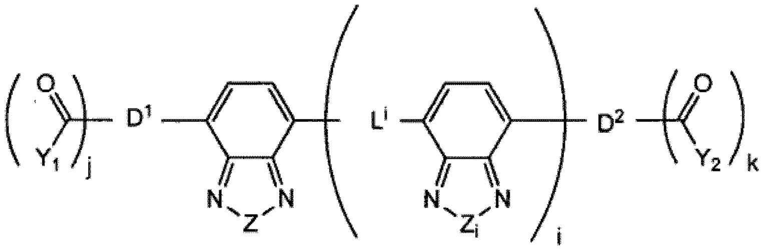

(VI) ;

dans laquelle

i est un entier dans la plage de 0 à 100 ;
Z et $Z_i$ sont chacun indépendamment choisis dans le groupe constitué de - O-, -S-, -Te-, $-NR^{12}-$, $-CR^{12}=CR^{12}-$ et $-CR^{12}=N-$, où $R^{12}$ est un hydrogène, un alkyle en $C_1$ à $C_6$ éventuellement substitué, ou un aryle en $C_1$ à $C_{10}$ éventuellement substitué ; et
$D^1$ et $D^2$ sont choisis indépendamment dans le groupe constitué d'alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique ;
j vaut 0,1 ou 2 et k vaut 0, 1 ou 2 ;
$Y_1$ et $Y_2$ sont choisis chacun indépendamment dans le groupe constitué d'aryle éventuellement substitué, alkyle éventuellement substitué, cycloalkyle éventuellement substitué, alkoxy éventuellement substitué et amino éventuellement substitué ; et
$L^i$ est choisi indépendamment dans le groupe constitué d'alkylène éventuellement substitué, alcénylène éventuellement substitué, alcynylène éventuellement substitué, arylène éventuellement substitué, hétéroarylène éventuellement substitué.

**7.** Film de conversion de longueur d'onde selon l'une quelconque des revendications 1 ou 2, comprenant en outre un second chromophore organique photostable, le second chromophore organique photostable étant représenté par la formule (VII-a) ou (VII-b) :

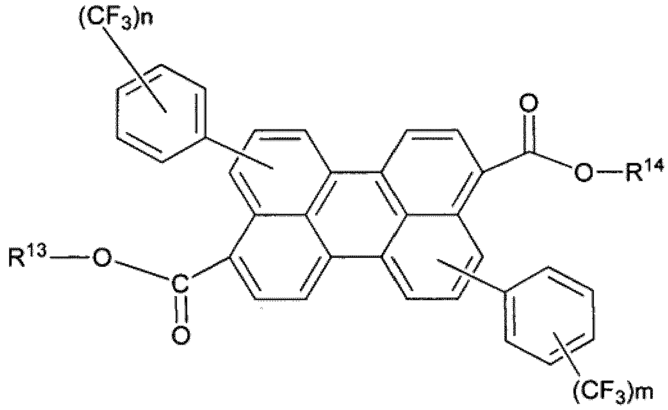

(VII-a)

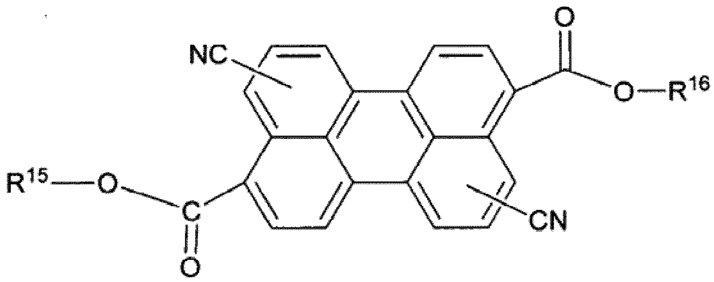

(VII-b);

où $R^{13}$ et $R^{14}$ dans la formule (VII-a) sont choisis chacun indépendamment dans le groupe constitué d'hydrogène, alkyle en $C_1$ à $C_{10}$, cycloalkyle en $C_3$ à $C_{10}$, alkoxy en $C_1$ à $C_{10}$, aryle en $C_6$ à $C_{18}$ et aralkyle en $C_6$ à $C_{20}$ ; m et n dans la formule (VII-a) sont chacun indépendamment dans la plage de 1 à 5 ; et $R^{15}$ et $R^{16}$ dans la formule (VII-b) sont choisis chacun indépendamment dans le groupe constitué d'aryle en $C_6$ à $C_{18}$ et aralkyle en $C_6$ à $C_{20}$.

**8.** Film de conversion de longueur d'onde selon l'une quelconque des revendications 1 ou 2, comprenant en outre un second chromophore organique photostable, le second chromophore organique photostable étant représenté par la formule (VIII) :

$$D_1-Het-(L-Het)_i-D_2 \quad (VIII)$$

dans laquelle Het est choisi dans le groupe constitué de :

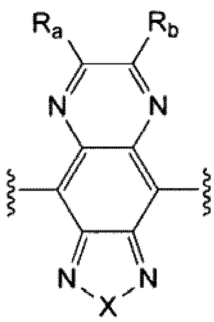 , 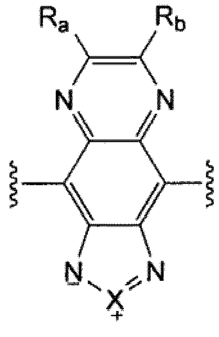 , 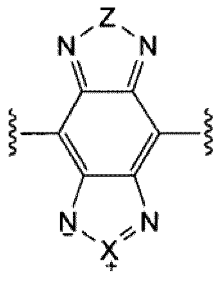 , 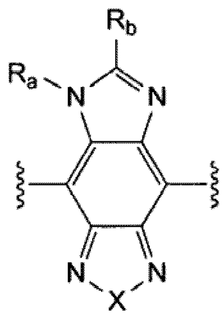 ,

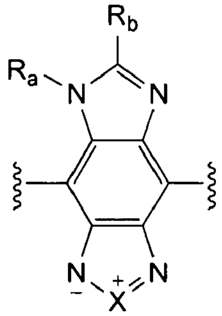 , 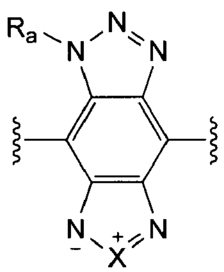 , 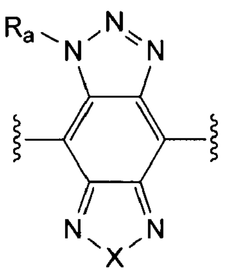 , 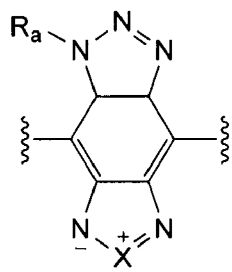 ,

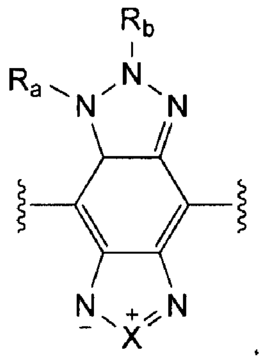 , 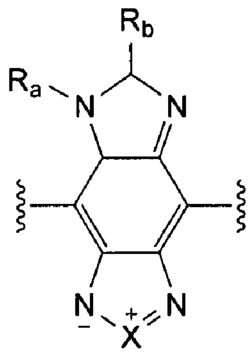 et 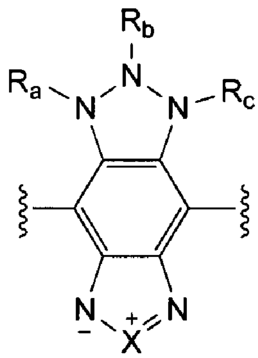 ;

où

i est en entier dans la plage de 1 à 100 ;

X est choisi dans le groupe constitué de -N($A_0$)-, -O-, -S-, -Se- et -Te- ;

Z est choisi dans le groupe constitué de -N($R_a$)-, -O-, -S-, -Se- et -Te- ;

$A_0$ est choisi dans le groupe constitué d'hydrogène, alkyle éventuellement substitué, alcényle éventuellement substitué, hétéroalkyle éventuellement substitué, aryle éventuellement substitué, hétéroaryle éventuellement substitué, amino éventuellement substitué, amido éventuellement substitué, amido cyclique éventuellement substitué, imido cyclique éventuellement substitué, alkoxy éventuellement substitué, acyle éventuellement substitué, carboxy éventuellement substitué et carbonyle éventuellement substitué ;

$R_a$, $R_b$ et $R_c$ sont choisis indépendamment dans le groupe constitué d'hydrogène, alkyle éventuellement substitué, alkoxyalkyle éventuellement substitué, alcényle éventuellement substitué, hétéroalkyle éventuellement substitué, hétéroalcényle éventuellement substitué, aryle éventuellement substitué, arylalkyle éventuellement substitué, hétéroaryle éventuellement substitué, cycloalkyle éventuellement substitué, cycloalcényle éventuellement substitué, cyclohétéroalkyle éventuellement substitué, cyclohétéroalcényle éventuellement substitué,

amino éventuellement substitué, amido éventuellement substitué, amido cyclique éventuellement substitué, imido cyclique éventuellement substitué, alkoxy éventuellement substitué, carboxy éventuellement substitué et carbonyle éventuellement substitué ; ou $R_a$ et $R_b$, ou $R_b$ et $R_c$, ou $R_a$ et $R_c$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ;
$D_1$ et $D_2$ sont choisis indépendamment dans le groupe constitué d'hydrogène, alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique, -aryl-NR'R", -aryl-aryl-NR'R" et -hétéroaryl-hétéroaryl-R' ; où R' et R" sont choisis indépendamment dans le groupe constitué d'alkyle éventuellement substitué, alcényle éventuellement substitué, aryle éventuellement substitué ; à condition que $D_1$ et $D_2$ ne soient pas tous deux un hydrogène, et que $D_1$ et $D_2$ ne soient pas un thiophène éventuellement substitué ou un furane éventuellement substitué ; et
L est choisi indépendamment dans le groupe constitué d'alkyle éventuellement substitué, aryle éventuellement substitué, hétéroaryle éventuellement substitué, amino, amido, imido, alkoxy éventuellement substitué, acyle, carboxy, à condition que L ne soit pas un thiophène éventuellement substitué ou un furane éventuellement substitué.

**9.** Film de conversion de longueur d'onde selon l'une quelconque des revendications 1 ou 2, dans lequel le second chromophore organique photostable est représenté par la formule (IX-a) ou (IX-b) :

$Het_2$-$A_0$-$Het_2$ (IX-a),

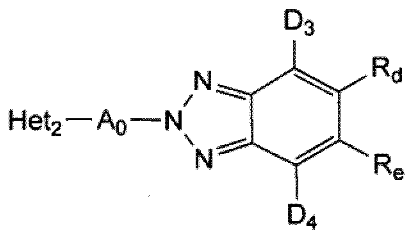

(IX-b)

dans lesquelles $Het_2$ est choisi dans le groupe constitué de :

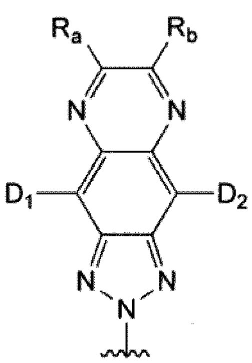 , 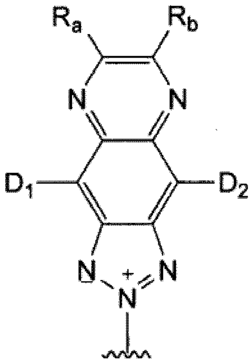 , 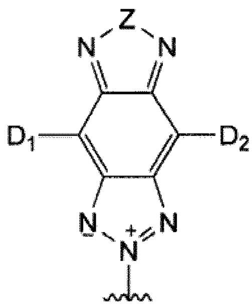 , 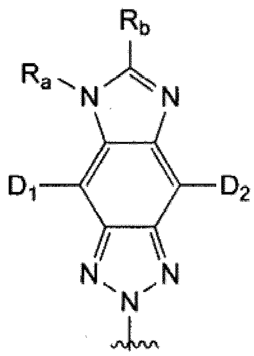 ,

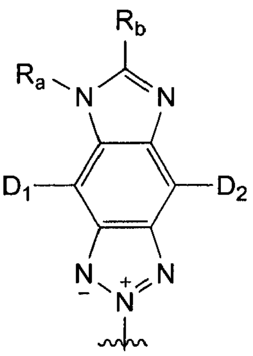 , 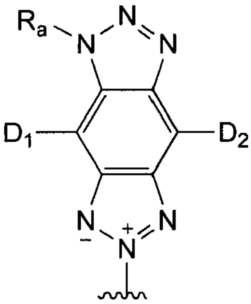 , 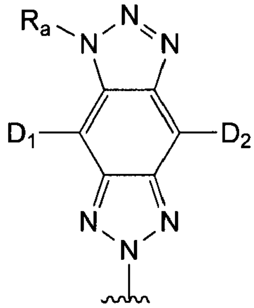 , 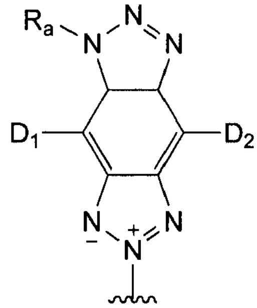 ,

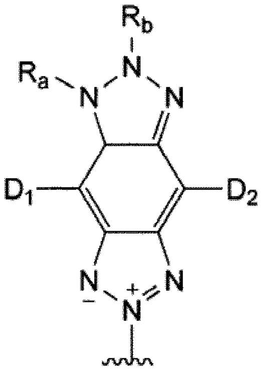 . 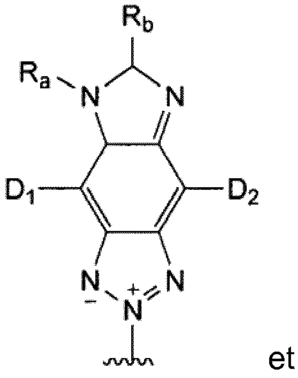 et 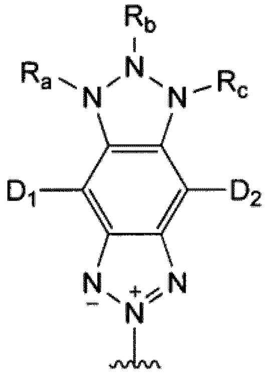 ;

où

Z est choisi dans le groupe constitué de -N($R_a$)-, -O-, -S-, -Se- et -Te- ;

$R_a$, $R_b$ et $R_c$ sont choisis indépendamment dans le groupe constitué d'hydrogène, alkyle éventuellement substitué, alkoxyalkyle éventuellement substitué, alcényle éventuellement substitué, hétéroalkyle éventuellement substitué, hétéroalcényle éventuellement substitué, aryle éventuellement substitué, arylalkyle éventuellement substitué, hétéroaryle éventuellement substitué, cycloalkyle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué, carboxy éventuellement substitué et carbonyle éventuellement substitué ; ou $R_a$ et $R_b$, ou $R_b$ et $R_c$, ou $R_a$ et $R_c$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ;

$R_d$ et $R_e$ sont choisis indépendamment dans le groupe constitué d'hydrogène, alkyle éventuellement substitué, alkoxyalkyle éventuellement substitué, alcényle éventuellement substitué, hétéroalkyle éventuellement substitué, hétéroalcényle éventuellement substitué, aryle éventuellement substitué, arylalkyle éventuellement substitué, hétéroaryle éventuellement substitué, cycloalkyle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué, carboxy éventuellement substitué et carbonyle éventuellement substitué ; ou $R_d$ et $R_e$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ;

$D_1$, $D_2$, $D_3$ et $D_4$ sont choisis indépendamment dans le groupe constitué d'hydrogène, alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique, -aryl-NR'R", -aryl-aryl-NR'R" et -hétéroaryl-hétéroaryl-R' ; où R' et R" sont choisis indépendamment dans le groupe constitué d'alkyle éventuellement substitué, alcényle éventuellement substitué, aryle éventuellement substitué ; à condition que $D_1$ et $D_2$ ne soient pas tous deux un hydrogène, et que $D_1$ et $D_2$ ne soient pas un thiophène éventuellement substitué ou un furane éventuellement substitué.

**10.** Film de conversion de longueur d'onde selon l'une quelconque des revendications 1 ou 2, dans lequel le second chromophore organique photostable est représenté par la formule (X-a) ou (X-b) :

$Het_3$-$R_a$-$Het_3$ (X-a),

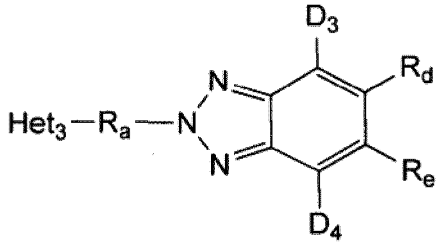

(X-b)

dans lesquelles $Het_3$ est choisi dans le groupe constitué de :

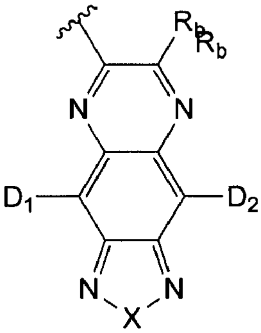 , 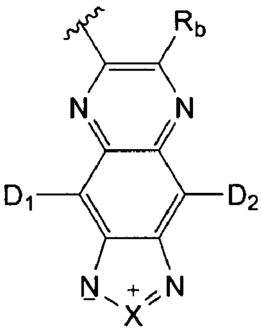 , 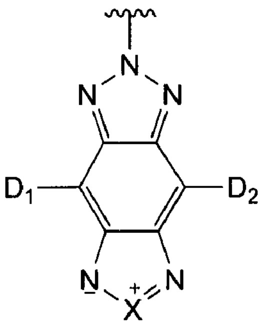 , 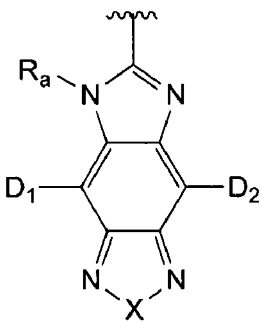 ,

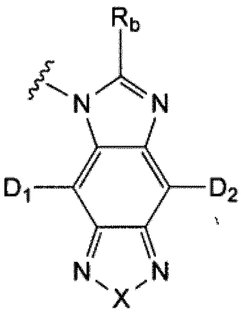 , 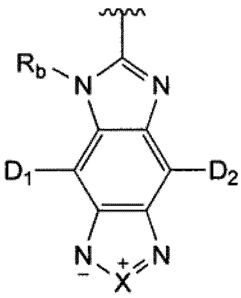 , 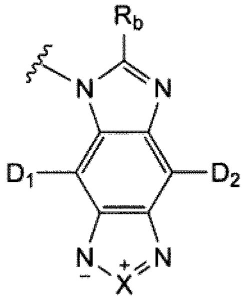 , 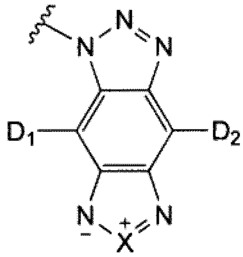 ,

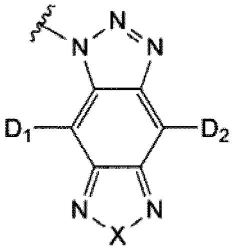 , 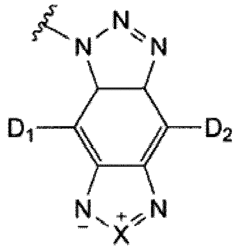 , 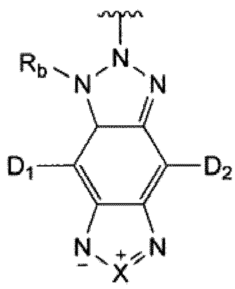 , 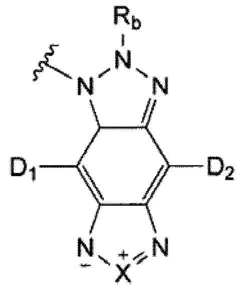 ,

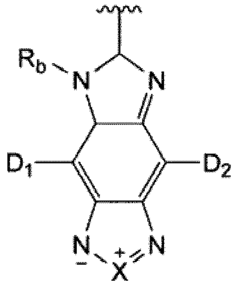 , 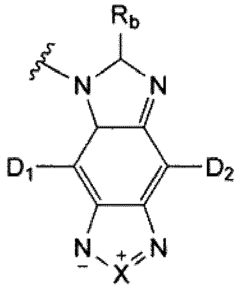 , 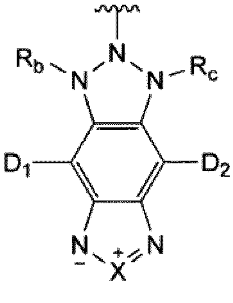 et 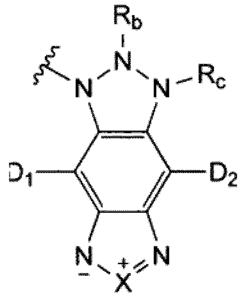 ;

où

X est choisi dans le groupe constitué de -N($A_0$)-, -O-, -S-, -Se- et -Te- ;
$A_0$ est choisi dans le groupe constitué d'hydrogène, alkyle éventuellement substitué, alcényle éventuellement substitué, hétéroalkyle éventuellement substitué, aryle éventuellement substitué, hétéroaryle éventuellement substitué, amino éventuellement substitué, amido éventuellement substitué, amido cyclique éventuellement substitué, imido cyclique éventuellement substitué, alkoxy éventuellement substitué, acyle éventuellement substitué, carboxy éventuellement substitué et carbonyle éventuellement substitué ;
$R_a$, $R_b$ et $R_c$ sont choisis indépendamment dans le groupe constitué d'hydrogène, alkyle éventuellement substitué, alkoxyalkyle éventuellement substitué, alcényle éventuellement substitué, hétéroalkyle éventuellement substitué, hétéroalcényle éventuellement substitué, aryle éventuellement substitué, arylalkyle éventuellement substitué, hétéroaryle éventuellement substitué, cycloalkyle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué, carboxy éventuellement substitué et carbonyle éventuellement substitué ; ou $R_a$ et $R_b$, ou $R_b$ et $R_c$, ou $R_a$ et $R_c$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ; $R_d$ et $R_e$ sont choisis indépendamment dans le groupe constitué d'hydrogène, alkyle éventuellement substitué, alkoxyalkyle éventuellement substitué, alcényle éventuellement substitué, hétéroalkyle éventuellement substitué, hétéroalcényle éventuellement substitué, aryle éventuellement substitué, arylalkyle éventuellement substitué, hétéroaryle éventuellement substitué, cycloalkyle éventuellement substitué, cycloalcényle éventuellement substitué, cyclohétéroalkyle éventuellement substitué, cyclohétéroalcényle éventuellement substitué, amino éventuellement substitué, amido éventuellement substitué, amido cyclique éventuellement substitué, imido cyclique éventuellement substitué, alkoxy éventuellement substitué, carboxy éventuellement substitué et carbonyle éventuellement substitué ; ou $R_d$ et $R_e$ forment ensemble un cycle éventuellement substitué ou un système de cycles polycyclique éventuellement substitué, dans lequel chaque cycle est indépendamment un cycloalkyle, un aryle, un hétérocycloalkyle ou un hétéroaryle ;
$D_1$, $D_2$, $D_3$ et $D_4$ sont choisis indépendamment dans le groupe constitué d'hydrogène, alkoxy éventuellement substitué, aryloxy éventuellement substitué, acyloxy éventuellement substitué, alkyle éventuellement substitué, aryle éventuellement substitué, hétéroaryle éventuellement substitué, amino éventuellement substitué, amido, amido cyclique et imido cyclique, -aryl-NR'R", -aryl-aryl-NR'R" et -hétéroaryl-hétéroaryl-R' ; où R' et R" sont choisis indépendamment dans le groupe constitué d'alkyle éventuellement substitué, alcényle éventuellement substitué et aryle éventuellement substitué ; à condition que $D_1$ et $D_2$ ne soient pas tous deux un hydrogène, et que $D_1$ et $D_2$ ne soient pas un thiophène éventuellement substitué ou un furane éventuellement substitué.

**11.** Film de conversion de longueur d'onde selon l'une quelconque des revendications 2 à 10, dans lequel le maximum d'absorption du premier chromophore est inférieur à 400 nm et le maximum d'absorption du second chromophore est supérieur à 400 nm.

**12.** Module photovoltaïque comprenant :

au moins un dispositif photovoltaïque ; et
le film de conversion de longueur d'onde selon l'une quelconque des revendications 1 à 11, le film de conversion de longueur d'onde étant configuré pour encapsuler l'au moins un dispositif photovoltaïque de telle sorte que la lumière incidente traverse le film de conversion de longueur d'onde avant d'atteindre l'au moins un dispositif photovoltaïque.

**13.** Module photovoltaïque selon la revendication 12, dans lequel le dispositif photovoltaïque comprend au moins un dispositif choisi dans le groupe constitué de dispositif à base de silicium, dispositif à jonction PN III-V ou II-VI, dispositif à film mince cuivre-indium-gallium-sélénium (CIGS), dispositif à agent sensibilisant organique, dispositif à film mince organique et dispositif à film mince sulfure de cadmium/tellurure de cadmium (CdS/CdTe).

**14.** Panneau luminescent comprenant au moins un film de conversion de longueur d'onde selon l'une quelconque des revendications 1 à 11.

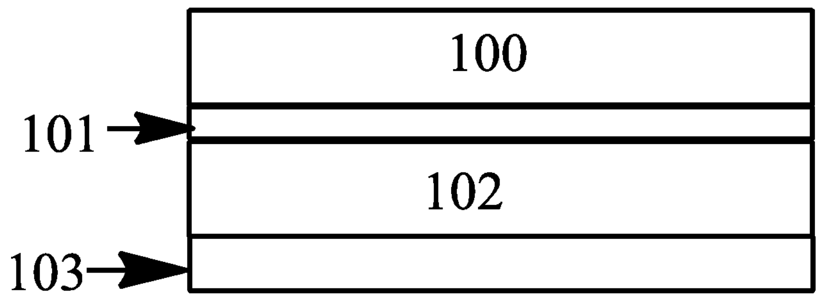


FIG. 1

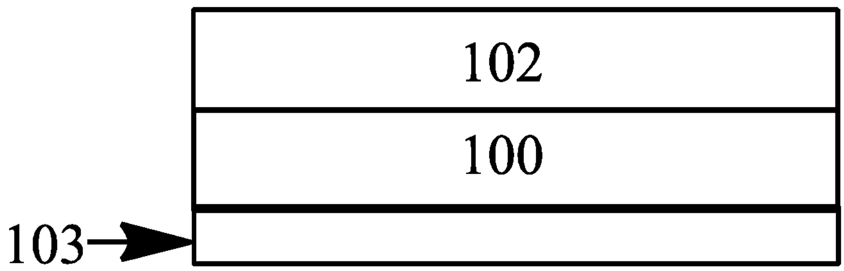


FIG. 2

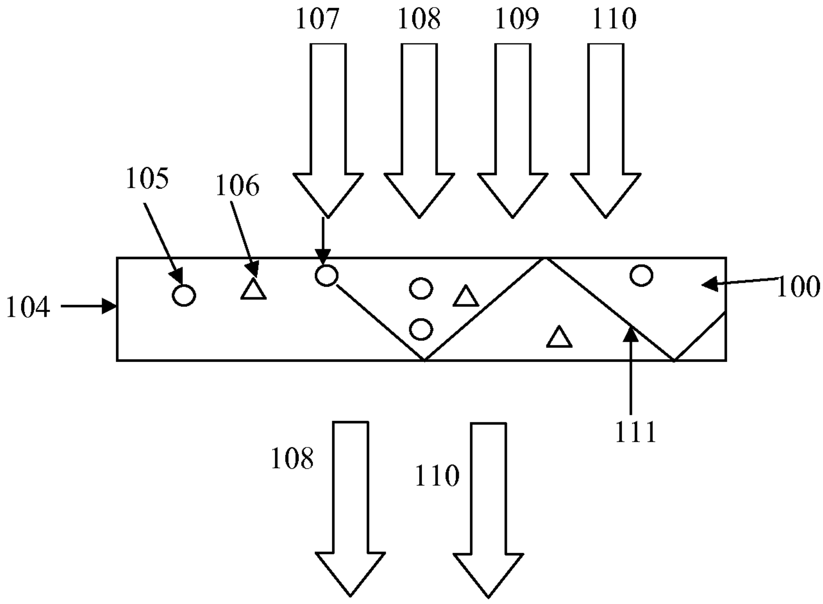


Figure 3

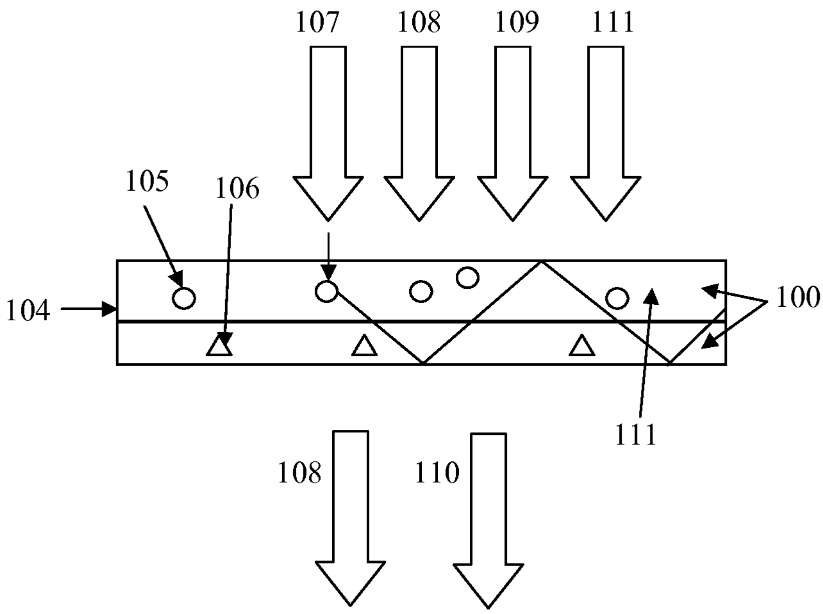


Figure 4

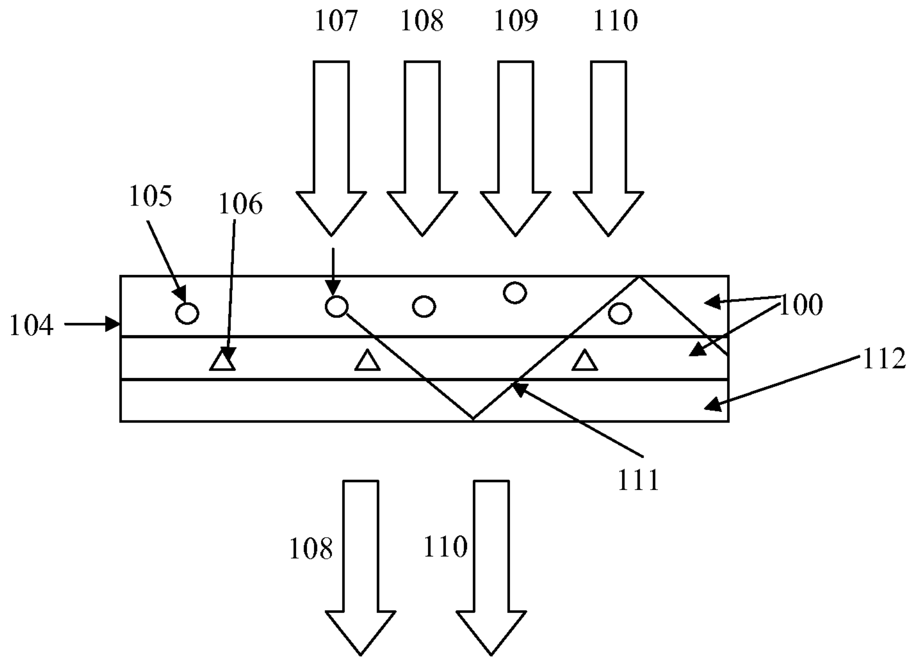


Figure 5

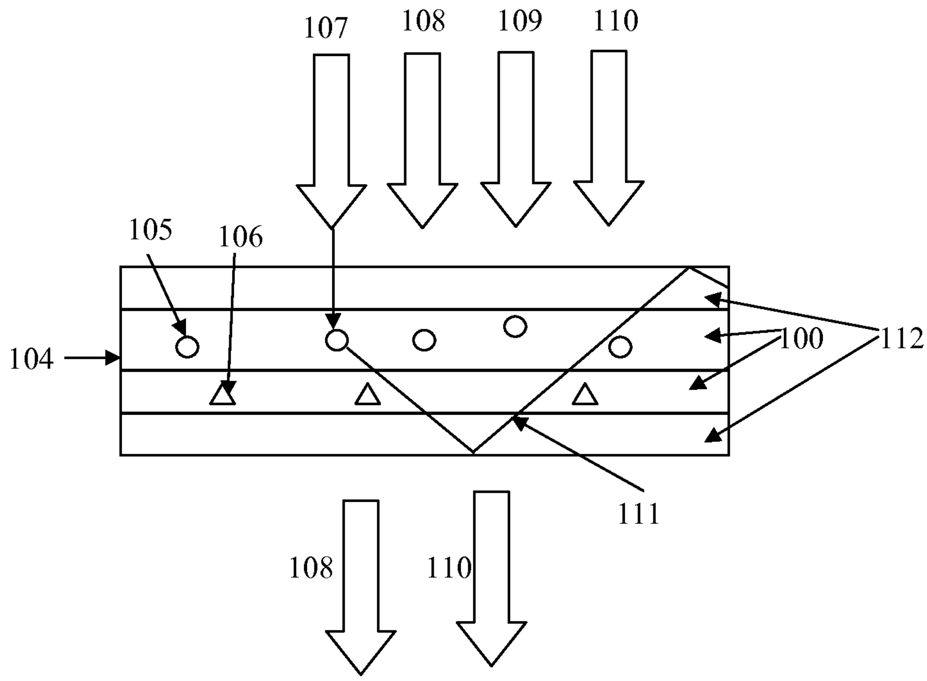


Figure 6

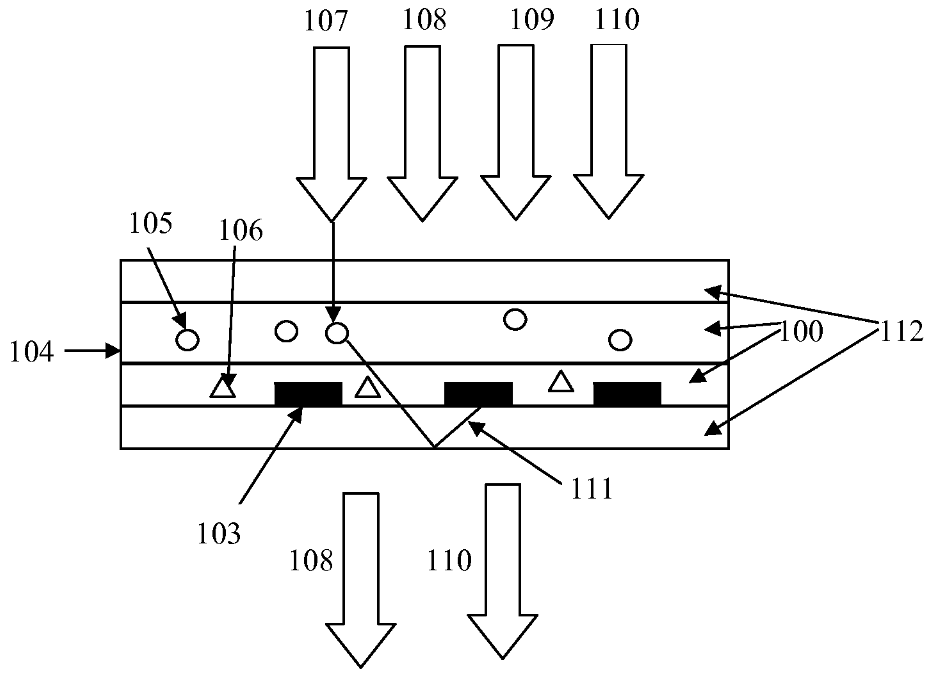


**Figure 7**

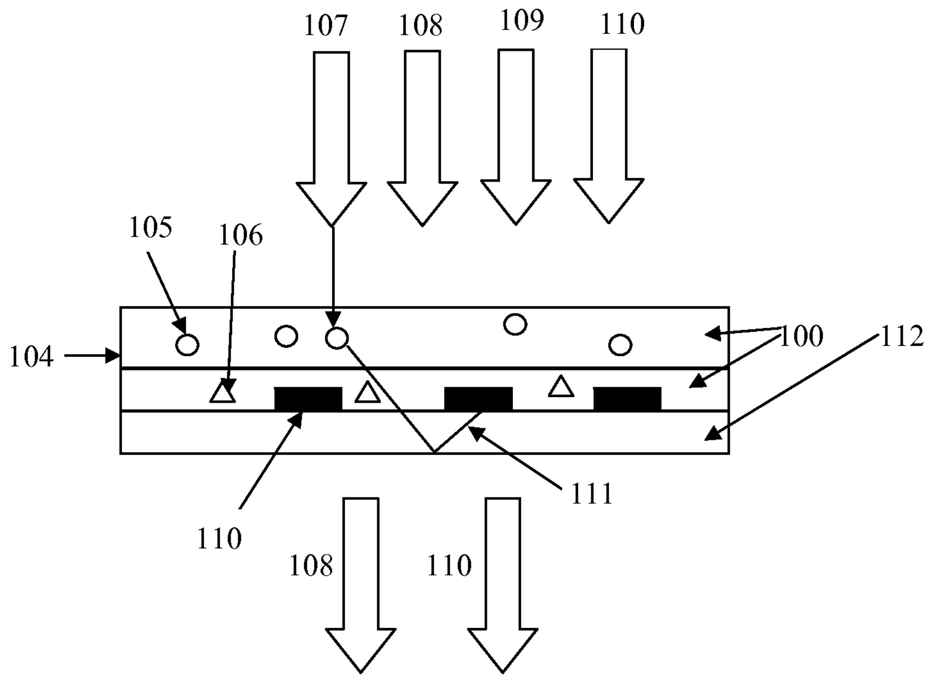


**Figure 8**

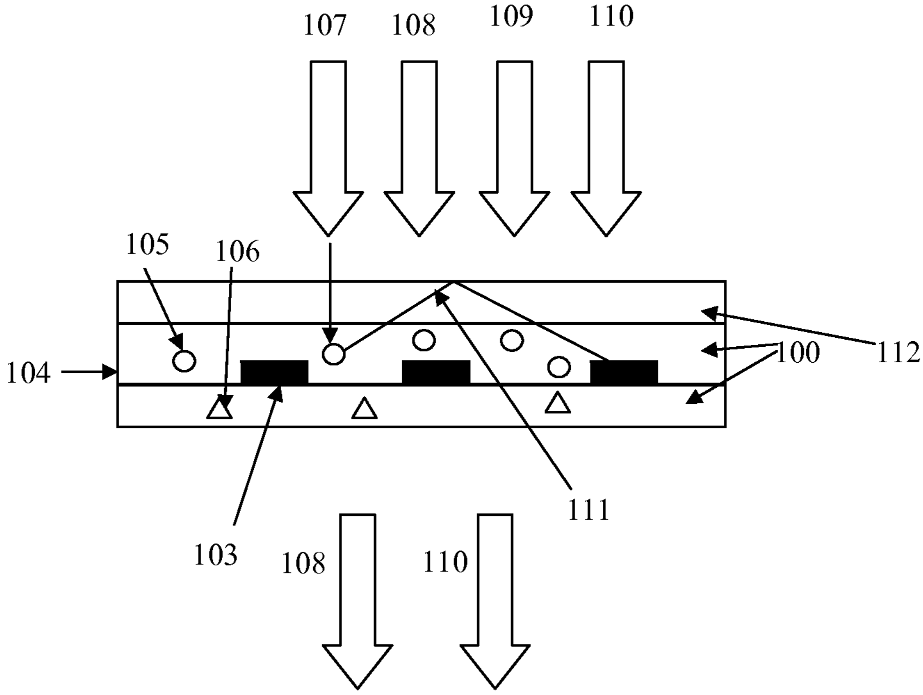


**Figure 9**

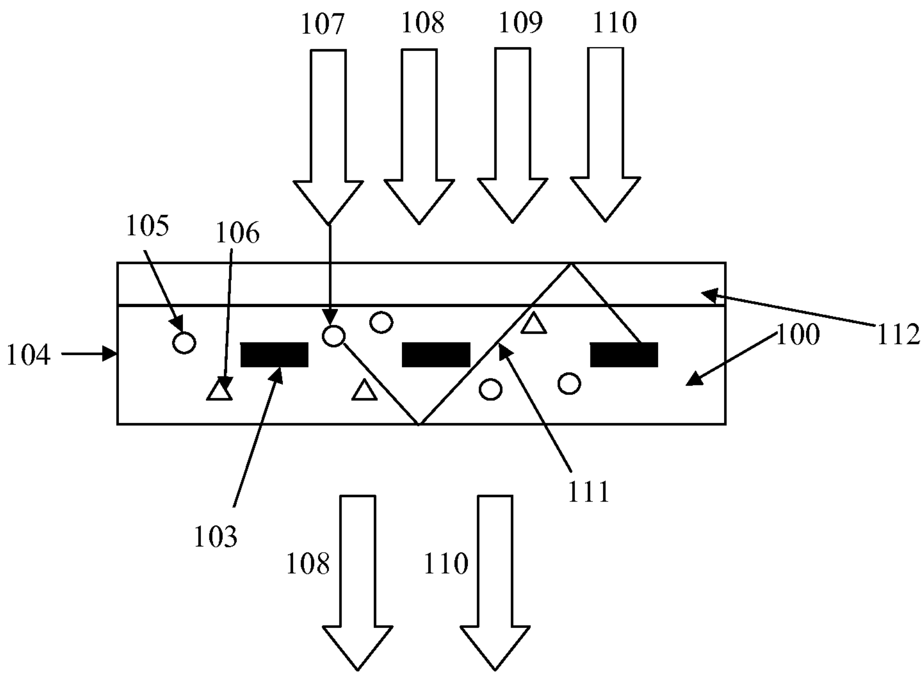


**Figure 10**

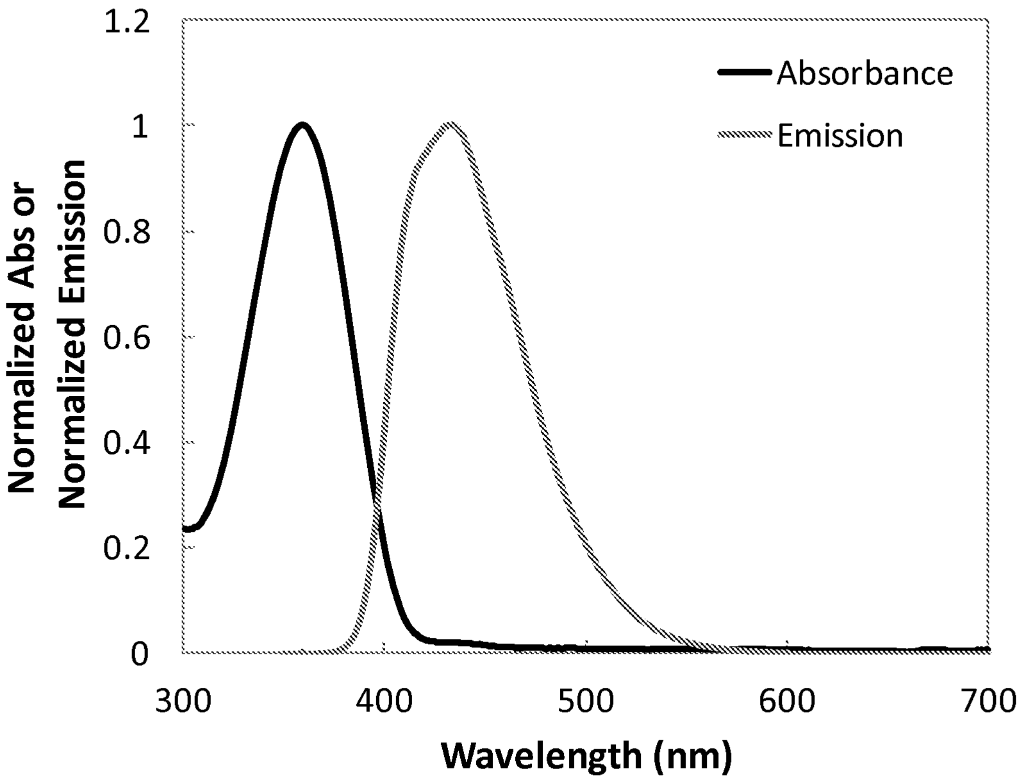
Absorbance
Emission
Normalized Abs or
Normalized Emission
Wavelength (nm)
0
0.2
0.4
0.6
0.8
1
1.2
300
400
500
600
700

Figure 11

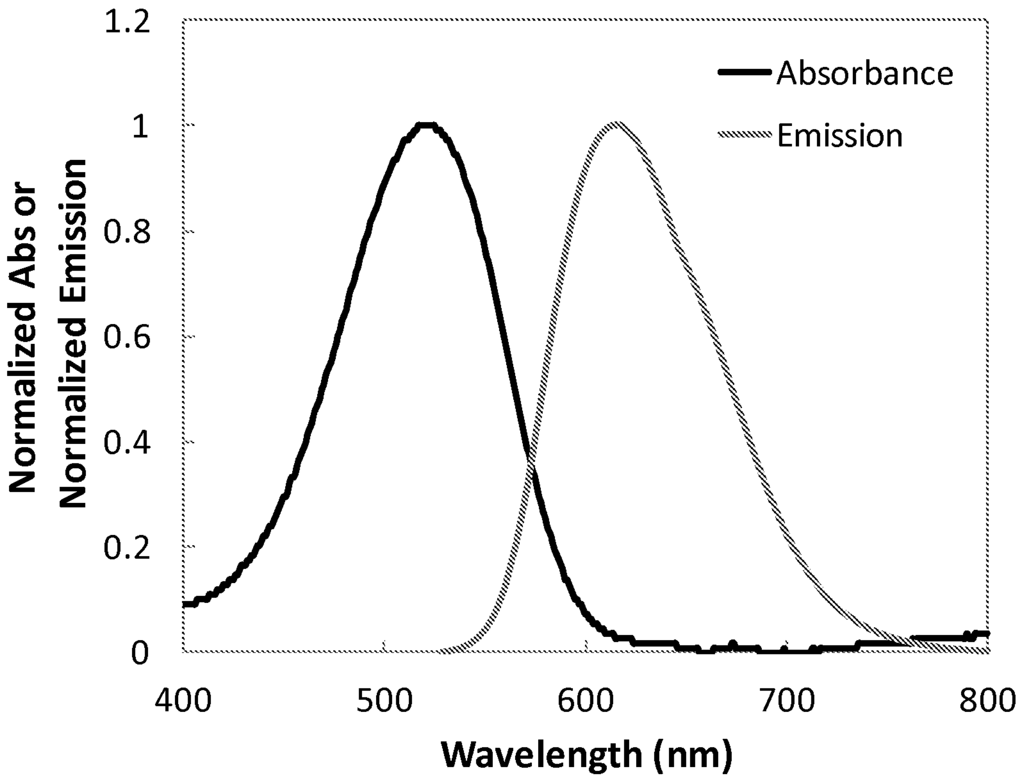
1.2
1
0.8
0.6
0.4
0.2
0
400
500
600
700
800
Normalized Abs or Normalized Emission
Wavelength (nm)
Absorbance
Emission

**Figure 12**

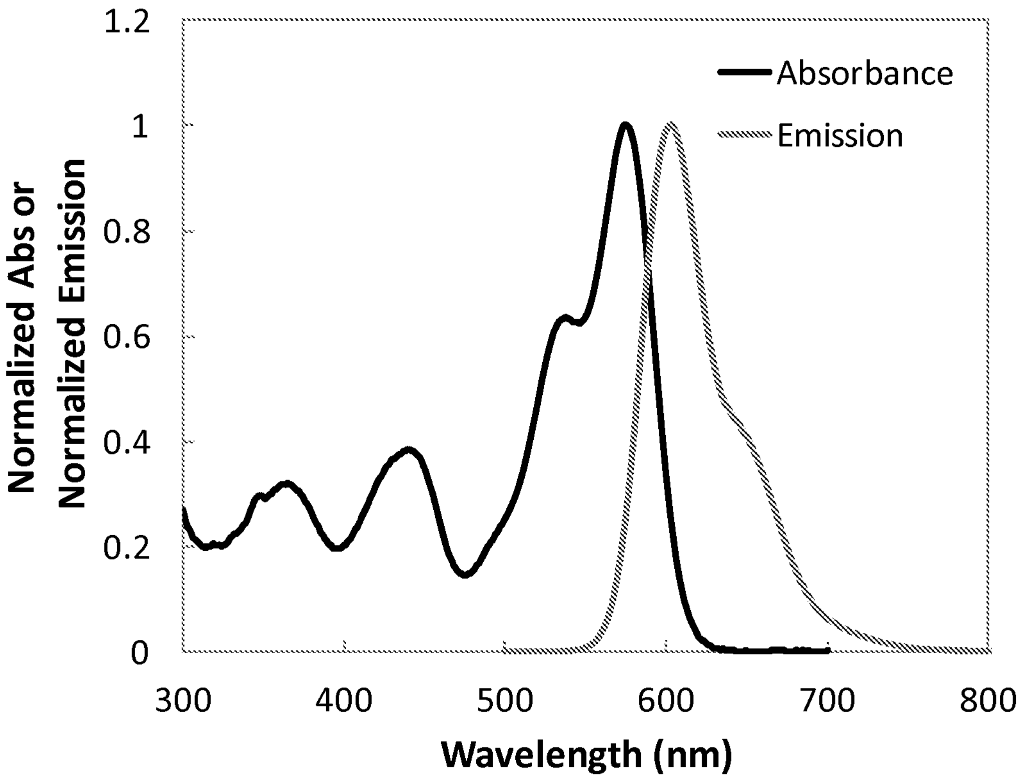
1.2
1
0.8
0.6
0.4
0.2
0
300
400
500
600
700
800
Normalized Abs or
Normalized Emission
Wavelength (nm)
Absorbance
Emission

**Figure 13**

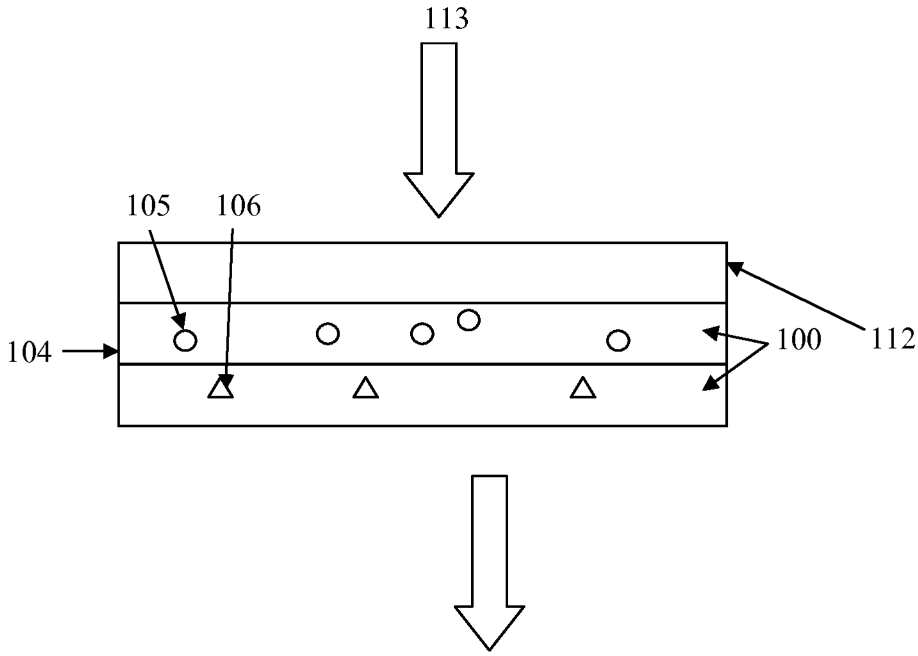


**Figure 14**

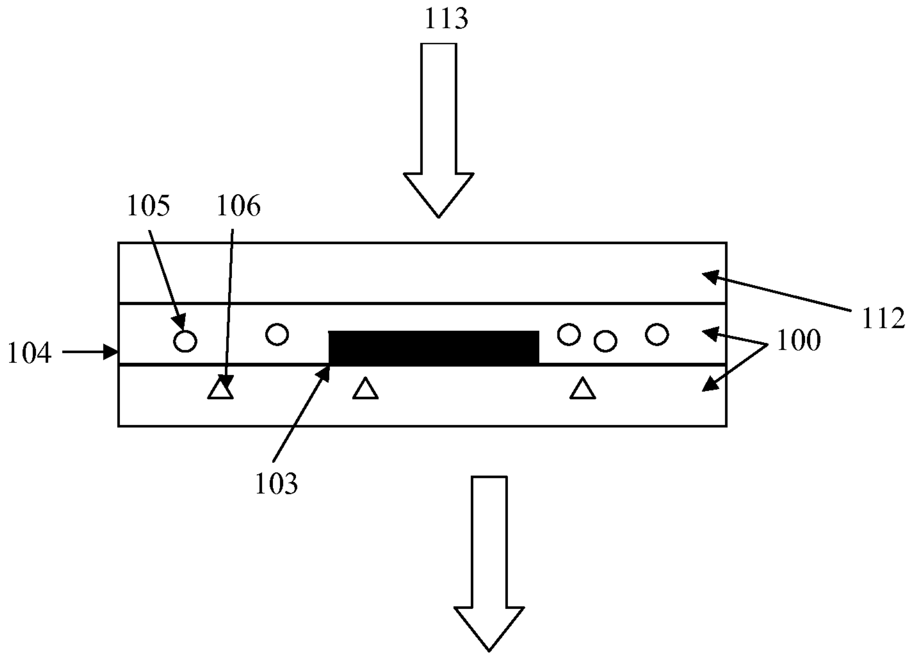


**Figure 15**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012134992 A2
- US 20100012183 A
- US 626679 A
- US 13978370 B
- US 61430053 A
- US 61485093 B
- US 61539392 B
- US 61749225 A
- WO 2012094409 A
- US 61555799 A
- US 20110016779 A
- US 6135665 A